# EUROPEAN PATENT APPLICATION

(11) **EP 3 828 190 A1**
(43) Date of publication of application: **02.06.2021**
(21) Application number: 20209767.1
(22) Date of filing: 25.11.2020
(51) Int. Cl.: C07F 15/00, C09K 11/06, H01L 51/00

(54) **ORGANOMETALLIC COMPOUND, ORGANIC LIGHT-EMITTING DEVICE INCLUDING THE ORGANOMETALLIC COMPOUND AND ELECTRONIC APPARATUS INCLUDING THE ORGANIC LIGHT-EMITTING DEVICE**

(30) Priority: 27.11.2019 KR 20190154355
(71) Applicant: Samsung Electronics Co., Ltd., Suwon-si 16677 (KR)
(72) Inventor: MIN, Minsik, 16678 Gyeonggi-do (KR); BAE, Hyejin, 16678 Gyeonggi-do (KR); JEON, Soonok, 16678 Gyeonggi-do (KR); KIM, Inkoo, 16678 Gyeonggi-do (KR); KIM, Jong Soo, 16678 Gyeonggi-do (KR); NAM, Sungho, 16678 Gyeonggi-do (KR); CHOI, Hyeonho, 16678 Gyeonggi-do (KR)
(74) Representative: Elkington and Fife LLP

(57) **Abstract**

Provided are an organometallic compound represented by Formula 1, an organic light-emitting device including the organometallic compound and an electronic apparatus including the organic light-emitting device:

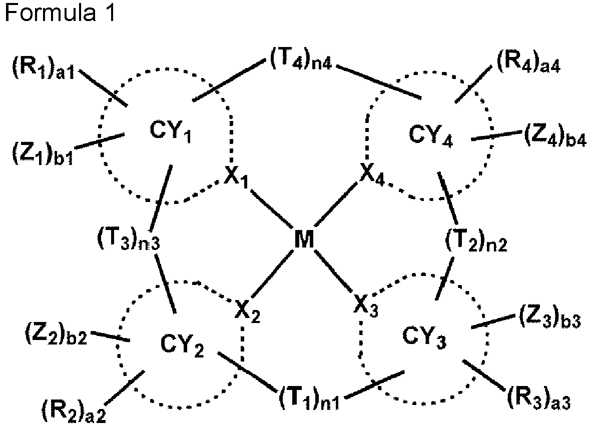

Formula 1 may be understood by referring to the descriptions of Formula 1 provided herein.

## Description

### FIELD OF THE INVENTION

The present disclosure relates to an organometallic compound, an organic light-emitting device including the same and an electronic apparatus including the organic light-emitting device.

### BACKGROUND OF THE INVENTION

Organic light-emitting devices (OLEDs) are self-emission devices which produce full-color images. In addition, OLEDs have wide viewing angles and exhibit excellent driving voltage and response speed characteristics.

Typical OLEDs include an anode, a cathode, and an organic layer that is between the anode and the cathode and includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state to thereby generate light.

### SUMMARY OF THE INVENTION

Provided are an organometallic compound, an organic light-emitting device including the organometallic compound and an electronic apparatus including the organic light emitting device.

Additional aspects will be set forth in part in the description which follows and, in part, will be apparent from the description, or may be learned by practice of the presented embodiments of the disclosure.

According an aspect of an embodiment, an organometallic compound is represented by Formula 1: 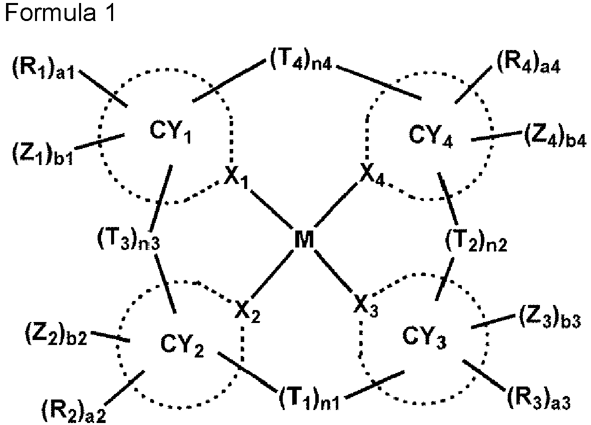
wherein, M in Formula 1 is a transition metal,
X₁ to X₄ in Formula 1 are each independently C or N,
in Formula 1, two of a bond between X₁ and M, a bond between X₂ and M, a bond between X₃ and M, and a bond between X₄ and M are each a coordinate bond, and the rest may each be a covalent bond,
Z₁ to Z₄ in Formula 1 are each independently a group represented by Formula 2: 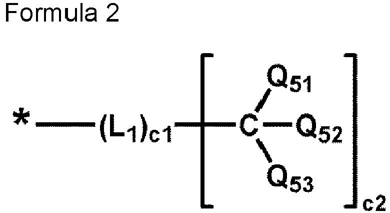
   b1 to b4 in Formula 1 are each independently an integer from 0 to 20, and the sum of b1 to b4 is 1 or greater,
   ring CY₁ to ring CY₄ in Formula 1 are each independently a C₅-C₃₀ carbocyclic group or a C₁-C₃₀ heterocyclic group,
   T₁ in Formula 1 is a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)2-*', *-C(R₅ₐ)=*', *=C(R₅a)-*', *-C(R₅ₐ)=C(R_{5b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
   T₂ in Formula 1 is a single bond, a double bond, *-N(R₆ₐ)-*', *-B(R₆ₐ)-*', *-P(R₆ₐ)-*', *-C(R₆ₐ)(R_{6b})-*', *-Si(R₆ₐ)(R_{6b})-*', *-Ge(R₆ₐ)(R_{6b})-*', *-S-*', *-Se-*', *-O-*', *-C(=O)-*', *-S(=O)-*', *-S(=O)₂-*', *-C(R₆ₐ)=*', *=C(R₆ₐ)-*', *-C(R₆ₐ)=C(R_{6b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
   T₃ in Formula 1 is a single bond, a double bond, *-N(R₇ₐ)-*', *-B(R₇ₐ)-*', *-P(R₇ₐ)-*', *-C(R₇ₐ)(R_{7b})-*', *-Si(R₇ₐ)(R_{7b})-*', *-Ge(R₇ₐ)(R_{7b})-*', *-S-*', *-Se-*', *-O-*', *-C(=O)-*', *-S(=O)-*', *-S(=O)₂-*', *-C(R₇ₐ)=*', *=C(R₇ₐ)-*', *-C(R₇a)=C(R_{7b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
   T₄ in Formula 1 is a single bond, a double bond, *-N(R₈ₐ)-*', *-B(R₈ₐ)-*', *-P(R₈ₐ)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*' *-C(=O)-*', *-S(=O)-*', *-S(=O)₂-*', *-C(R₈ₐ)=*', *=C(R₈ₐ)-*', *-C(R₈ₐ)=C(R_{8b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
   n1 to n4 in Formula 1 are each independently an integer from 0 to 5, and at least three of n1 to n4 are each independently an integer from 1 to 5,
   in Formula 1, when n1 is 0, T₁ is not present, when n2 is 0, T₂ is not present, when n3 is 0, T₃ is not present, and when n4 is 0, T₄ is not present,
   in Formula 1, when n1 is 2 or greater, at least two T₁(s) are identical to or different from each other, when n2 is 2 or greater, at least two T₂(s) are identical to or different from each other, when n3 is 2 or greater, at least two T₃(s) are identical to or different from each other, and when n4 is 2 or greater, at least two T₄(s) are identical to or different from each other,
   R₁ to R₄, R₅ₐ, R_{5b}, R₆ₐ, R_{6b}, R₇ₐ, R_{7b}, R₈ₐ, R_{8b}, and Q₅₁ to Q₅₃ in Formulae 1 and 2 are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted unsaturated C₁-C₁₀ heterocyclic group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉), and none of Q₅₁ to Q₅₃ in Formula 2 may be hydrogen,
   at least one of Q₅₁ to Q₅₃ in Formula 2 is independently a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
   a1 to a4 in Formula 1 are each independently an integer from 0 to 20,
   L₁ in Formula 2 is a single bond, a C₅-C₃₀ carbocyclic group unsubstituted or substituted with at least one R₁₀ₐ or a C₁-C₃₀ heterocyclic group unsubstituted or substituted with at least one R₁₀ₐ,
   c1 in Formula 2 is an integer from 1 to 10,
   c2 in Formula 2 is an integer from 1 to 20,
   at least two R₁(s) in the number of a1 in Formula 1 is optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
   at least two R₂(s) in the number of a2 in Formula 1 is optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
   at least two R₃(s) in the number of a3 in Formula 1 is optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
   at least two R₄(s) in the number of a4 in Formula 1 is optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
   at least two R₁ to R₄, R₅ₐ, R_{5b}, R₆ₐ, R_{6b}, R₇ₐ, R_{7b}, R₈ₐ, and R_{8b} is optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
   R₁₀ₐ is understood by referring to the description of R₁ provided herein,
   * and *' each indicate a binding site to an adjacent atom, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted unsaturated C₁-C₁₀ heterocyclic group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group is:
   deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
   a C₁-C₆₀ alkyl group, a C₂-C₆₀ alkenyl group, a C₂-C₆₀ alkynyl group, or C₁-C₆₀ alkoxy group, each substituted with deuterium, -F, -Cl, -Br, -I, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or any combination thereof;
   a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), - Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
   -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
   any combination thereof,
   wherein Q₁ to Q₉, Q₁₁ to Q₁₉, Q₂₁ to Q₂₉, and Q₃₁ to Q₃₉ is independently hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₂-C₁₀ heterocycloalkenyl group; an unsaturated C₁-C₁₀ heterocyclic group, a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

According to an aspect of another embodiment, an organic light-emitting device may include: a first electrode; a second electrode; and an organic layer disposed between the first electrode and the second electrode and including an emission layer, wherein the organic layer may include at least one organometallic compound represented by Formula 1.

The organometallic compound may be included in the emission layer of the organic layer, and the organometallic compound included in the emission layer may serve as a dopant.

According to an aspect of another embodiment, there is provided an electronic apparatus including the organic light-emitting device.

### BRIEF DESCRIPTION OF THE DRAWINGS

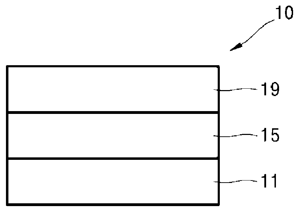

The above and other aspects, features, and advantages of certain embodiments of the disclosure will be more apparent from the following description taken in conjunction with the accompanying drawings, in which:
The FIGURE is a schematic cross-sectional view of an organic light-emitting device according to an exemplary embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween In contrast, when an element is referred to as being "directly on" another element, there are no intervening elements present

It will be understood that, although the terms "first," "second," "third" etc. may be used herein to describe various elements, components, regions, layers and/or sections, these elements, components, regions, layers and/or sections should not be limited by these terms These terms are only used to distinguish one element, component, region, layer or section from another element, component, region, layer or section Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures It will be understood that relative terms are intended to encompass different orientations of the device in addition to the orientation depicted in the Figures For example, if the device in one of the figures is turned over, elements described as being on the "lower" side of other elements would then be oriented on "upper" sides of the other elements The exemplary term "lower," can therefore, encompasses both an orientation of "lower" and "upper," depending on the particular orientation of the figure Similarly, if the device in one of the figures is turned over, elements described as "below" or "beneath" other elements would then be oriented "above" the other elements The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments As such, variations from the shapes of the illustrations as a result, for example, of manufacturing techniques and/or tolerances, are to be expected Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features Moreover, sharp angles that are illustrated may be rounded Thus, the regions illustrated in the figures are schematic in nature and their shapes are not intended to illustrate the precise shape of a region and are not intended to limit the scope of the present claims.

According to an aspect, an organometallic compound may be represented by Formula 1: 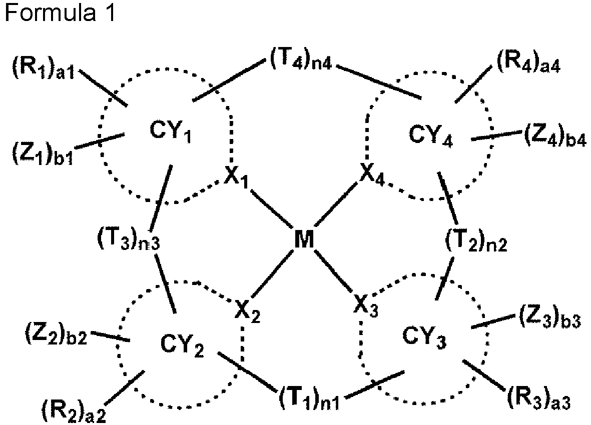 wherein, in Formula 1, M may be a transition metal.

In some embodiments, M may a first-row transition metal, a second-row transition metal, or a third-row transition metal in the periodic table of elements.

In some embodiments, M may be iridium (Ir), platinum (Pt), osmium (Os), titanium (Ti), zirconium (Zr), hafnium (Hf), europium (Eu), terbium (Tb), thulium (Tm), rhodium (Rh), palladium (Pd), or gold (Au).

In some embodiments, M in Formula 1 may be Pt, Pd, or Au.

In Formula 1, X₁ to X₄ may each independently be C or N.

In some embodiments, X₂ and X₃ may each be C, and X₄ may be N.

In some embodiments, X₁ to X₃ may each be C, and X₄ may be N.

In Formula 1, two a bond between X₁ and M, a bond between X₂ and M, a bond between X₃ and M, and a bond between X₄ and M may each be a coordinate bond, and the rest may each be a covalent bond.

In some embodiments, a bond between X₁ and M in Formula 1 may be a coordinate bond. For example, in Formula 1, a bond between X₁ and M may be a coordinate bond and X₁ may be C. Alternatively, in Formula 1, a bond between X₁ and M may be a coordinate bond and X₁ may be N.

In one or more embodiments, in Formula 1, a bond between X₁ and M and a bond between X₄ and M may each be a coordinate bond, and a bond between X₂ and M and a bond between X₃ and M may each be a covalent bond.

In one or more embodiments, in Formula 1,
X₂ and X₃ may each be C,
X₄ may be N,
a bond between X₂ and M and a bond between X₃ and M may each be a covalent bond, and
a bond between X₁ and M and a bond between X₄ and M may each be a coordinate bond.

Z₁ to Z₄ in Formula 1 may each independently be a group represented by Formula 2:

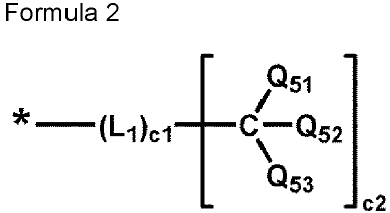

Formula 2 may be understood by referring to the description thereof provided herein.

In Formula 1, b1 to b4 may respectively indicate the number of Z₁(s) to Z₄(s), and b1 to b4 may each independently be an integer from 0 to 20 (e.g., 0, 1, 2, or 3), wherein the sum of b1 to b4 may be 1 or greater (e.g., 1, 2, 3, 4, 5, or 6). That is, the organometallic compound represented by Formula 1 may include at least one (e.g., one, two, three, four, five, or six) group represented by Formula 2. When b1 is 2 or greater, at least two Z₁ groups may be identical to or different from each other, when b2 is 2 or greater, at least two Z₂ groups may be identical to or different from each other, when b3 is 2 is or greater, at least two Z₃ groups may be identical to or different from each other, and when b4 is 2 is or greater, at least two Z₄ groups may be identical to or different from each other.

In some embodiments, in Formula 1, b1 may be 0, 1, 2 or 3 and b2 to b4 may be 0 or 1.

In some embodiments, in Formula 1, the sum of b1, b2, b3 and b4 may be 1, 2 or 3.

In some embodiments, in Formula 1,
i) b1 may be 1, 2 or 3, and b2, b3, and b4 may each be 0,
ii) b2 may be 1, and b1, b3, and b4 may each be 0,
iii) b3 may be 1, and b1, b2, and b4 may each be 0,
iv) b4 may be 1, and b1, b2, and b3 may be 0,
v) b1 may be 1 or 2, b2 may be 1, and b3 and b4 may each be 0,
vi) b1 may be 1 or 2, b3 may be 1, and b2 and b4 may each be 0,
vii) b1 may be 1 or 2, b4 may be 1, and b2 and b3 may each be 0,
viii) b1 may be 0, b2 may be 1, and b3 may be 1, and b4 may be 0,
ix) b1 may be 0, b2 may be 1, and b3 may be 0, and b4 may be 1, or
x) b1 may be 0, b2 may be 0, and b3 may be 1, and b4 may be 1.

In Formula 1, ring CY₁ to ring CY₄ may each independently be a C₅-C₃₀ carbocyclic group or a C₁-C₃₀ heterocyclic group.

In some embodiments, ring CY₁ to ring CY₄ in Formula 1 may each independently be i) a first ring, ii) a second ring, iii) a condensed ring in which at least two first rings are condensed, iv) a condensed ring in which at least two second rings are condensed, or v) a condensed ring in which at least one first ring is condensed with at least one second ring,
the first ring may be a cyclopentane group, a cyclopentadiene group, a furan group, a thiophene group, a pyrrole group, a silole group, a borole group, a phosphole group, a germole group, a selenophene group, an oxazole group, an isoxazole group, a 1,2,3-oxadiazole group, a 1,2,4-oxadiazole group, a 1,2,5-oxadiazole group, a 1,3,4-oxadiazole group, an oxatriazole group, an isooxatriazole group, a thiazole group, an isothiazole group, a 1,2,3-thiadiazole group, a 1,2,4-thiadiazole group, a 1,2,5-thiadiazole group, a 1,3,4-thiadiazole group, a thiatriazole group, an isothiatriazole group, a pyrazole group, an imidazole group, a 1,2,3-triazole group, a 1,2,4-triazole group, a tetrazole group, an azasilole group, a 1,2,3-diazasilole group, a 1,2,4-diazasilole group, a 1,2,5-diazasilole group, a 1,3,4-diazasilole group, or a triazasilole group, and
the second ring may be an adamantane group, a norbornane group, a norbornene group, a cyclohexane group, a cyclohexene group, a cyclohexadiene group, a benzene group, a pyridine group, a pyrimidine group, a pyrazine group, a pyridazine group, a 1,3,5-triazine group, a 1,2,3-triazine group, a 1,2,4-triazine group, a 1,2-oxazine group, a 1,3-oxazine group, a 1,4-oxazine group, a 1,2-thiazine group, a 1,3-thiazine group, a 1,4-thiazine group, a dihydropyrazine group, a dihydropyridine group, or a dihydroazasilole group.

In some embodiments, ring CY₁ in Formula 1 may be i) a first ring, ii) a condensed ring in which at least two first rings are condensed, or iii) a condensed ring in which at least one first ring is condensed with at least one second ring, and C or N in the first ring included in ring CY₁ may be X₁ in Formula 1. That is, the first ring (e.g., a 5-membered ring) included in ring CY₁ may be bound to M in Formula 1. The first ring and the second ring may respectively be understood by referring to the descriptions of the first ring and the second ring provided herein.

In one or more embodiments, in Formula 1, ring CY₁ to ring CY₄ may each independently be a cyclopentane group, a cyclopentene group, a cyclohexane group, a cyclohexene group, a cyclohexadiene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a 1,3,5-triazine group, a 1,2,3-triazine group, a 1,2,4-triazine group, a quinoline group, an isoquinoline group, a quinoxaline group, a quinazoline group, a phenanthroline group, a pyrrole group, a pyrazole group, an imidazole group, a 1,2,3-triazole group, a 1,2,4-triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, in Formula 1, ring CY₁ may be a pyrazole group, an imidazole group, a 1,2,3-triazole group, a 1,2,4-triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a pyridine group, a pyrimidine group, a pyrazine group, a pyridazine group, a 1,3,5-triazine group, a 1,2,3-triazine group, a 1,2,4-triazine group, a quinoline group, an isoquinoline group, a quinoxaline group, a quinazoline group, a 5,6,7,8-tetrahydroisoquinoline group, or a 5,6,7,8-tetrahydroquinoline group.

In one or more embodiments, in Formula 1, ring CY₂ and CY₃ may each independently be a benzene group, a naphthalene group, a carbazole group, a fluorene group, a dibenzosilole group, a dibenzothiophene group, a dibenzofuran group, an azacarbazole group, an azafluorene group, an azadibenzosilole group, an azadibenzothiophene group, an azadibenzofuran group, a pyridine group, a pyrimidine group, a pyrazine group, a pyridazine group, a 1,3,5-triazine group, a 1,2,3-triazine group, a 1,2,4-triazine group, a quinoline group, an isoquinoline group, a quinoxaline group, a quinazoline group, a 5,6,7,8-tetrahydroisoquinoline group, or a 5,6,7,8-tetrahydroquinoline group.

In one or more embodiments, in Formula 1, ring CY₄ may be a benzene group, a naphthalene group, a carbazole group, a fluorene group, a dibenzosilole group, a dibenzothiophene group, a dibenzofuran group, an azacarbazole group, an azafluorene group, an azadibenzosilole group, an azadibenzothiophene group, an azadibenzofuran group, a pyridine group, a pyrimidine group, a pyrazine group, a pyridazine group, a 1,3,5-triazine group, a 1,2,3-triazine group, a 1,2,4-triazine group, a quinoline group, an isoquinoline group, a quinoxaline group, a quinazoline group, a 5,6,7,8-tetrahydroisoquinoline group, a 5,6,7,8-tetrahydroquinoline group, benzimidazole group, a benzoxazole group, or a benzothiazole group.

In Formula 1, T₁ may be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)2-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ, T₂ may be a single bond, a double bond, *-N(R₆ₐ)-*', *-B(R₆ₐ)-*', *-P(R₆ₐ)-*', *-C(R₆ₐ)(R_{6b})-*', *-Si(R₆ₐ)(R_{6b})-*', *-Ge(R₆ₐ)(R_{6b})-*', *-S-*', *-Se-*', *-O-*', *-C(=O)-*', *-S(=O)-*', *-S(=O)₂-*' *-C(R₆ₐ)=*', *=C(R₆ₐ)-*', *-C(R₆ₐ)=C(R_{6b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ, T₃ may be a single bond, a double bond, *-N(R₇ₐ)-*', *-B(R₇ₐ)-*', *-P(R₇ₐ)-*', *-C(R₇ₐ)(R_{7b})-*', *-Si(R₇ₐ)(R_{7b})-*', *-Ge(R₇ₐ)(R_{7b})-*', *-S-*', *-Se-*', *-O-*', *-C(=O)-*', *-S(=O)-*', *-S(=O)₂-*', *-C(R₇ₐ)*', *=C(R₇ₐ)-*', *-C(R₇ₐ)=C(R_{7b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ, and T₄ may be a single bond, a double bond, *-N(R₈ₐ)-*', *-B(R₈ₐ)-*', *-P(R₈ₐ)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈ₐ)=*', *=C(R₈ₐ)-*', *-C(R₈ₐ)=C(R_{8b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ. R₅ₐ, R_{5b}, R₆ₐ, R_{6b}, R₇ₐ, R_{7b}, R₈ₐ, and R_{8b} may respectively be understood by referring to the descriptions of R₅ₐ, R_{5b}, R₆ₐ, R_{6b}, R₇ₐ, R_{7b}, R₈ₐ, and R_{8b} provided herein.

In one or more embodiments, in Formula 1, T₁ may be *-N(R₅ₐ)-*', *-B(R₅ₐ)-*', *-C(R₅ₐ)(R_{5b})-*', *-Si(R₅ₐ)(R_{5b})-*', *-S-*', or *-O-*'.

In one or more embodiments, in Formula 1, T₂ may be a single bond, *-N(R₆ₐ)-*', *-B(R₆ₐ)-*', *-C(R₆ₐ)(R_{6b})-*', *-Si(R₆ₐ)(R_{6b})-*', *-S-*', or *-O-*'.

In one or more embodiments, in Formula 1, T₃ may be a single bond.

In one or more embodiments, in Formula 1, T₄ may be *-N(R₈ₐ)-*', *-B(R₈ₐ)-*', *-C(R₈ₐ)(R_{8b})-*', *-Si(R₈ₐ)(R_{8b})-*', *-S-*', *-O-*', a C₅-C₃₀ carbocyclic group unsubstituted or substituted with at least one R₁₀ₐ, or a C₁-C₃₀ heterocyclic group unsubstituted or substituted with at least one R₁₀ₐ.

n1 to n4 in Formula 1 may each independently be an integer from 0 to 5, and at least three of n1 to n4 may each independently be an integer from 1 to 5. That is, the organometallic compound represented by Formula 1 may be a tetradentate ligand.

In one or more embodiments, in Formula 1, i) n1 may be 0 and n2, n3 and n4 may each independently be an integer from 1 to 5, ii) n2 may be 0 and n1, n3 and n4 may each independently be an integer from 1 to 5, iii) n3 may be 0 and n1, n2 and n4 may each independently be an integer from 1 to 5, iv) n4 may be 0 and n1, n2 and n3 may each independently be an integer from 1 to 5, or v) n1, n2, n3 and n4 may each independently be an integer from 1 to 5.

In Formula 1, when n1 is 0, T₁ may not be present, when n2 is 0, T₂ may not be present, when n3 is 0, T₃ may not be present, and when n4 is 0, T₄ may not be present.

In Formula 1, when n1 is 2 or greater, at least two T₁(s) may be identical to or different from each other, when n2 is 2 or greater, at least two T₂(s) may be identical to or different from each other, when n3 is 2 or greater, at least two T₃(s) may be identical to or different from each other, and when n4 is 2 or greater, at least two T₄(s) may be identical to or different from each other.

In some embodiments, in Formula 1,
1) n4 may be 0, and n1, n2, and n3 may be 1,
2) n4 may be 1, 2, 3, or 4, and n1, n2, and n3 may each be 1,
3) n3 may be 0, n1 and n2 may each be 1, and n4 may be 1, 2, 3, or 4,
4) n2 may be 0, n1 and n3 may each be 1, and n4 may be 1, 2, 3, or 4, or
5) n1 may be 0, n2 and n3 may each be 1, and n4 may be 1, 2, 3, or 4.

In some embodiments, in Formula 1, n1 and n3 may each not be 0.

In some embodiments, in Formula 1, n1 may not be 0 (for example, n1 may be 1), and T₁ may be *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

In one or more embodiments, in Formula 1, n2 may not be 0 (for example, n2 may be 1), and T₂ may be a single bond.

In one or more embodiments, in Formula 1, n2 may not be 0 (for example, n2 may be 1), and T₂ may be *-N(R₆ₐ)-*', *-B(R₆ₐ)-*', *-P(R₆ₐ)-*', *-C(R₆ₐ)(R_{6b})-*', *-Si(R₆ₐ)(R_{6b})-*', *-Ge(R₆ₐ)(R_{6b})-*', *-S-*', or *-O-*'.

In one or more embodiments, in Formula 1, n3 may not be 0 (for example, n3 may be 1), and T₃ may be a single bond.

In one or more embodiments, in Formula 1, n4 may be 0.

In one or more embodiments, in Formula 1, n4 may not be 0, and T₄ may be *-N(R₈ₐ)-*', *-B(R₈ₐ)-*', *-P(R₈ₐ)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*' *-C(R₈ₐ)=*', *=C(R₈ₐ)-*', *-C(R₈ₐ)=C(R_{8b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ.

In one or more embodiments, in Formula 1, n4 may be 1, 2, 3, or 4, and T₄ may be *-C(R₈ₐ)(R_{8b})-*', *-S-*', *-O-*', or a C₅-C₃₀ carbocyclic group unsubstituted or substituted with at least one R₁₀ₐ.

In Formulae 1 and 2, R₁ to R₄, R₅ₐ, R_{5b}, R₆ₐ, R_{6b}, R₇ₐ, R_{7b}, R₈ₐ, R_{8b}, and Q₅₁ to Q₅₃ may each independently be hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted unsaturated C₁-C₁₀ heterocyclic group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - Ge(Q₃)(Q₄)(Q₅), -B(Q₆)(Q₇), -P(=O)(Q₈)(Q₉), or -P(Q₈)(Q₉), wherein none of Q₅₁ to Q₅₃ in Formula 2 may be hydrogen and at least one of Q₅₁ to Q₅₃ (e.g., one or two of Q₅₁ to Q₅₃) in Formula 2 may each independently be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In some embodiments, R₁ to R₄, R₅ₐ, R_{5b}, R₆ₐ, R_{6b}, R₇ₐ, R_{7b}, R₈ₐ, R_{8b}, and Q₅₁ to Q₅₃ may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with deuterium, -F, -Cl, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a cyclooctenyl group, a cyclopentadienyl group, a cyclohexadienyl group, a cycloheptadienyl group, a cyclooctadienyl group, a cycloheptatrienyl group, a cyclooctatrienyl group, a bicyclo[1.1.1]pentyl group, a bicyclo[2.1.1]hexyl group, a bicyclo[2.2.2]octyl group, a bicyclo[2.2.2]octenyl group, a bicyclo[2.2.2]octadienyl group, a bicyclo[2.2.2]octatrienyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)cyclopentadienyl group, a (C₁-C₂₀ alkyl)cyclohexadienyl group, a (C₁-C₂₀ alkyl)cycloheptadienyl group, a (C₁-C₂₀ alkyl)cyclooctadienyl group, a (C₁-C₂₀ alkyl)cycloheptatrienyl group, a (C₁-C₂₀ alkyl)cyclooctatrienyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a (C₁-C₂₀ alkyl)bicyclo[2.2.2]octadienyl group, a (C₁-C₂₀ alkyl)bicyclo[2.2.2]octatrienyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a cyclooctenyl group, a cyclopentadienyl group, a cyclohexadienyl group, a cycloheptadienyl group, a cyclooctadienyl group, a cycloheptatrienyl group, a cyclooctatrienyl group, a bicyclo[1.1.1]pentyl group, a bicyclo[2.1.1]hexyl group, a bicyclo[2.2.2]octyl group, a bicyclo[2.2.2]octenyl group, a bicyclo[2.2.2]octadienyl group, a bicyclo[2.2.2]octatrienyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₂-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a cyclooctenyl group, a cyclopentadienyl group, a cyclohexadienyl group, a cycloheptadienyl group, a cyclooctadienyl group, a cycloheptatrienyl group, a cyclooctatrienyl group, a bicyclo[1.1.1]pentyl group, a bicyclo[2.1.1]hexyl group, a bicyclo[2.2.2]octyl group, a bicyclo[2.2.2]octenyl group, a bicyclo[2.2.2]octadienyl group, a bicyclo[2.2.2]octatrienyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)cyclopentadienyl group, a (C₁-C₂₀ alkyl)cyclohexadienyl group, a (C₁-C₂₀ alkyl)cycloheptadienyl group, a (C₁-C₂₀ alkyl)cyclooctadienyl group, a (C₁-C₂₀ alkyl)cycloheptatrienyl group, a (C₁-C₂₀ alkyl)cyclooctatrienyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
wherein Q₁ to Q₉ may each independently be:
   deuterium, -F, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, -CD₂CDH₂, -CF₃, -CF₂H, -CFH₂, -CH₂CF₃, -CH₂CF₂H, -CH₂CFH₂, -CHFCH₃, - CHFCF₂H, -CHFCFH₂, -CHFCF₃, -CF₂CF₃, -CF₂CF₂H, or -CF₂CFH₂; or
   an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or any combination thereof.

In some embodiments, Q₅₁ to Q₅₃ may each independently be a substituted or unsubstituted C₁-C₆₀ alkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, wherein at least one of Q₅₁ to Q₅₃ (e.g., one or two of Q₅₁ to Q₅₃) may be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments,
Q₅₁ to Q₅₃ may each independently be a C₁-C₂₀ alkyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a phenyl group, a (C₁-C₂₀ alkyl)phenyl group, a biphenyl group, a terphenyl group, a naphthyl group, a pyridinyl group, a pyrimidinyl group, or any combination thereof,
wherein at least one of Q₅₁ to Q₅₃ (e.g., one or two of Q₅₁ to Q₅₃) may be a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a phenyl group, a (C₁-C₂₀ alkyl)phenyl group, a biphenyl group, a terphenyl group, a naphthyl group, a pyridinyl group, a pyrimidinyl group, or any combination thereof.

In one or more embodiments, in Formulae 1 and 2, R₁ to R₄, R₅ₐ, R_{5b}, R₆ₐ, R_{6b}, R₇ₐ, R_{7b}, R₅ₐ, R_{8b}, and Q₅₁ to Q₅₃ may each independently be hydrogen, deuterium, -F, - CH₃, -CD₃, -CD₂H, -CDH₂, -CF₃, -CF₂H, -CFH₂, C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with a deuterium, a group represented by one of Formulae 9-1 to 9-39 in which at least one hydrogen is substituted with -F, a group represented by one of Formulae 9-201 to 9-237, a group represented by one of Formulae 9-201 to 9-237 in which at least one hydrogen is substituted with a deuterium, a group represented by one of Formulae 9-201 to 9-237 in which at least one hydrogen is substituted with -F, a group represented by one of Formulae 10-1 to 10-129, a group represented by one of Formulae 10-1 to 10-129 in which at least one hydrogen is substituted with a deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with a deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (wherein Q₃ to Q₅ may respectively be understood by referring to the descriptions of Q₃ to Q₅ provided herein), wherein none of Q₅₁ to Q₅₃ in Formula 2 may be hydrogen and at least one of Q₅₁ to Q₅₃ may each independently a group represented by one of Formulae 10-12 to 10-129, a group represented by one of Formulae 10-12 to 10-129 in which at least one hydrogen is substituted with a deuterium, a group represented by one of Formulae 10-12 to 10-129 in which at least one hydrogen is substituted with -F, a group represented by one of Formulae 10-201 to 10-350, a group represented by one of Formulae 10-201 to 10-350 in which at least one hydrogen is substituted with a deuterium, or a group represented by one of Formulae 10-201 to 10-350 in which at least one hydrogen is substituted with -F:

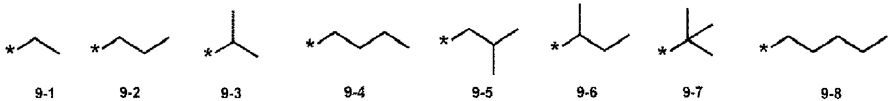

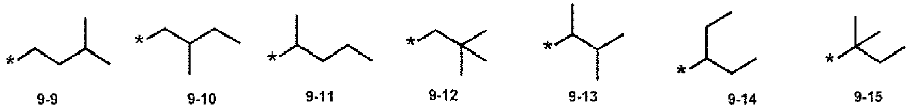

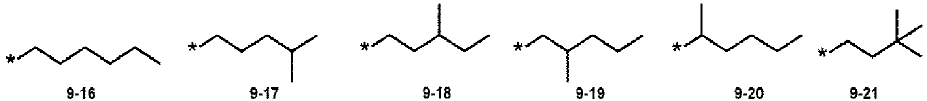

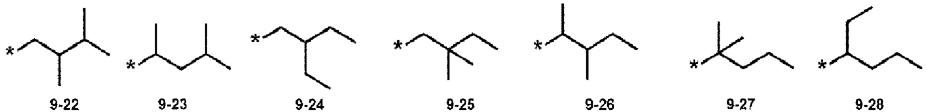

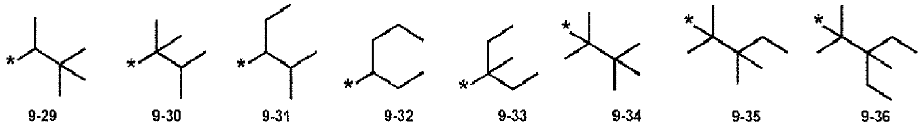

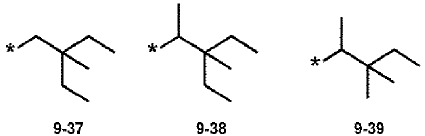

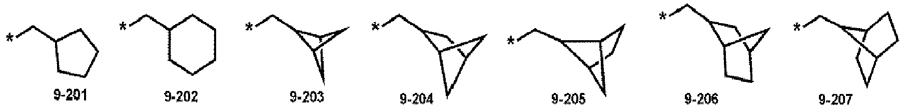

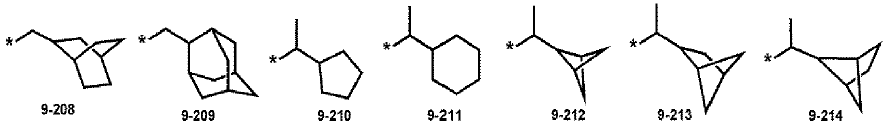

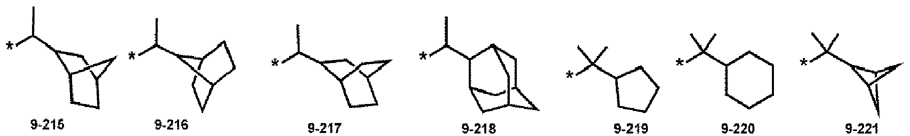

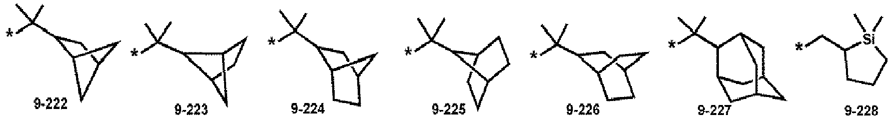

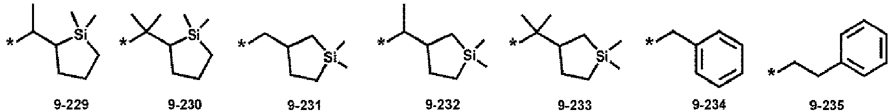

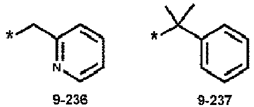

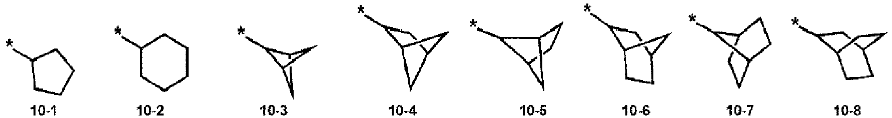

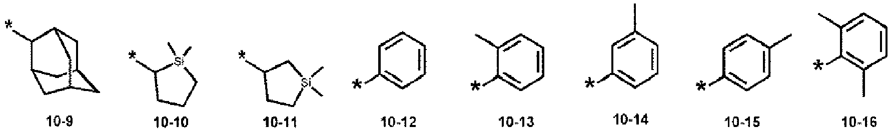

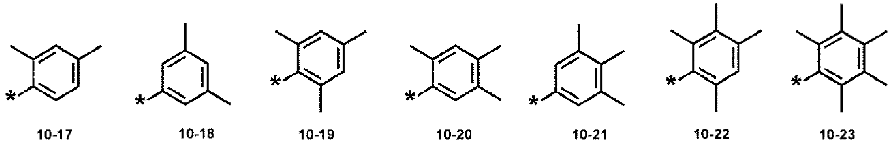

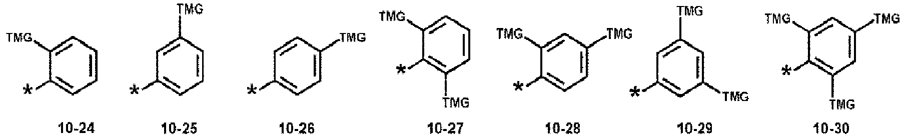

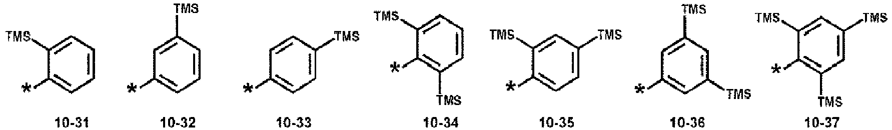

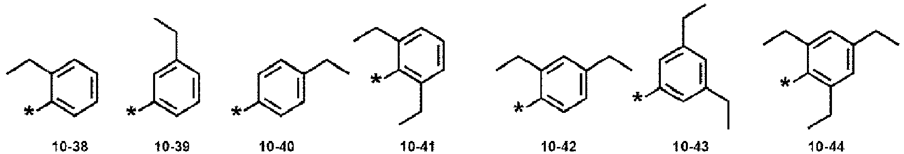

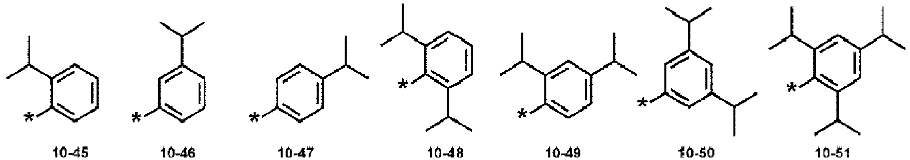

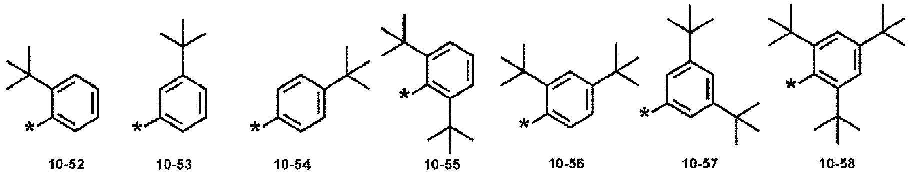

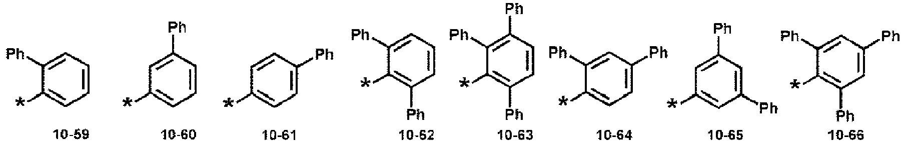

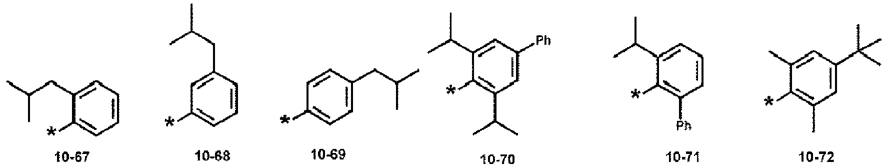

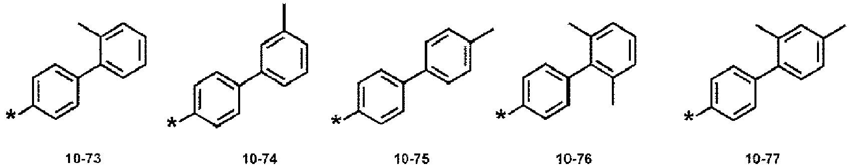

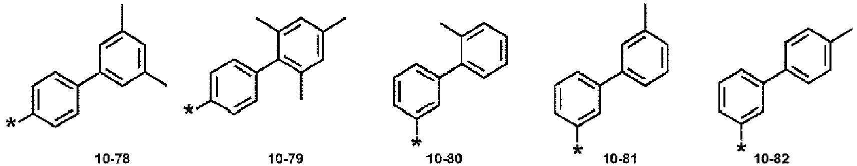

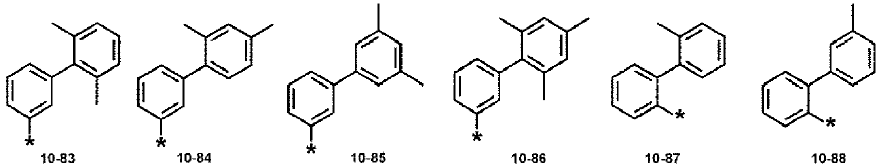

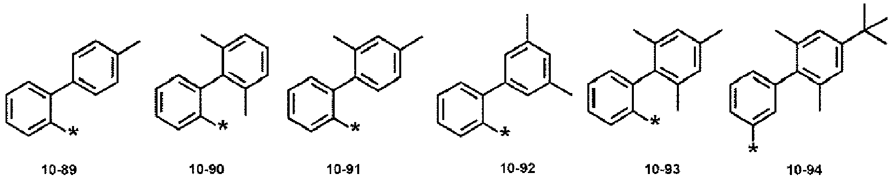

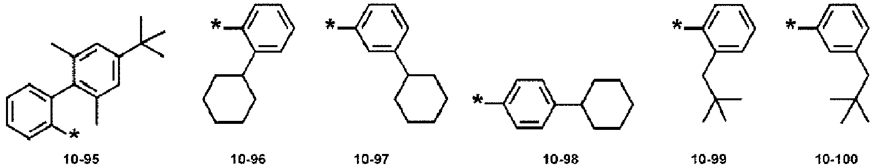

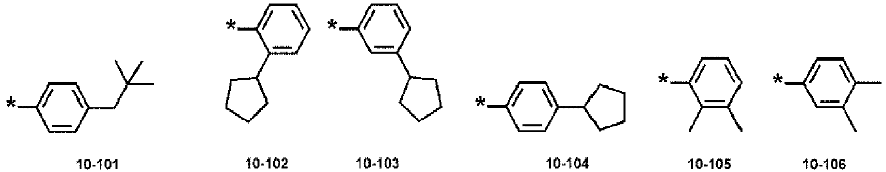

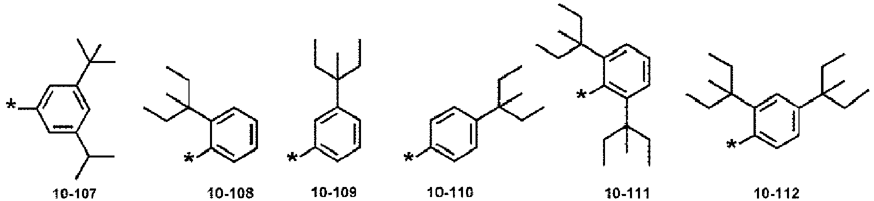

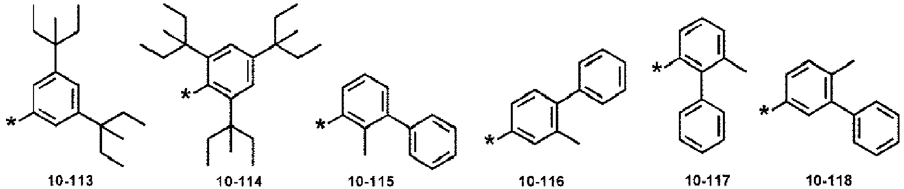

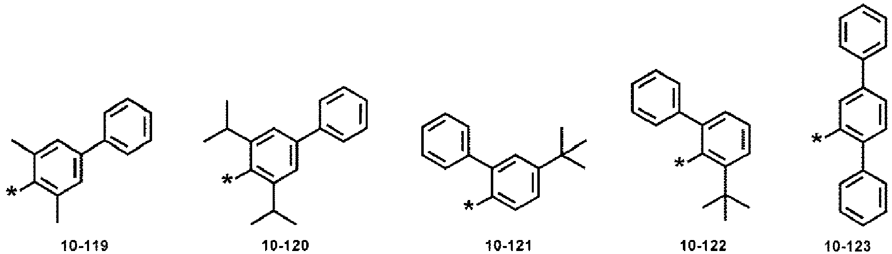

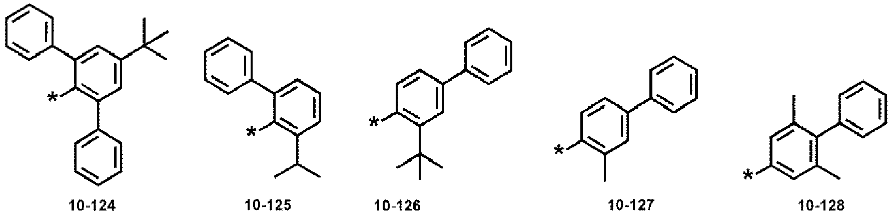

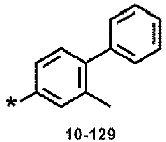

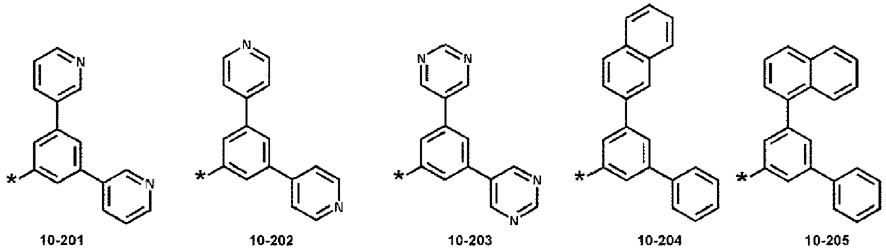

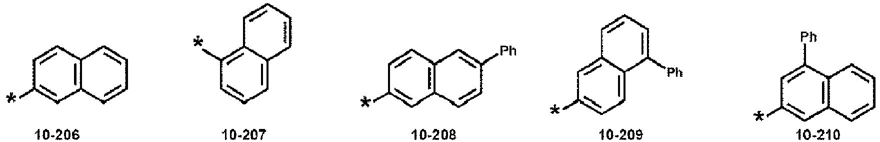

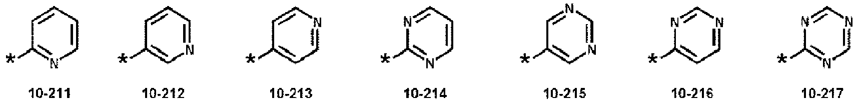

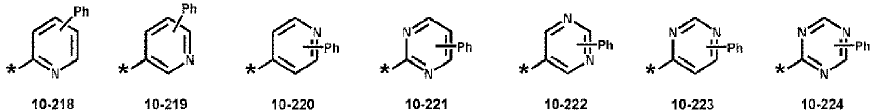

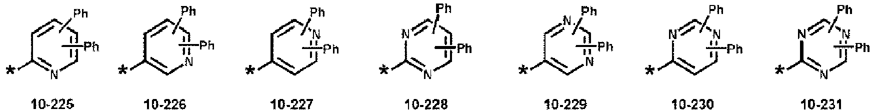

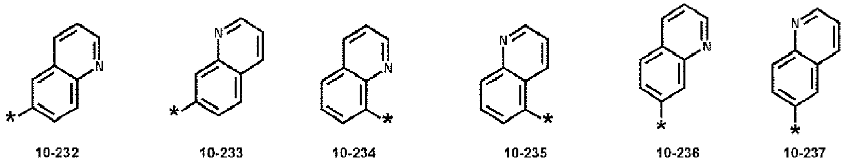

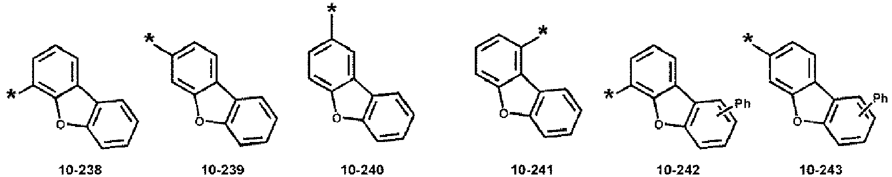

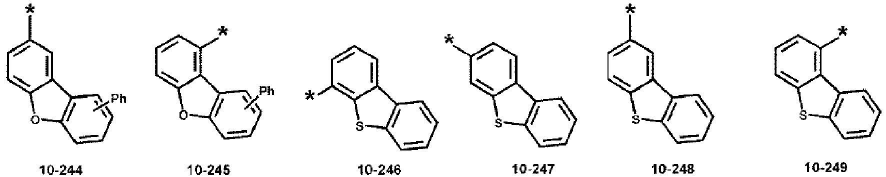

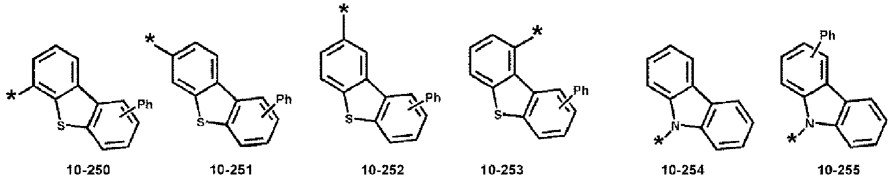

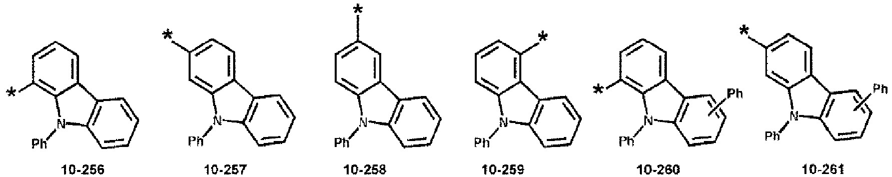

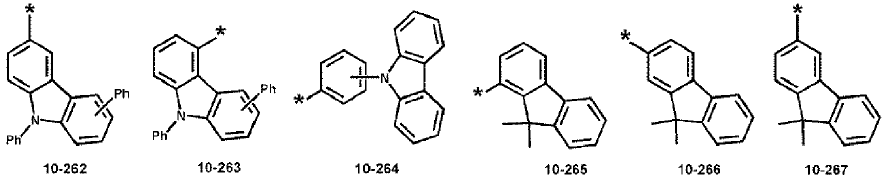

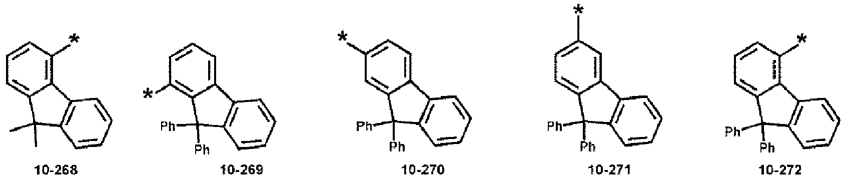

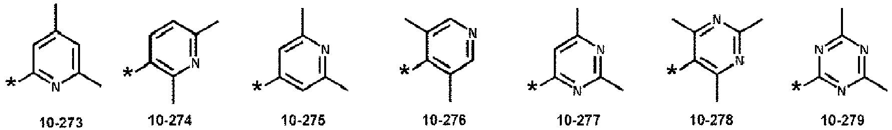

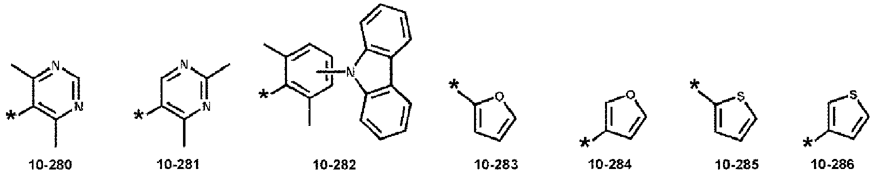

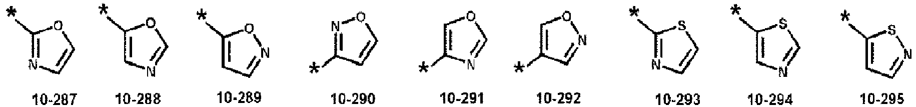

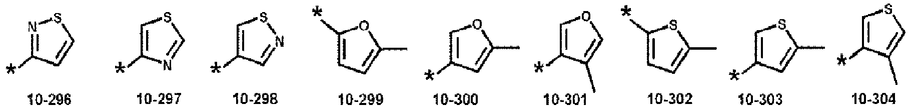

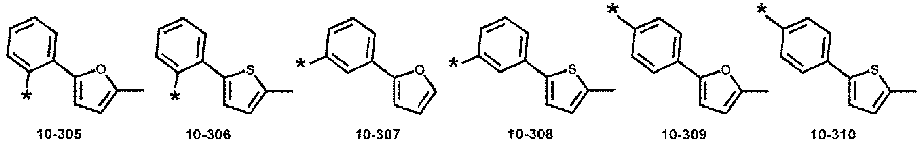

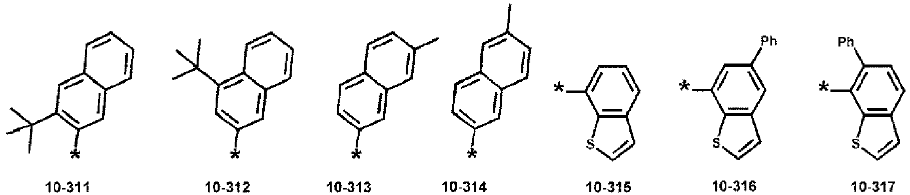

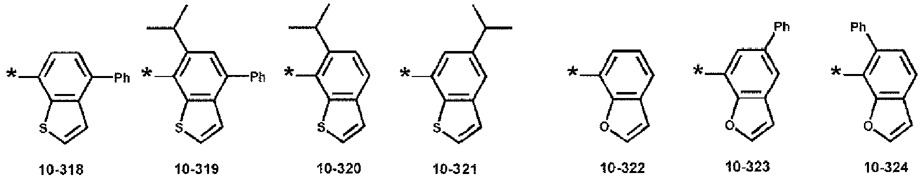

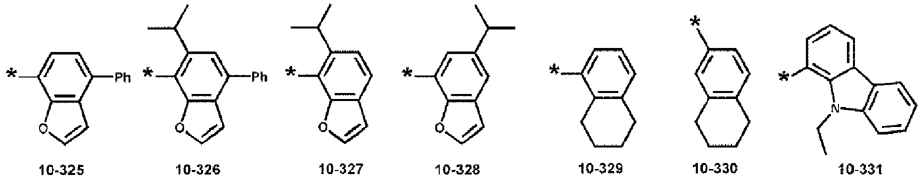

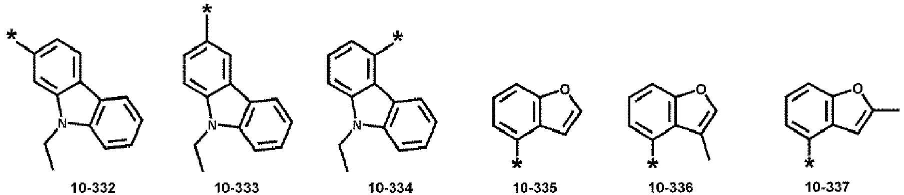

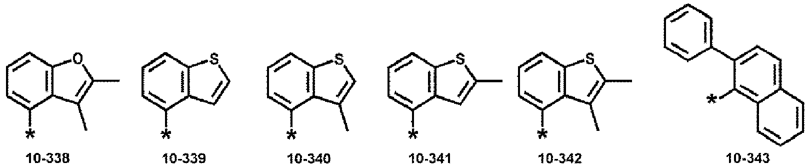

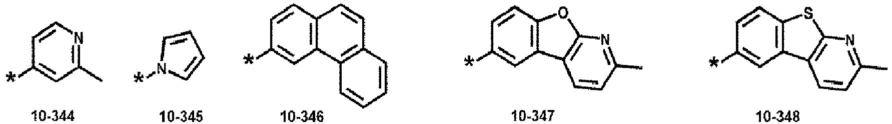

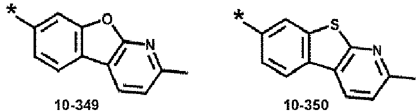

In one or more embodiments, in Formula 2, Q₅₁ to Q₅₃ may each independently be -CH₃, -CD₃, -CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with a deuterium, a group represented by one of Formulae 9-1 to 9-39 in which at least one hydrogen is substituted with -F, a group represented by one of Formulae 10-12 to 10-129, a group represented by one of Formulae 10-1 to 10-129 in which at least one hydrogen is substituted with a deuterium, or a group represented by one of Formulae 10-1 to 10-129 in which at least one hydrogen is substituted with -F.

In one or more embodiments, at least one of Q₅₁ to Q₅₃ (e.g., one of Q₅₁ to Q₅₃) may be a group represented by one of Formulae 10-12 to 10-129, a group represented by one of Formulae 10-1 to 10-129 in which at least one hydrogen is substituted with a deuterium, or a group represented by one of Formulae 10-1 to 10-129 in which at least one hydrogen is substituted with -F.In Formulae 9-1 to 9-39, 9-201 to 9-237, 10-1 to 10-129, and 10-201 to 10-350, * may indicate a binding site to an adjacent atom, "Ph" represents a phenyl group, "TMS" represents a trimethylsilyl group, and "TMG" represents a trimethylgermyl group.

The "group represented by one of Formulae 9-1 to 9-39 in which at least one hydrogen is substituted with a deuterium" and the "group represented by one of Formulae 9-201 to 9-237 in which at least one hydrogen is substituted with a deuterium" may each be, for example, a group represented by one of Formulae 9-501 to 9-514 and 9-601 to 9-636:

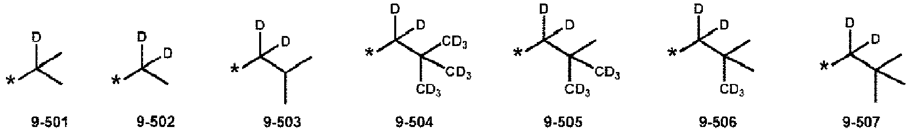

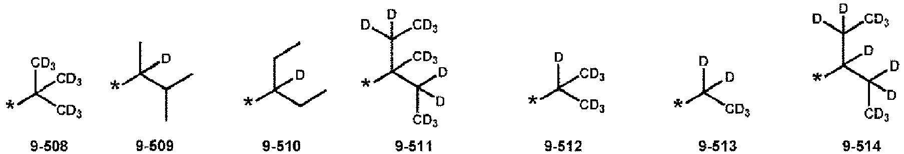

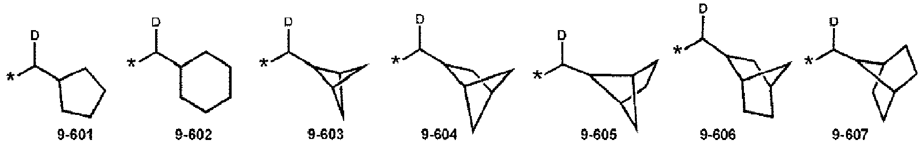

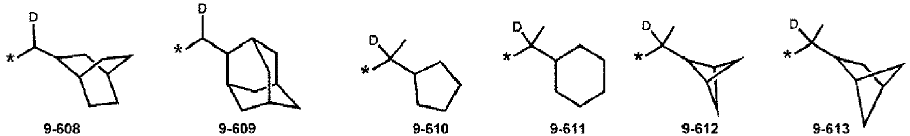

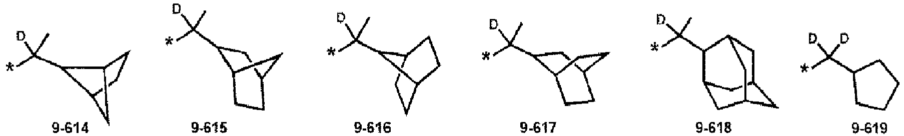

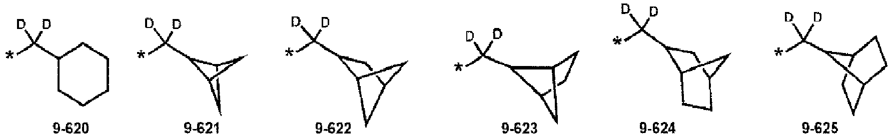

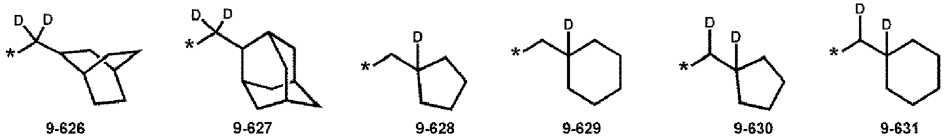

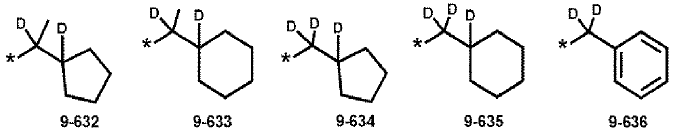

The "group represented by one of Formulae 9-1 to 9-39 in which at least one hydrogen is substituted with -F" and the "group represented by one of Formulae 9-201 to 9-236 in which at least one hydrogen is substituted with -F" may each be, for example, a group represented by one of Formulae 9-701 to 710:

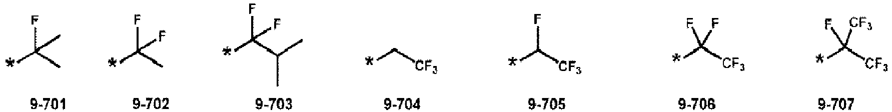

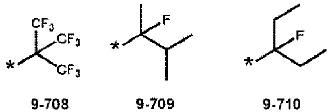

The "group represented by one of Formulae 10-1 to 10-129 in which at least one hydrogen is substituted with a deuterium atom" and the "group represented by one of Formulae 10-201 to 10-350 in which at least one hydrogen is substituted with a deuterium atom" may each be, for example, a group represented by one of Formulae 10-501 to 553:

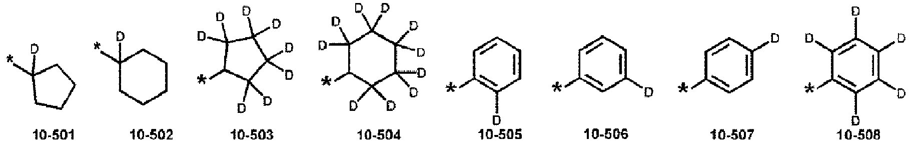

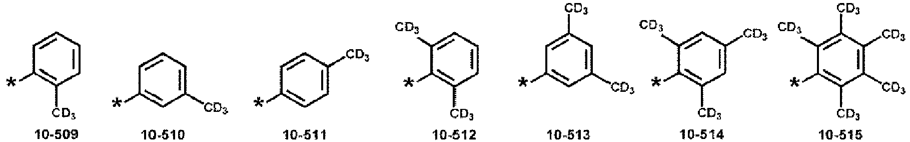

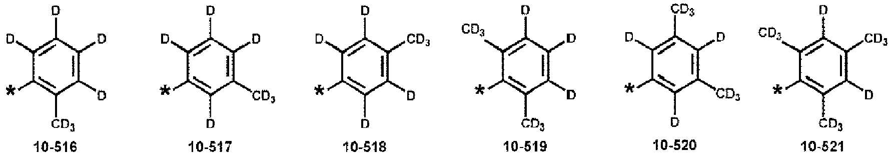

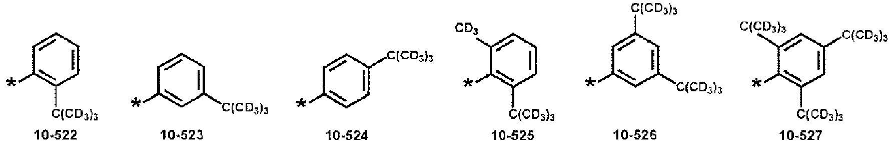

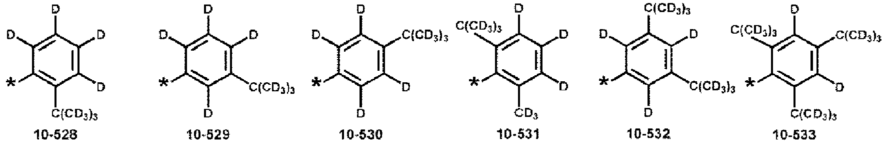

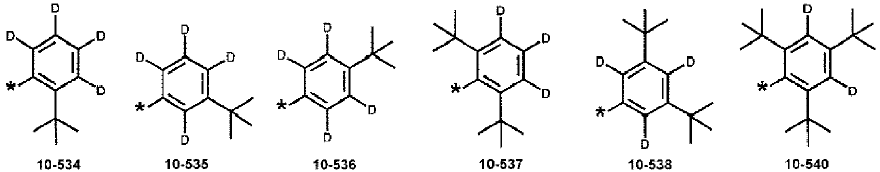

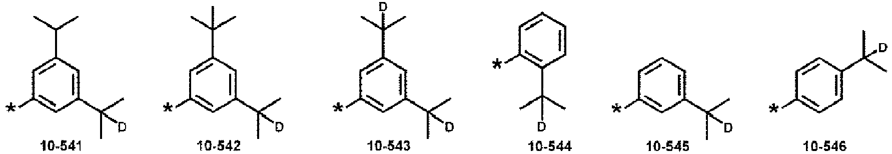

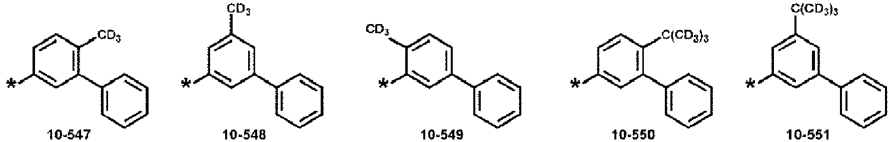

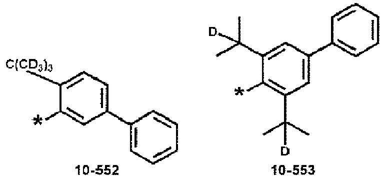

The "group represented by one of Formulae 10-1 to 10-129 in which at least one hydrogen is substituted with -F" and the "group represented by one of Formulae 10-201 to 10-350 in which at least one hydrogen is substituted with -F" may each be, for example, a group represented by one of Formulae 10-601 to 617:

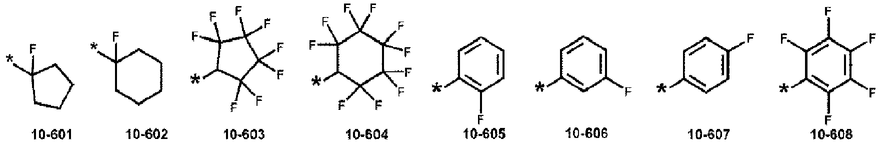

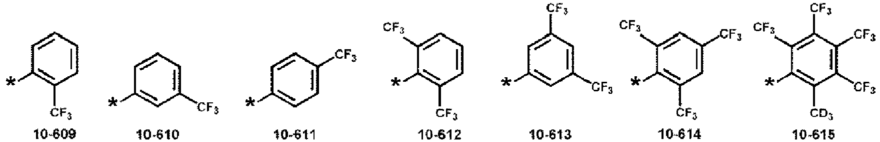

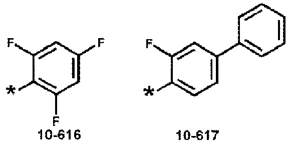

In Formula 1, a1 to a4 may respectively indicate the number of R₁(s) to R₄(s). a1 to a4 may each independently be an integer from 0 to 20 (e.g., 0, 1, 2, or 3). When a1 is 2 or greater, at least two R₁ groups may be identical to or different from each other, when a2 is 2 or greater, at least two R₂ groups may be identical to or different from each other, when a3 is 2 is or greater, at least two R₃ groups may be identical to or different from each other, and when a4 is 2 is or greater, at least two R₄ groups may be identical to or different from each other.

In some embodiments, in Formula 1,
i) a1, a2, a3, and a4 may each be 0,
ii) a1 may be 1, 2 or 3, and a2, a3, and a4 may each be 0,
iii) a2 may be 1 or 2, and a1, a3, and a4 may each be 0,
iv) a3 may be 1 or 2, and a1, a2, and a4 may each be 0,
v) a4 may be 1 or 2, and a1, a2, and a3 may each be 0, or
vi) a1 and a4 may each be 1, and a2 and a3 may each be 0.

L₁ in Formula 2 may be a single bond, a C₅-C₃₀ carbocyclic group unsubstituted or substituted with at least one R₁₀ₐ or a C₁-C₃₀ heterocyclic group unsubstituted or substituted with at least one R₁₀ₐ.

In some embodiments, L₁ in Formula 1 may be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a 1,3,5-triazine group, a 1,2,3-triazine group, a 1,2,4-triazine group, a quinoline group, an isoquinoline group, a quinoxaline group, a quinazoline group, a phenanthroline group, a pyrrole group, a pyrazole group, an imidazole group, a 1,2,3-triazole group, a 1,2,4-triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In some embodiments, L₁ may be:
a single bond; or
a benzene group unsubstituted or substituted with at least one R₁₀ₐ.

In Formula 2, c1 may indicate the number of L₁(s). c1 may be an integer from 1 to 10 (e.g., 1, 2, or 3). When c1 is 2 or greater, at least two L₁(s) may be identical to different from each other.

In Formula 2, c2 may indicate the number of groups represented by *-C(Q₅₁)(Q₅₂)(Q₅₃) (wherein * indicates a binding site to adjacent L₁). c2 may be an integer from 1 to 20 (e.g., 1, 2, or 3). When c2 is 2 or greater, at least two groups represented by *-C(Q₅₁)(Q₅₂)(Q₅₃) may be identical to or different from each other.

In Formula 1, 1) at least two of R₁(s) in the number of a1 may optionally be bound to form a C₅-C₃₀ carbocyclic group unsubstituted or substituted with at least one R₁₀ₐ or a C₁-C₃₀ heterocyclic group unsubstituted or substituted with at least one R₁₀ₐ, 2) at least two of R₂(s) in the number of a2 may optionally be bound to form a C₅-C₃₀ carbocyclic group unsubstituted or substituted with at least one R₁₀ₐ or a C₁-C₃₀ heterocyclic group unsubstituted or substituted with at least one R₁₀ₐ, 3) at least two of R₃(s) in the number of a3 may optionally be bound to form a C₅-C₃₀ carbocyclic group unsubstituted or substituted with at least one R₁₀ₐ or a C₁-C₃₀ heterocyclic group unsubstituted or substituted with at least one R₁₀ₐ, 4) at least two of R₄(s) in the number of a4 may optionally be bound to form a C₅-C₃₀ carbocyclic group unsubstituted or substituted with at least one R₁₀ₐ or a C₁-C₃₀ heterocyclic group unsubstituted or substituted with at least one R₁₀ₐ, 5) at least two of R₁ to R₄, R₅ₐ, R_{5b}, R₆ₐ, R_{6b}, R₇ₐ, R_{7b}, R₅ₐ, and R_{8b} may optionally be bound to form a C₅-C₃₀ carbocyclic group unsubstituted or substituted with at least one R₁₀ₐ or a C₁-C₃₀ heterocyclic group unsubstituted or substituted with at least one R₁₀ₐ.

R₁₀ₐ as used herein may be understood by referring to the description of R₁ provided herein.

In some embodiments, in Formula 1, n3 may not be 0, and ring CY₁ may be represented by one of Formulae CY1(1) to CY1(56) and CY1(101) to CY1(108): 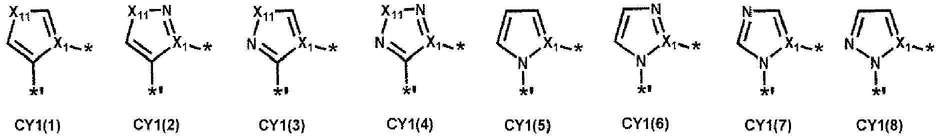 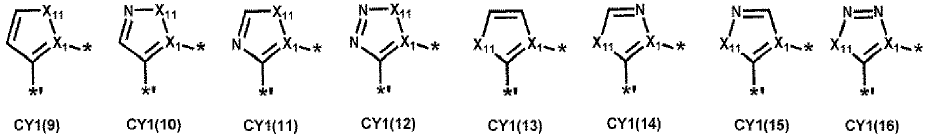 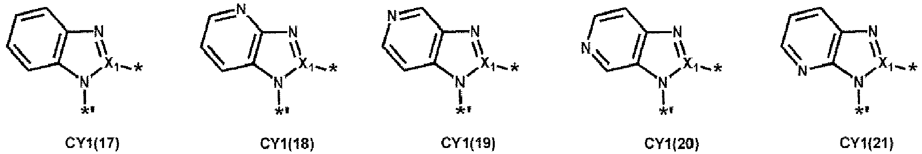 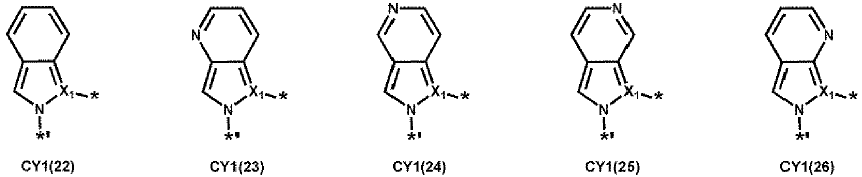 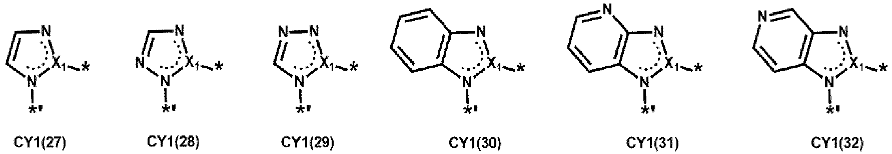 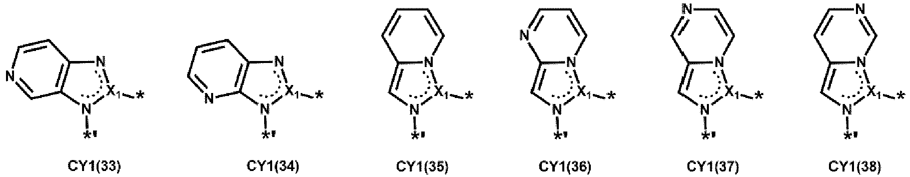 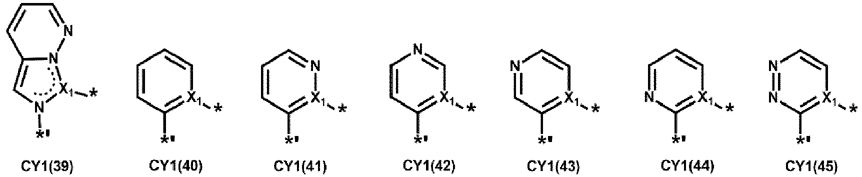 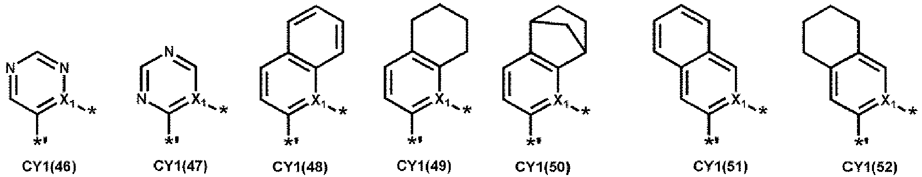 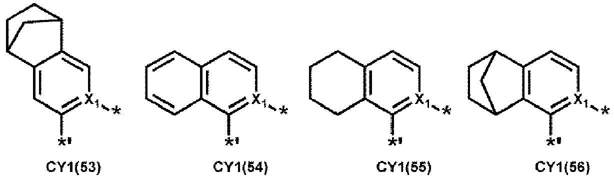 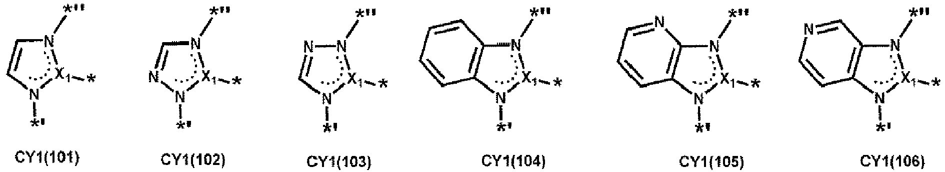 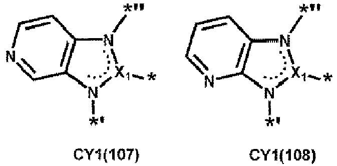
wherein, in Formulae CY1(1) to CY1(56) and CY1(101) to CY1(108),
X₁ may be C or N, provided that, X₁ in Formulae CY1(27) to CY1(39) and CY1(101) to CY1(108) may be C,
X₁₁ may be O, S, N(R₁₈), C(R₁₈)(R₁₉), or Si(R₁₈)(R₁₉), and R₁₈ and R₁₉ may each be understood by referring to the descriptions of R₁ provided herein,
* indicates a binding site to M in Formula 1,
*' indicates a binding site to T₃ in Formula 1, and
*" indicates a binding site to T₄ in Formula 1.

In one or more embodiments, in Formula 1, n3 may not be 0, n4 may be 0, and the group represented by 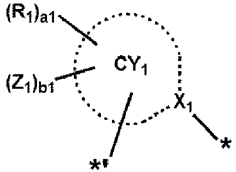 may be represented by one of Formulae CY1-1 to CY1-41 and CY1-Z1 to CY1-Z69: 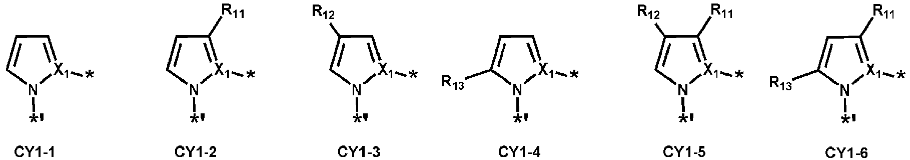 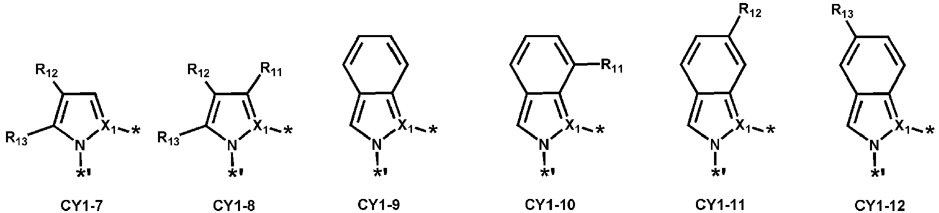 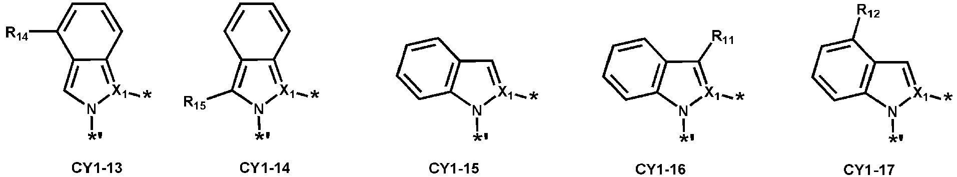 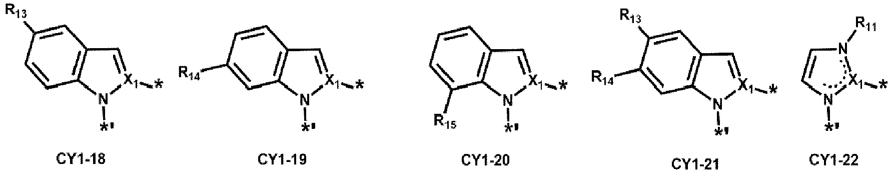 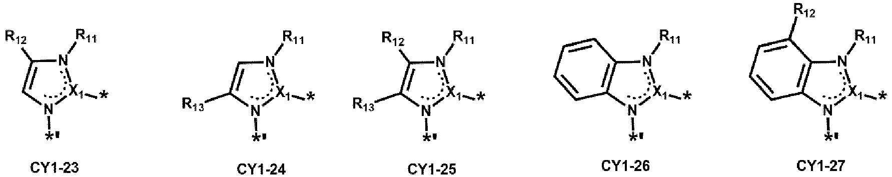 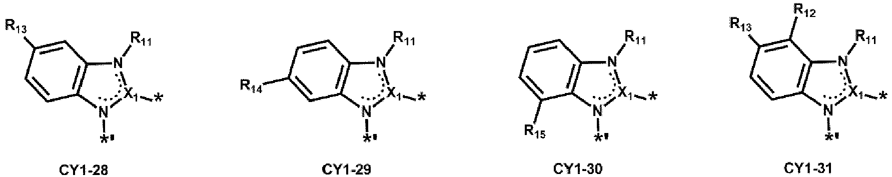 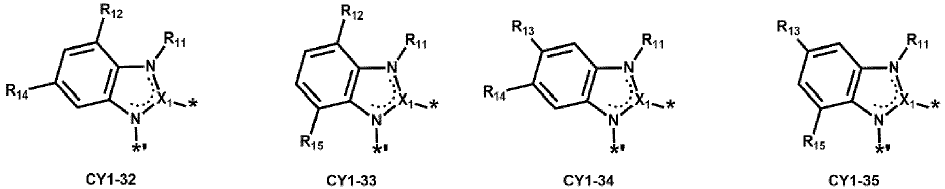 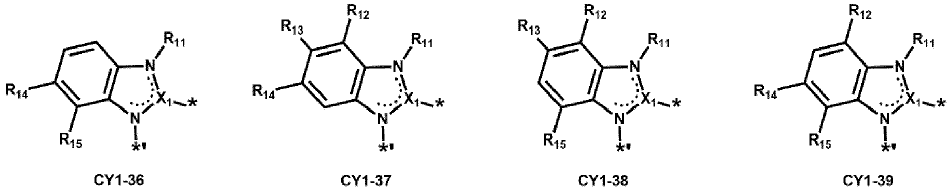 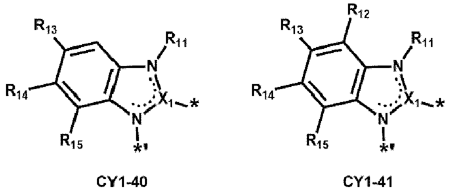 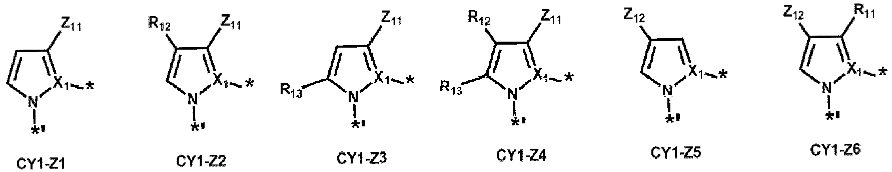 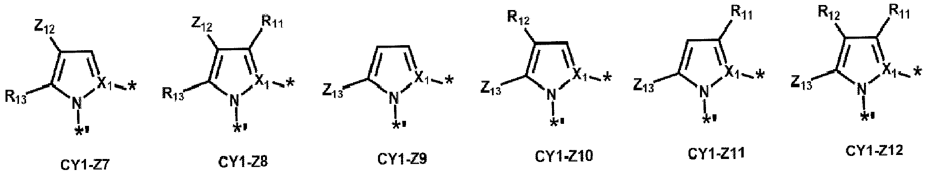 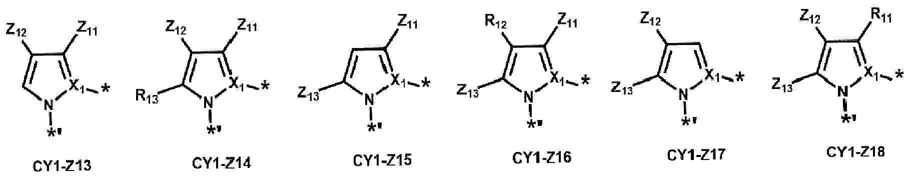 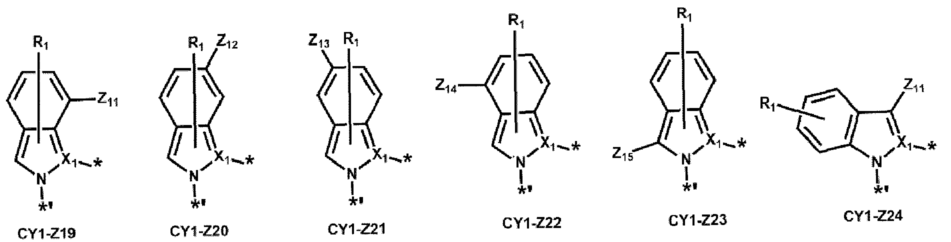 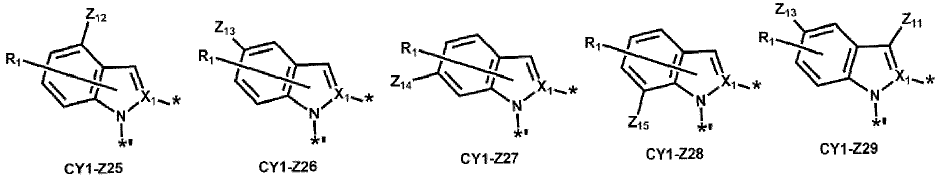 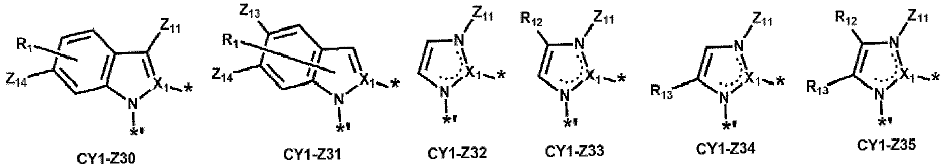 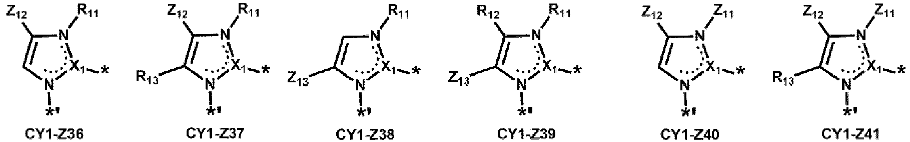 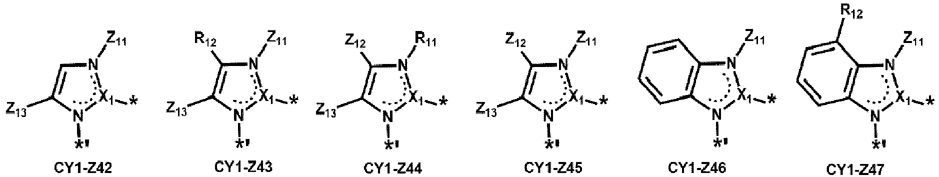 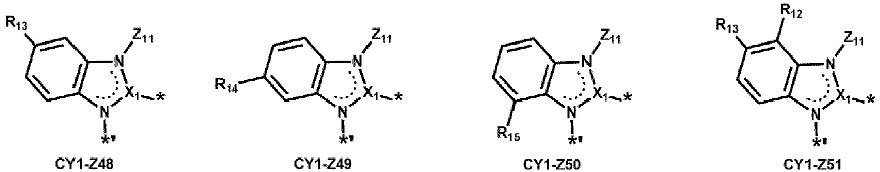 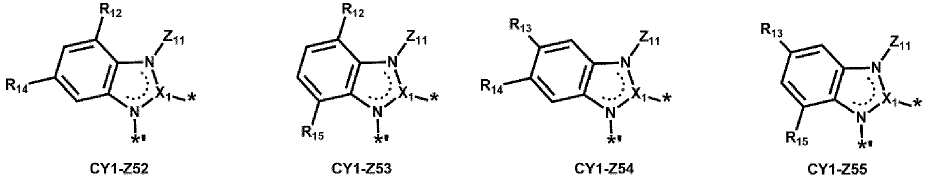 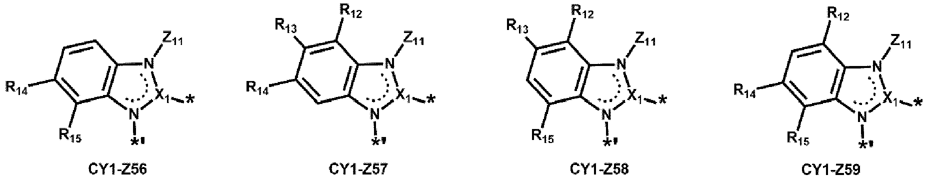 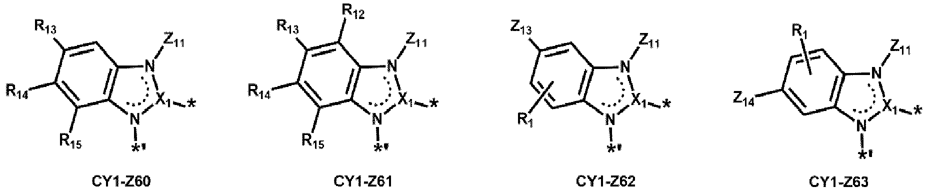 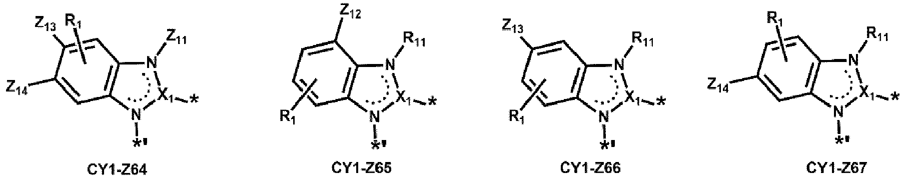 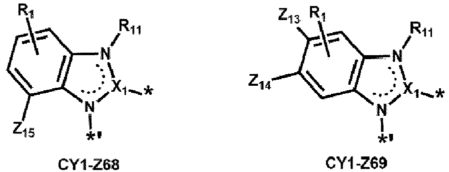
wherein, in Formulae CY1-1 to CY1-41 and CY1-Z1 to CY1-Z69,
X₁ may be C or N, provided that, X₁ in Formulae CY1-22 to CY1-41 and CY1-Z32 to CY1-Z69 may be C,
R₁ and R₁₁ to R₁₅ may each be understood by referring to the description of R₁ provided herein, wherein R₁₁ to R₁₅ may each not be hydrogen,
Z₁₁ to Z₁₅ may each be understood by referring to the description of Z₁ provided herein,
* indicates a binding site to M in Formula 1, and
*' indicates a binding site to T₃ in Formula 1.

In one or more embodiments, in Formula 1, n1 may not be 0, n3 may not be 0, and ring CY₂ may be represented by one of Formulae CY2(1) to CY2(15): 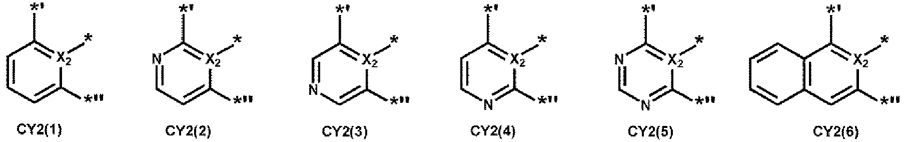 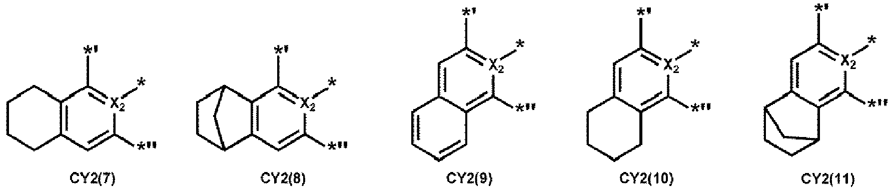 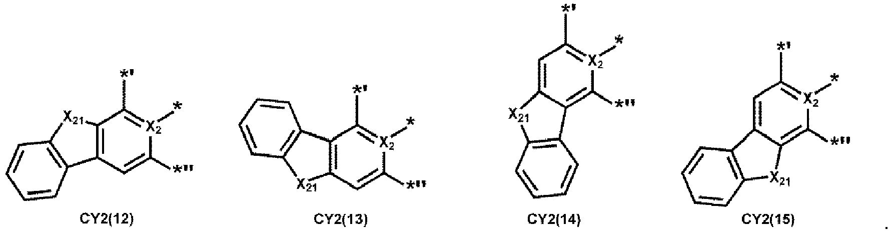
wherein, in Formulae CY2(1) to CY2(15),
X₂ may be C or N,
X₂₁ may be O, S, N(R₂₈), C(R₂₈)(R₂₉), or Si(R₂₈)(R₂₉), and R₂₈ and R₂₉ may each be understood by referring to the descriptions of R₂ provided herein,
*' indicates a binding site to T₃ in Formula 1,
* indicates a binding site to M in Formula 1, and
*" indicates a binding site to T₁ in Formula 1.

In one or more embodiments, in Formula 1, n1 may not be 0, n3 may not be 0, and the group represented by 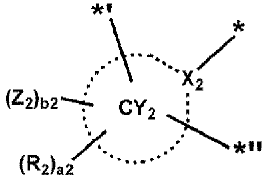 may be represented by one of Formulae CY2-1 to CY2-8 and CY2-Z1 to CY2-Z6: 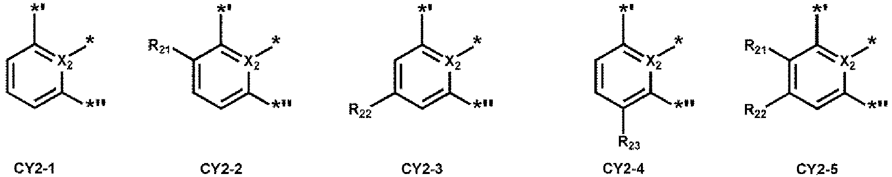 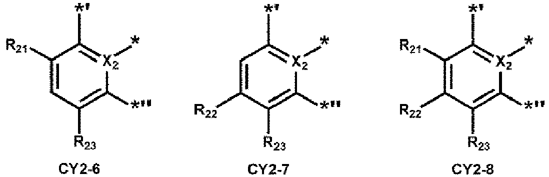 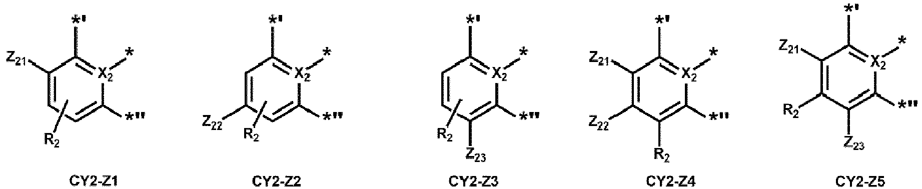 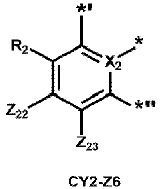
wherein, in Formulae CY2-1 to CY2-8 and CY2-Z1 to CY2-Z6,
X₁ may be C or N,
R₂ and R₂₁ to R₂₃ may each be understood by referring to the description of R₂ provided herein, wherein R₂₁ to R₂₃ may each not be hydrogen,
Z₂₁ to Z₂₃ may each be understood by referring to the description of Z₂ provided herein,
*' indicates a binding site to T₃ in Formula 1,
* indicates a binding site to M in Formula 1, and
*" indicates a binding site to T₁ in Formula 1.

In one or more embodiments, in Formula 1, n1 may not be 0, n2 may not be 0, and ring CY₃ may be a group represented by Formula CY3-A or CY3-B: 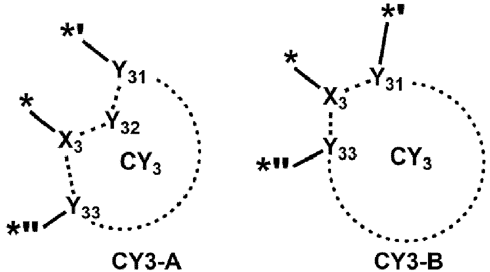
wherein, in Formulae CY3-A and CY3-B,
X₃ and ring CY₃ may respectively be understood by referring to the descriptions of X₃ and ring CY₃ provided herein,
Y₃₁ and Y₃₃ may each independently be C or N and Y₃₂ may be O, S, N, C, or Si,
a bond between X₃ and Y₃₃, a bond between X₃ and Y₃₂ and a bond between Y₃₂ and Y₃₁ in Formula CY3-A may each be a chemical bond (for example, a single bond or a double bond), a bond between X₃ and Y₃₁ and a bond between X₃ and Y₃₃ in Formula CY3-B may each be a chemical bond (for example, a single bond or a double bond),
*" indicates a binding site to T₁ in Formula 1,
* indicates a binding site to M in Formula 1, and
*' indicates a binding site to T₂ in Formula 1.

In some embodiments, in Formula 1, n1 may not be 0, n2 may not be 0, and ring CY₃ may be a group represented by Formula CY3-A.

In one or more embodiments, in Formula 1, n2 may not be 0, n4 may be 0, and ring CY₄ may be a group represented by Formula CY4-A or CY4-B: 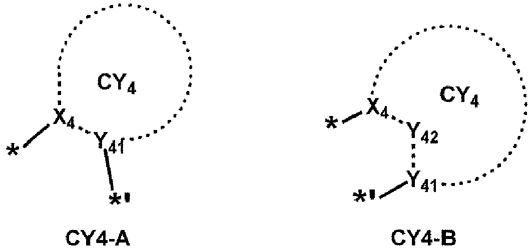
wherein, in Formulae CY4-A and CY4-B,
X₄ and ring CY₄ may respectively be understood by referring to the descriptions of X₄ and ring CY₄ provided herein,
Y₄₁ may be C or N and Y₄₂ may be O, S, N, C, or Si,
a bond between X₄ and Y₄₁ in Formula CY4-A may be a chemical bond (for example, a single bond or a double bond), a bond between X₄ and Y₄₂ and a bond between Y₄₂ and Y₄₁ in Formula CY4-B may each be a chemical bond (for example, a single bond or a double bond),
* indicates a binding site to M in Formula 1, and
*' indicates a binding site to T₂ in Formula 1.

In some embodiments, in Formula 1, n2 may not be 0, n4 may be 0, and ring CY₄ may be a group represented by Formula CY4-A.

In some embodiments, in Formula 1, n2 may not be 0, T₁ may be a single bond, n4 may be 0, ring CY₃ may be a group represented by Formula CY3-A, and ring CY₄ may be a group represented by Formula CY4-A.

In some embodiments, in Formula 1, n2 may not be 0, T₁ may be a single bond, n4 may be 0, ring CY₃ may be a group represented by Formula CY3-B, and ring CY₄ may be a group represented by Formula CY4-B.

In some embodiments, in Formula 1, n2 may not be 0, T₁ may not be a single bond, n4 may be 0, ring CY₃ may be a group represented by Formula CY3-B, and ring CY₄ may be a group represented by Formula CY4-A.

In one or more embodiments, in Formula 1, n1 may not be 0, and ring CY₃ may be a group represented by one of Formulae CY3(1) to CY3(12) and CY3(101) to CY3(122): 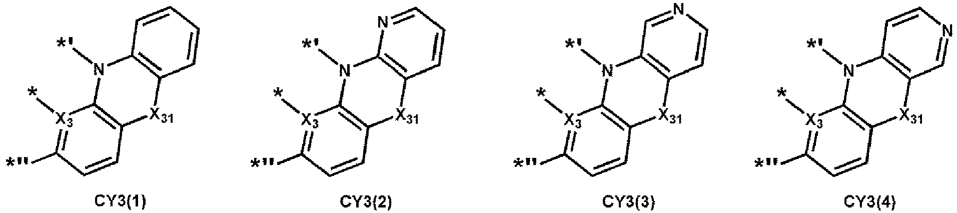 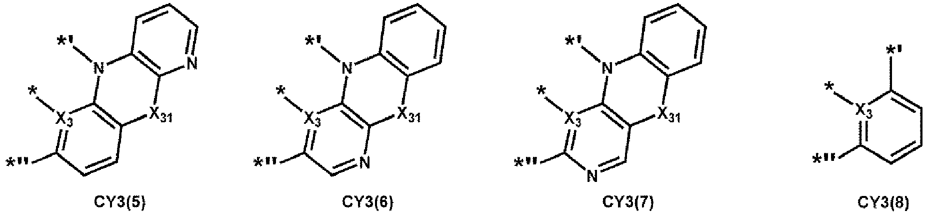 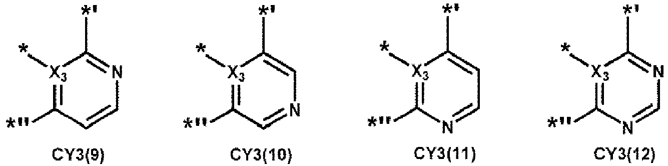 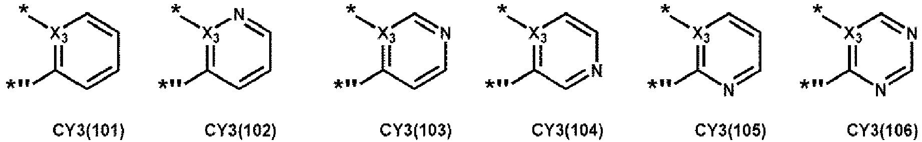 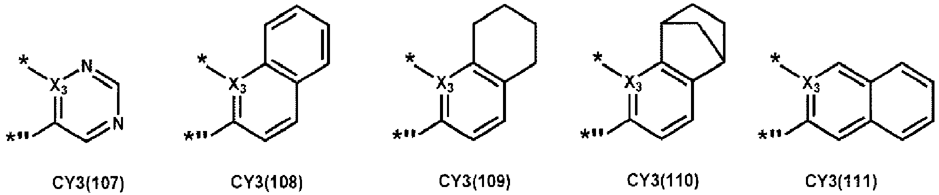 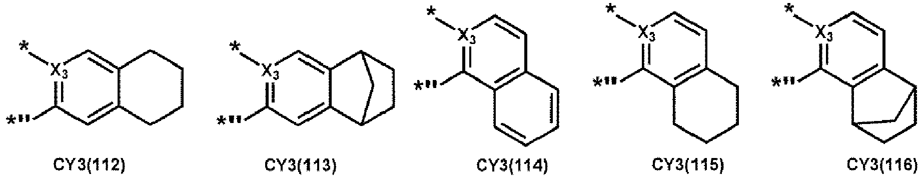 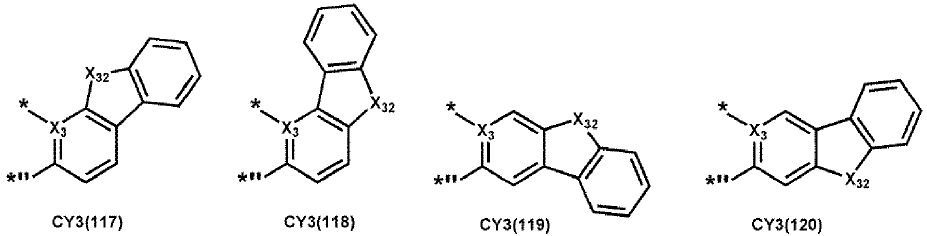 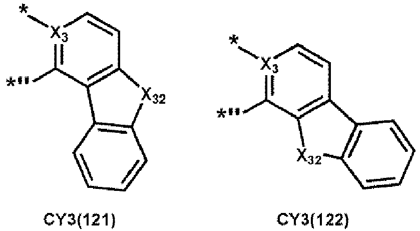
wherein, in Formulae CY3(1) to CY3(12) and CY3(101) to CY3(122),
X₃ may be C or N,
X₃₁ may be a single bond, O, S, N(R₃₈), C(R₃₈)(R₃₉), or Si(R₃₈)(R₃₉), X₃₂ may be O, S, N(R₃₈), C(R₃₈)(R₃₉), or Si(R₃₈)(R₃₉), R₃₈ and R₃₉ may each be understood by referring to the description of R₃ provided herein,
*" indicates a binding site to T₁ in Formula 1,
* indicates a binding site to M in Formula 1, and
*' indicates a binding site to T₂ in Formula 1.

In one or more embodiments, in Formula 1, n1 may not be 0, n2 may not be 0, and the group represented by 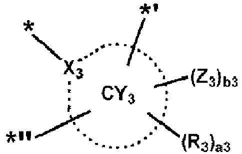 may be represented by one of Formulae CY3-1 to CY3-16 and CY3-Z1 to CY3-Z10: 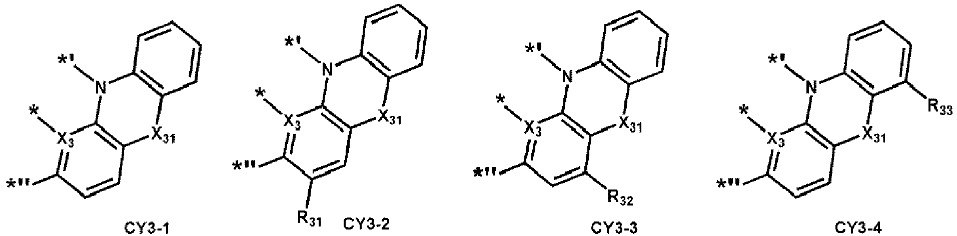 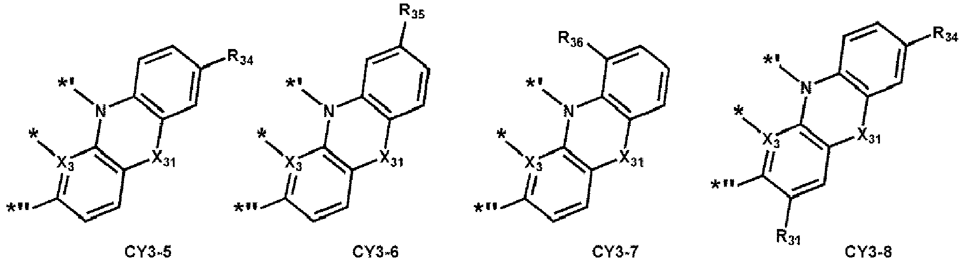 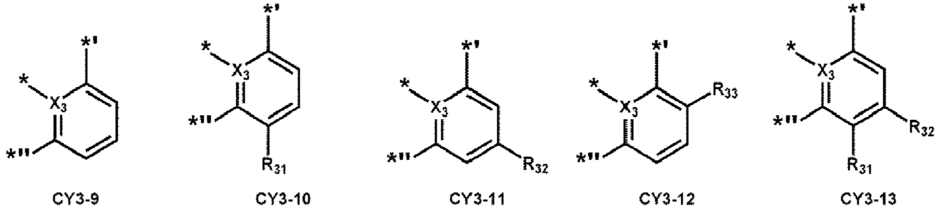 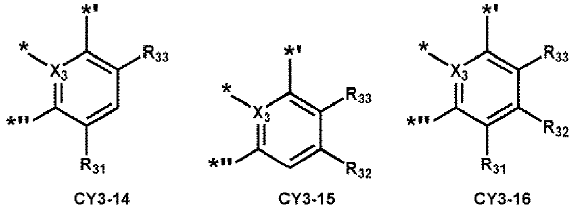 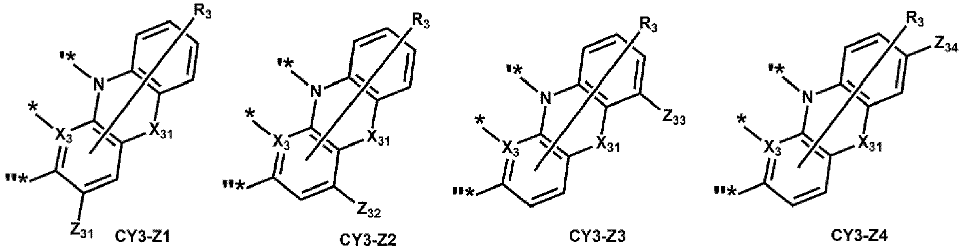 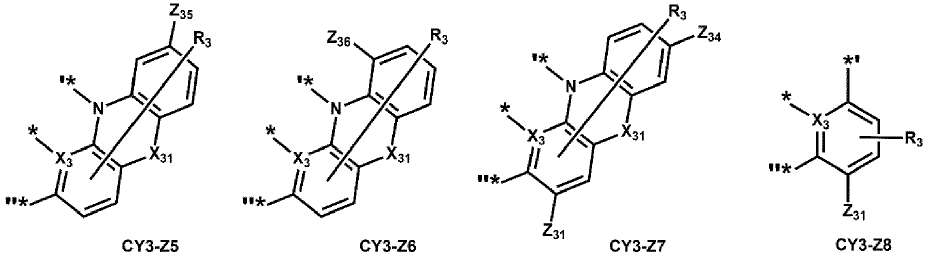 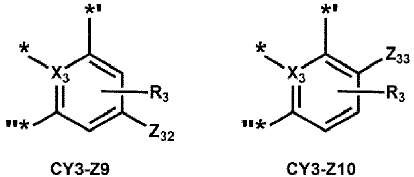
wherein, in Formulae CY3-1 to CY3-16 and CY3-Z1 to CY3-Z10,
X₃ may be C or N,
R₃ and R₃₁ to R₃₆ may each be understood by referring to the description of R₃ provided herein, wherein R₃₁ to R₃₆ may each not be hydrogen,
Z₃₁ to Z₃₆ may each be understood by referring to the description of Z₃ provided herein,
*" indicates a binding site to T₁ in Formula 1,
* indicates a binding site to M in Formula 1, and
*' indicates a binding site to T₂ in Formula 1.

In one or more embodiments, in Formula 1, n2 may not be 0, and ring CY₄ may be a group represented by one of Formulae CY4(1) to CY4(42) and CY4(101) to CY4(111): 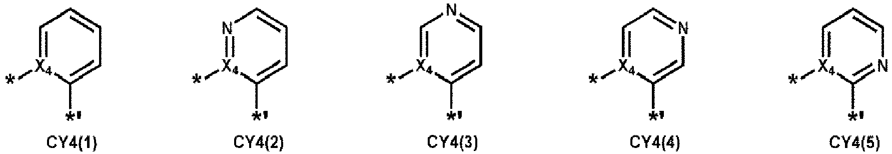 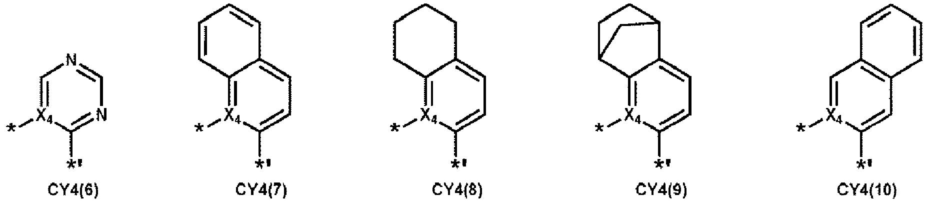 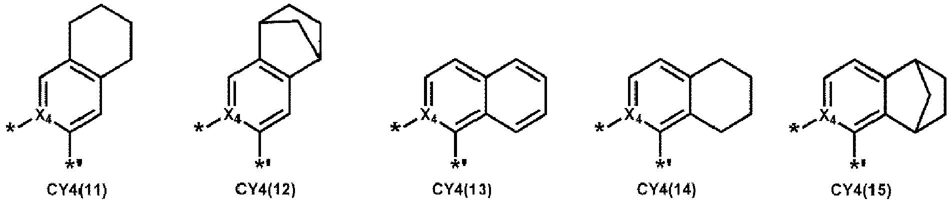 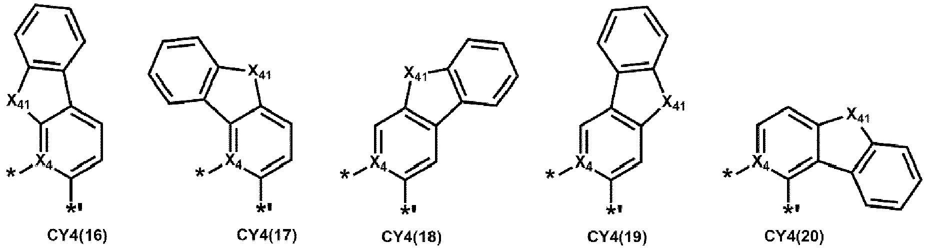 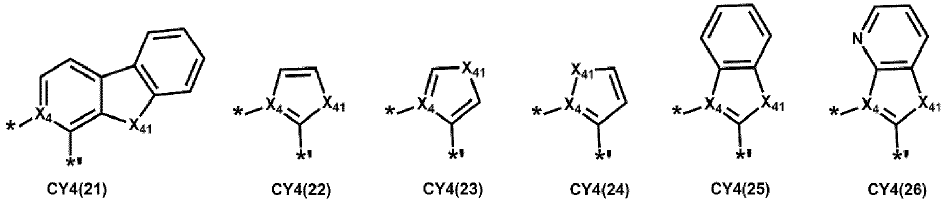 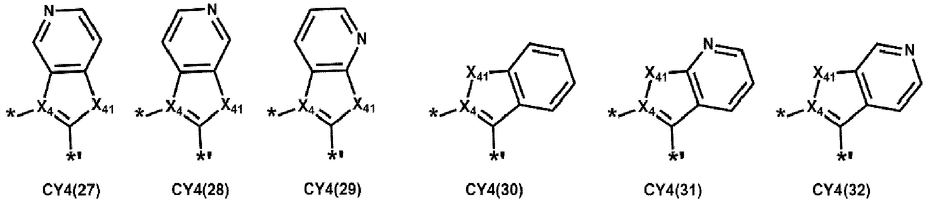 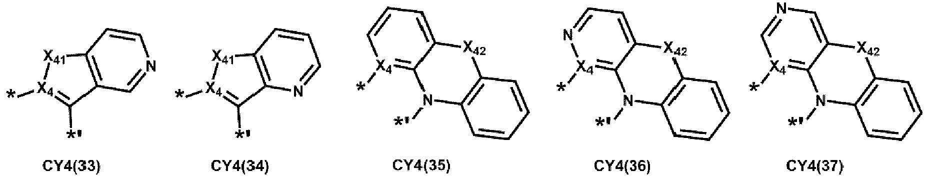 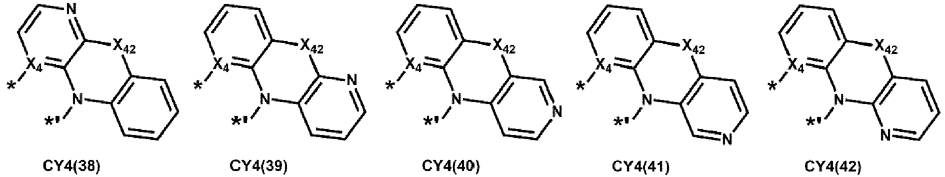 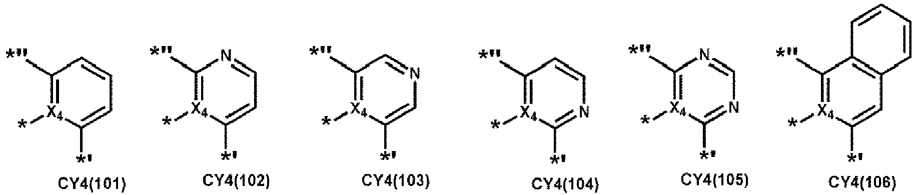 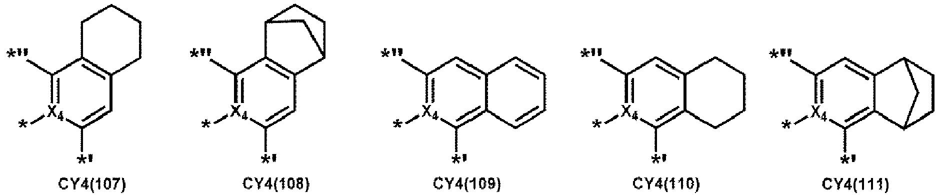
wherein, in Formulae CY4(1) to CY4(42) and CY4(101) to CY4(111),
X₄ may be C or N,
X₄₁ may be O, S, N(R₄₈), C(R₄₈)(R₄₉), or Si(R₄₈)(R₄₉), X₄₂ may be a single bond, O, S, N(R₄₈), C(R₄₈)(R₄₉), or Si(R₄₈)(R₄₉), and R₄₈ and R₄₉ may each be understood by referring to the descriptions of R₄ provided herein,
* indicates a binding site to M in Formula 1,
*' indicates a binding site to T₂ in Formula 1, and
*" indicates a binding site to T₄ in Formula 1.

In one or more embodiments, in Formula 1, n2 may not be 0, n4 may be 0, and the group represented by 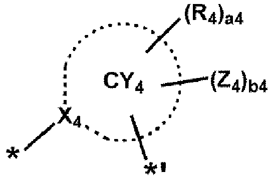 may be represented by one of Formulae CY4-1 to CY4-24 and CY4-Z1 to CY4-Z8: 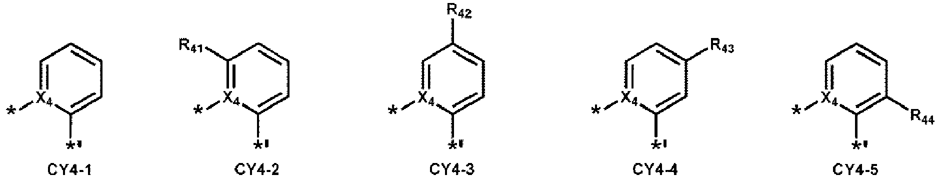 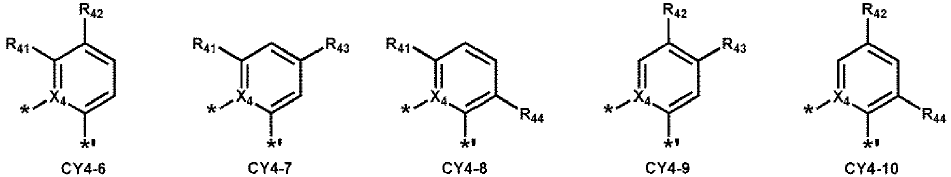 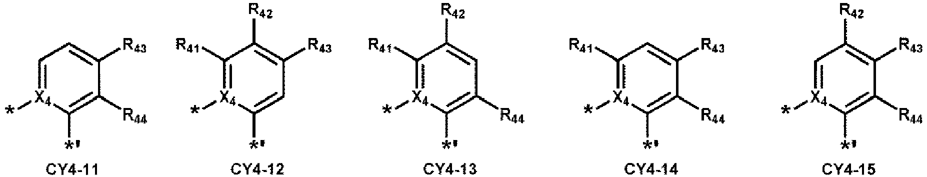 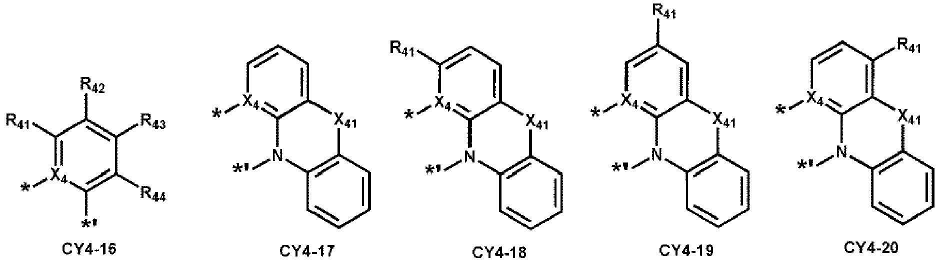 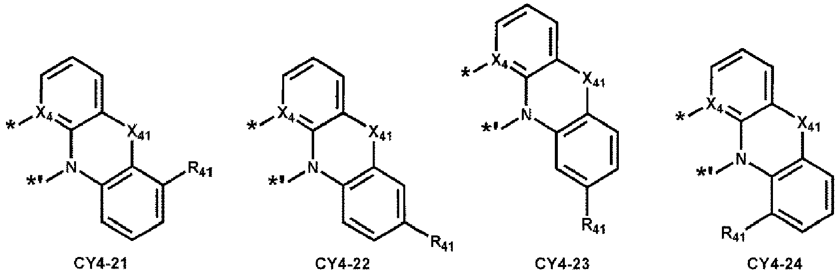 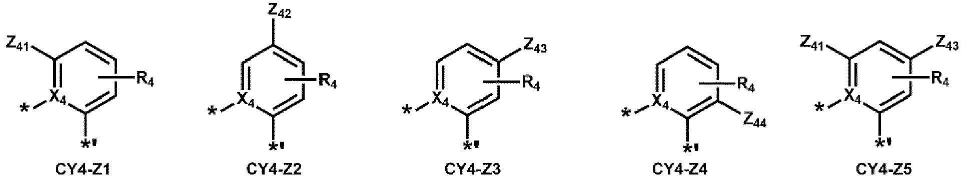 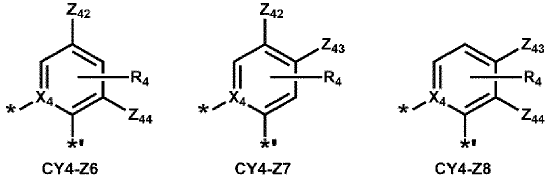
wherein, in Formulae CY4-1 to CY4-24 and CY4-Z1 to CY4-Z8,
X₄ may be C or N,
X₄₂ may be understood by referring to the description provided herein,
R₄ and R₄₁ to R₄₇ may each be understood by referring to the description of R₄ provided herein, wherein R₄₁ to R₄₇ may each not be hydrogen,
Z₄₁ to Z₄₄ may each be understood by referring to the description of Z₄ provided herein,
* indicates a binding site to M in Formula 1, and
*' indicates a binding site to T₂ in Formula 1.

In one or more embodiments, a group represented by *-C(Q₅₁)(Q₅₂)(Q₅₃) in Formula 2 may be represented by one of Formulae 2-1 to 2-20: 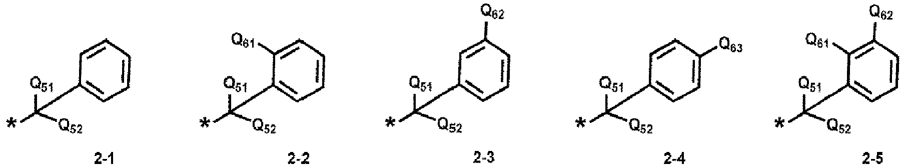 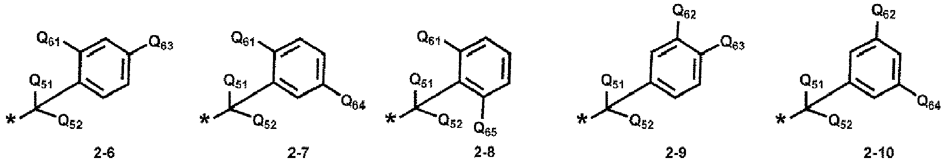 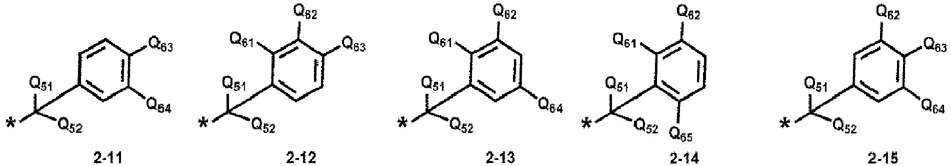 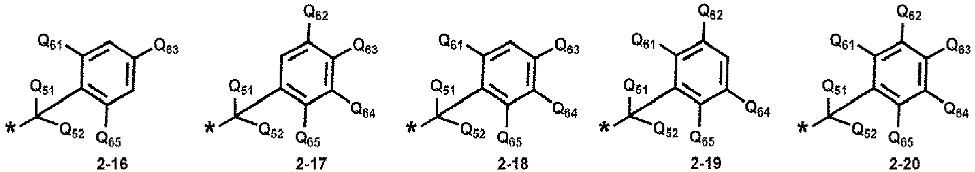 wherein, in Formulae 2-1 to 2-20, Q₅₁, Q₅₂ and Q₆₁ to Q₆₅ may each independently be a substituted or unsubstituted C₁-C₆₀ alkyl group or a substituted or unsubstituted phenyl group, wherein Q₅₁, Q₅₂, and Q₆₁ to Q₆₅ may be identical to or different from each other, and * indicates a binding site to L₁ in Formula 2.

In some embodiments, in Formulae 2-1 to 2-20, Q₅₁, Q₅₂, and Q₆₁ to Q₆₅ may each independently be a C₁-C₂₀ alkyl group or a phenyl group, each unsubstituted or substituted with deuterium, a C₁-C₂₀ alkyl group, a phenyl group, a biphenyl group, or any combination thereof.

In some embodiments, L₁ may be a single bond in the group represented by Formula 2, and the group represented by Formula 2 may be represented by one of Formulae 2-1 to 2-20.

In some embodiments, Z₁ to Z₄, Z₁₁ to Z₁₅, Z₂₁ to Z₂₃, Z₃₁ to Z₃₆, and Z₄₁ to Z₄₄ may each independently be represented by one of Formulae 2-1 to 2-20.

In one or more embodiments, L₁ in Formula 2 may be a benzene group, c1 in Formula 2 may be 1, and the group represented by Formula 2 may be represented by one of Formulae 2(1) to 2(19): 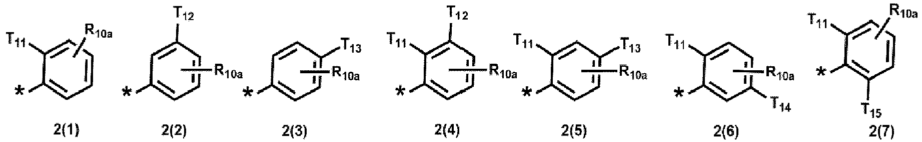 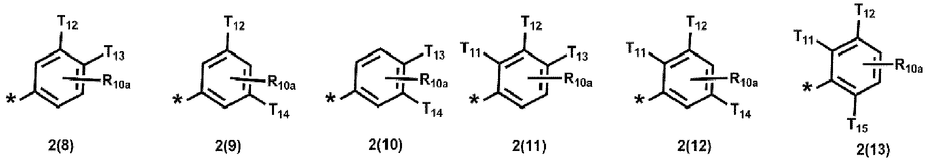 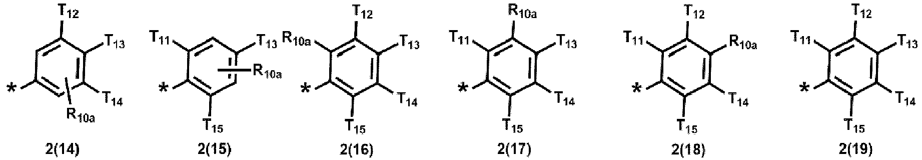 wherein, in Formulae 2(1) to 2(19), T₁₁ to T₁₅ may each be a group represented by *-C(Q₅₁)(Q₅₂)(Q₅₃) in Formula 2, T₁₁ to T₁₅ may be identical to or different from each other, R₁₀ₐ may be understood by referring to the description of R₁ in claim 1, and * indicates a binding site to at least one of ring CY₁ to ring CY₄ in Formula 1.

In some embodiments, Z₁ to Z₄, Z₁₁ to Z₁₅, Z₂₁ to Z₂₃, Z₃₁ to Z₃₆, and Z₄₁ to Z₄₄ may each independently be represented by one of Formulae 2(1) to 2(19).

In one or more embodiments, the organometallic compound represented by Formula 1 may satisfy at least one of Conditions 1 to 4:
Condition 1 In Formula 1, n3 may not be 0, n4 may be 0, and the group represented by 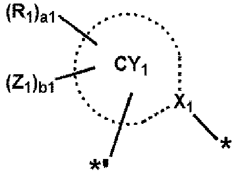 may be represented by one of Formulae CY1-Z1 to CY1-Z69.
Condition 2 In Formula 1, n1 may not be 0, n3 may not be 0, and the group represented by 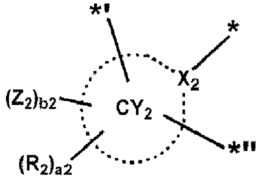 may be represented by one of Formulae CY2-Z1 to CY2-Z6.
Condition 3 In Formula 1, n1 may not be 0, n2 may not be 0, and the group represented by 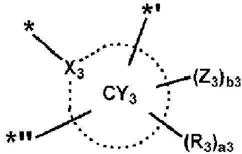 may be represented by one of Formulae CY3-Z1 to CY3-Z10.
Condition 4 In Formula 1, n2 may not be 0, n4 may be 0, and the group represented by 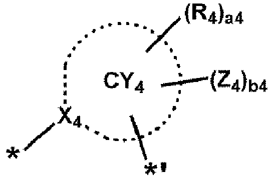 may be represented by one of Formulae CY4-Z1 to CY4-Z8.

In one or more embodiments, the organometallic compound represented by Formula 1 may emit blue light.

In one or more embodiments, the organometallic compound represented by Formula 1 may be one of the following compounds. Compound Pt-2, Pt-3, Pt-13, Pt-17, Pt-18, and Pt-21 are same as Compound 4, 2009, 2076, 2132, 2133, and 2187, respectively:

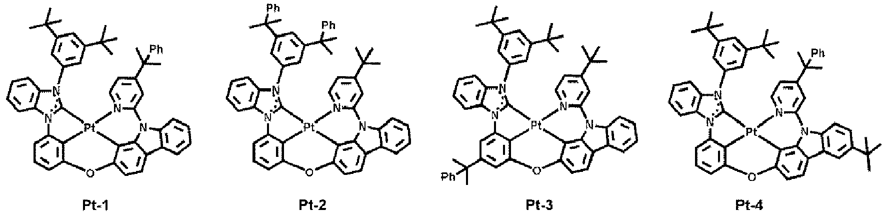

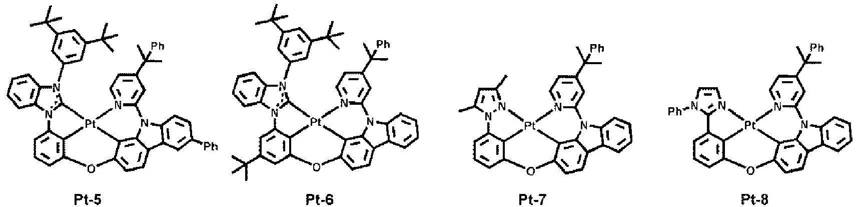

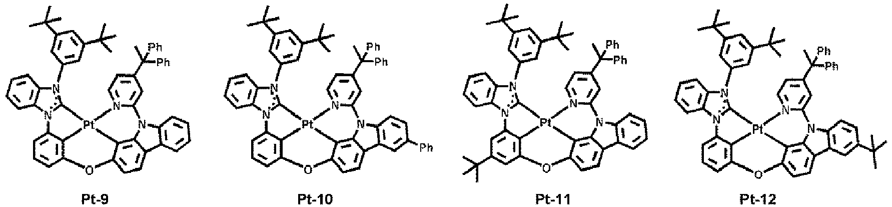

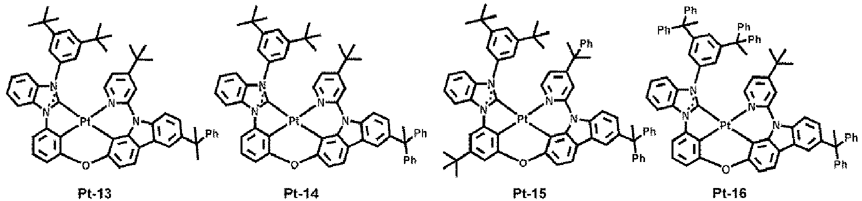

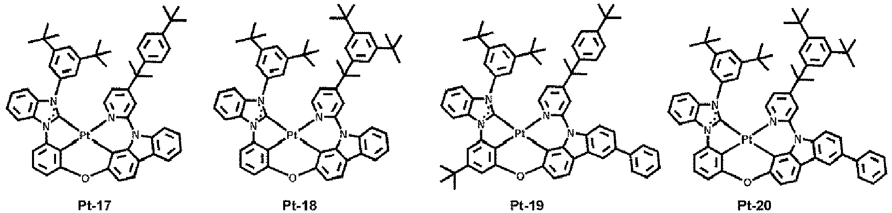

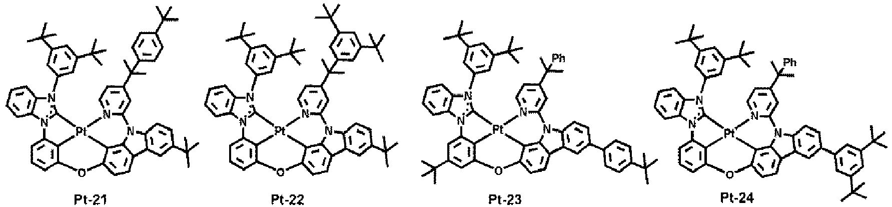

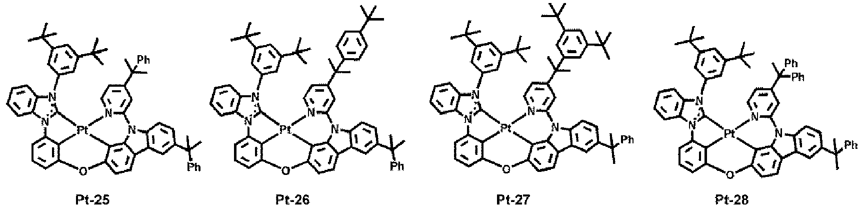

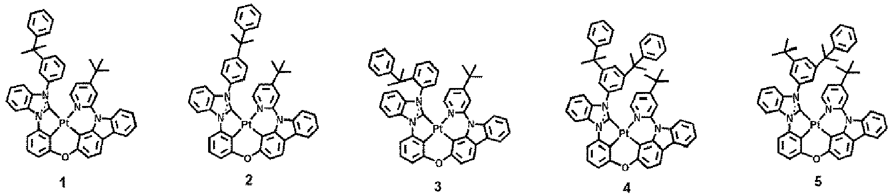

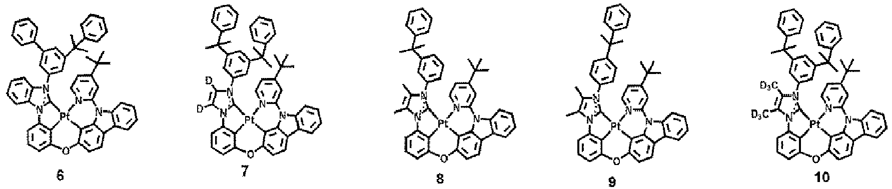

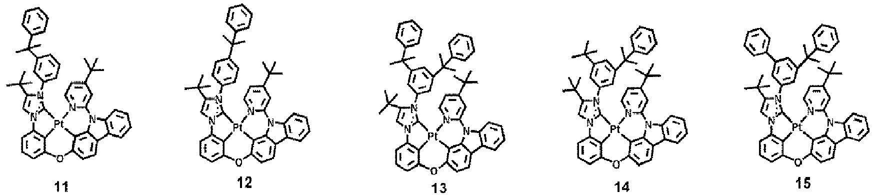

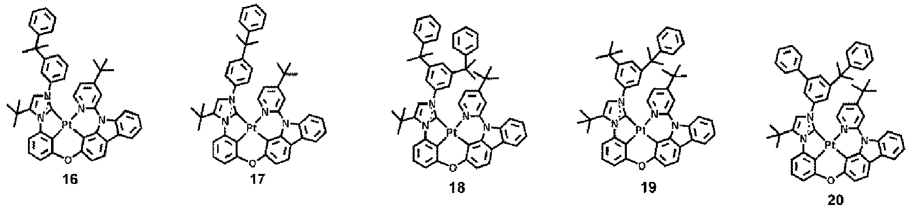

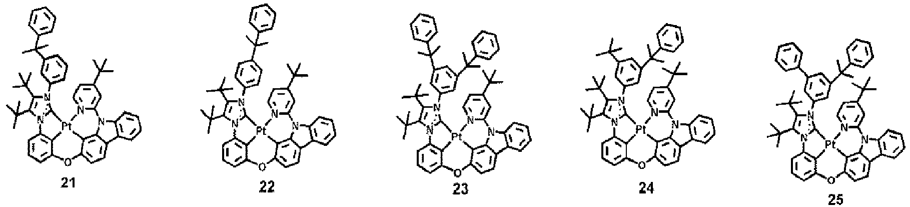

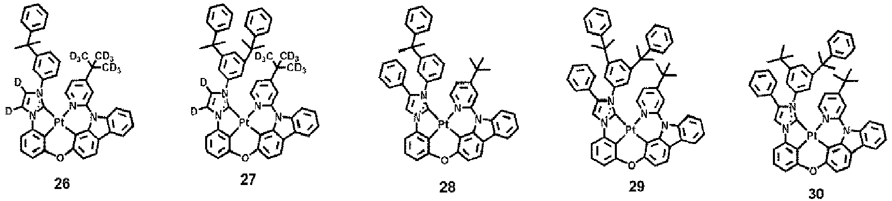

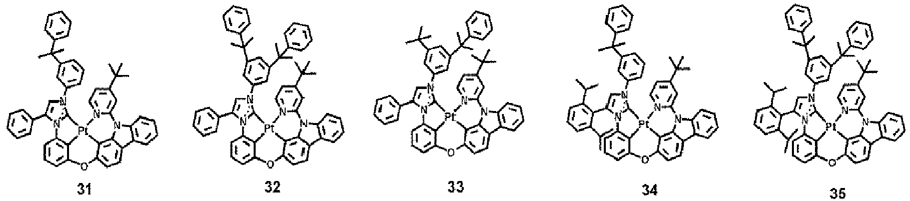

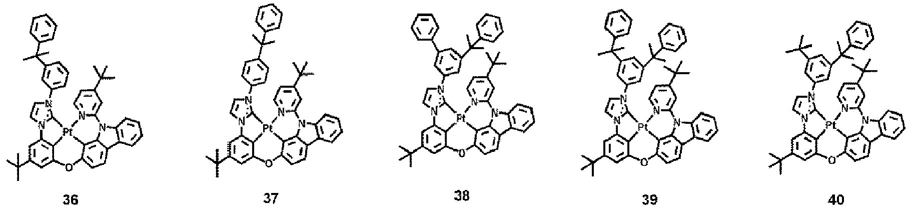

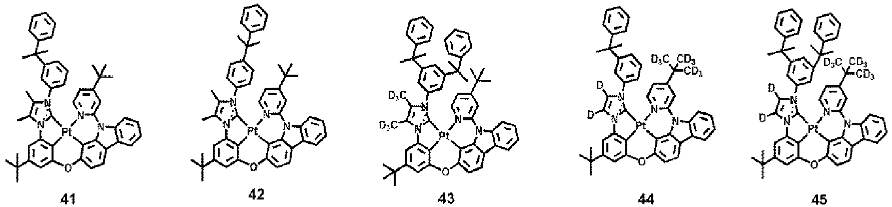

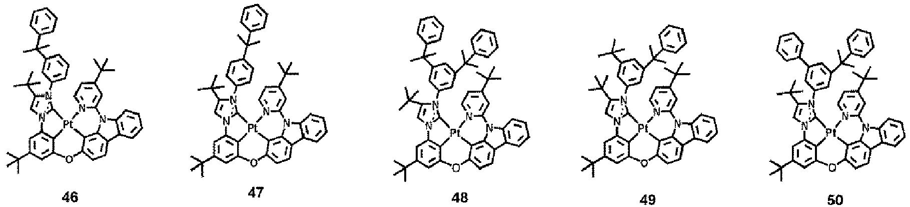

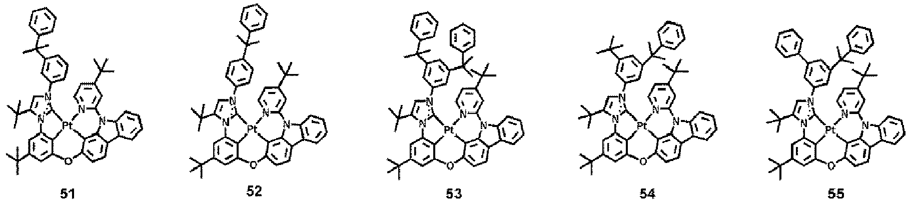

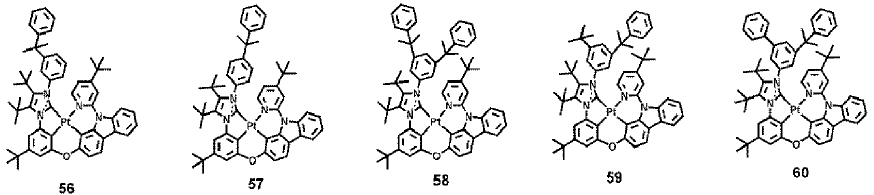

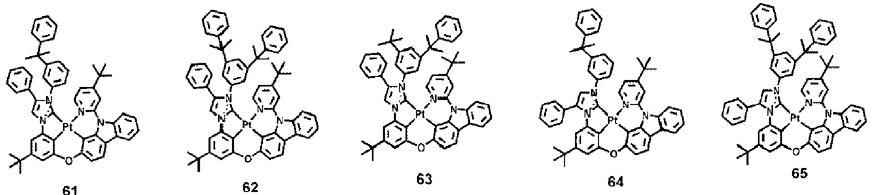

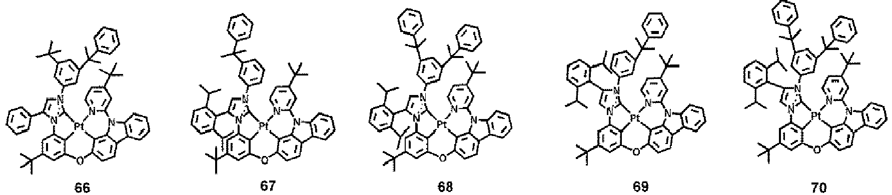

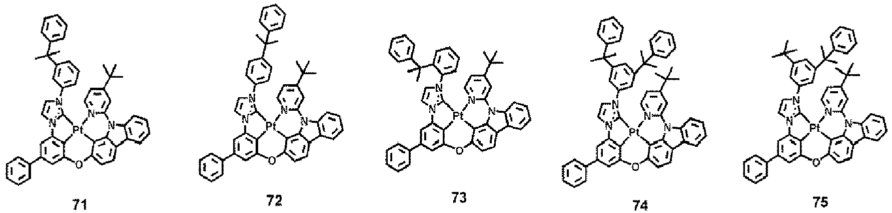

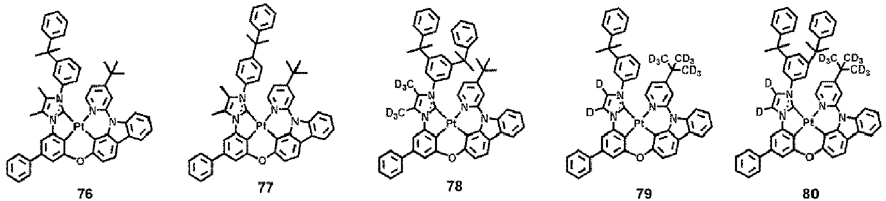

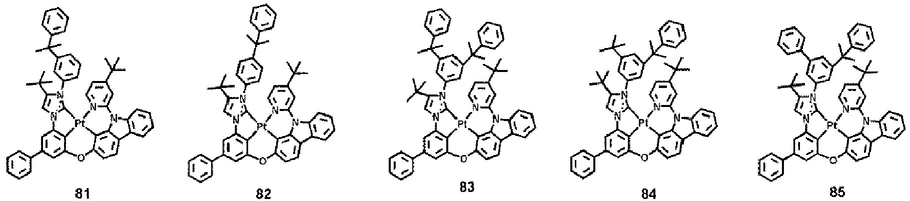

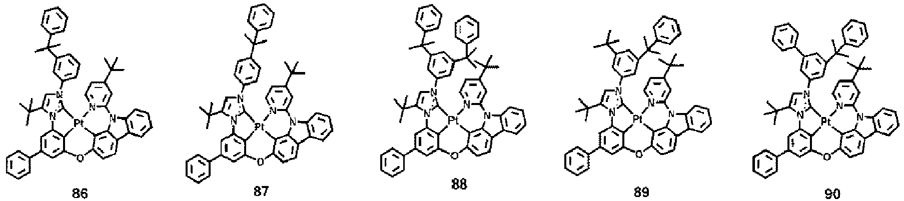

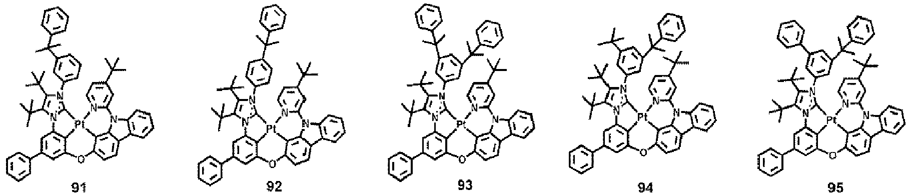

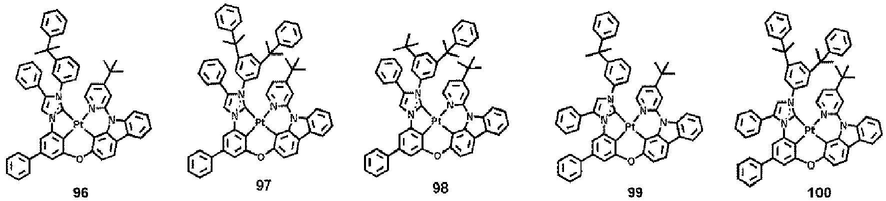

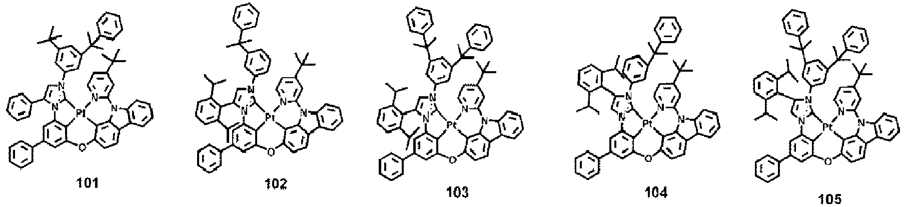

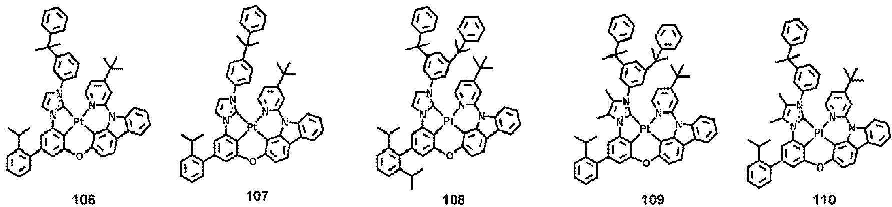

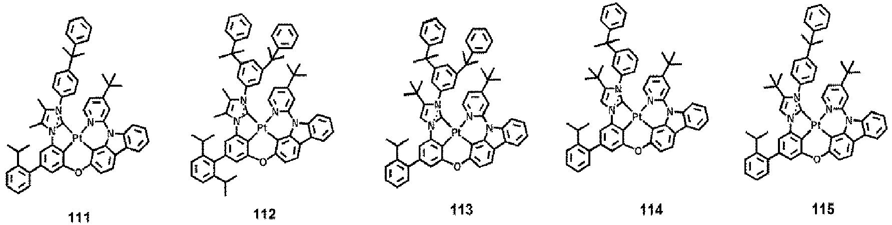

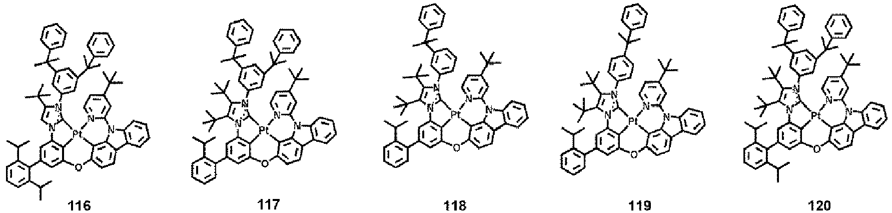

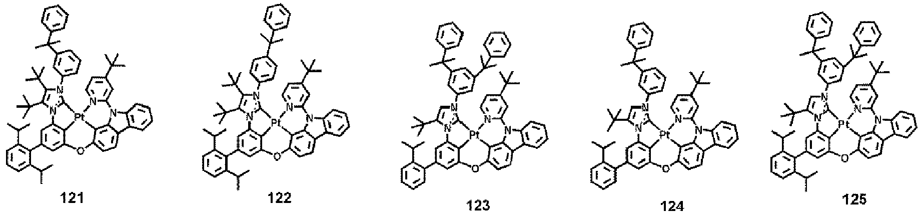

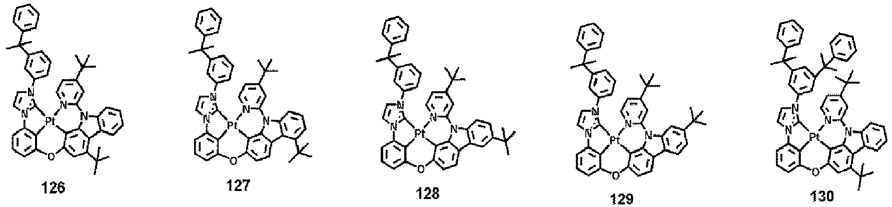

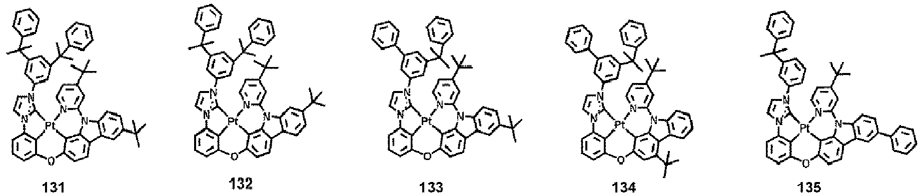

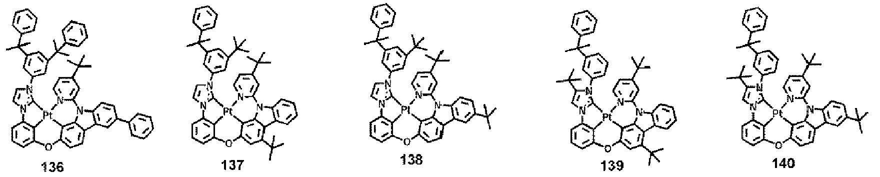

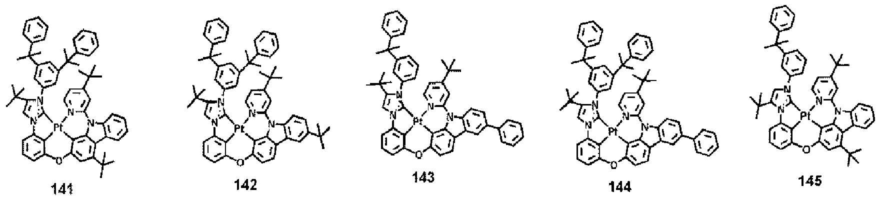

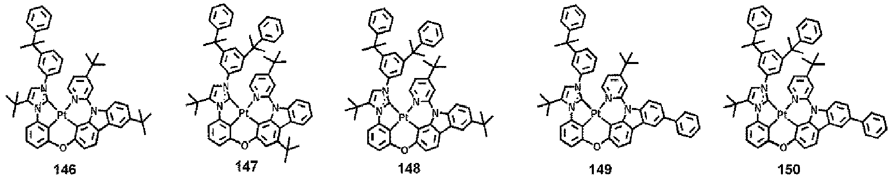

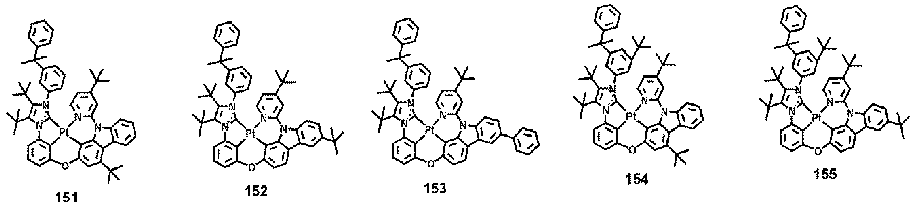

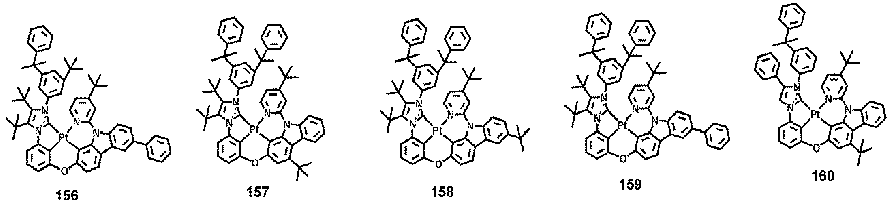

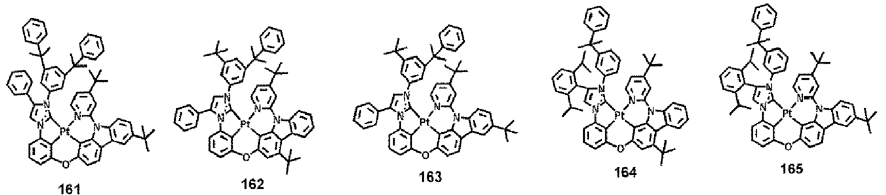

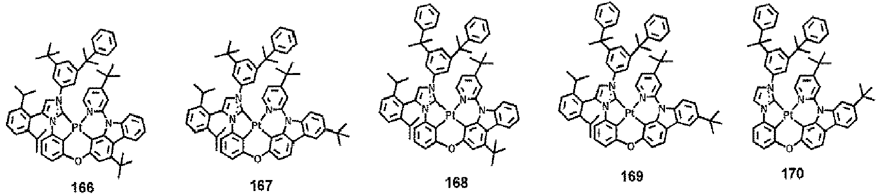

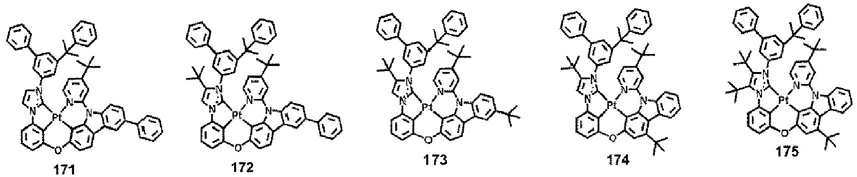

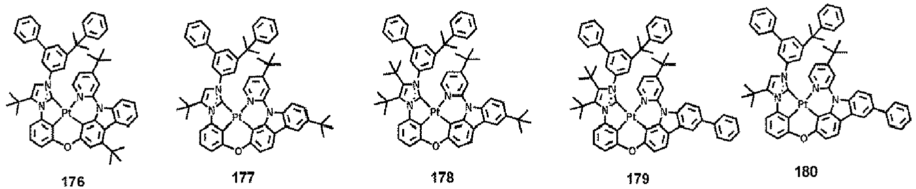

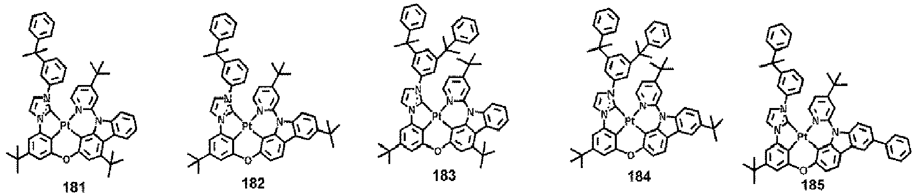

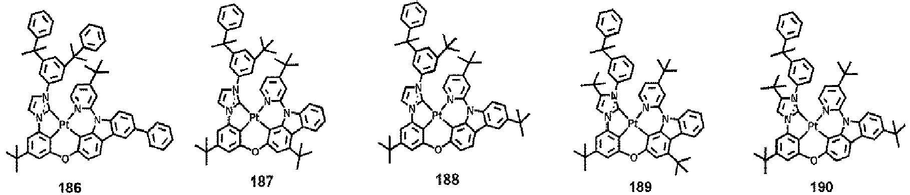

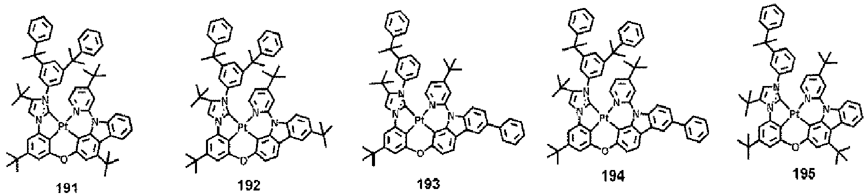

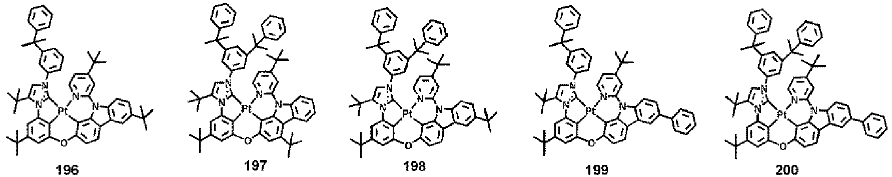

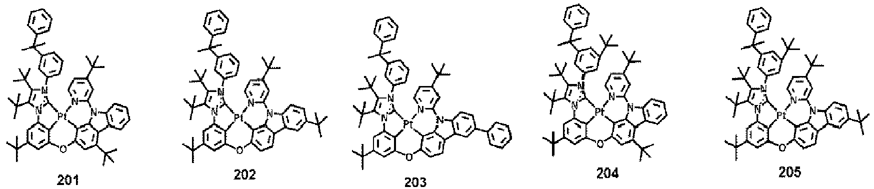

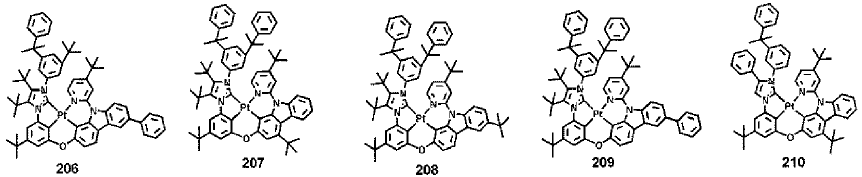

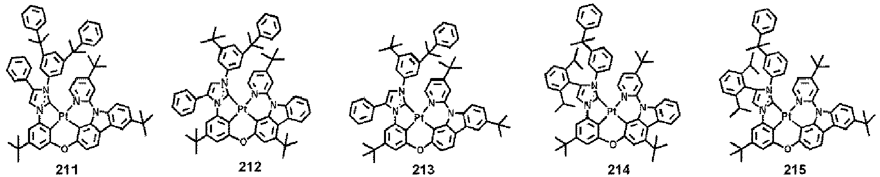

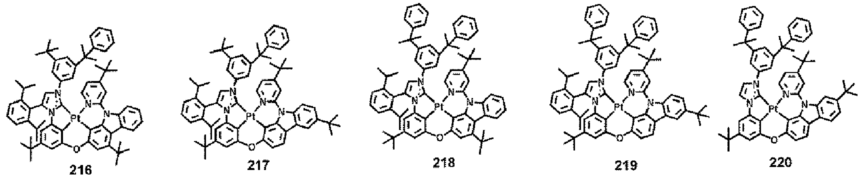

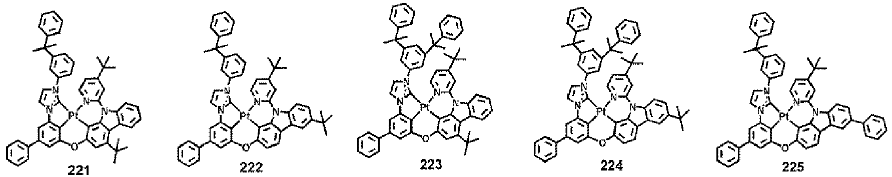

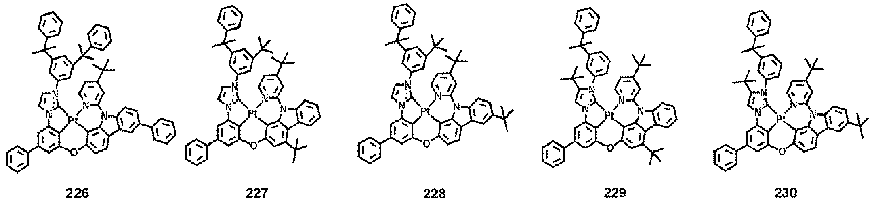

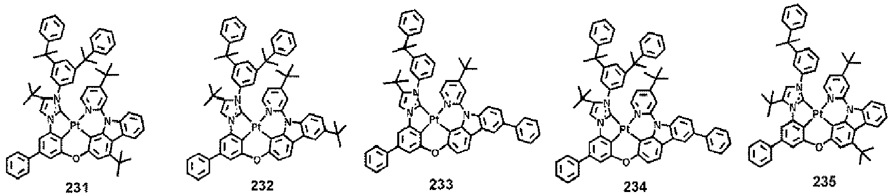

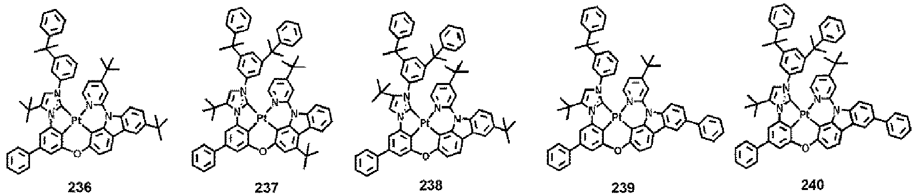

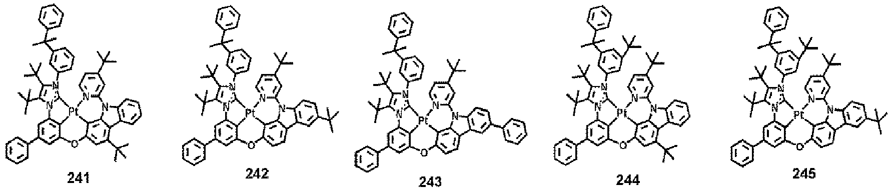

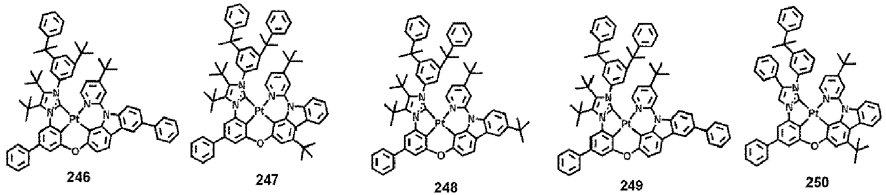

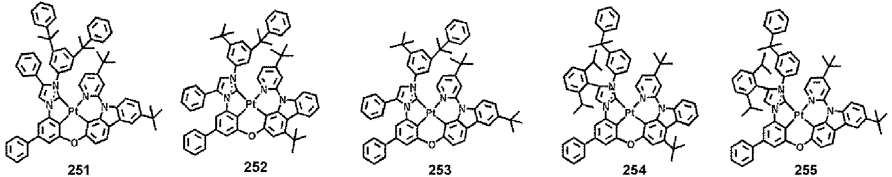

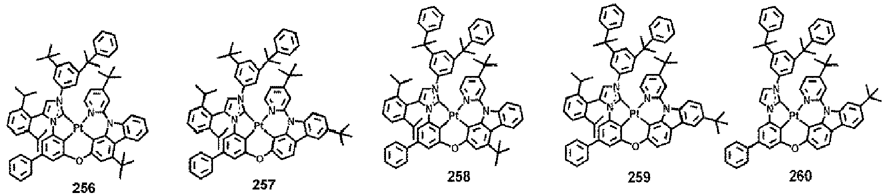

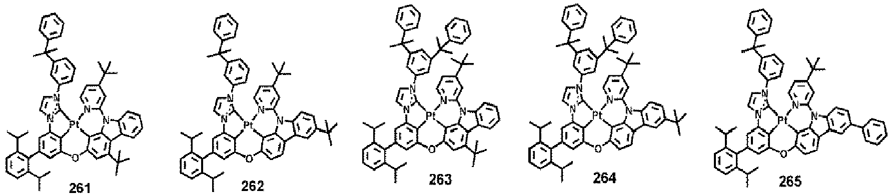

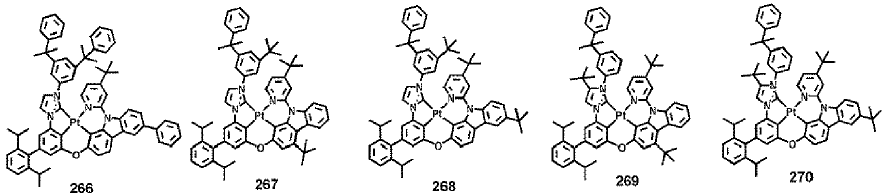

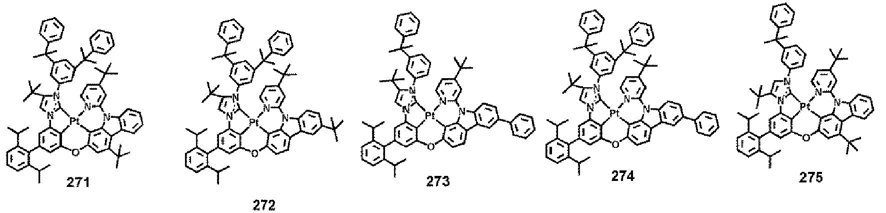

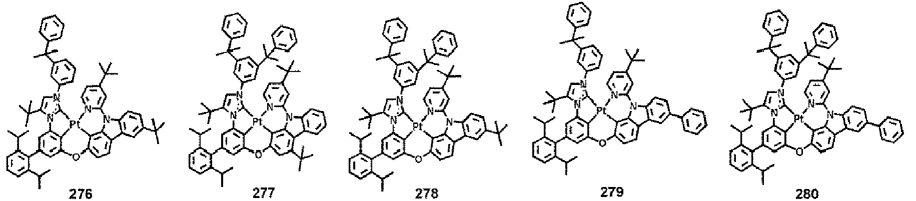

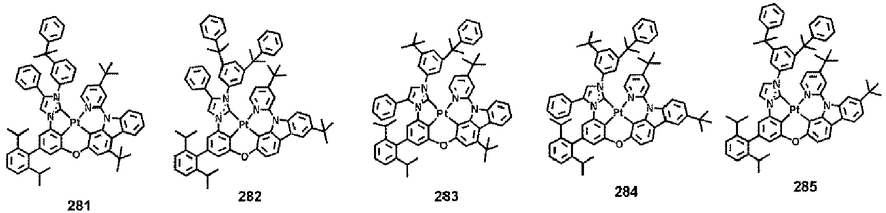

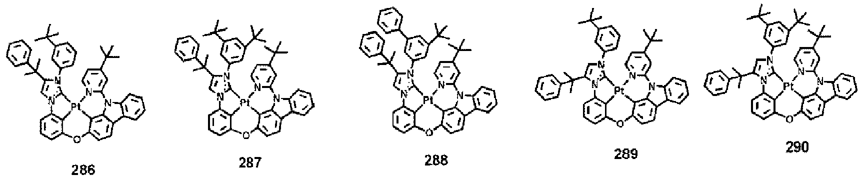

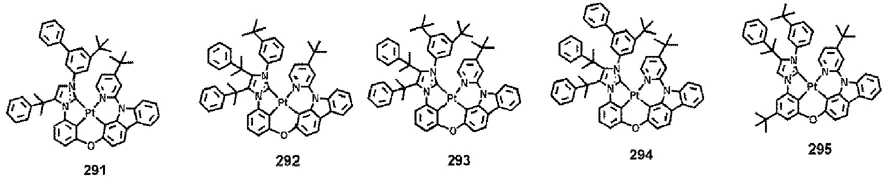

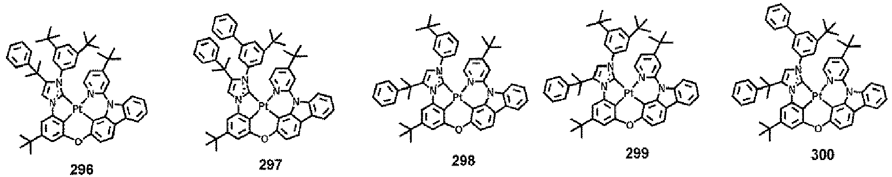

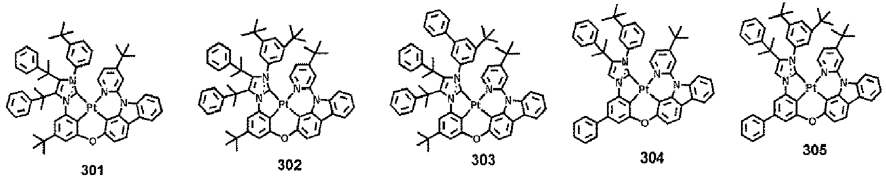

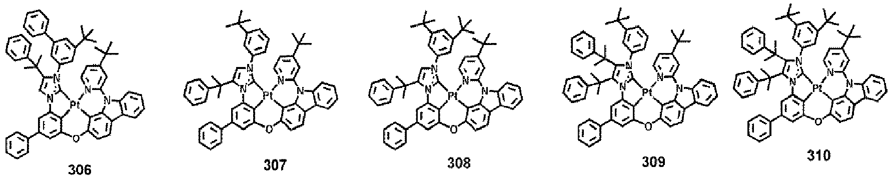

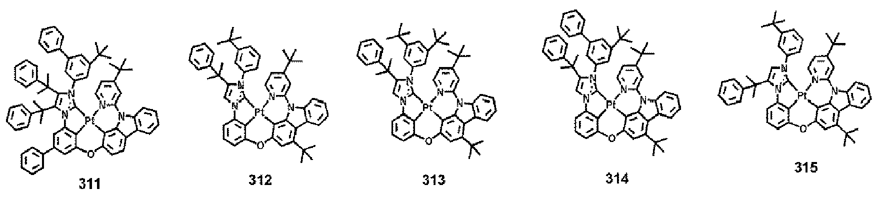

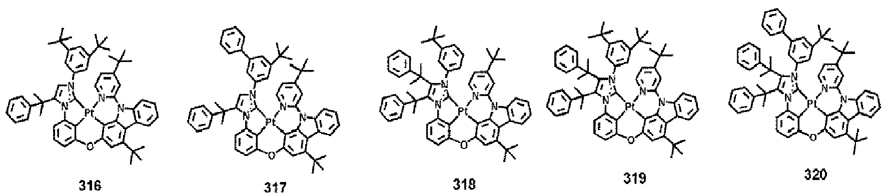

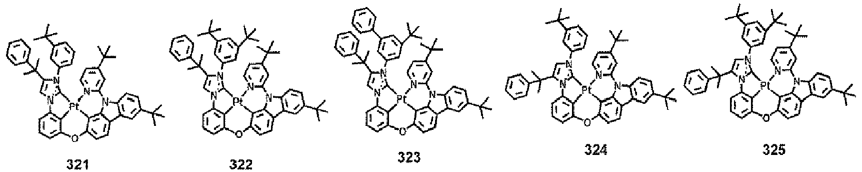

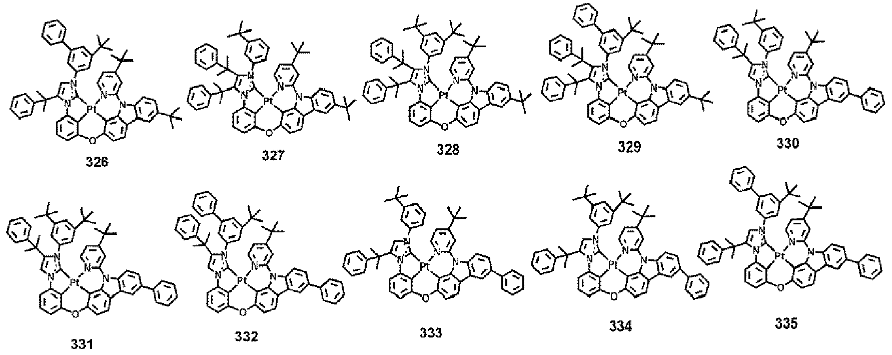

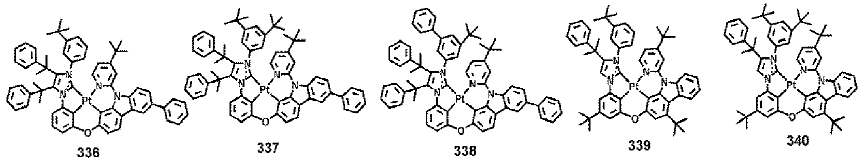

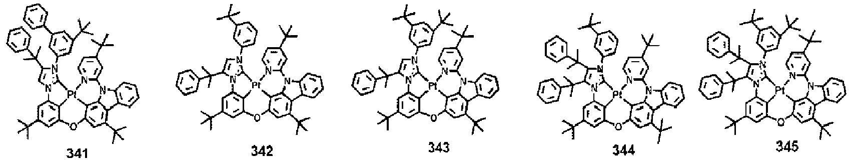

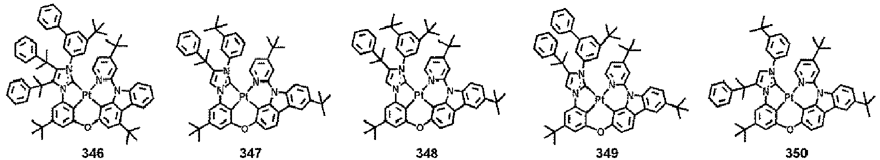

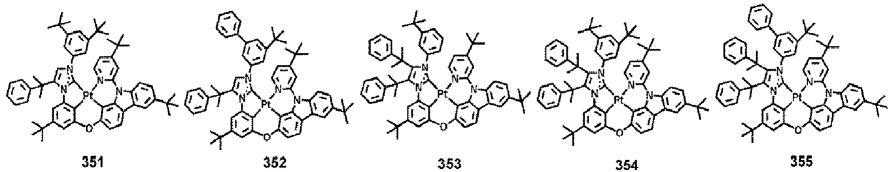

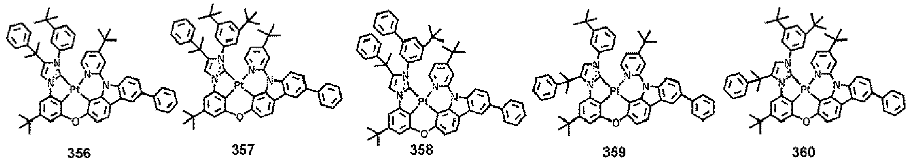

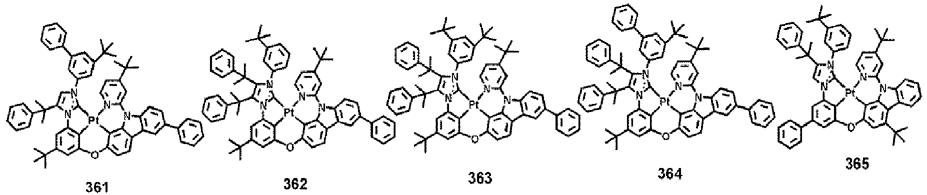

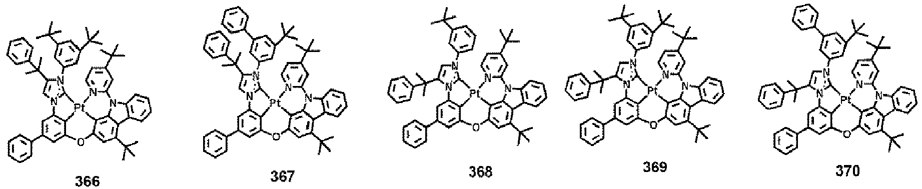

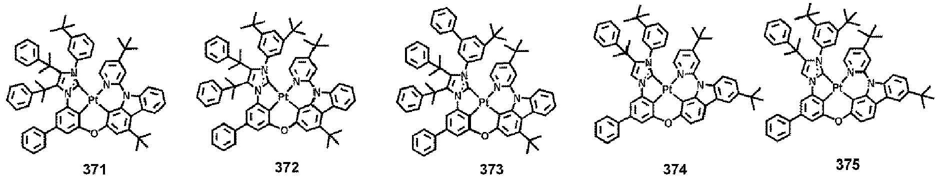

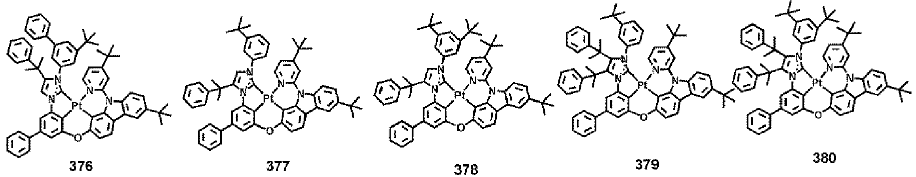

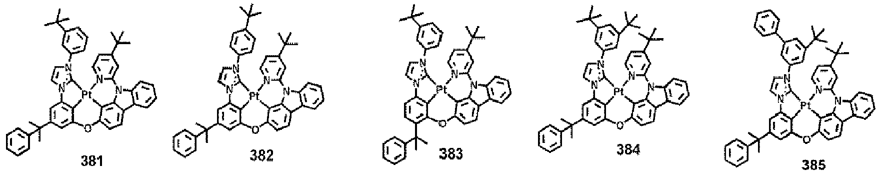

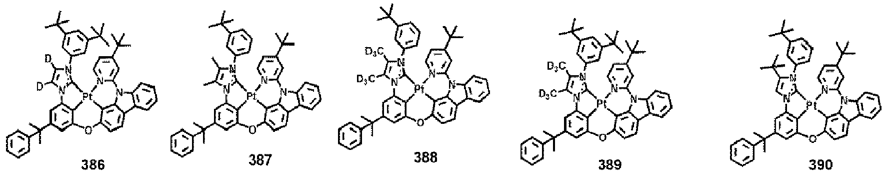

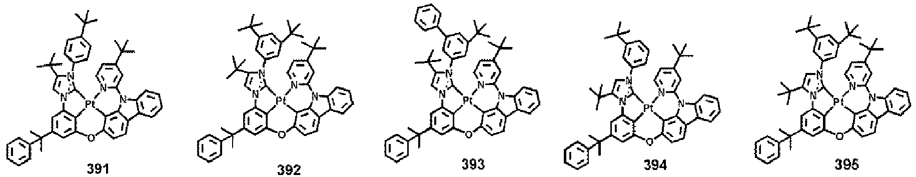

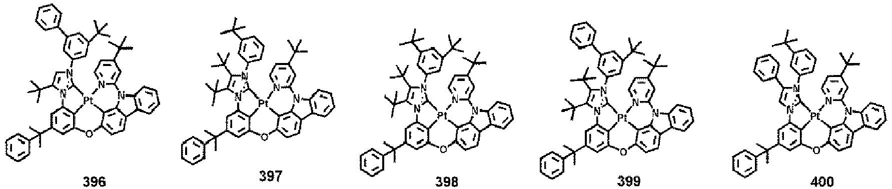

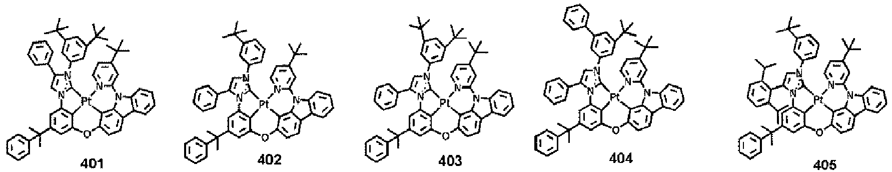

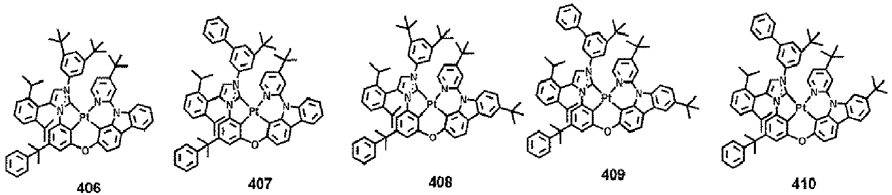

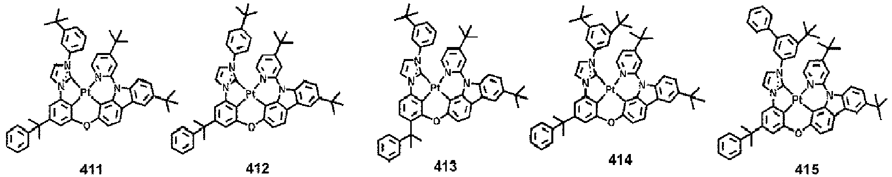

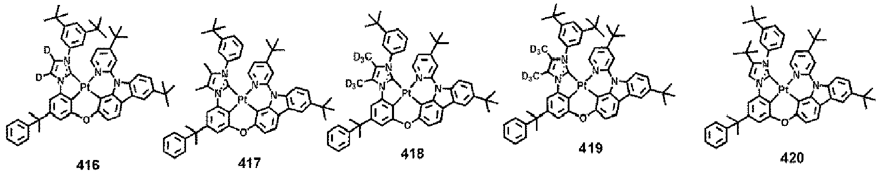

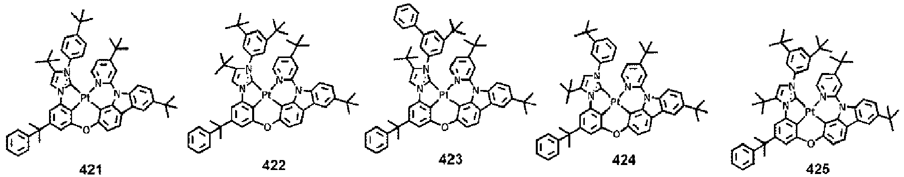

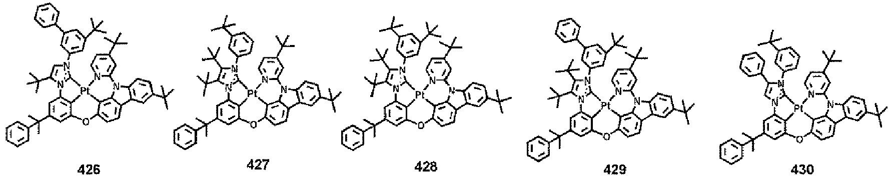

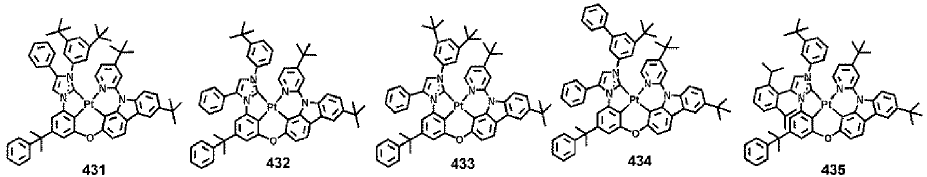

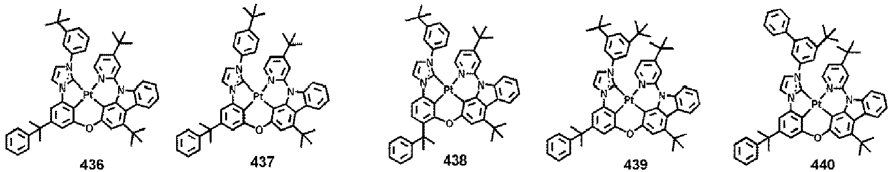

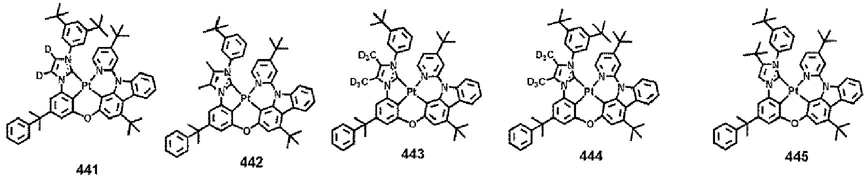

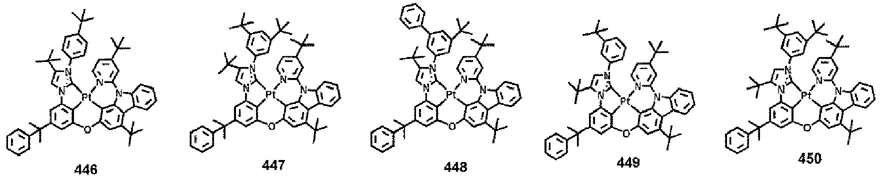

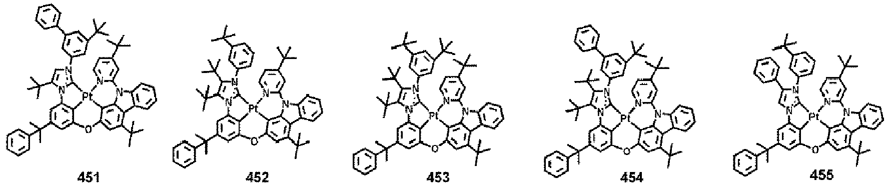

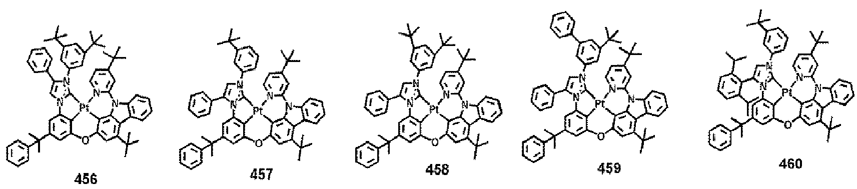

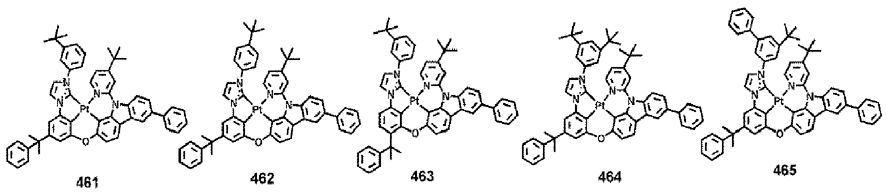

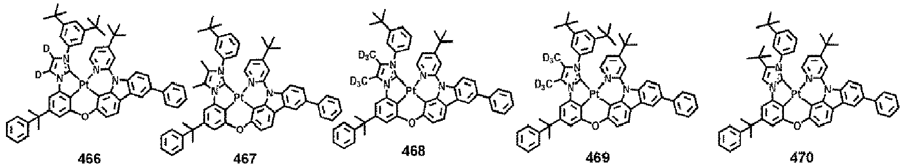

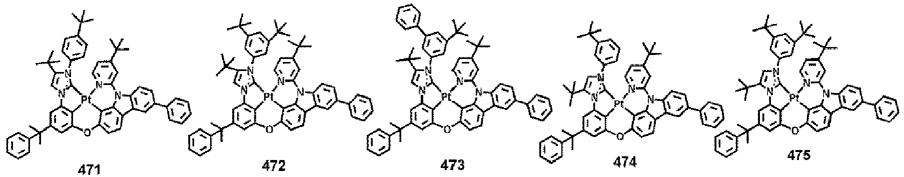

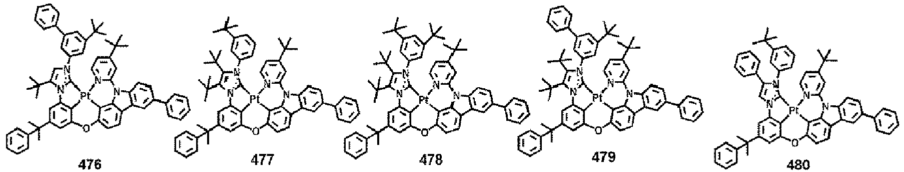

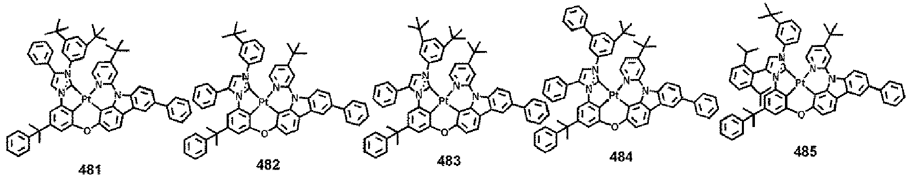

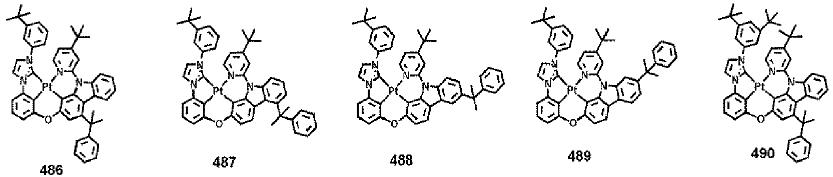

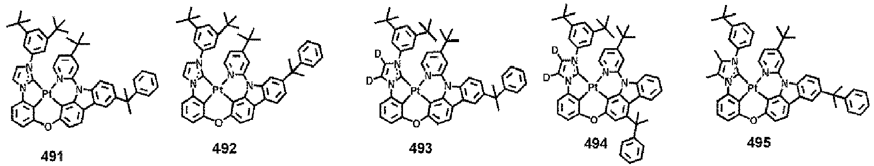

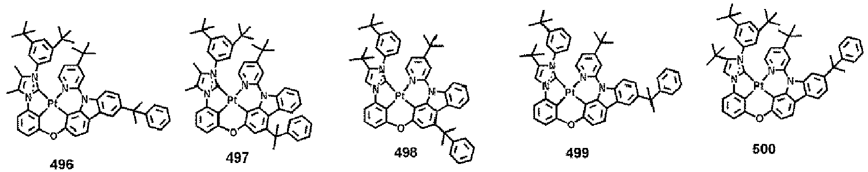

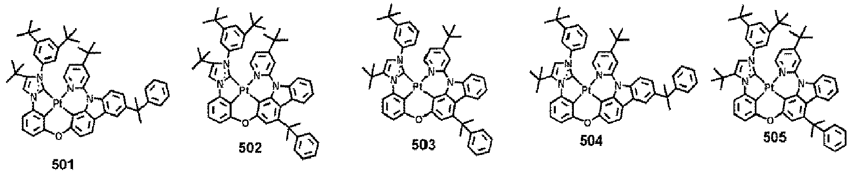

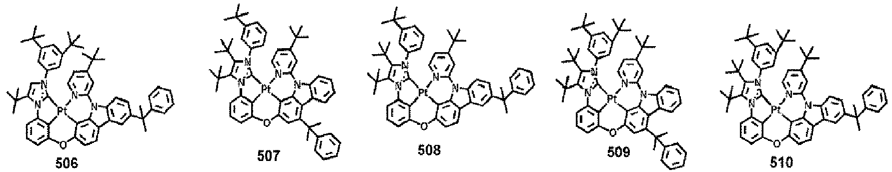

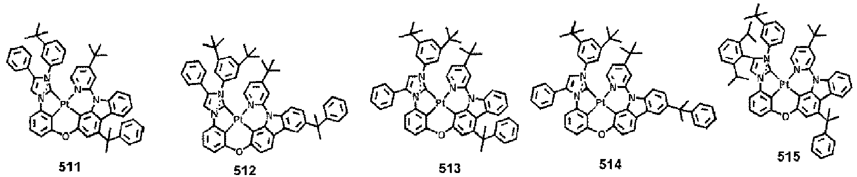

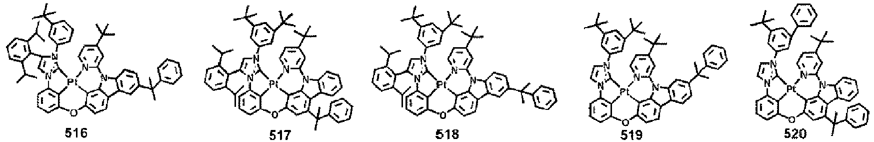

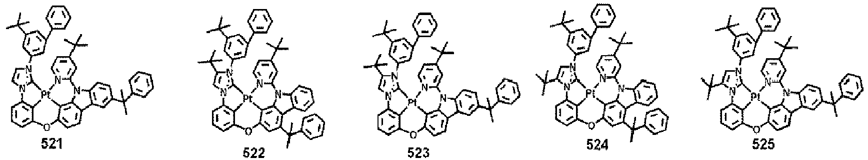

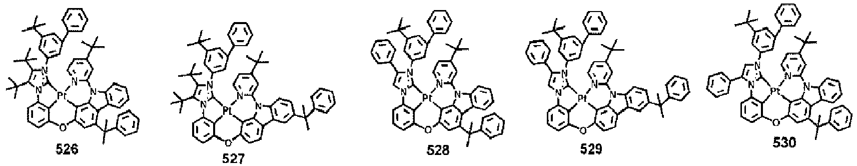

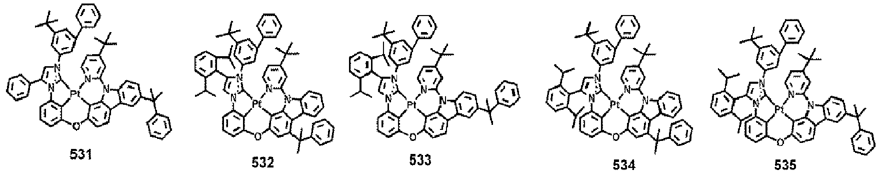

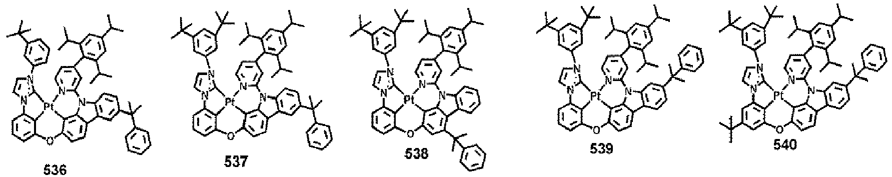

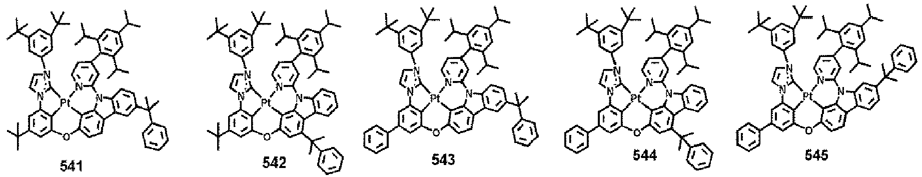

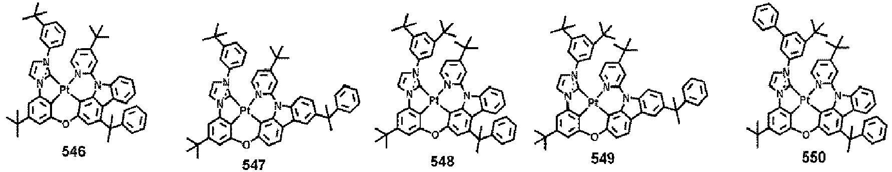

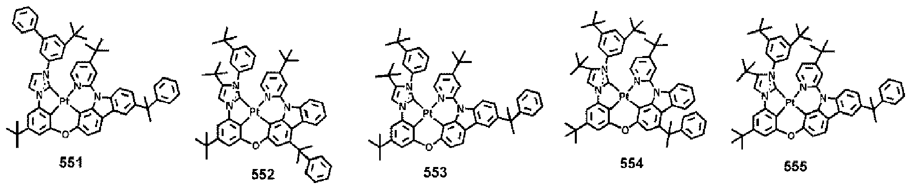

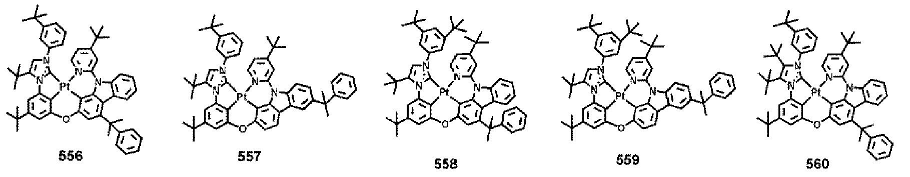

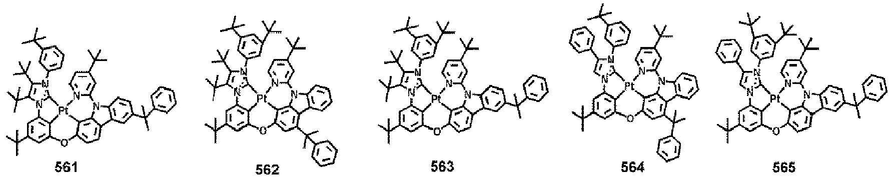

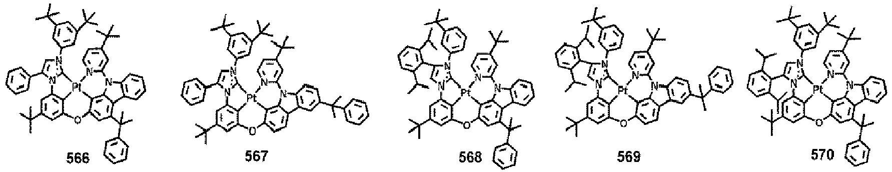

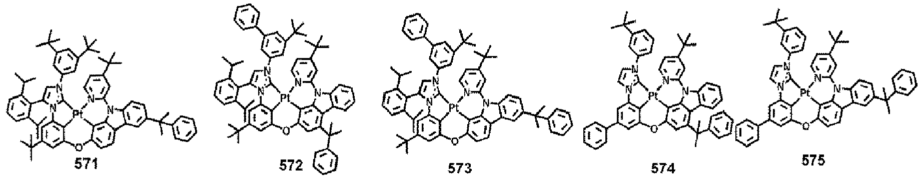

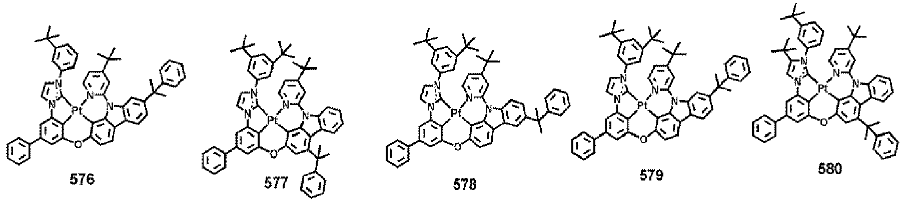

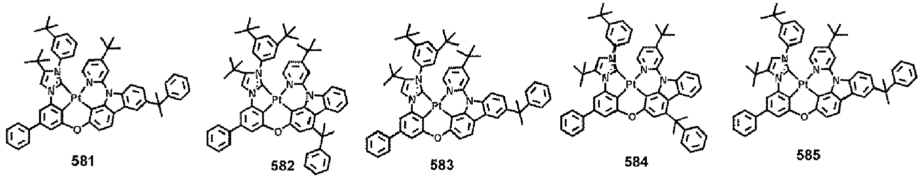

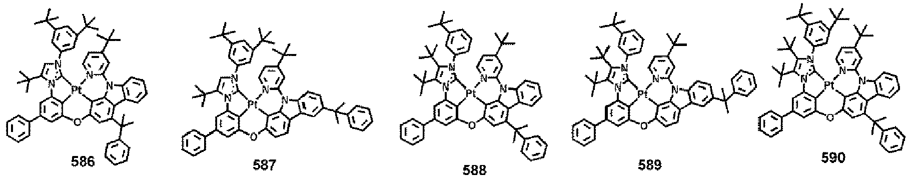

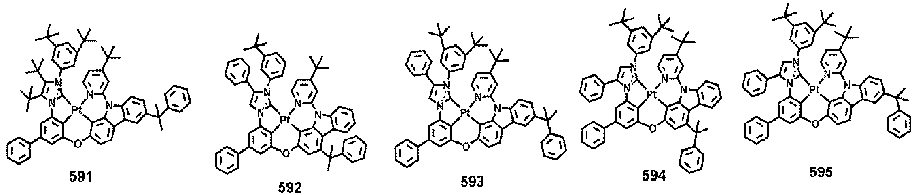

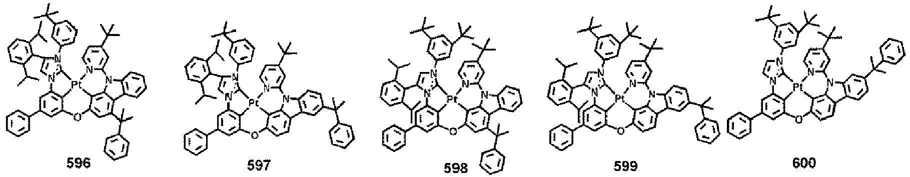

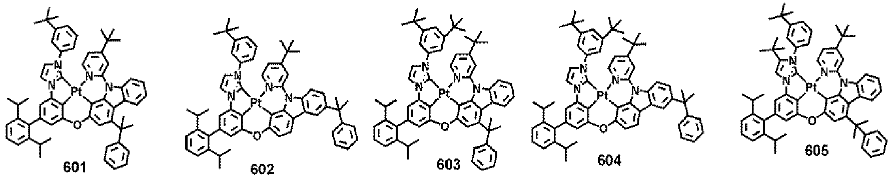

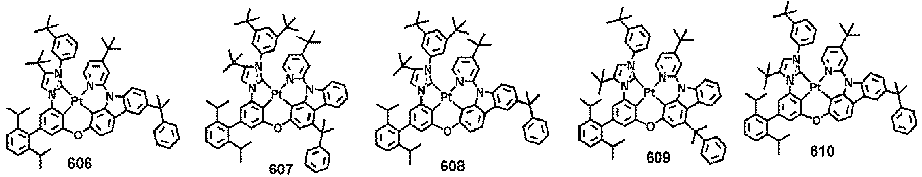

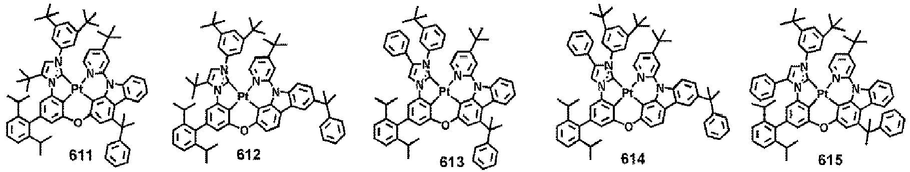

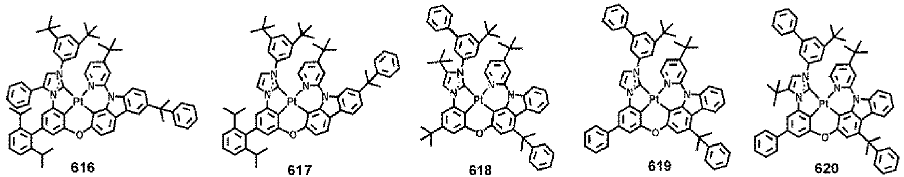

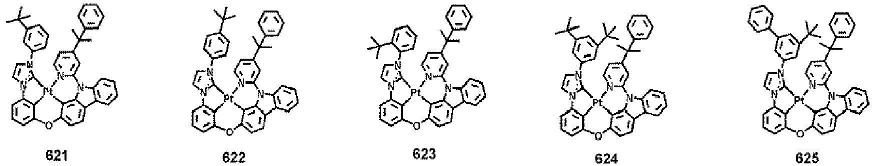

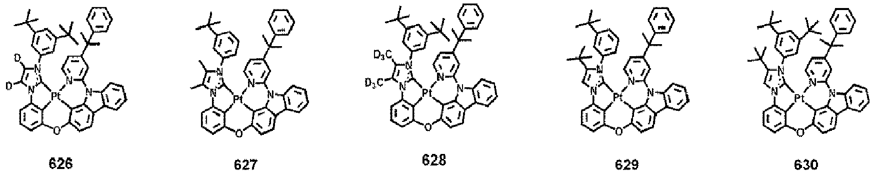

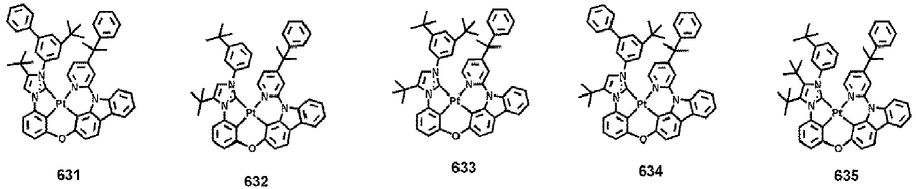

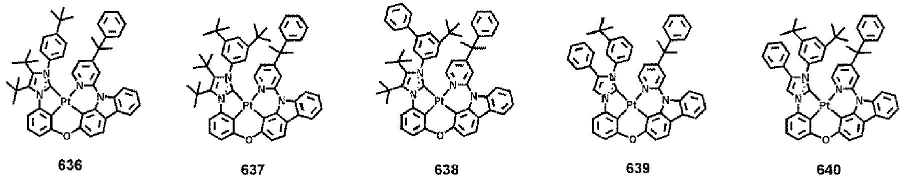

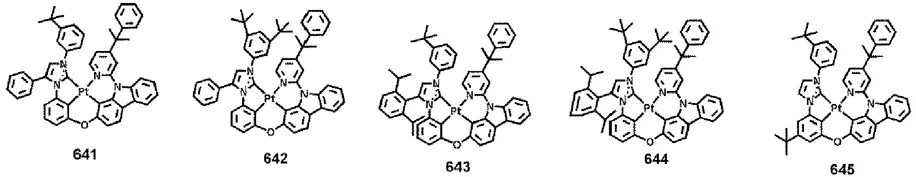

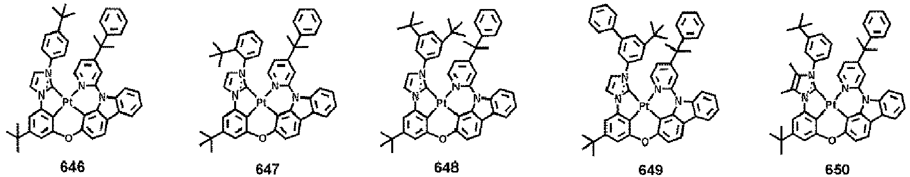

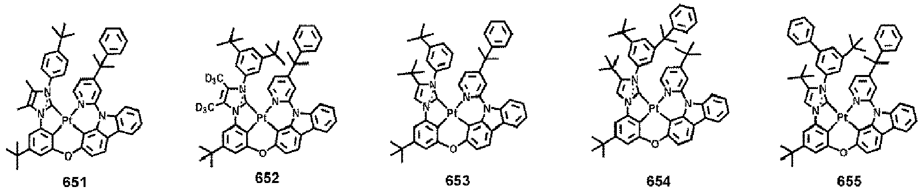

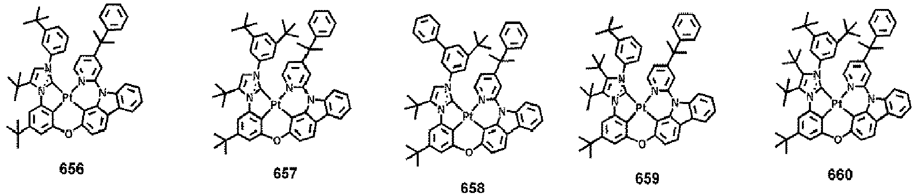

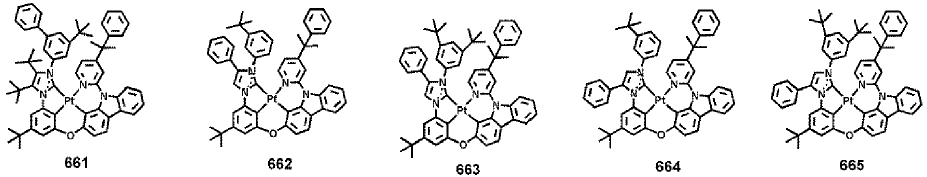

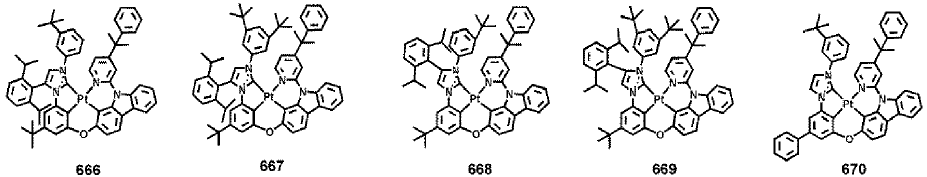

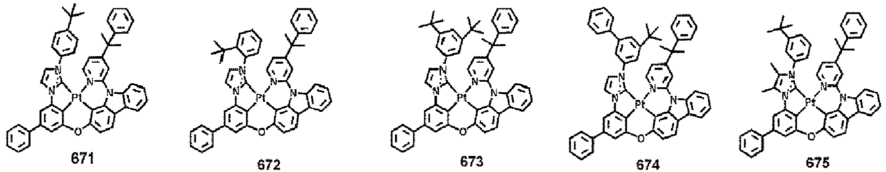

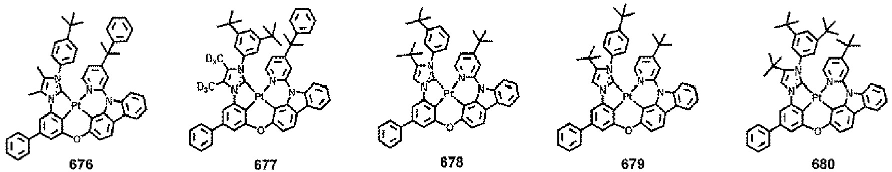

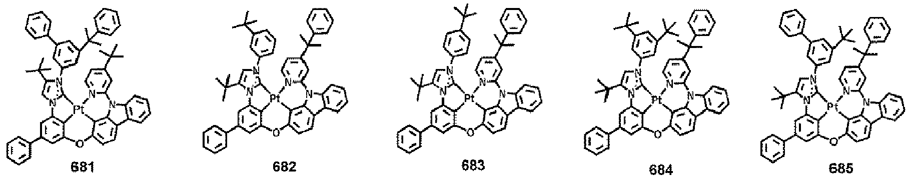

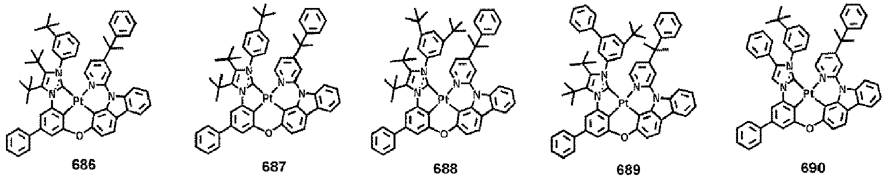

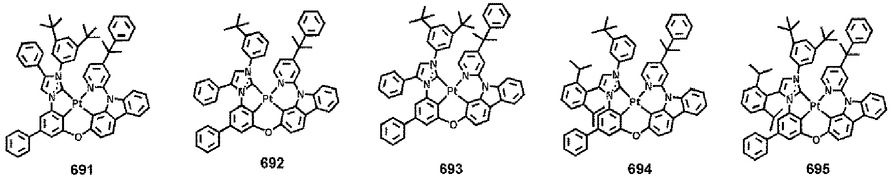

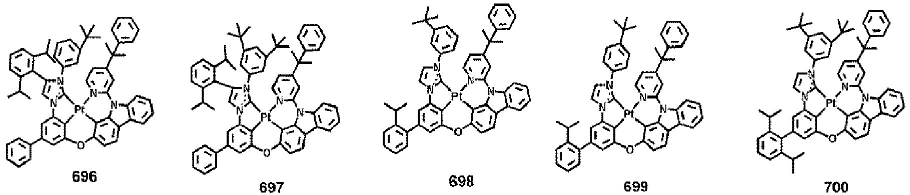

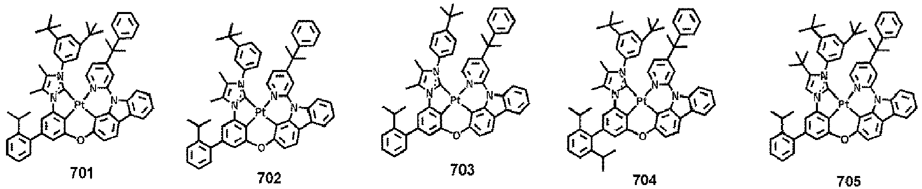

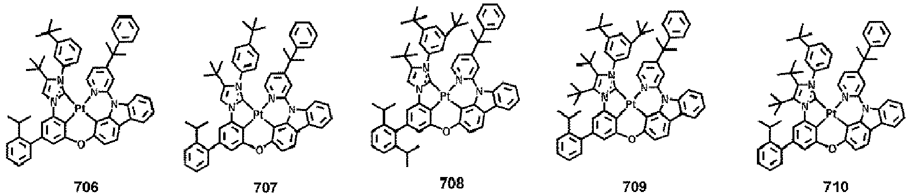

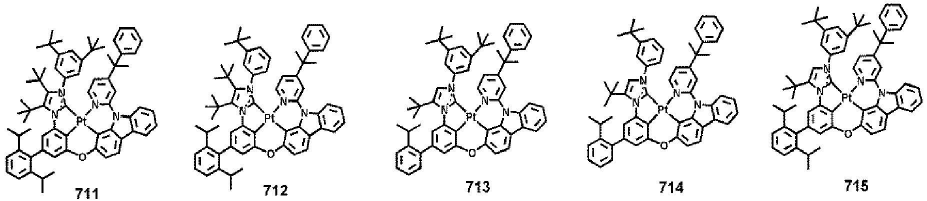

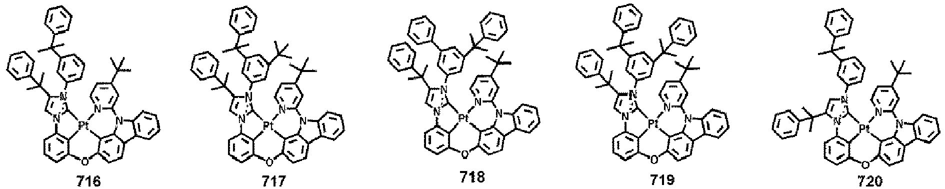

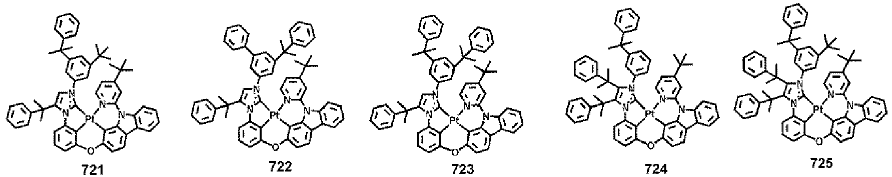

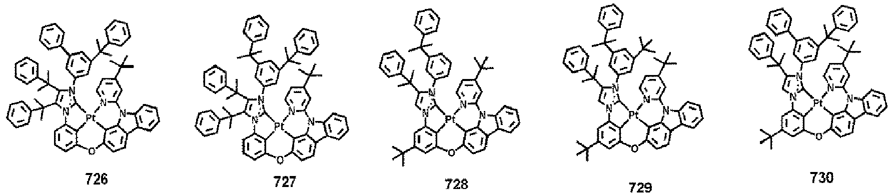

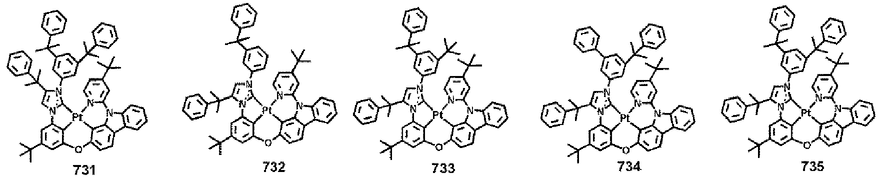

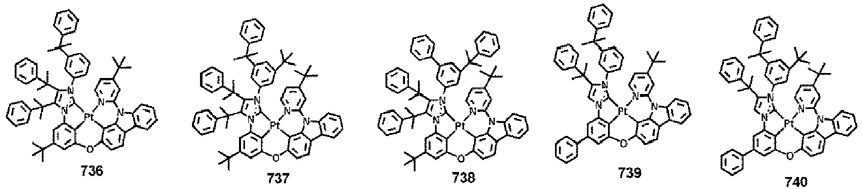

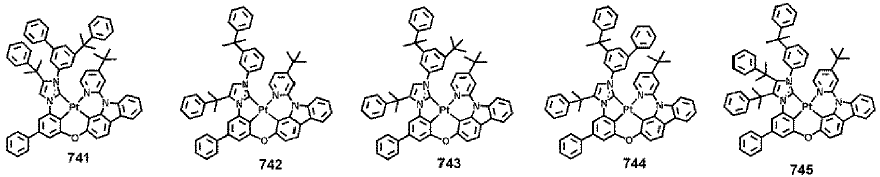

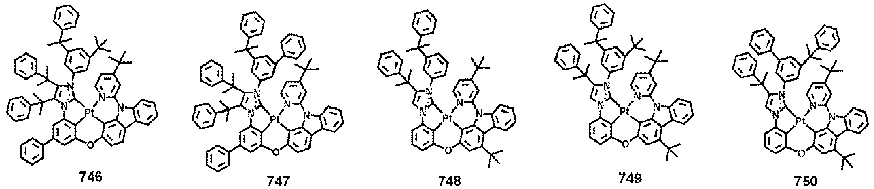

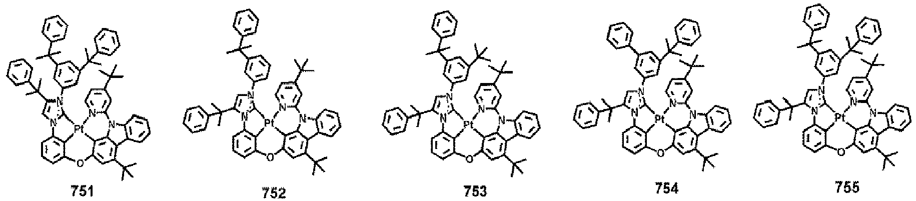

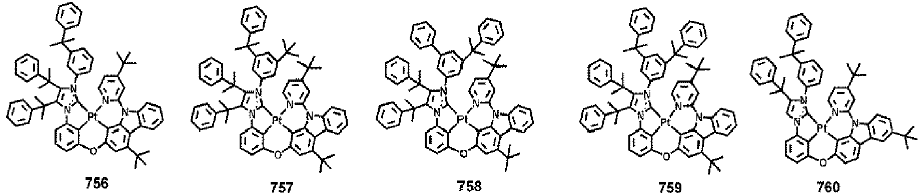

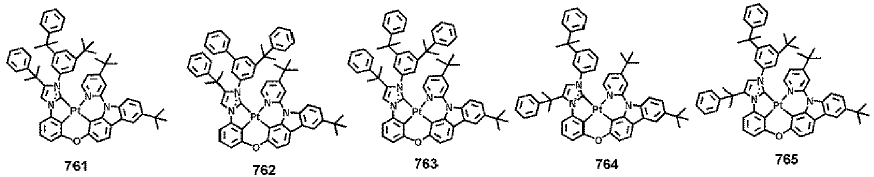

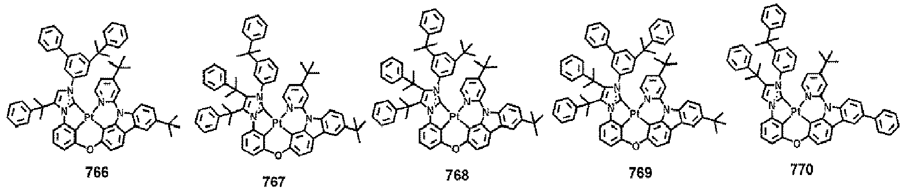

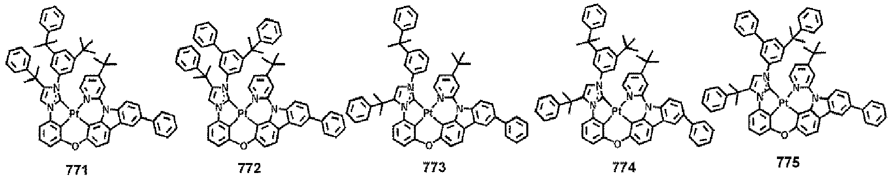

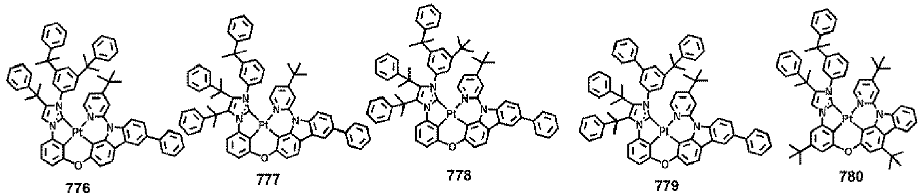

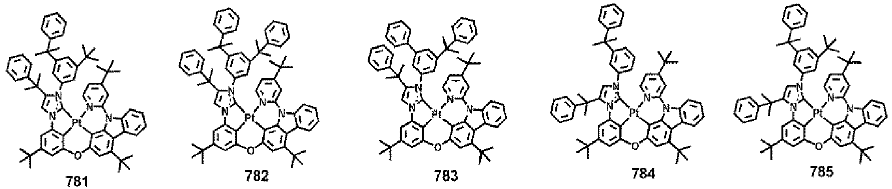

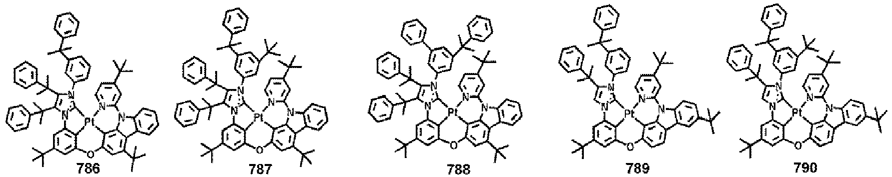

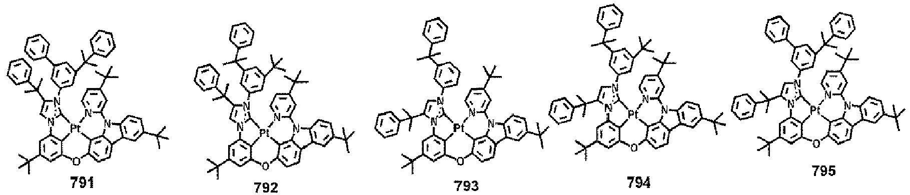

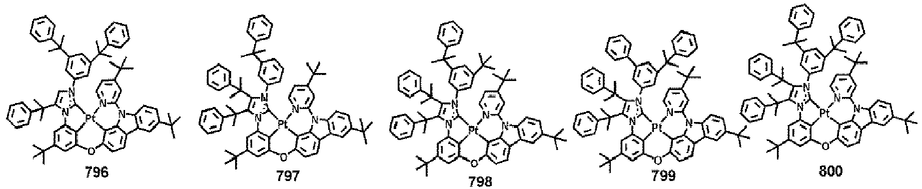

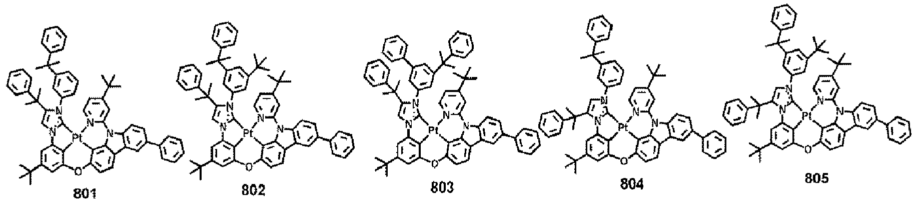

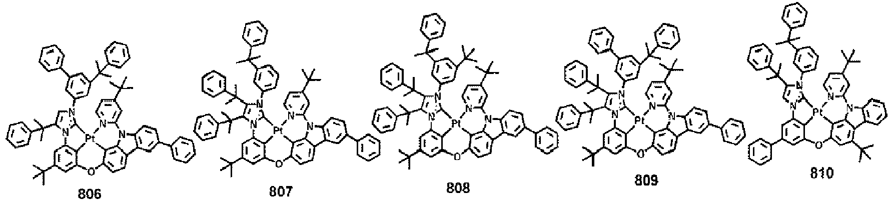

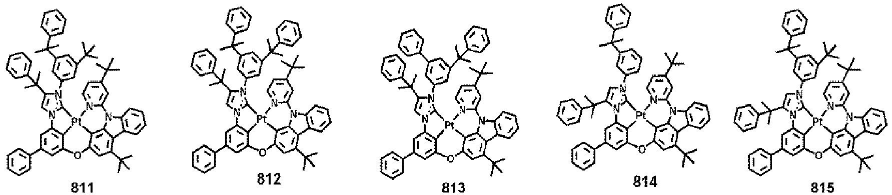

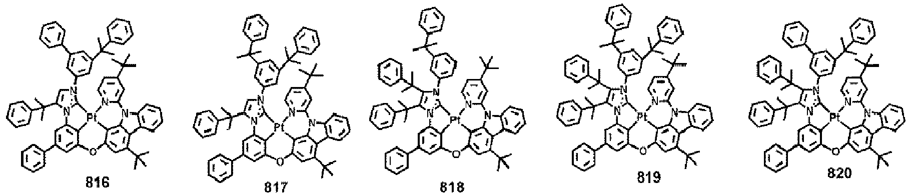

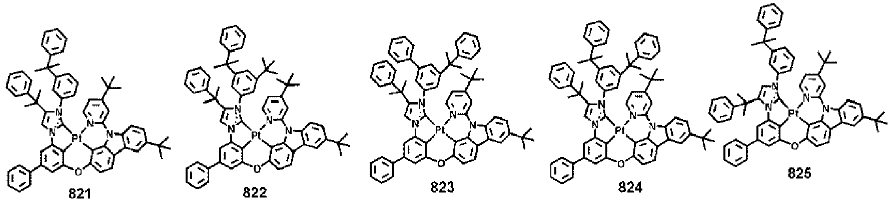

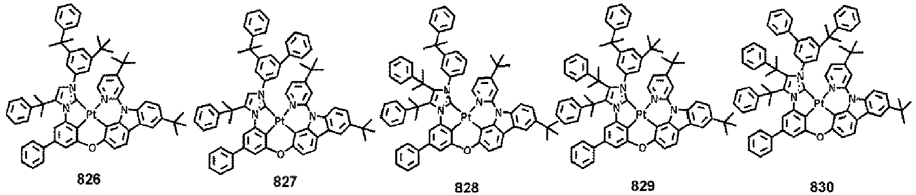

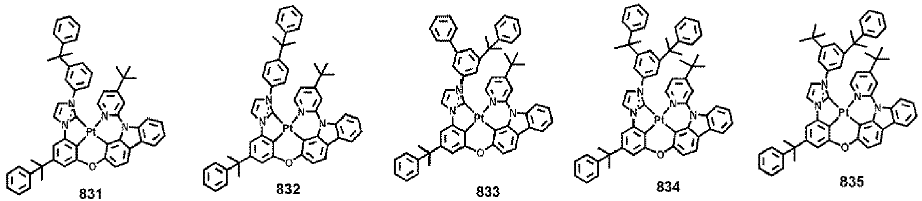

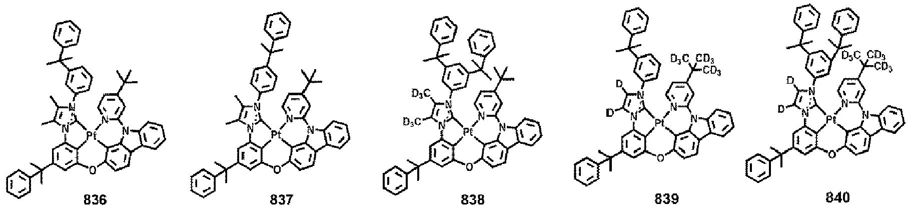

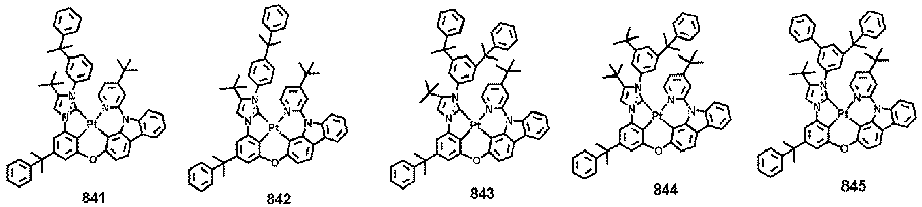

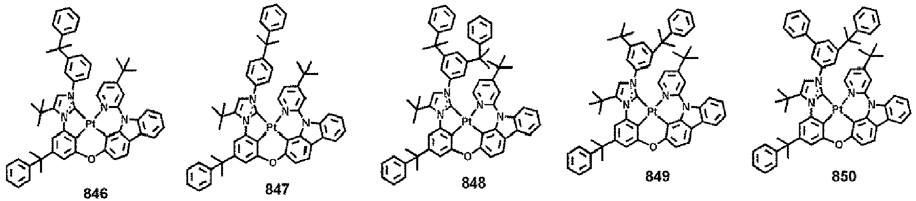

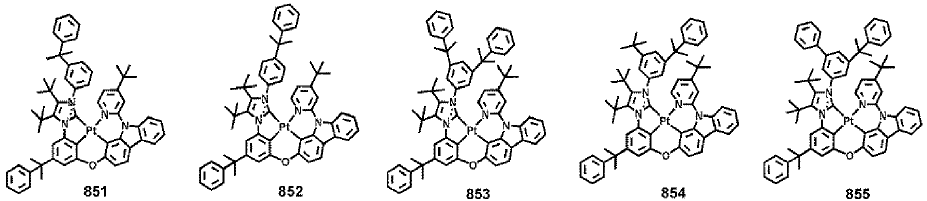

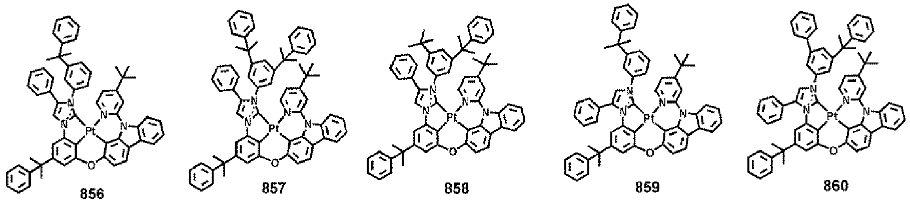

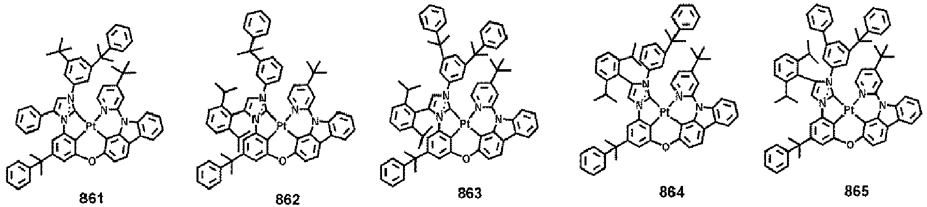

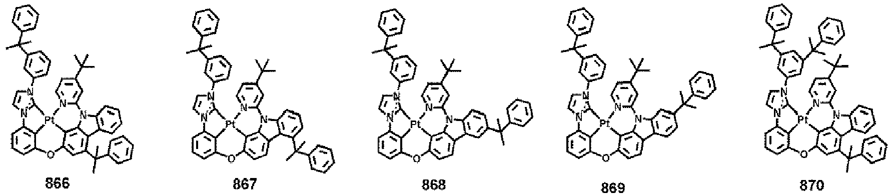

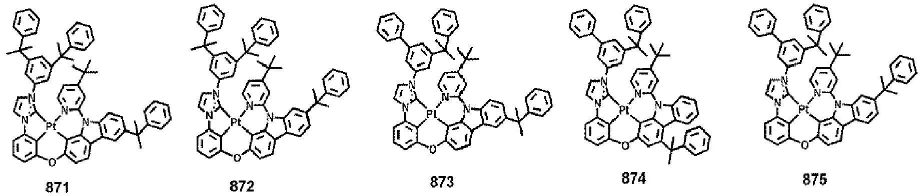

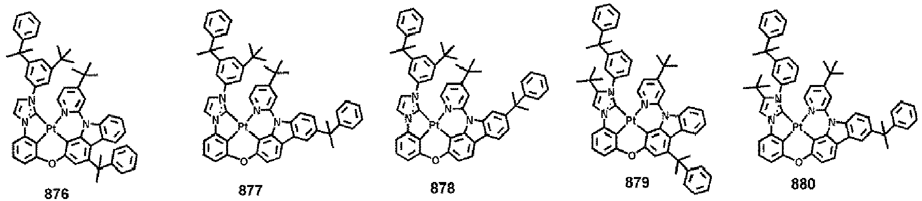

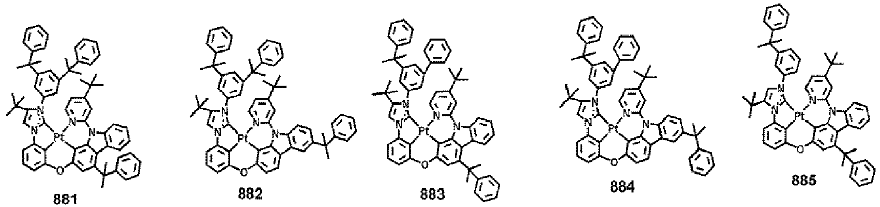

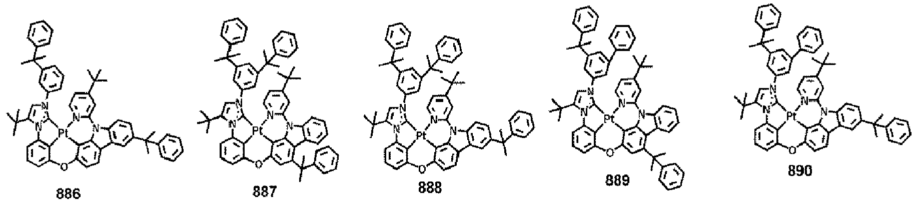

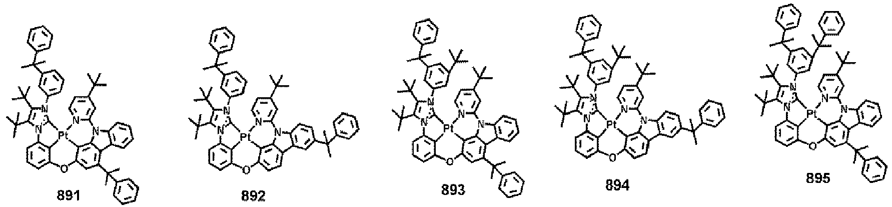

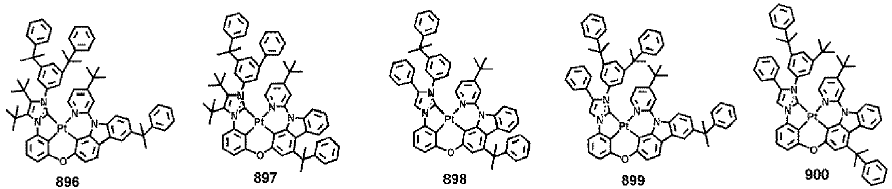

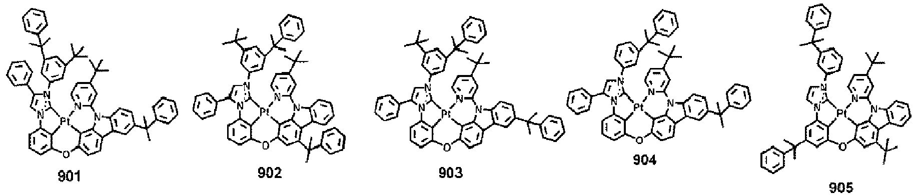

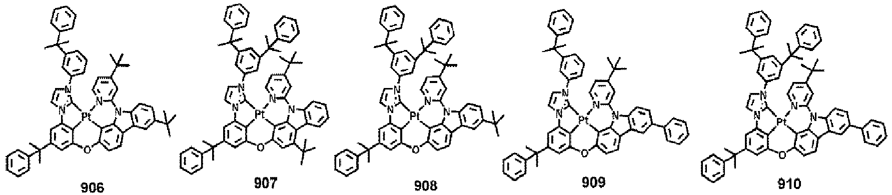

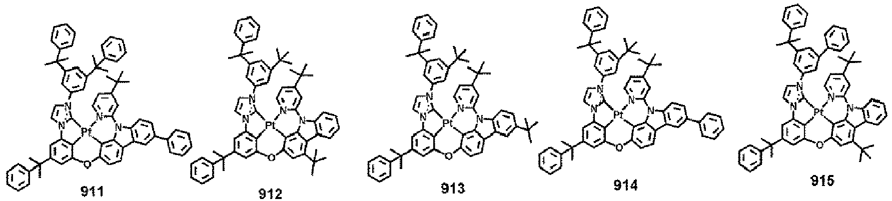

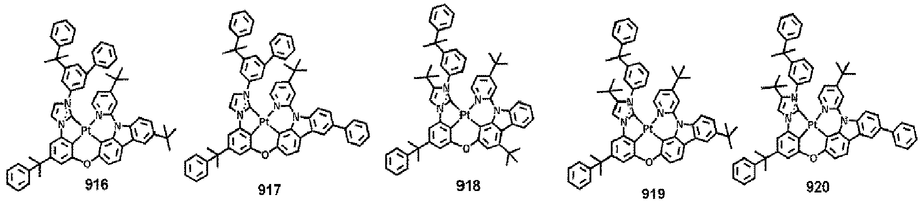

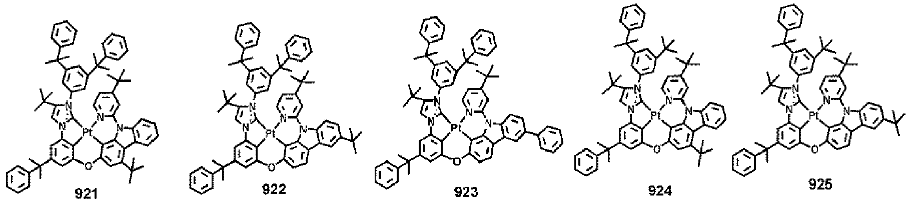

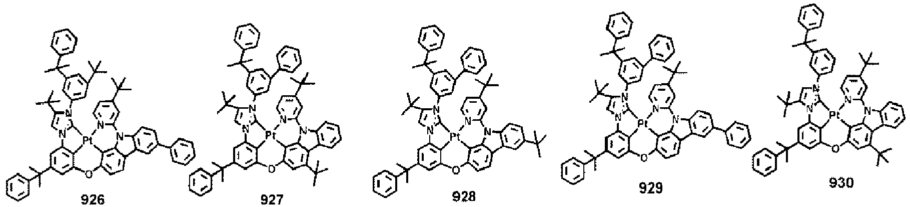

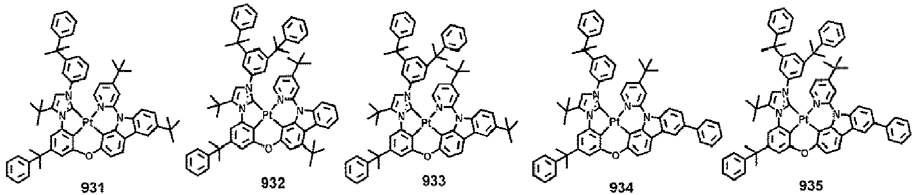

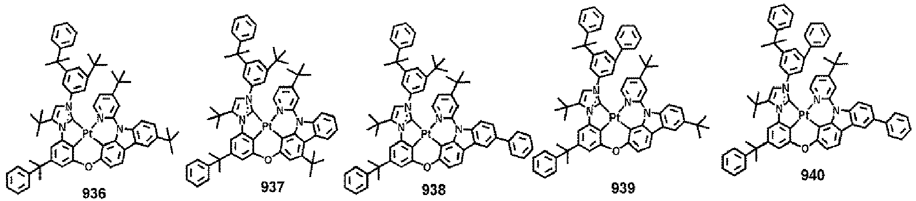

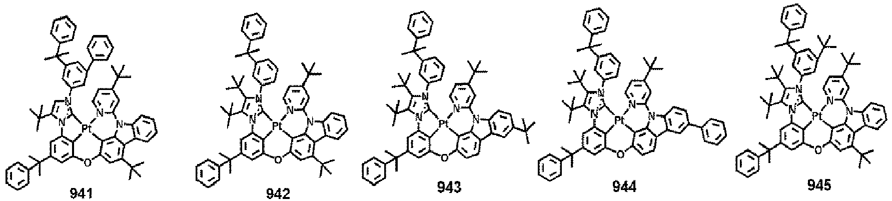

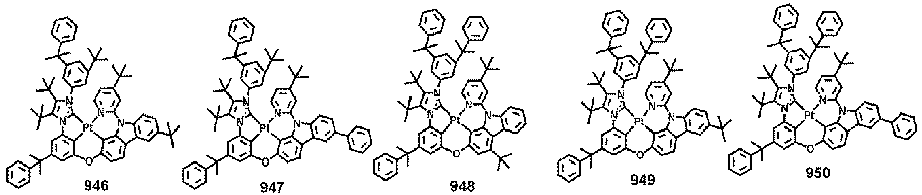

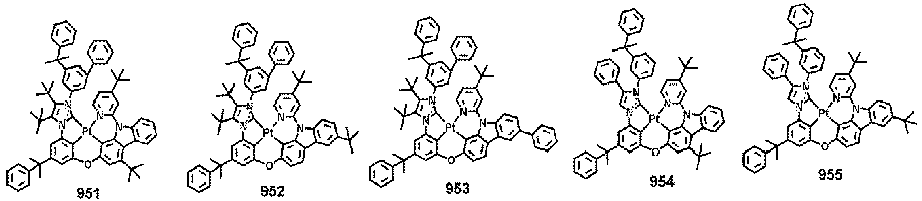

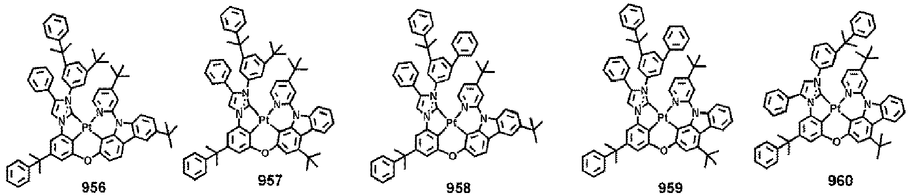

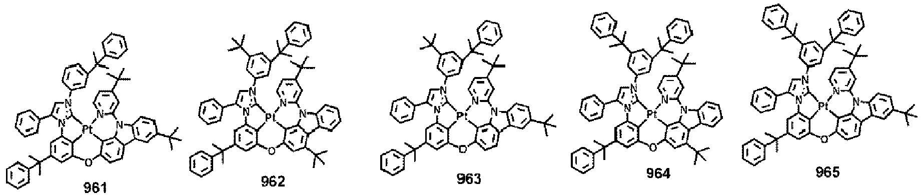

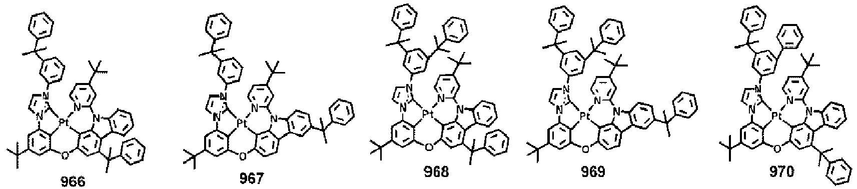

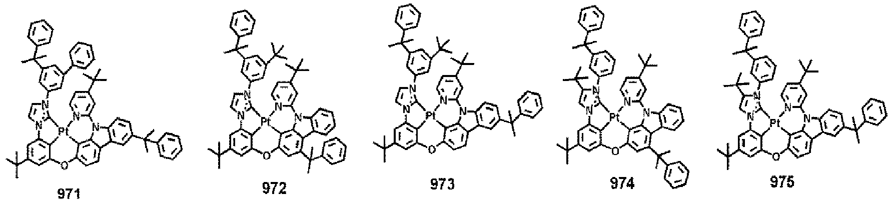

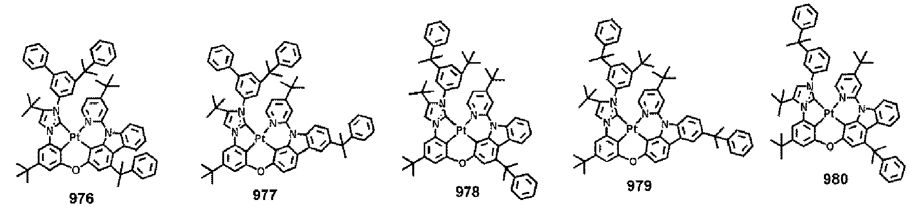

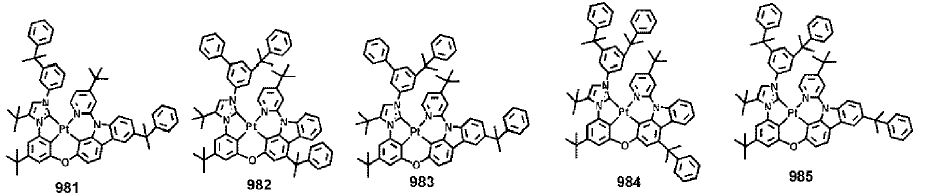

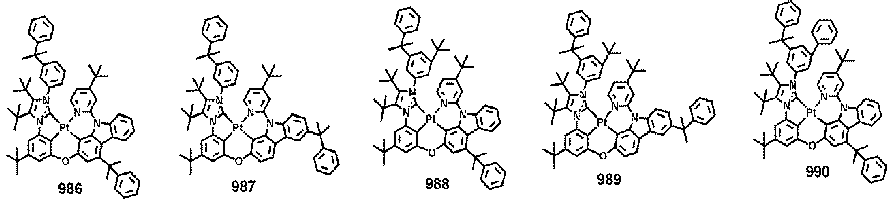

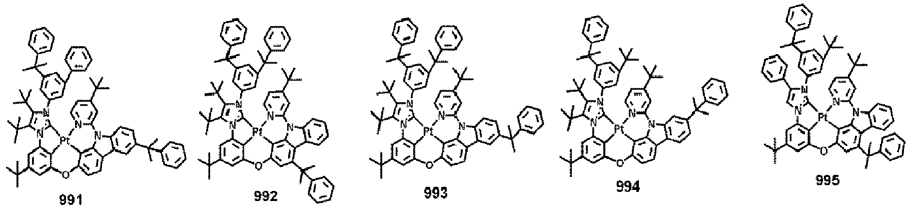

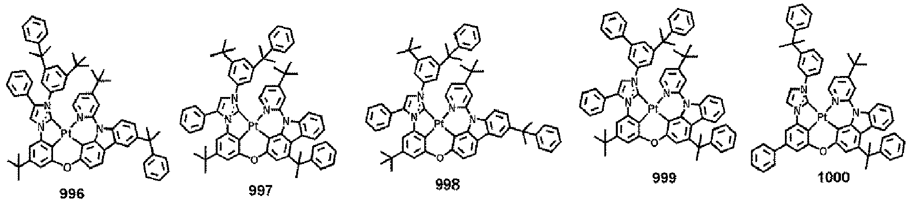

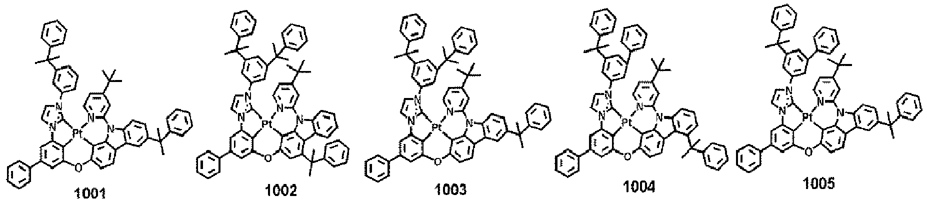

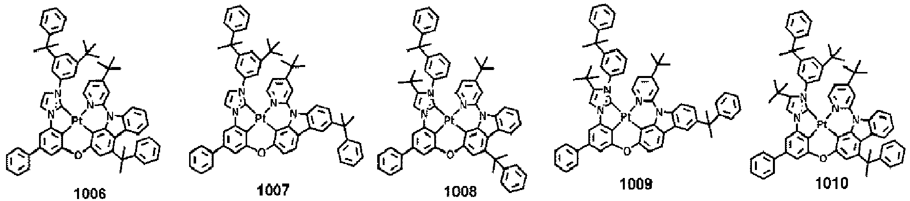

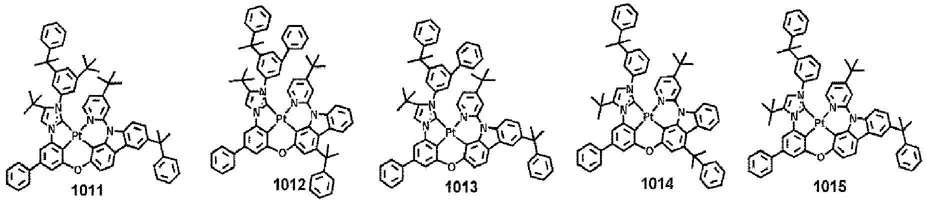

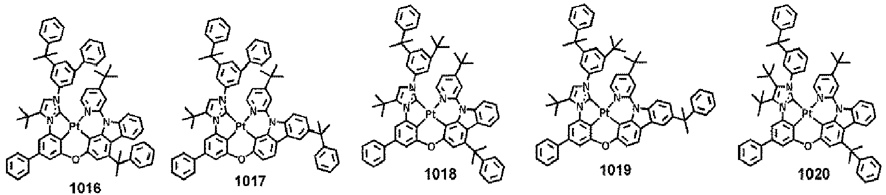

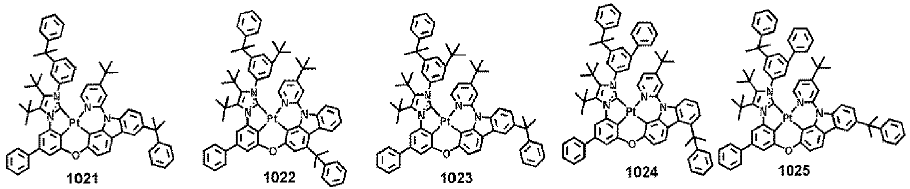

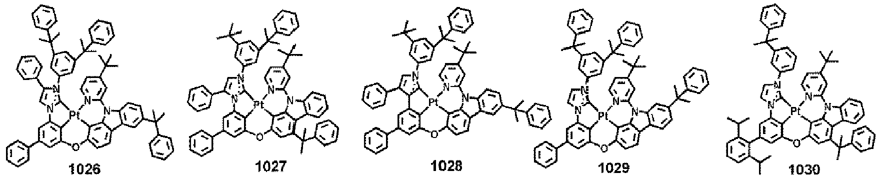

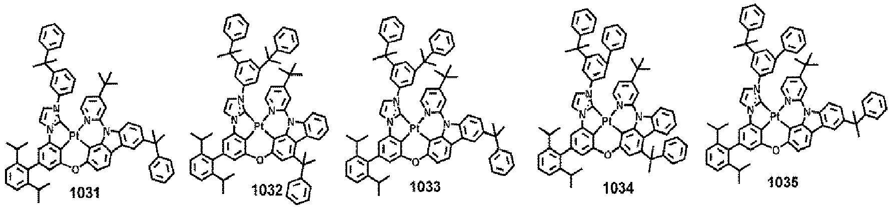

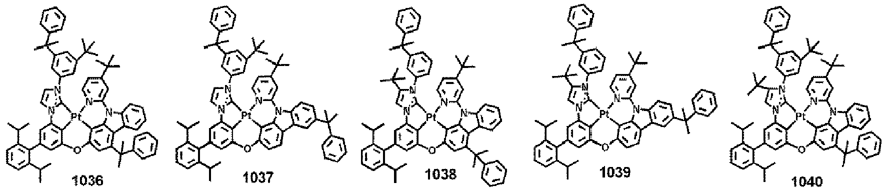

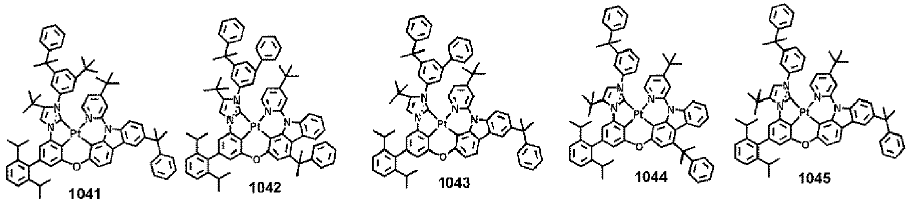

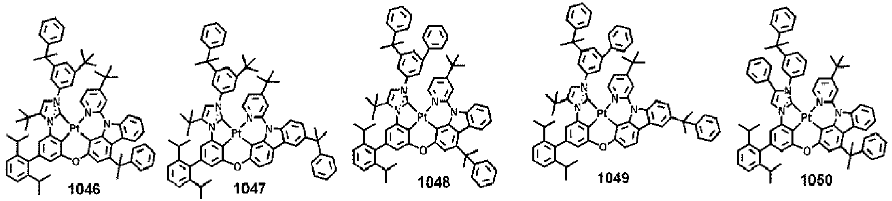

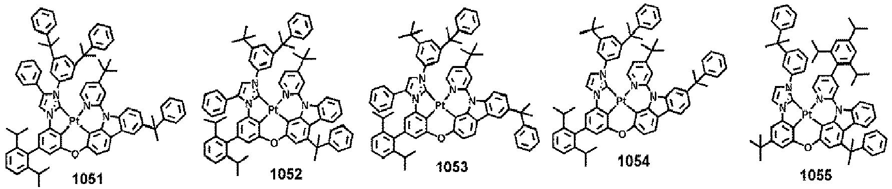

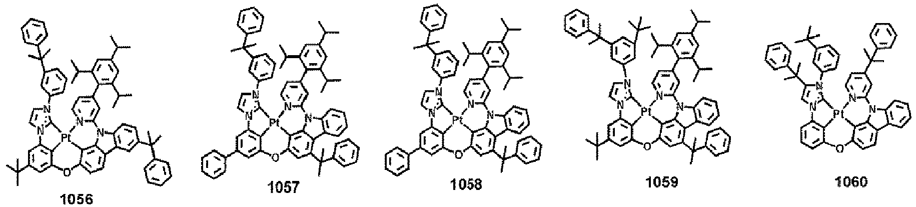

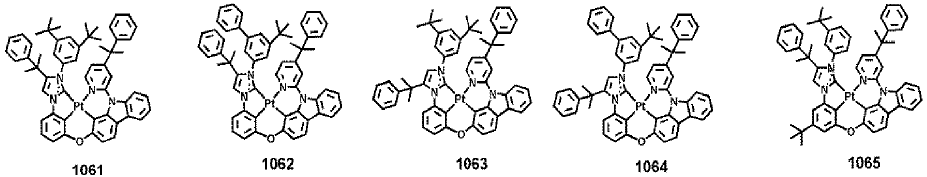

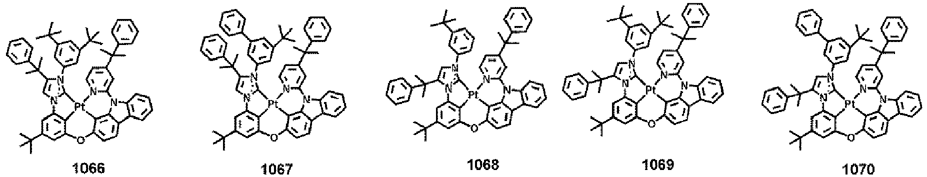

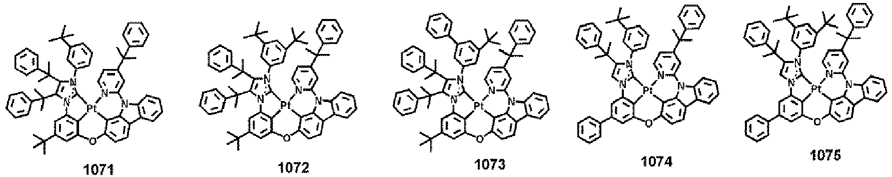

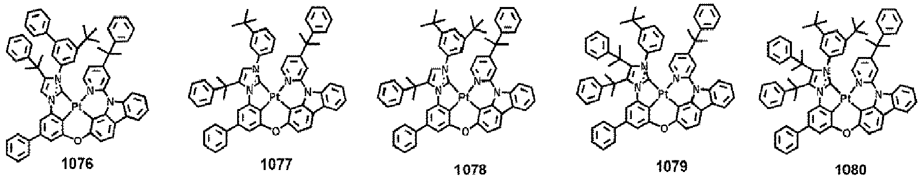

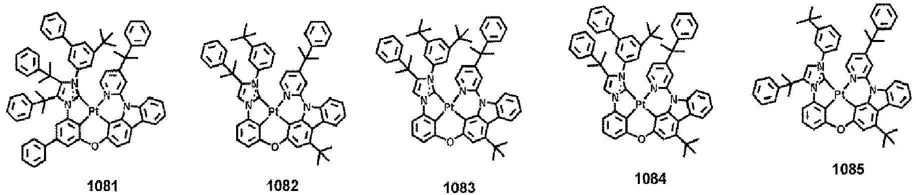

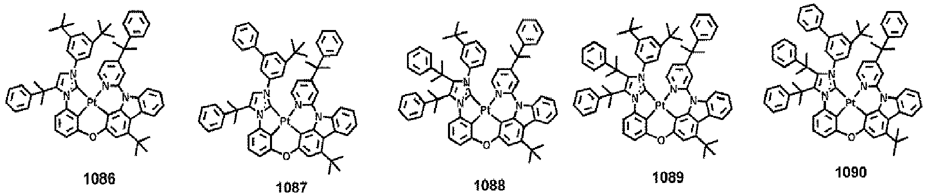

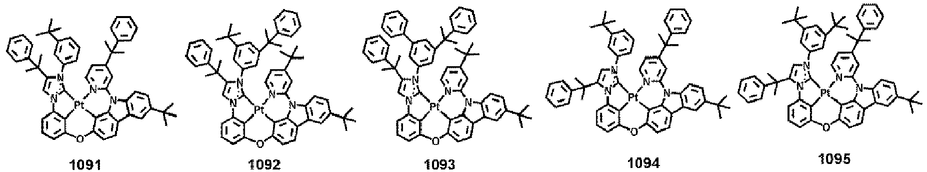

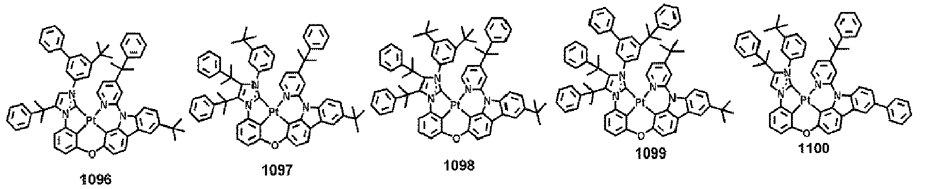

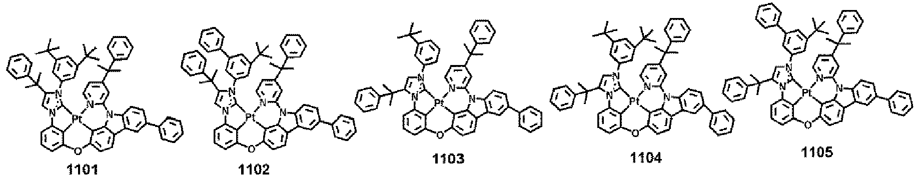

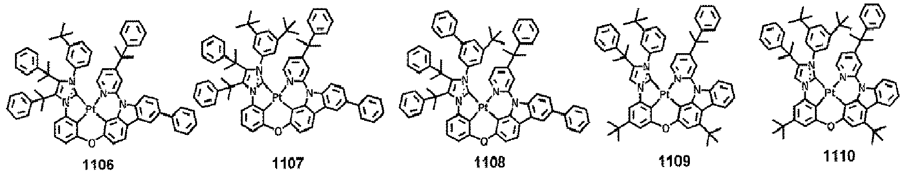

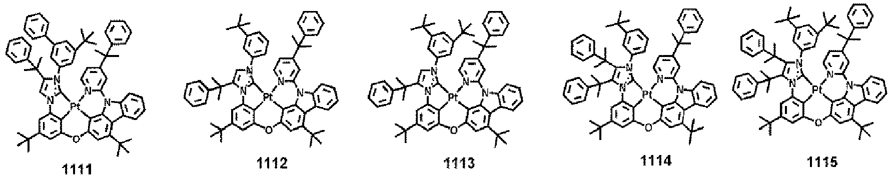

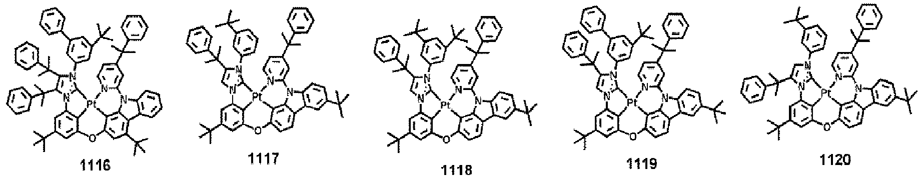

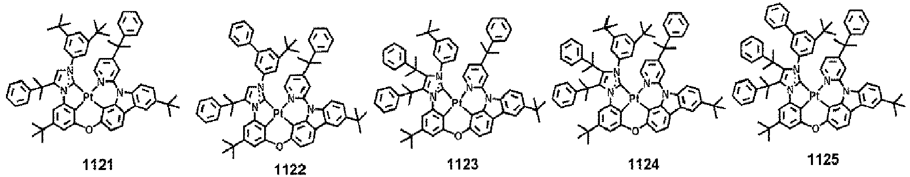

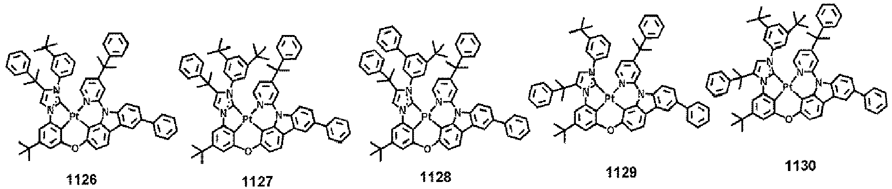

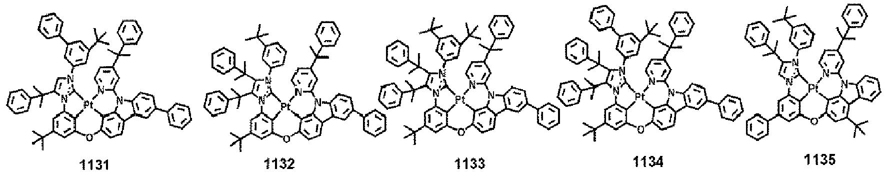

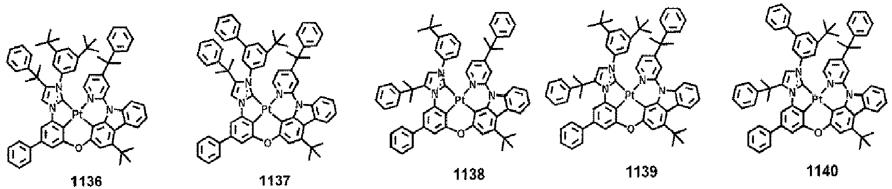

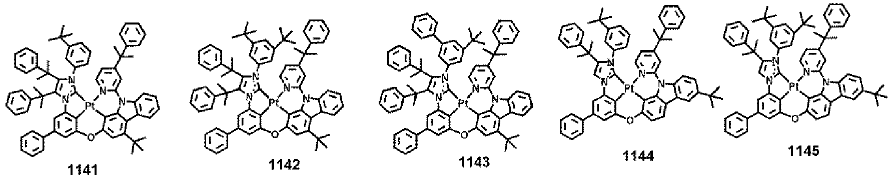

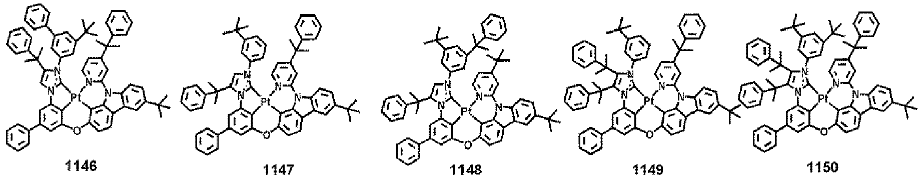

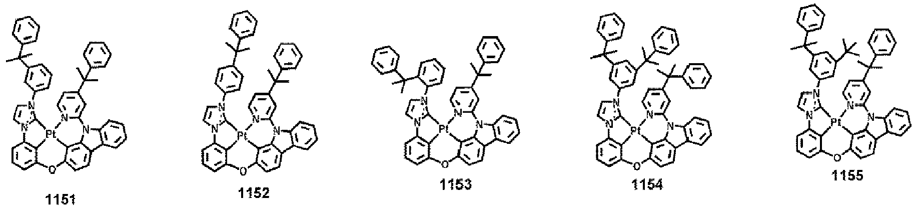

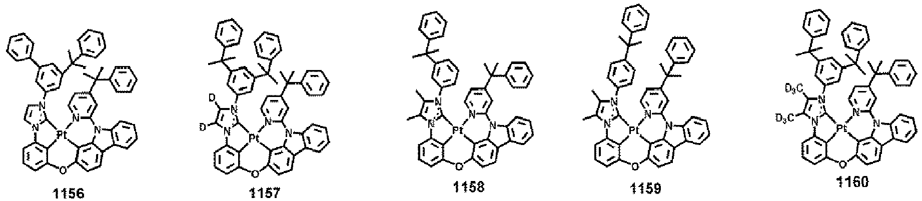

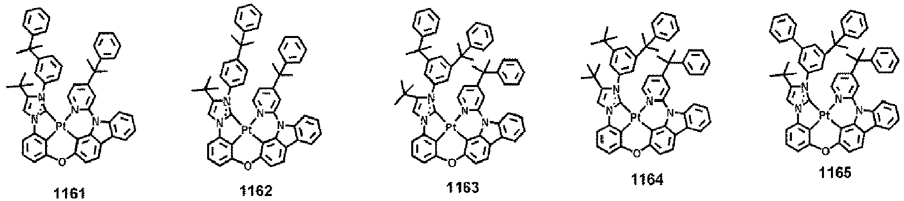

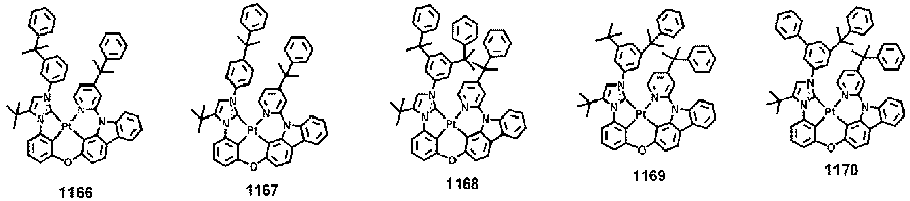

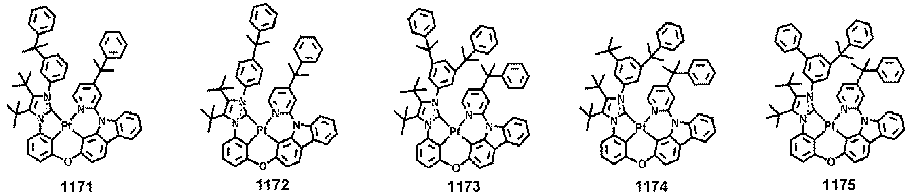

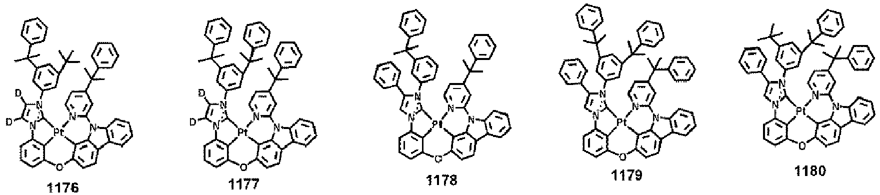

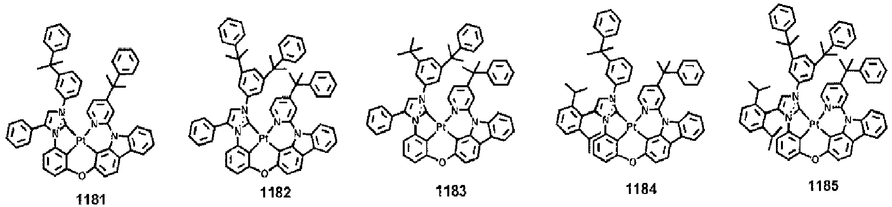

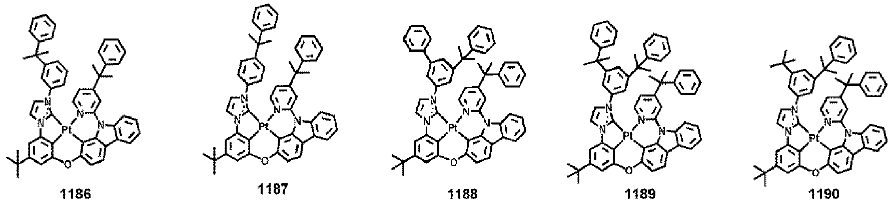

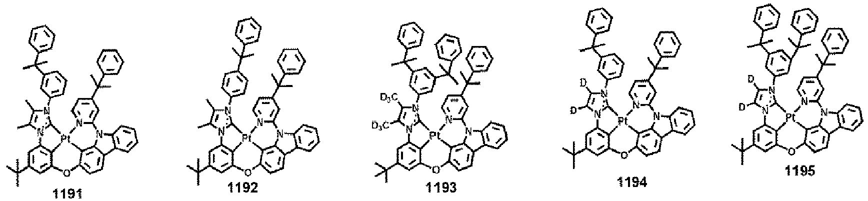

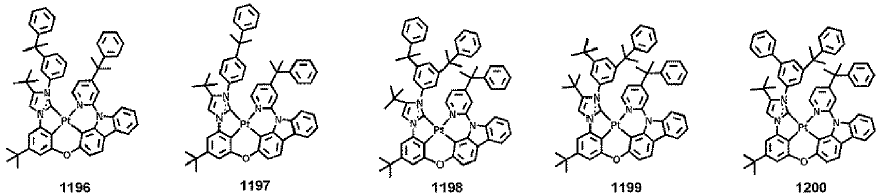

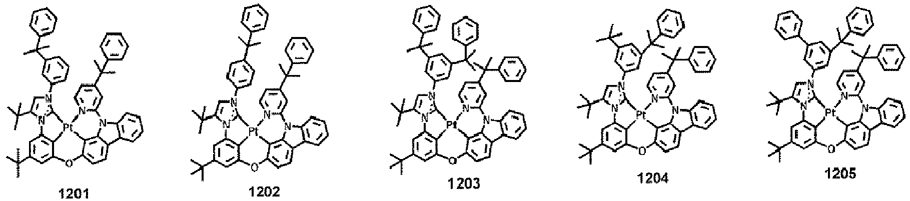

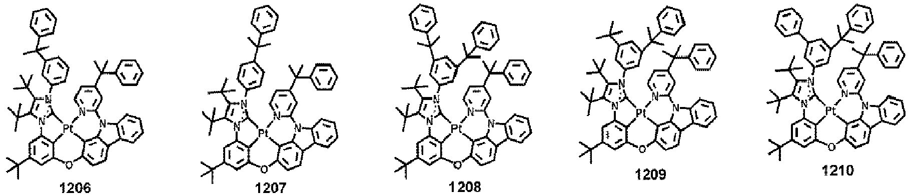

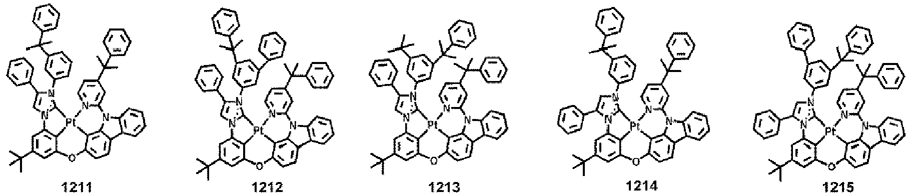

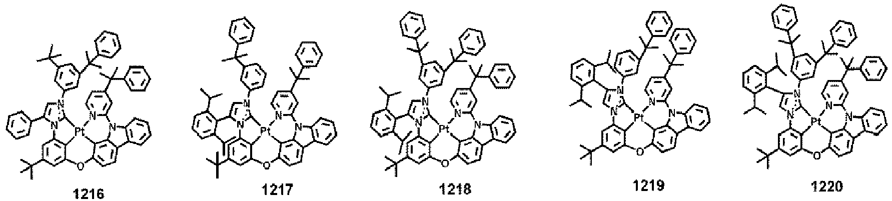

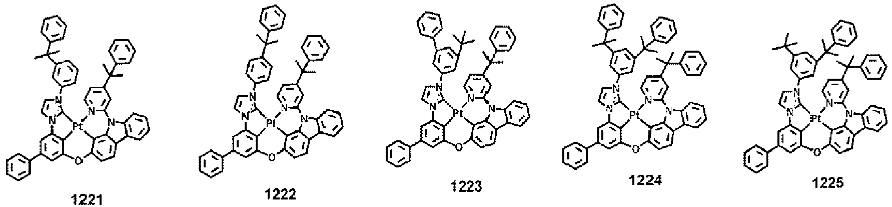

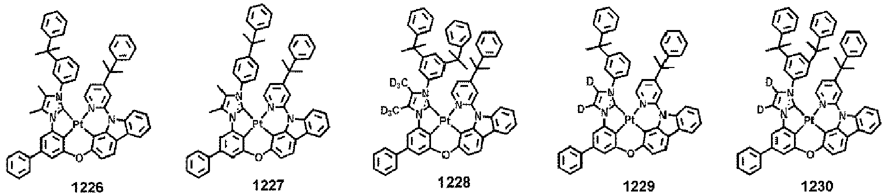

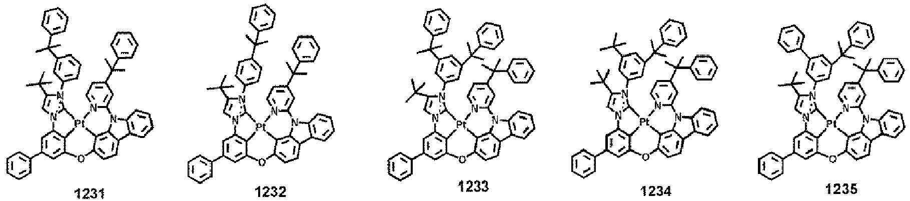

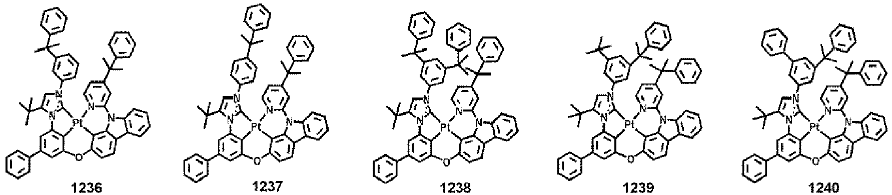

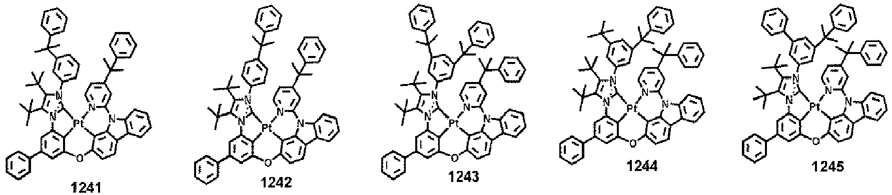

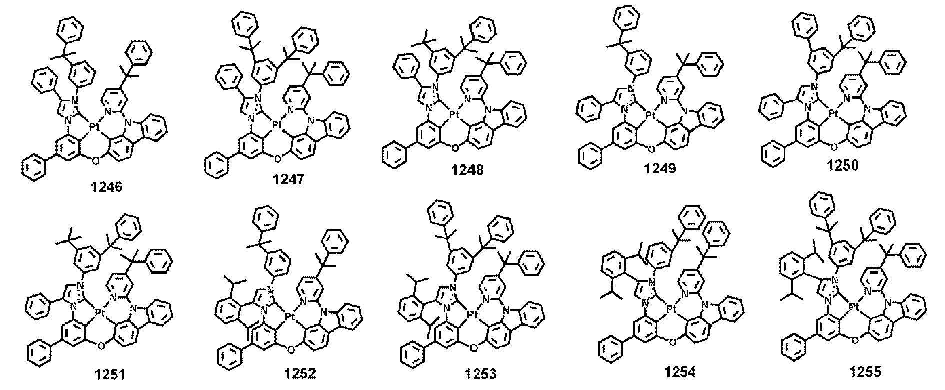

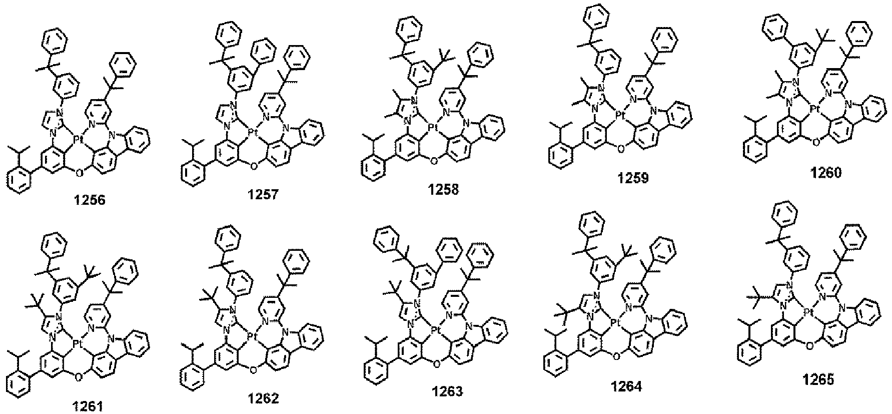

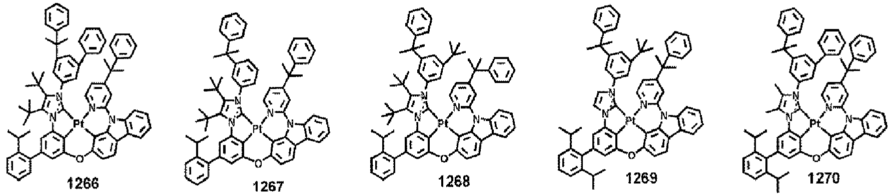

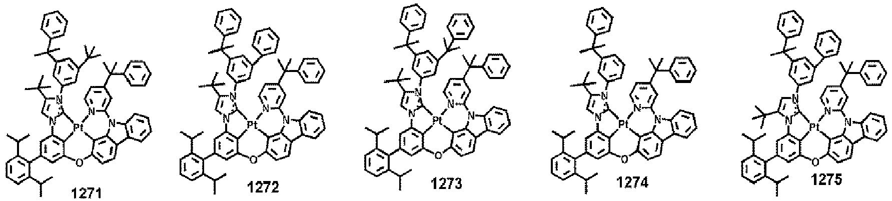

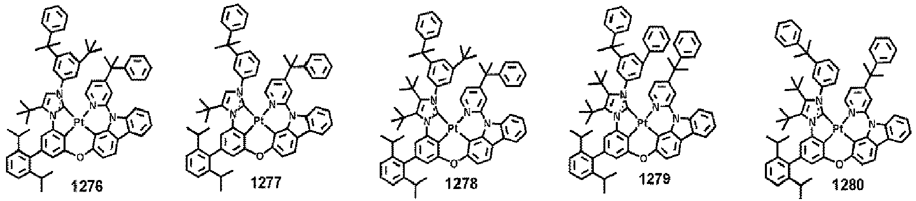

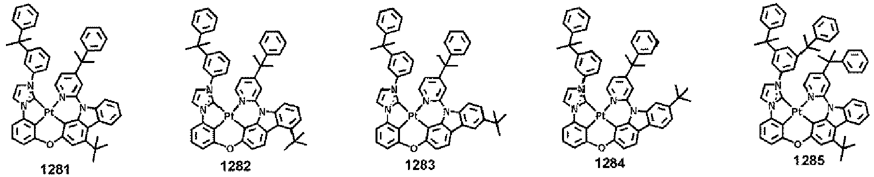

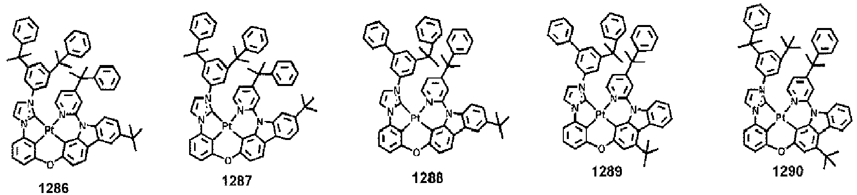

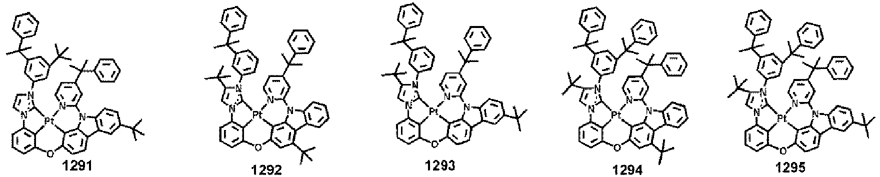

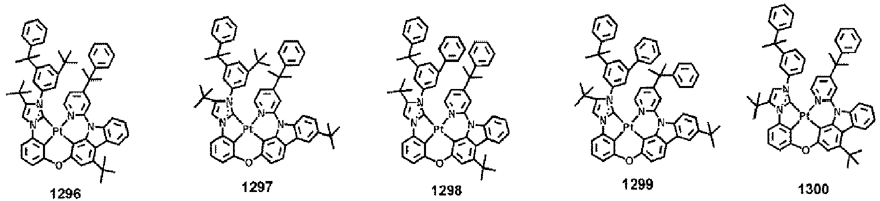

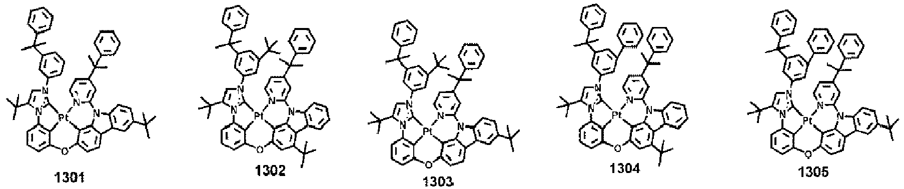

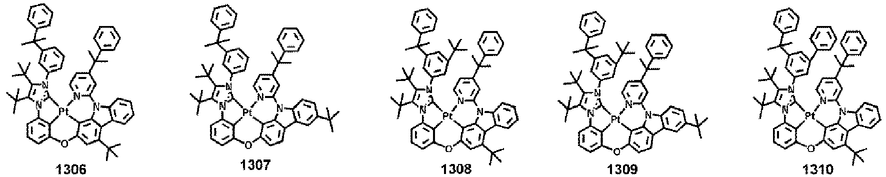

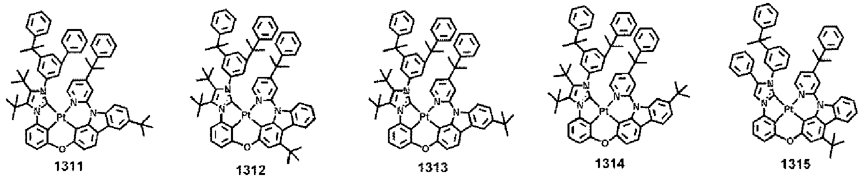

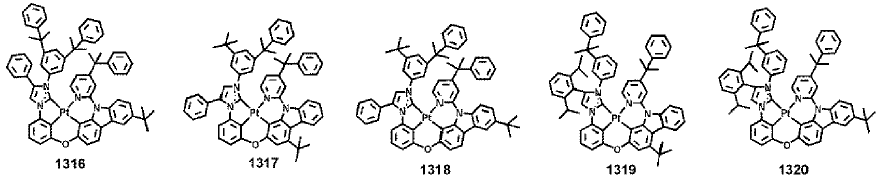

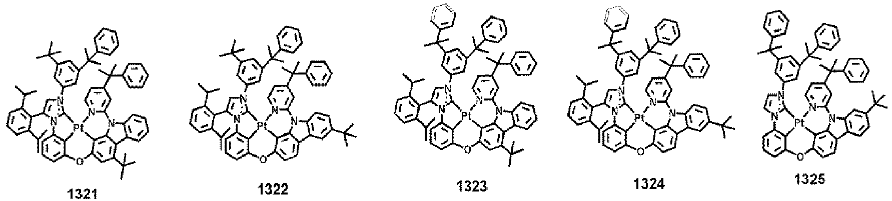

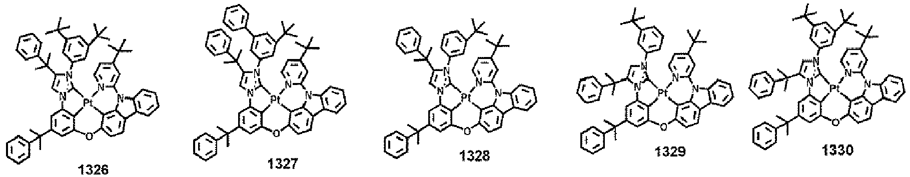

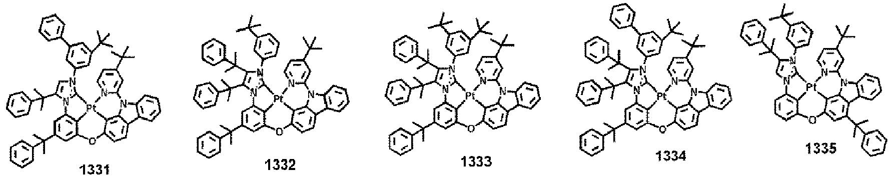

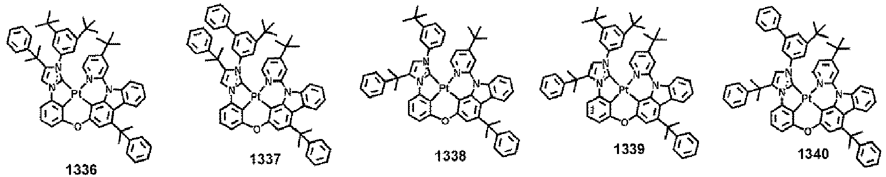

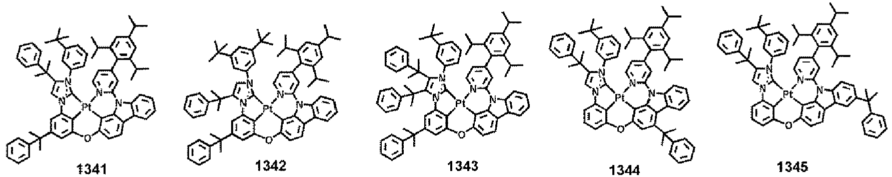

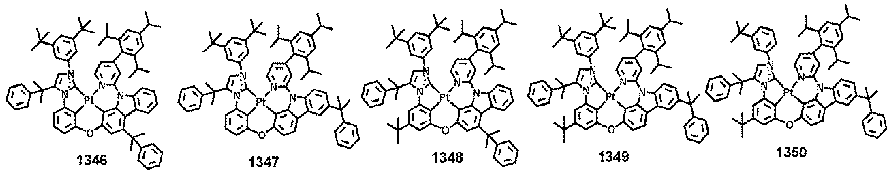

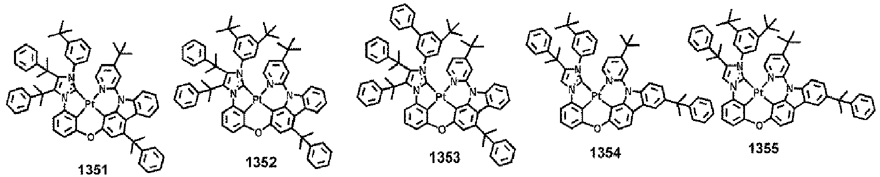

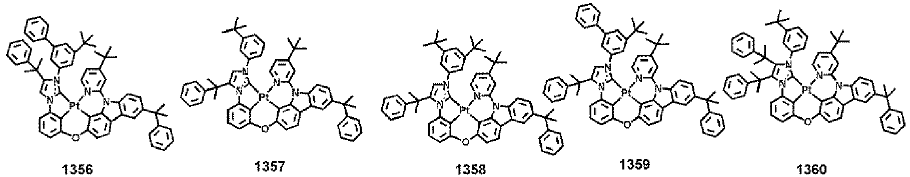

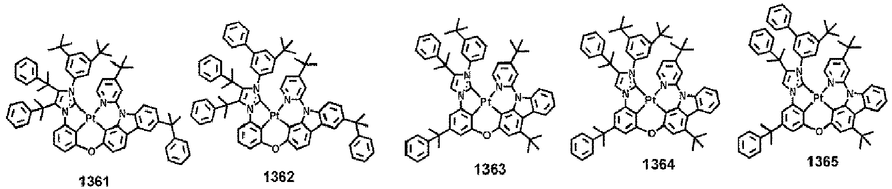

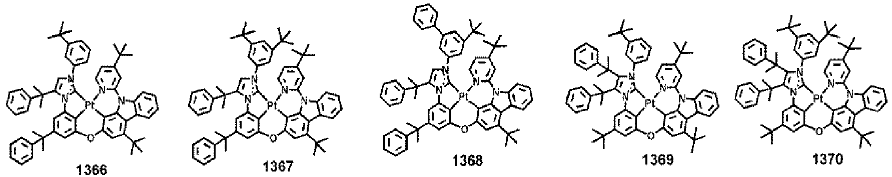

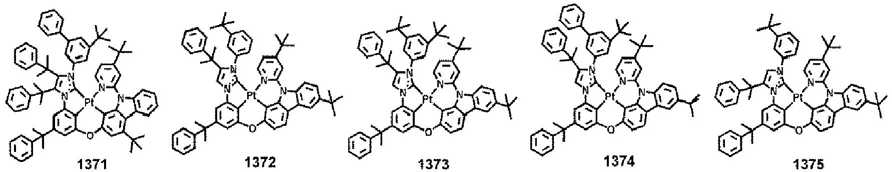

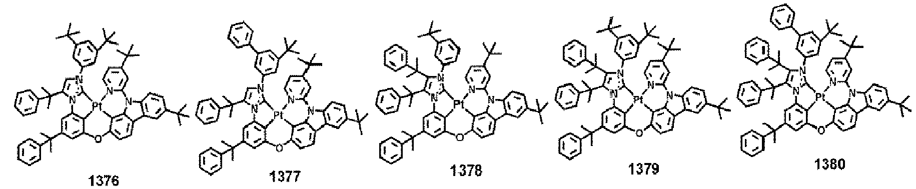

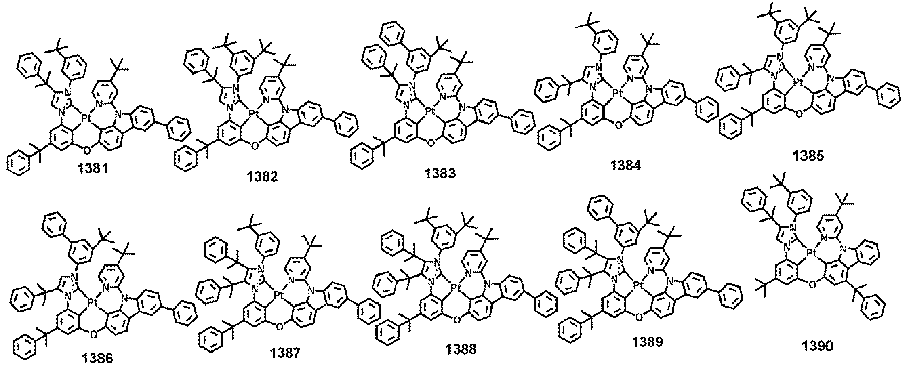

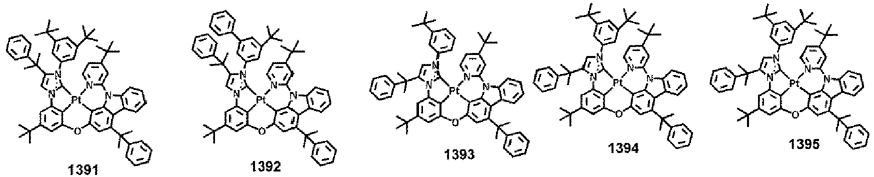

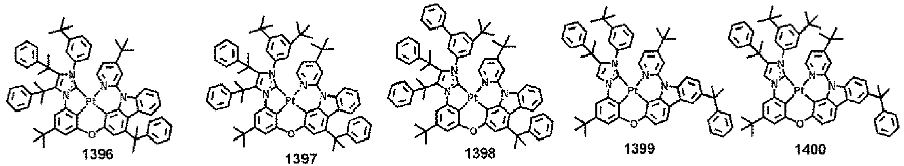

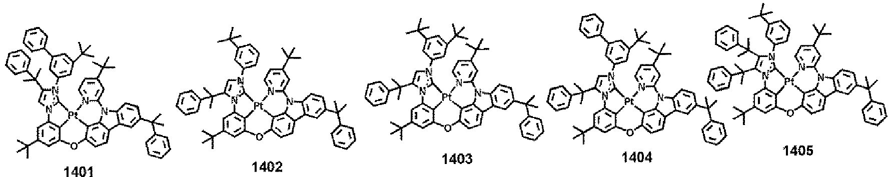

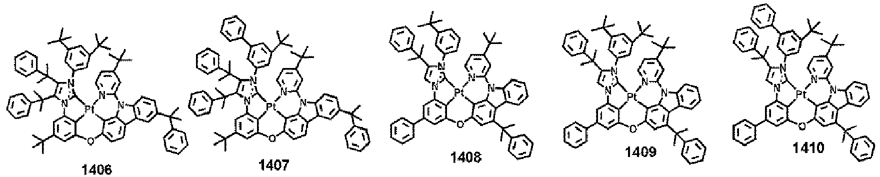

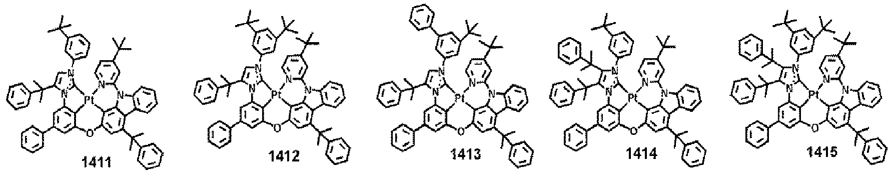

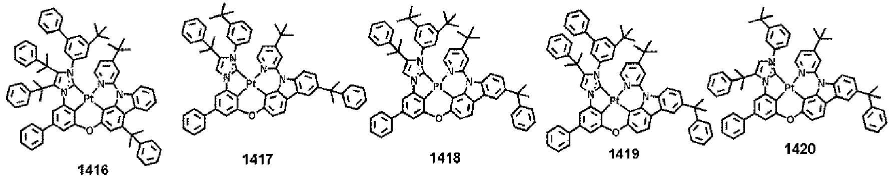

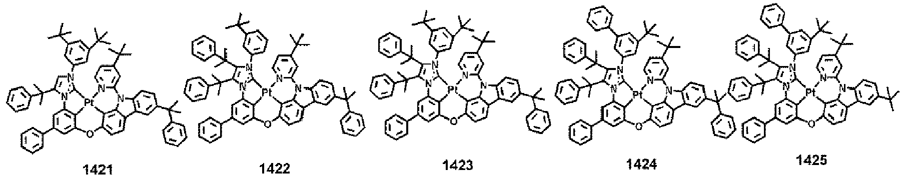

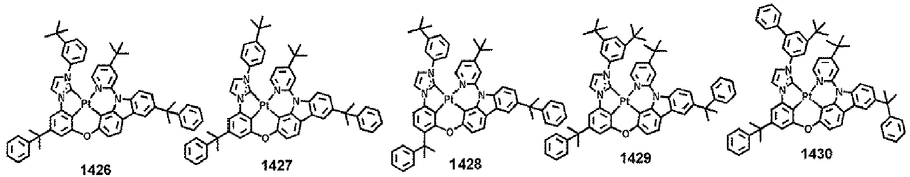

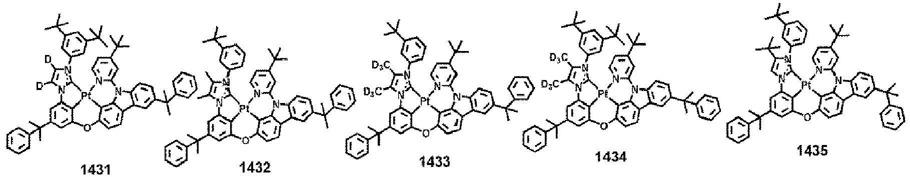

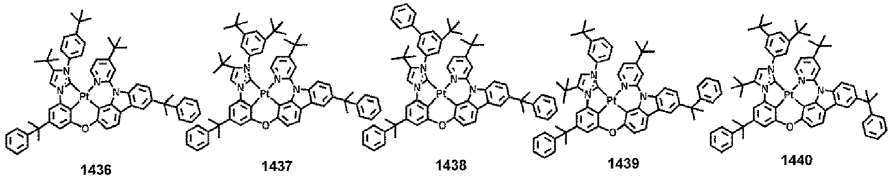

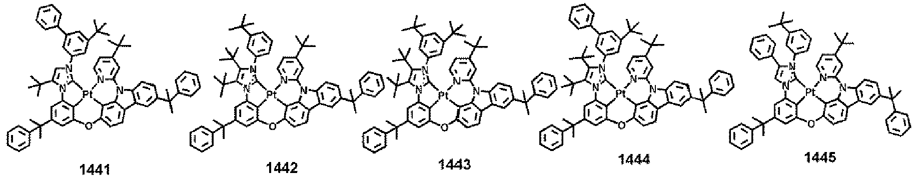

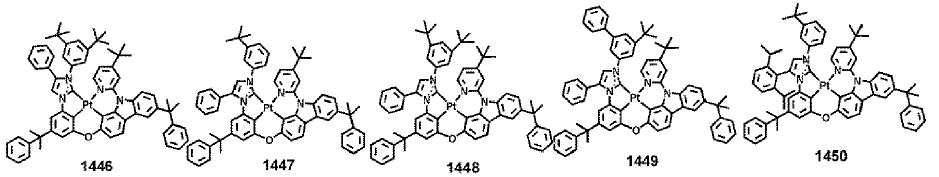

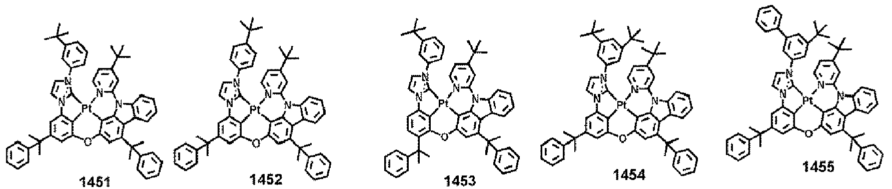

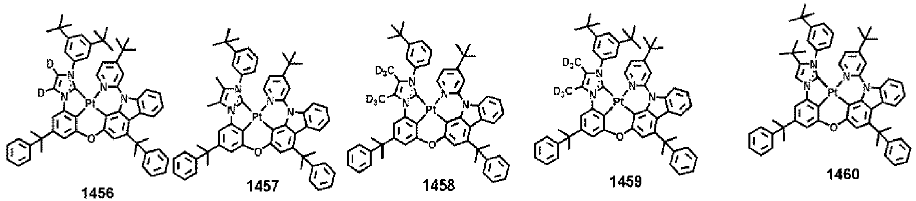

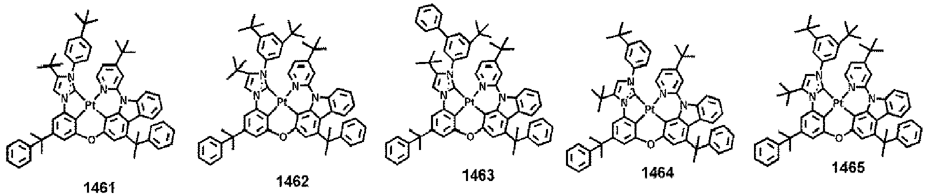

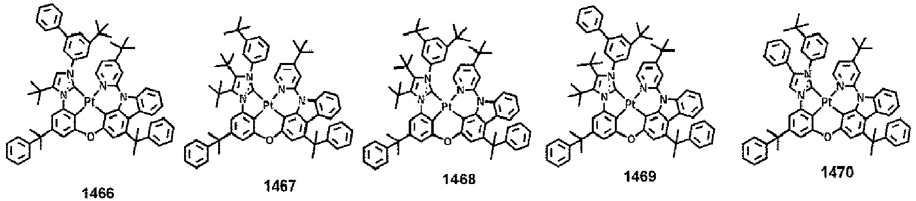

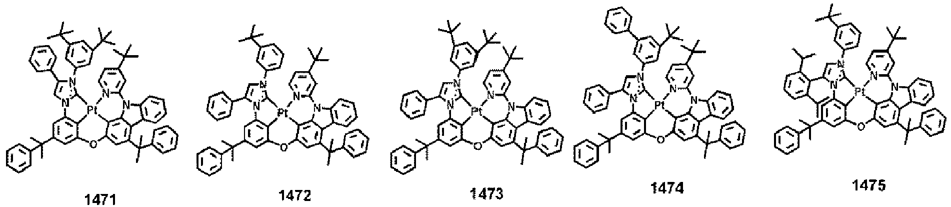

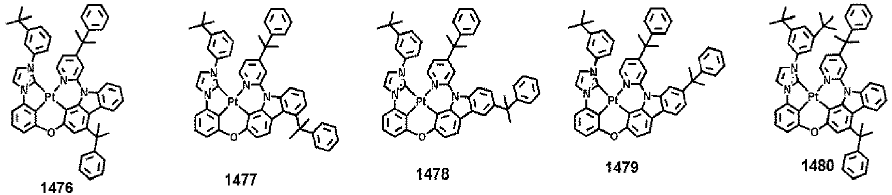

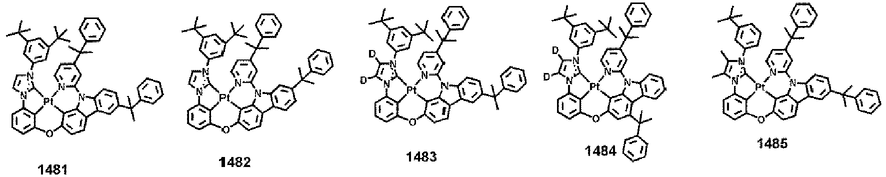

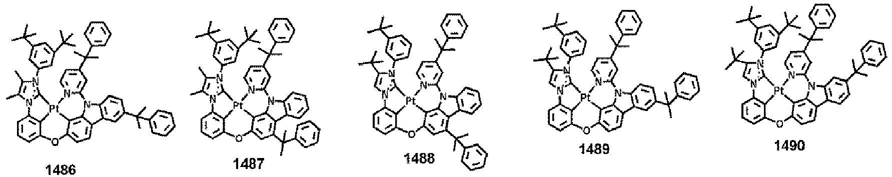

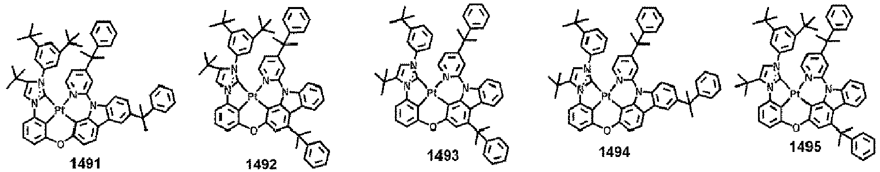

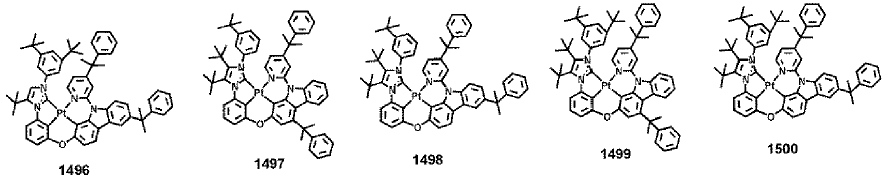

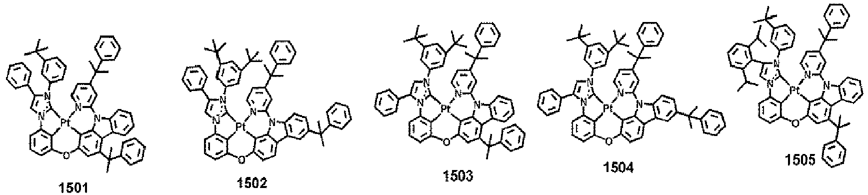

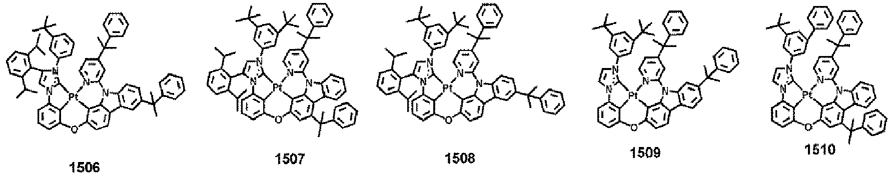

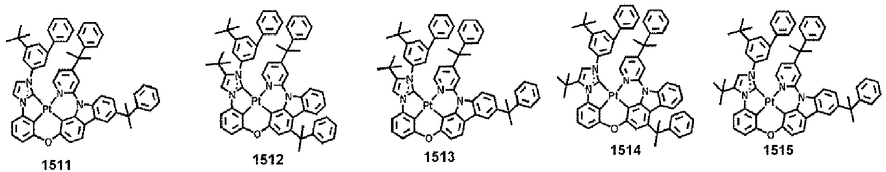

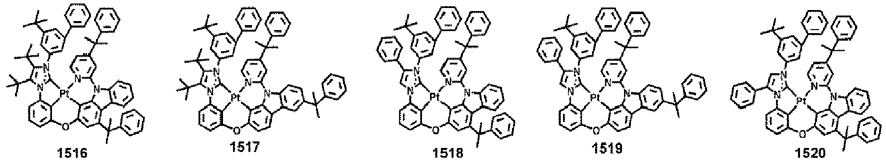

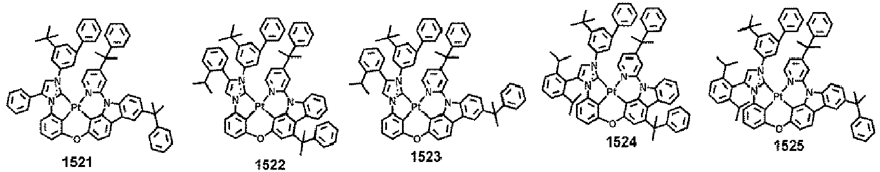

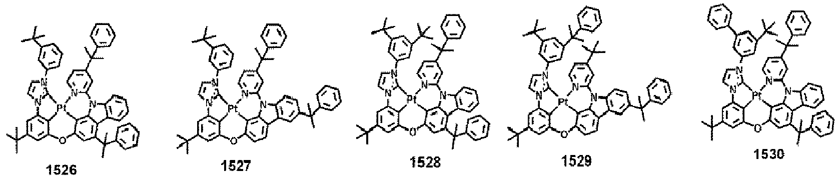

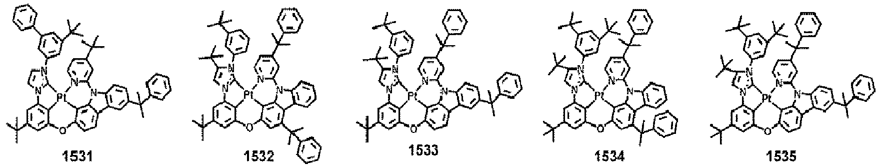

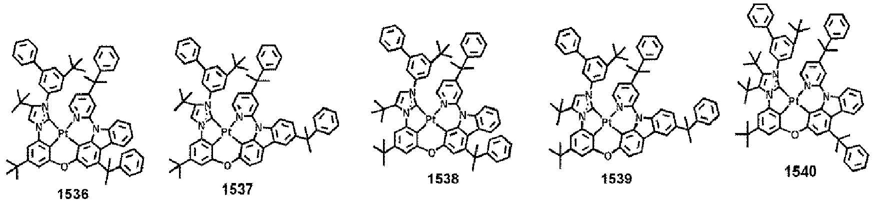

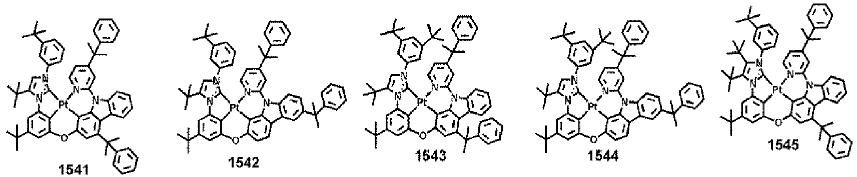

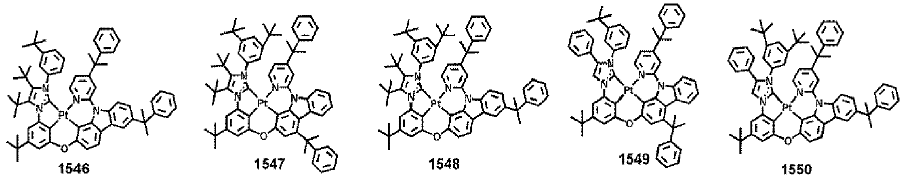

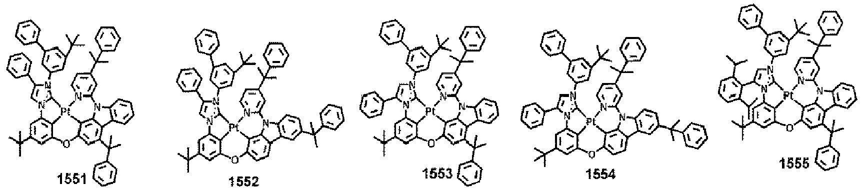

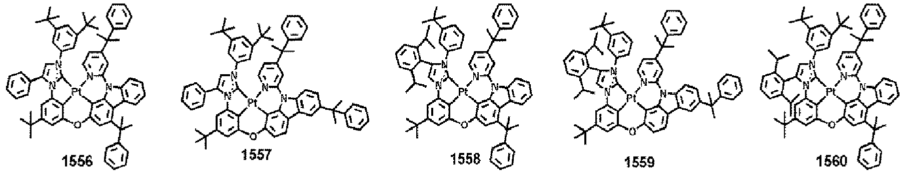

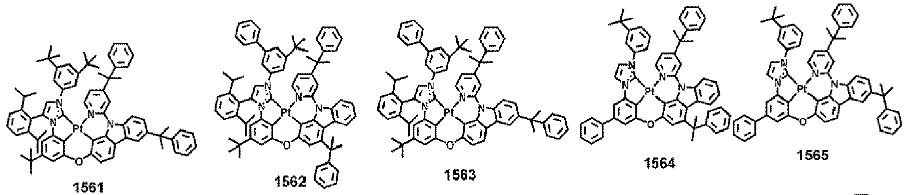

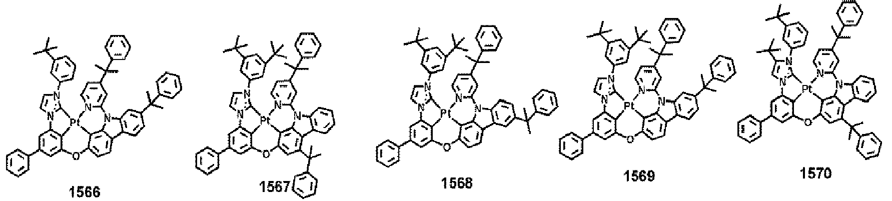

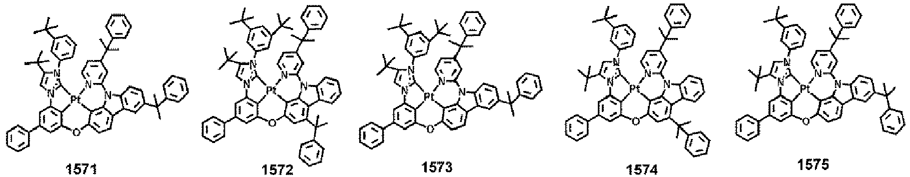

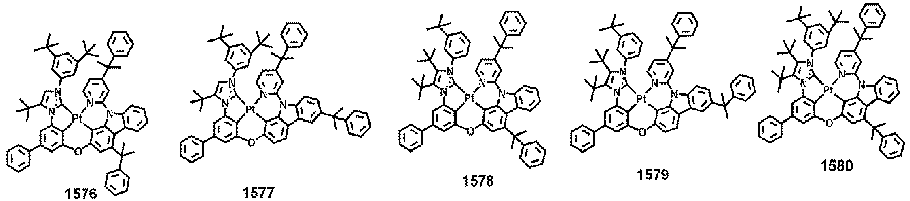

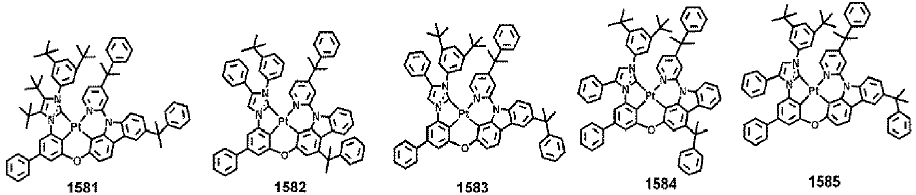

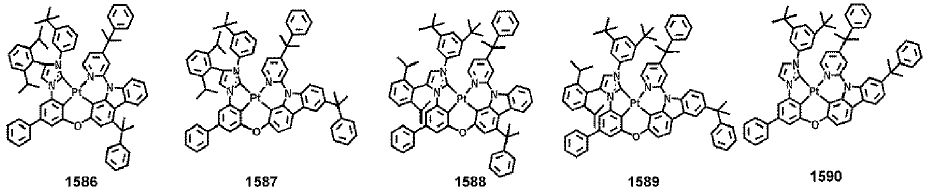

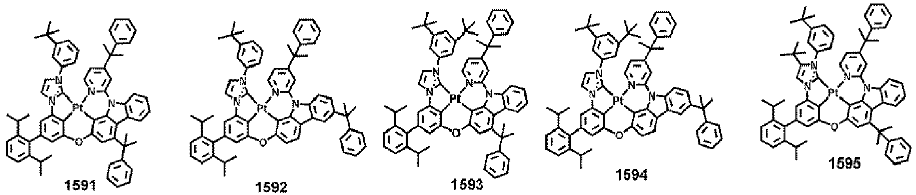

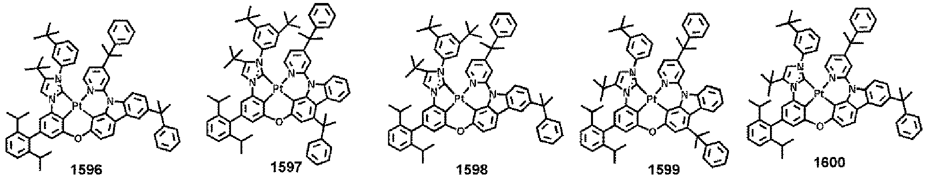

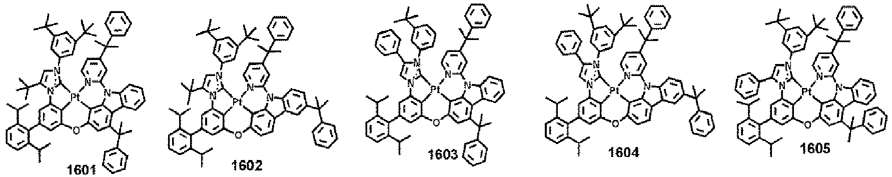

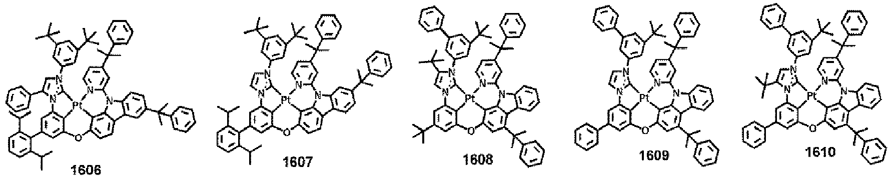

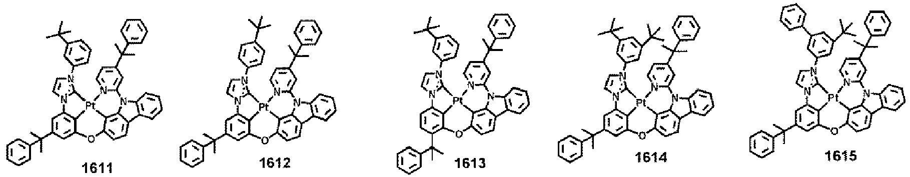

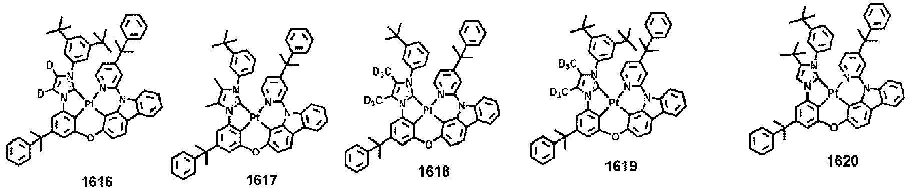

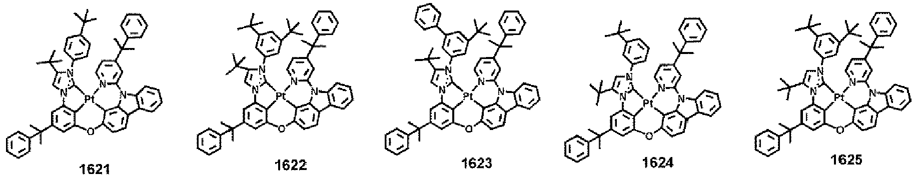

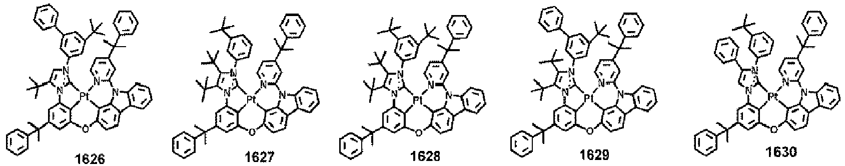

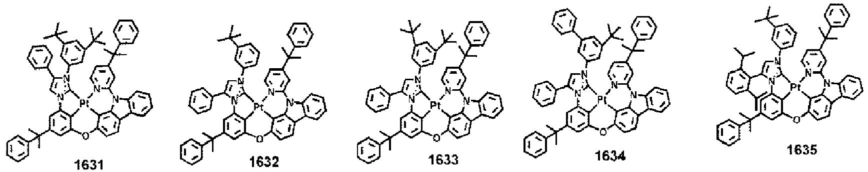

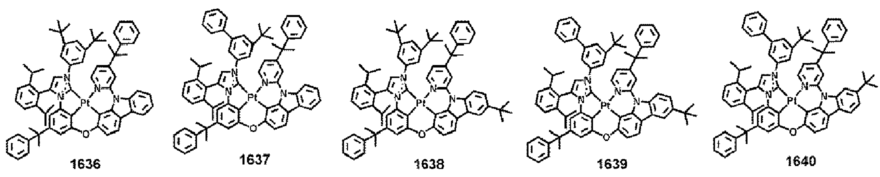

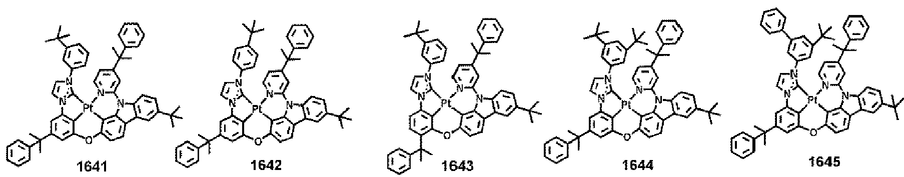

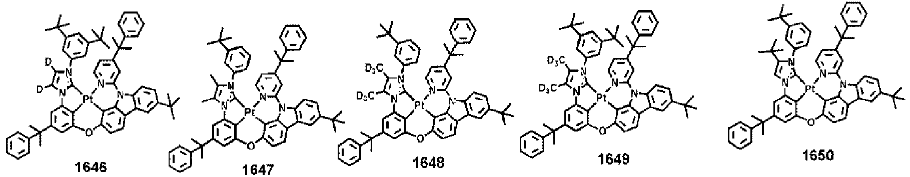

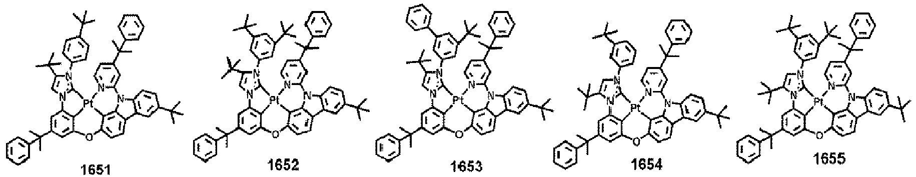

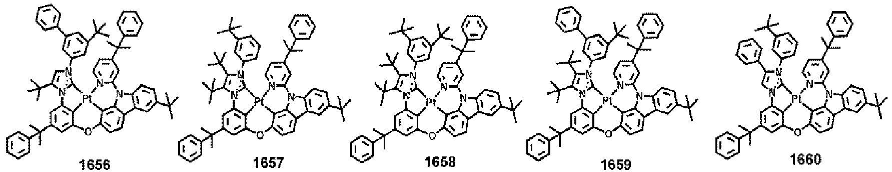

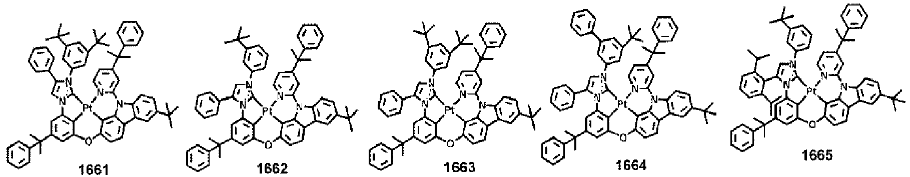

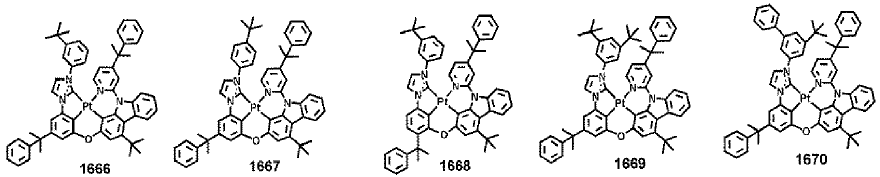

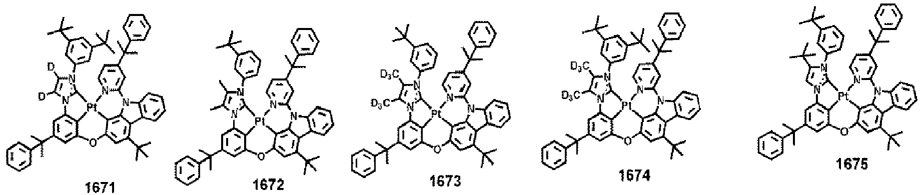

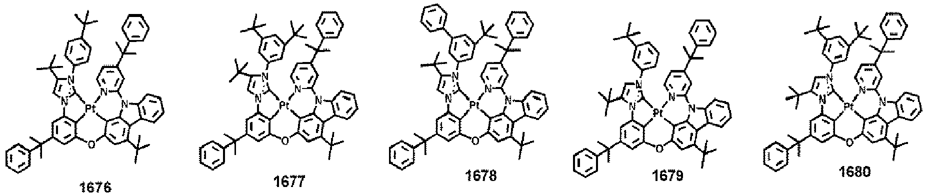

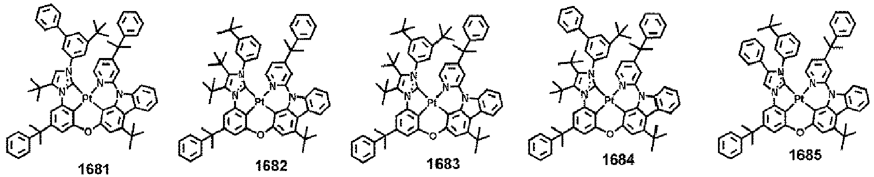

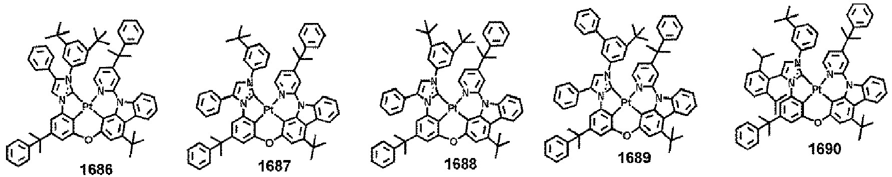

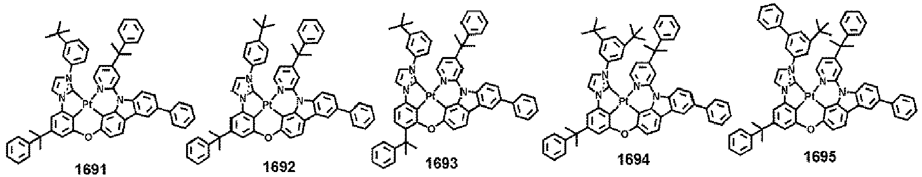

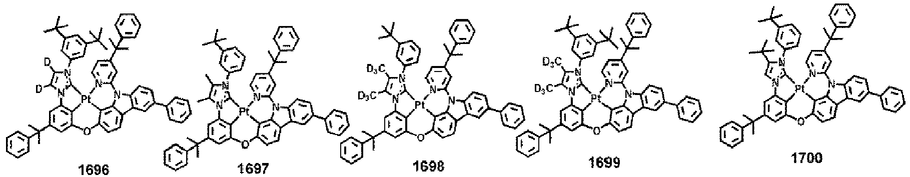

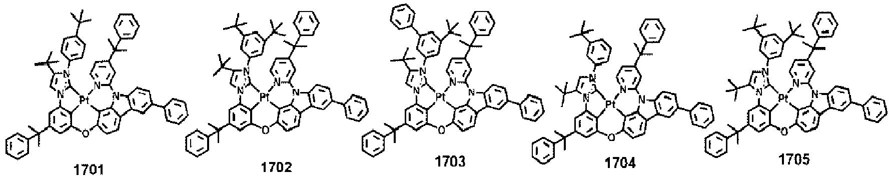

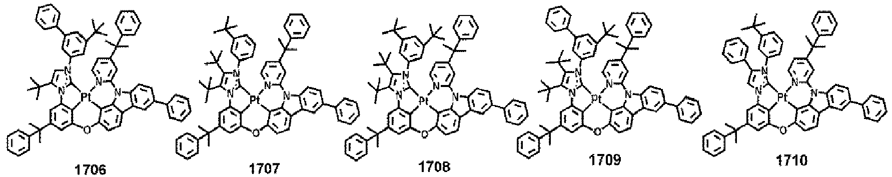

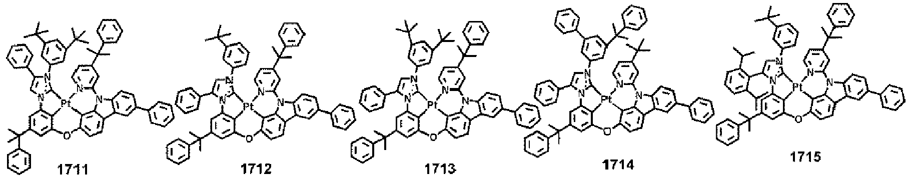

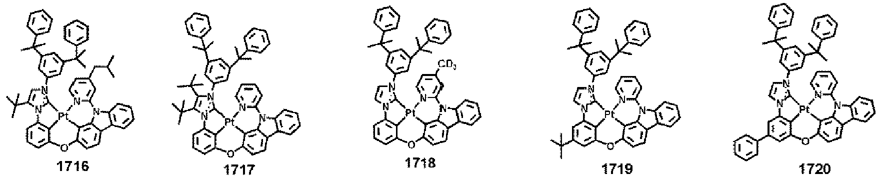

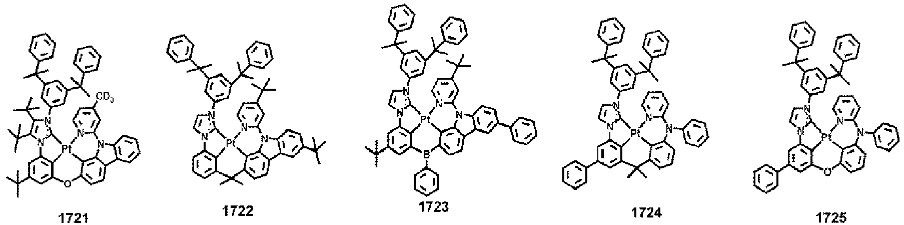

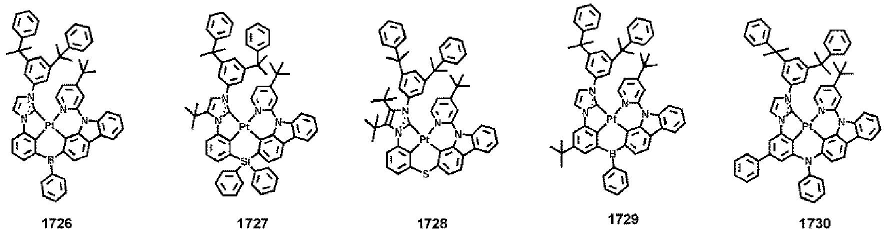

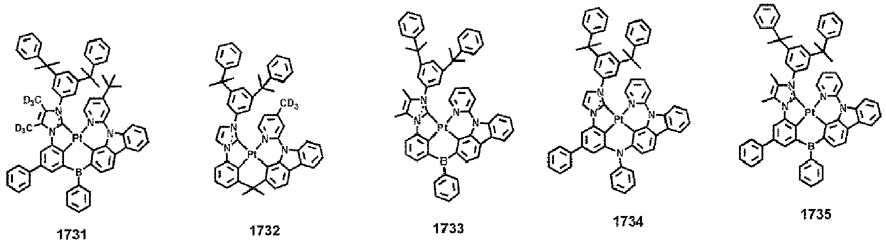

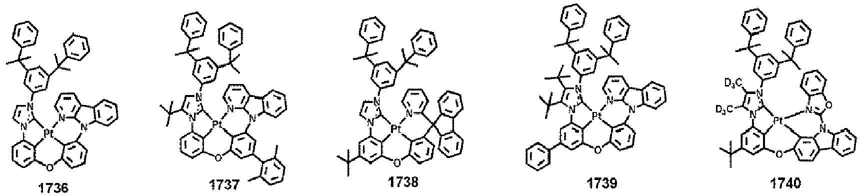

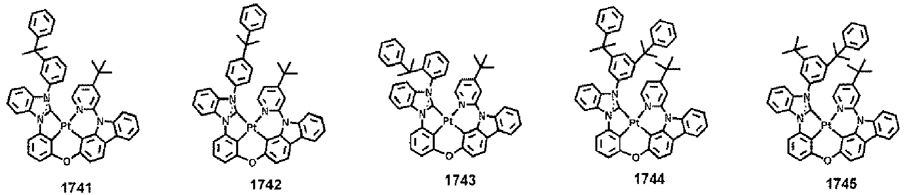

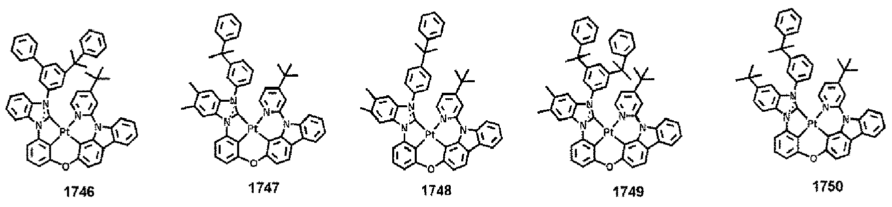

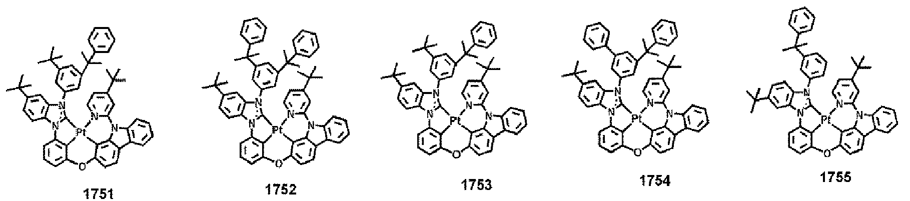

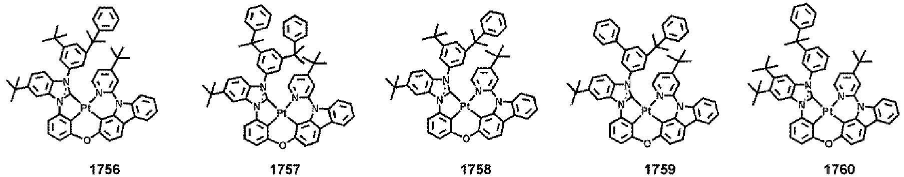

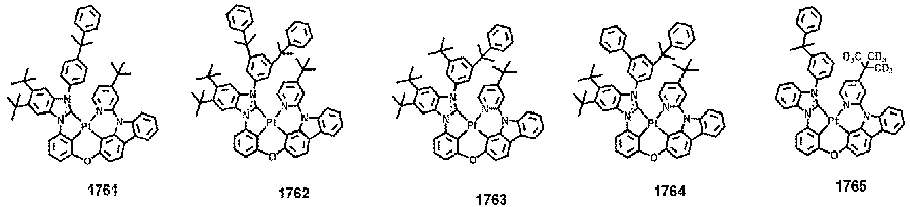

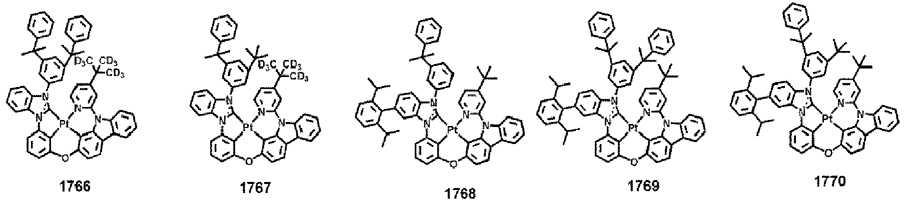

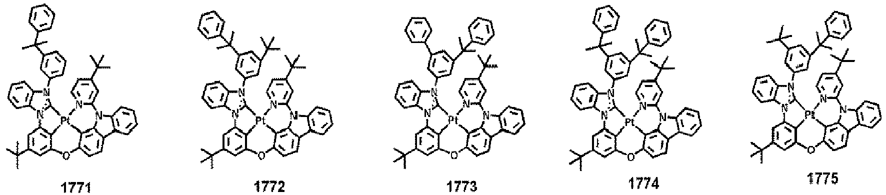

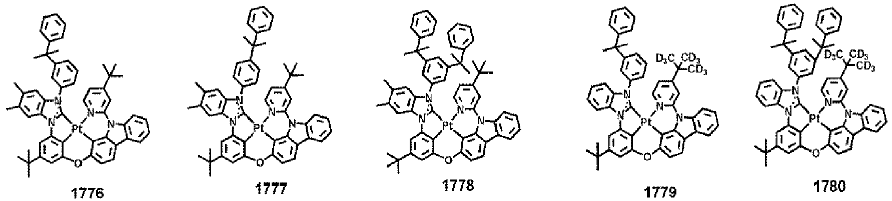

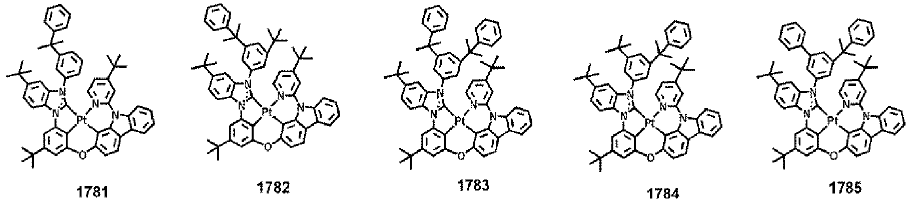

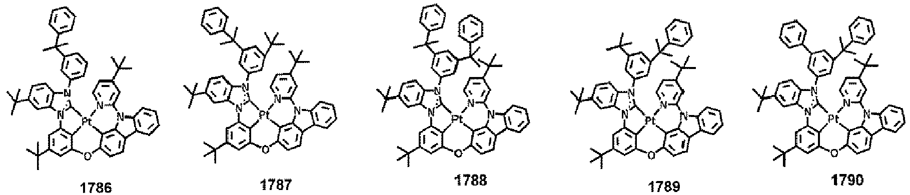

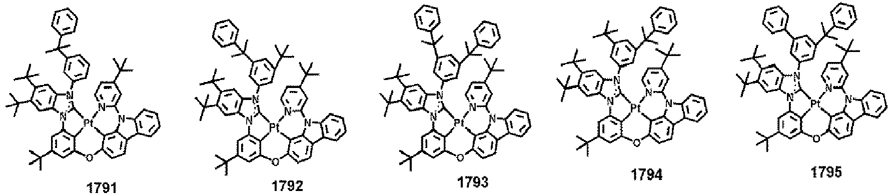

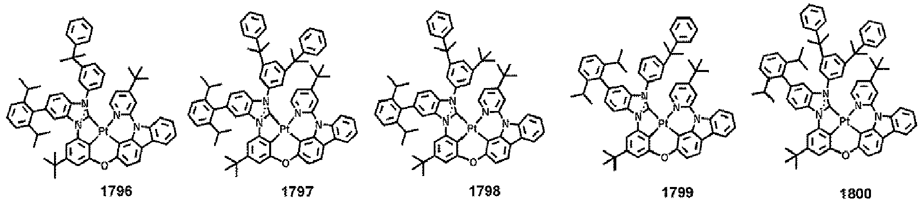

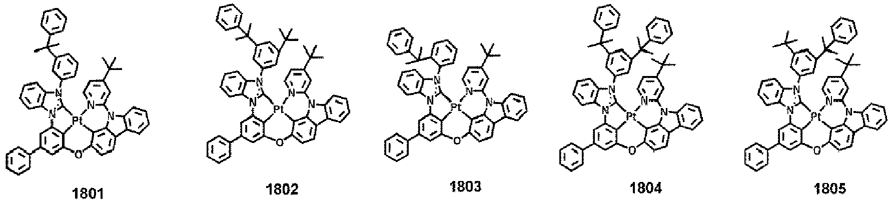

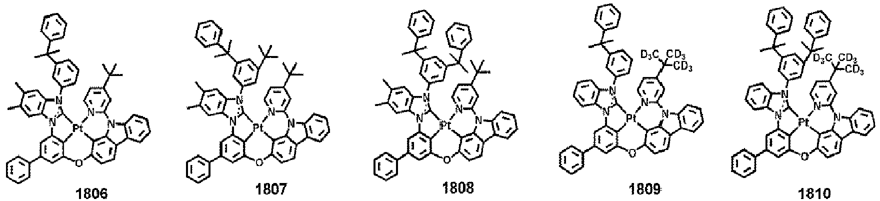

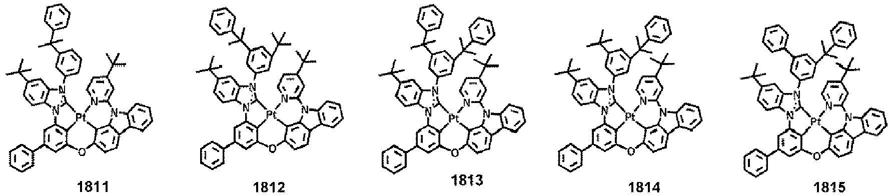

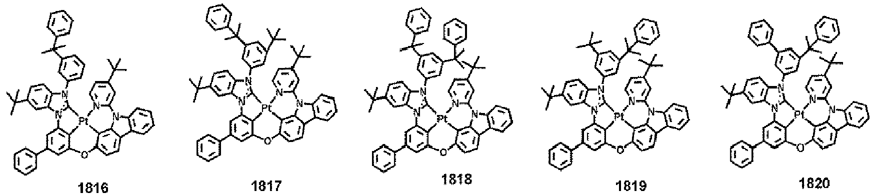

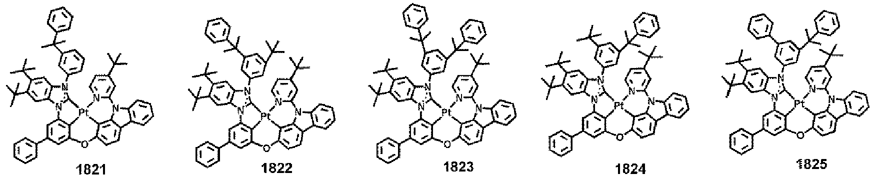

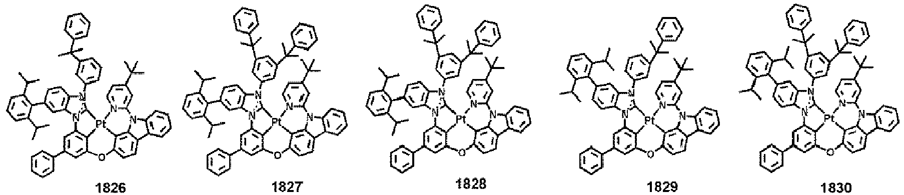

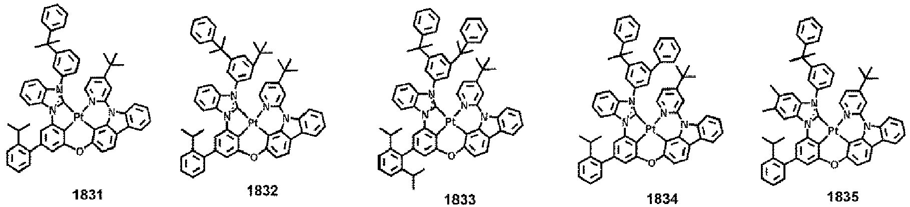

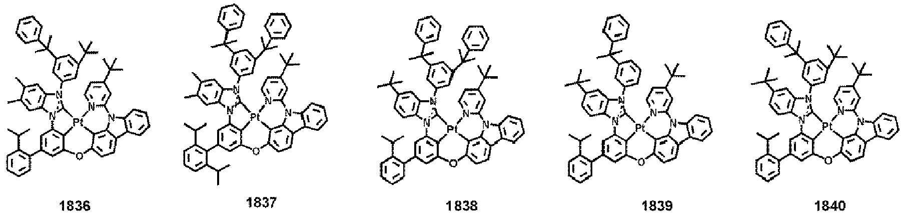

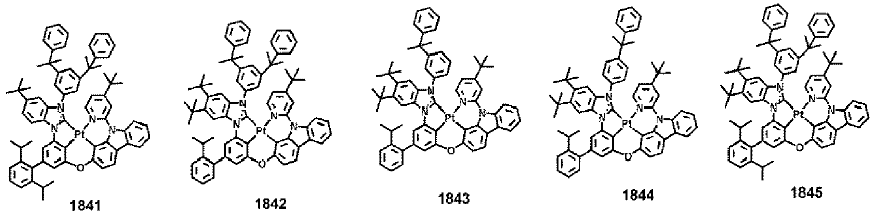

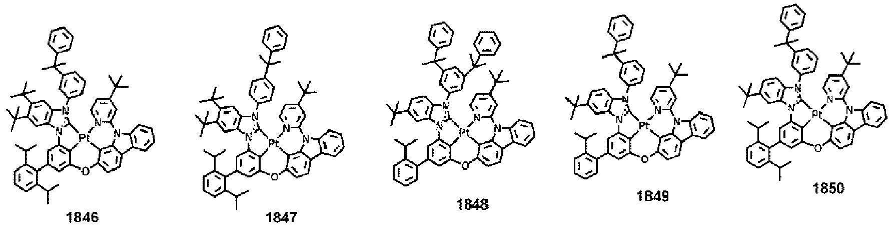

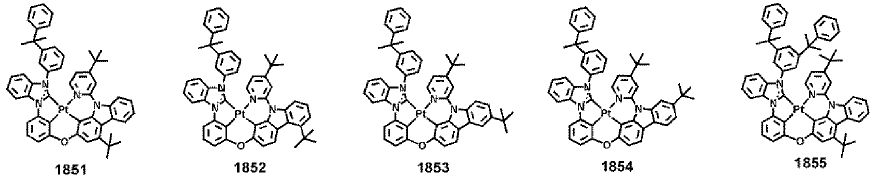

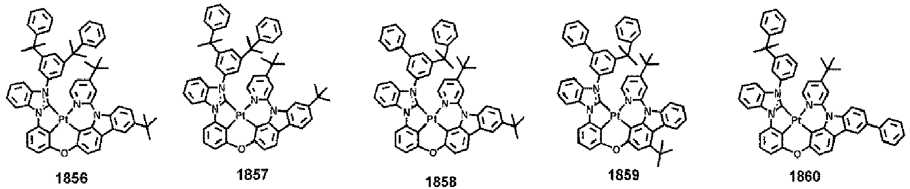

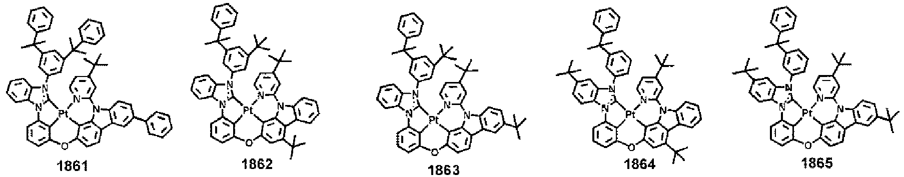

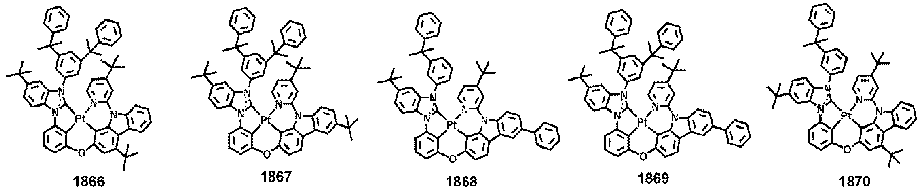

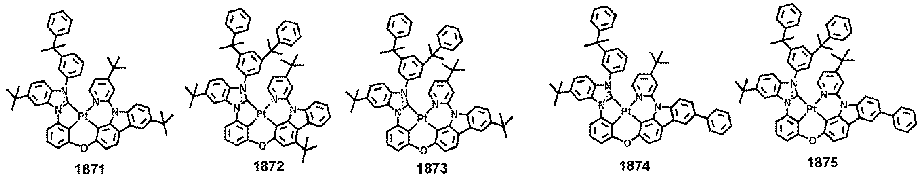

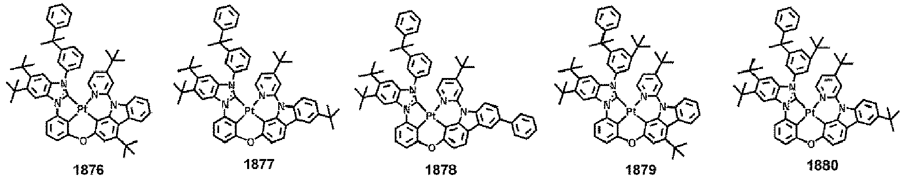

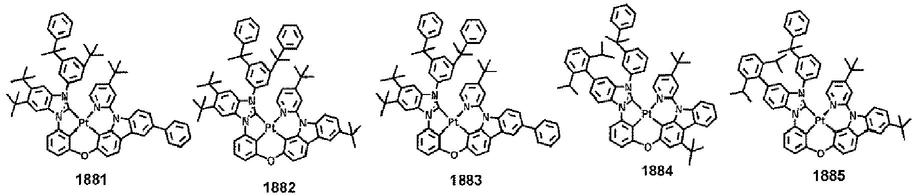

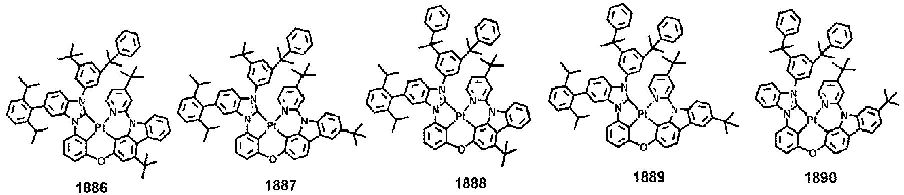

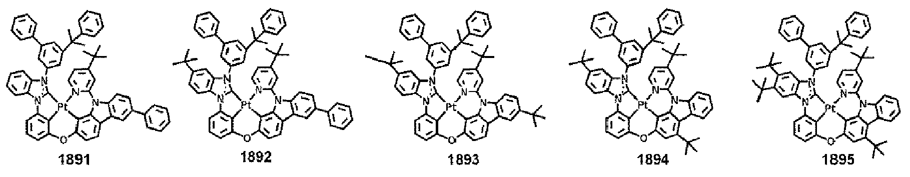

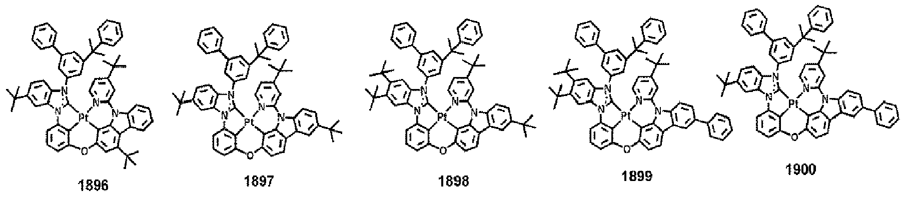

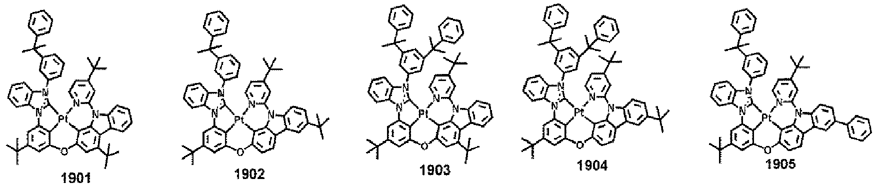

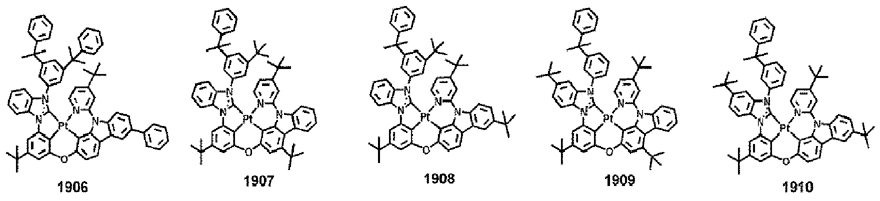

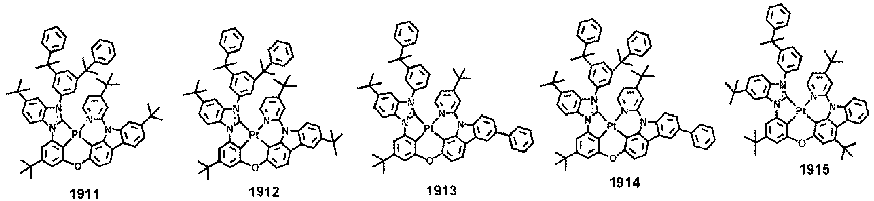

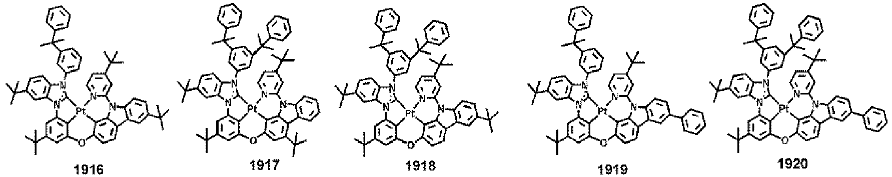

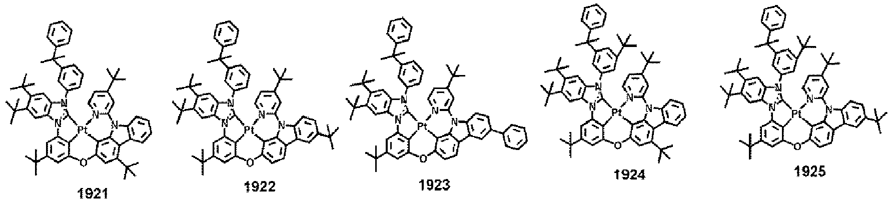

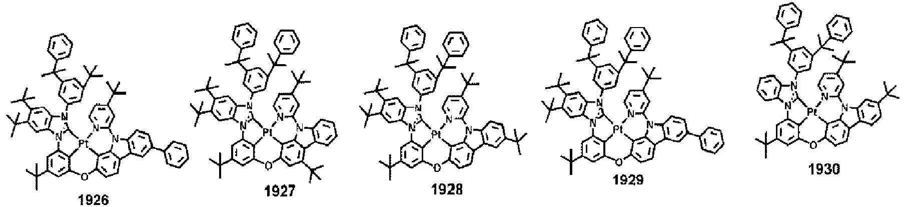

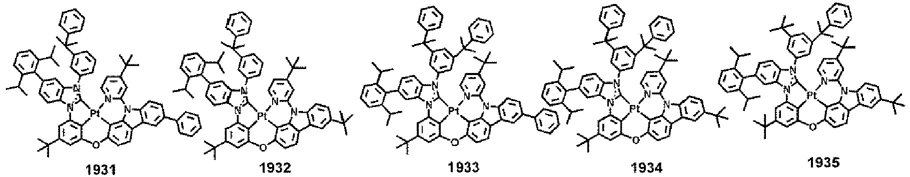

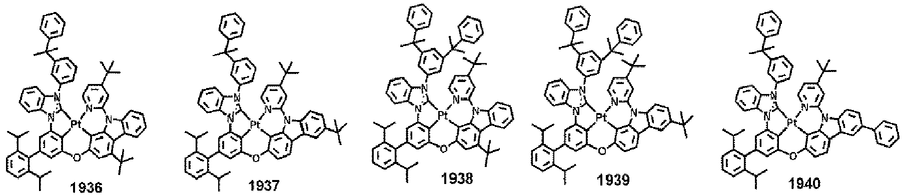

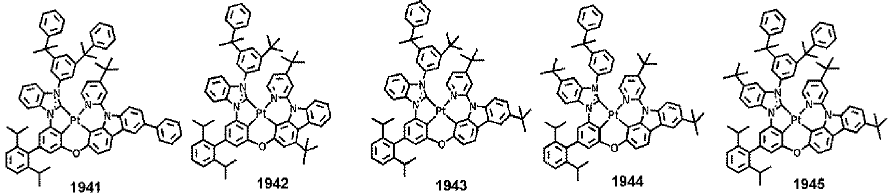

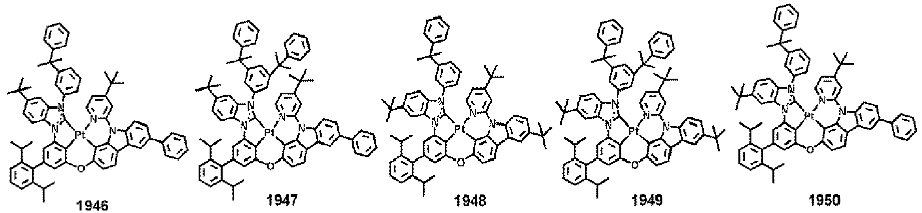

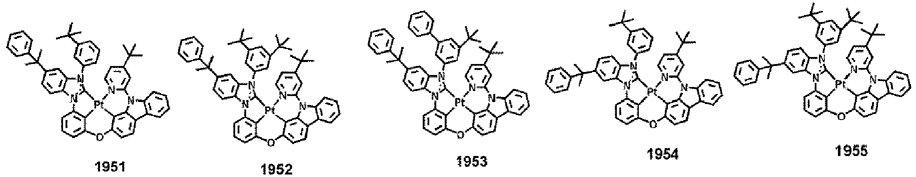

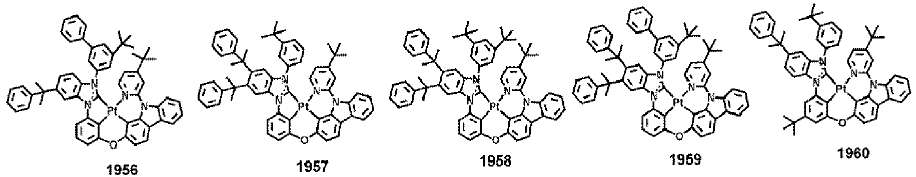

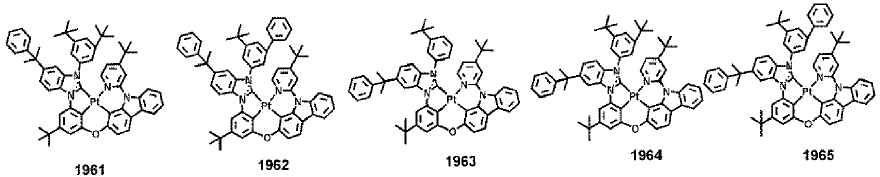

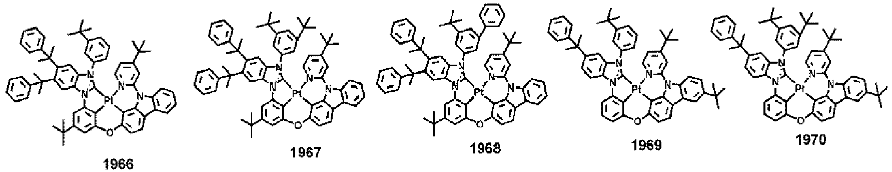

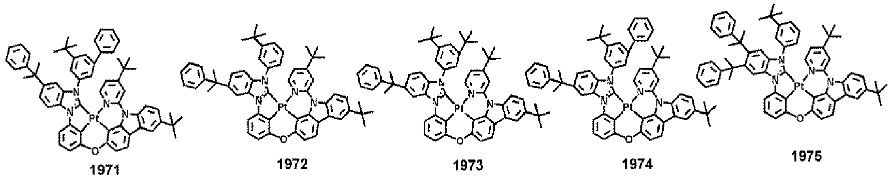

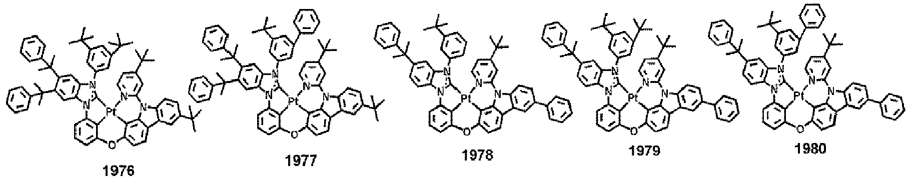

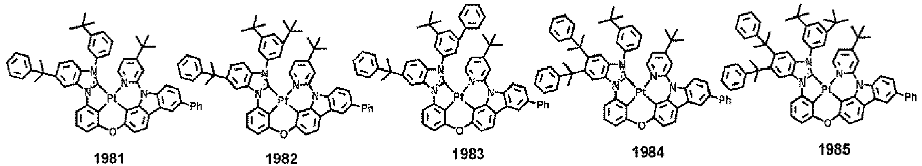

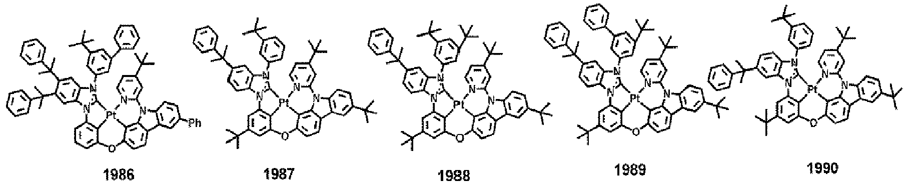

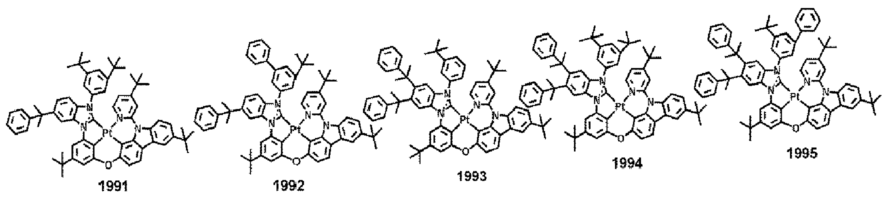

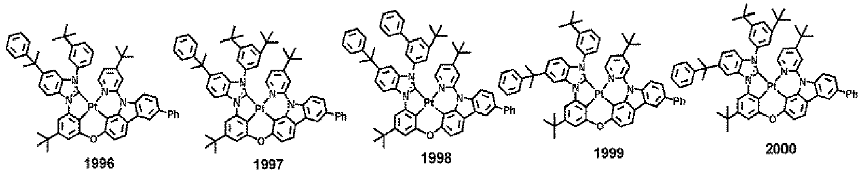

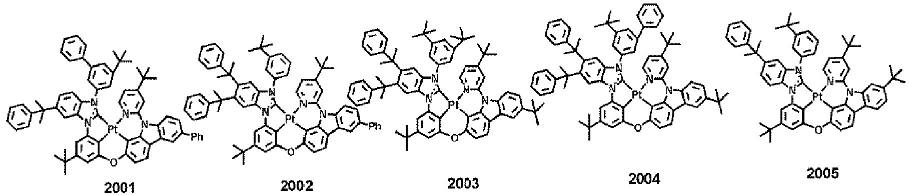

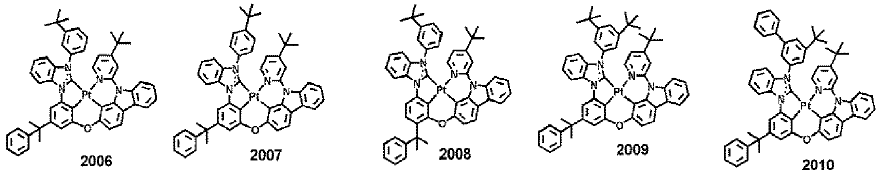

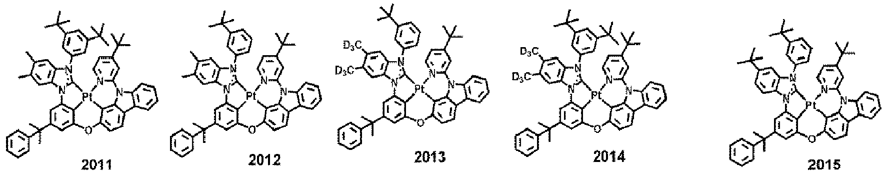

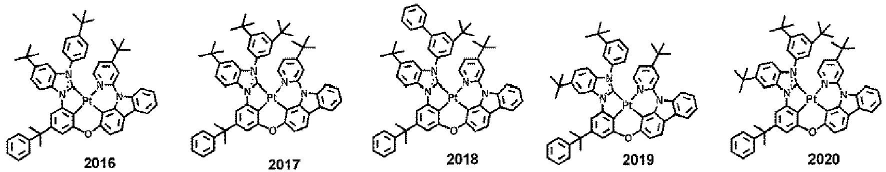

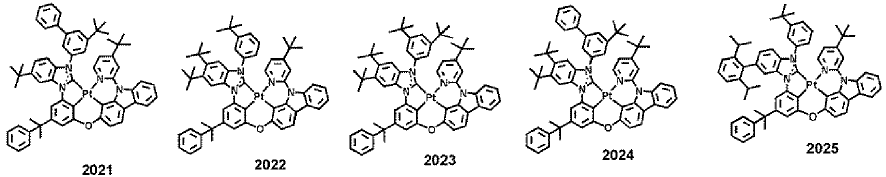

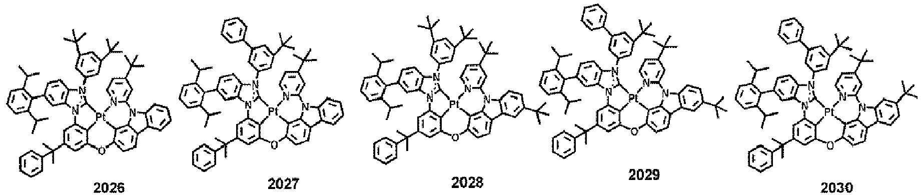

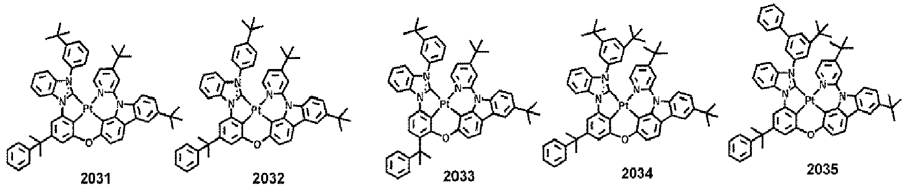

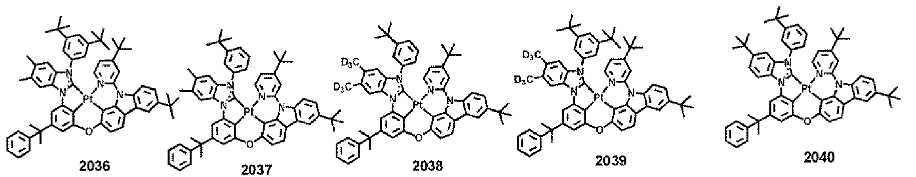

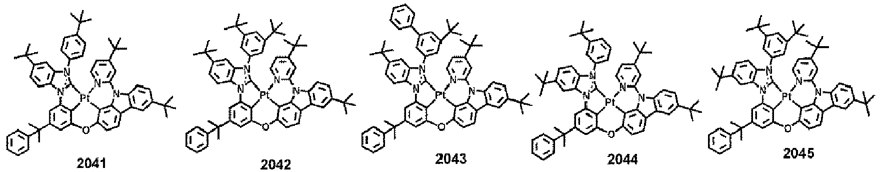

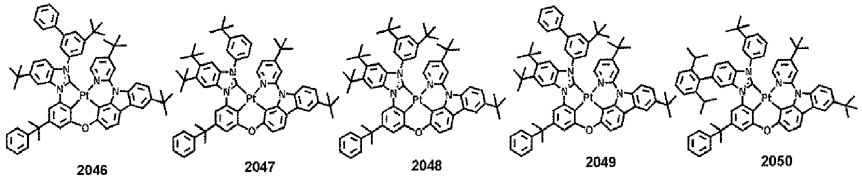

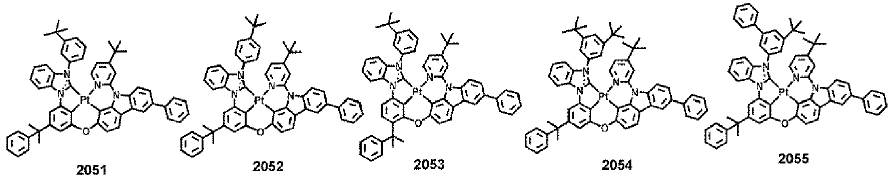

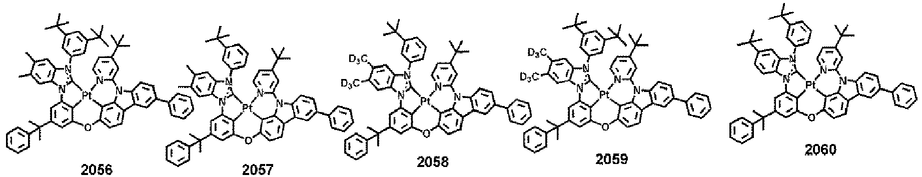

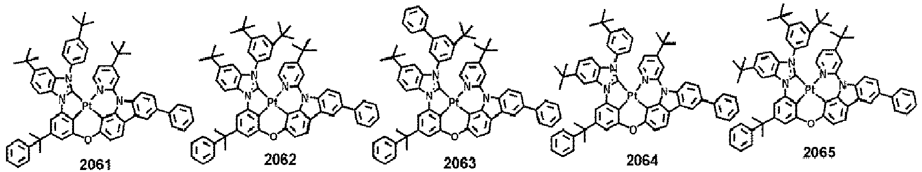

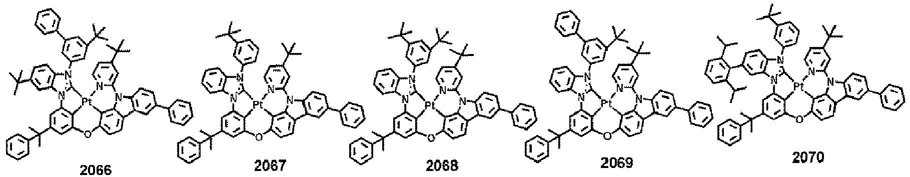

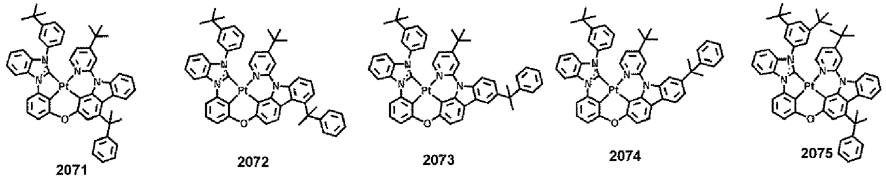

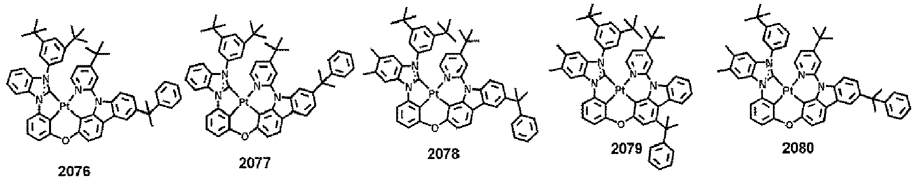

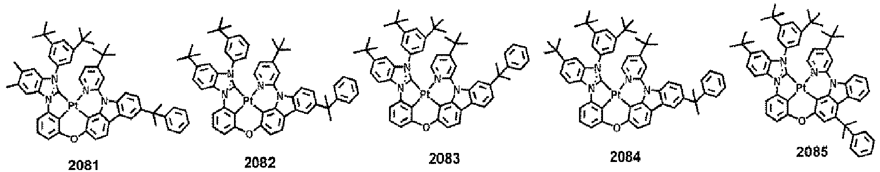

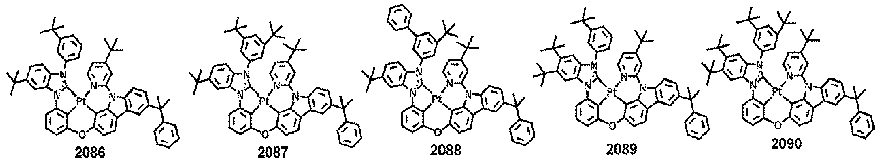

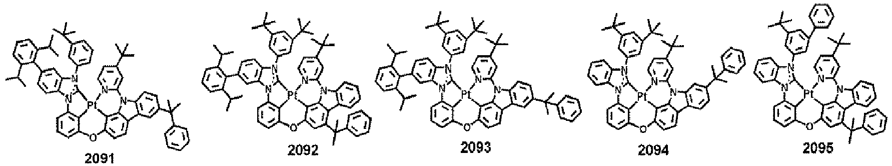

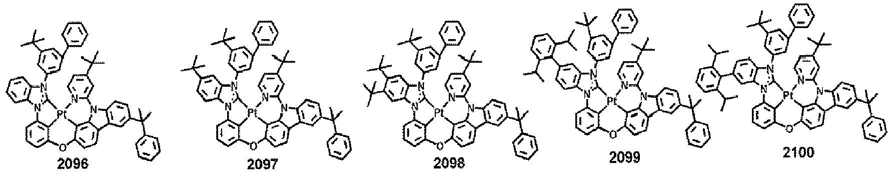

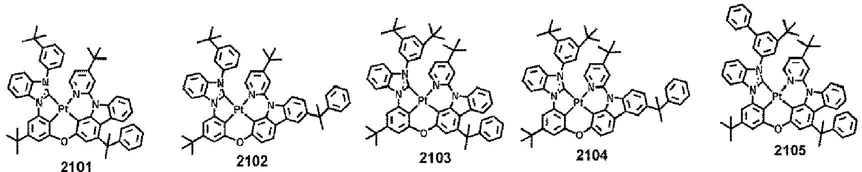

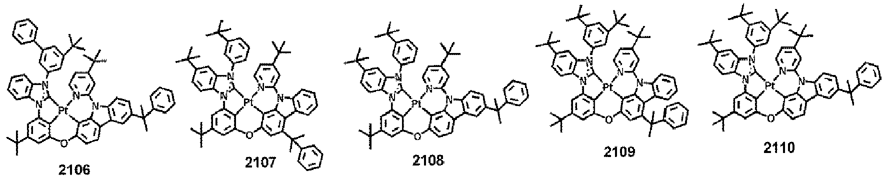

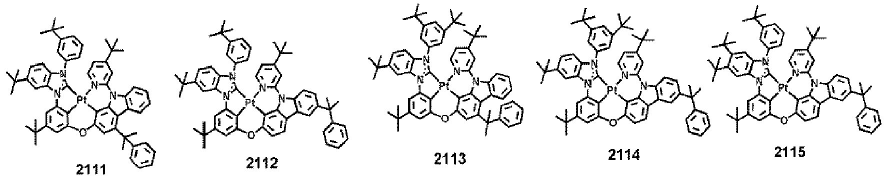

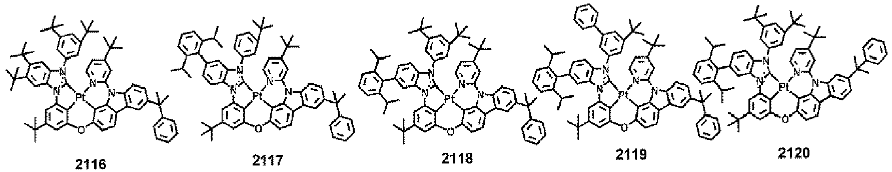

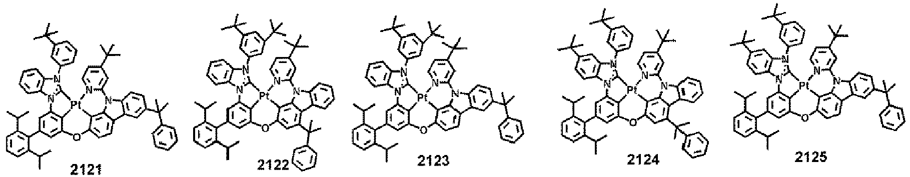

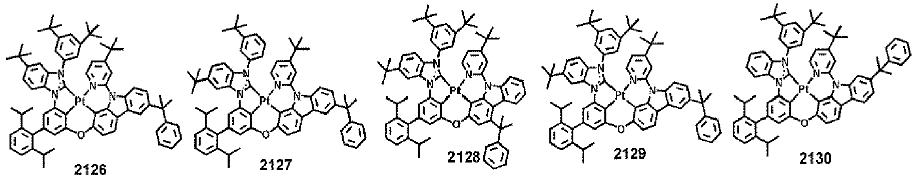

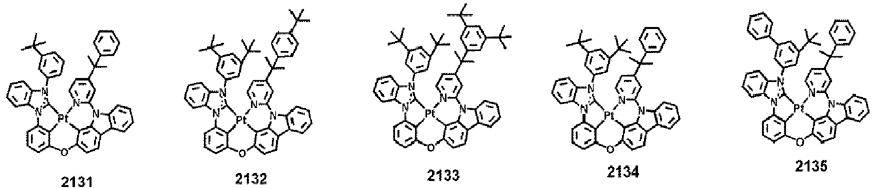

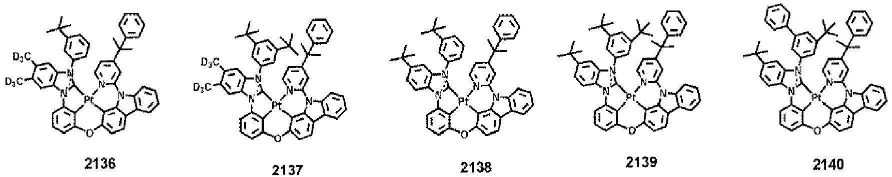

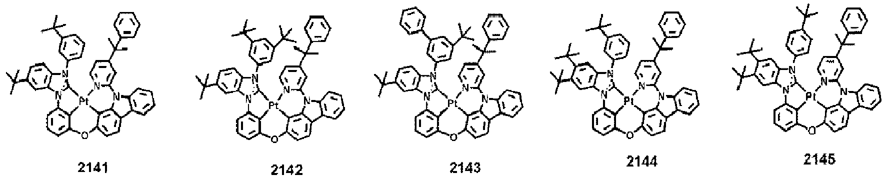

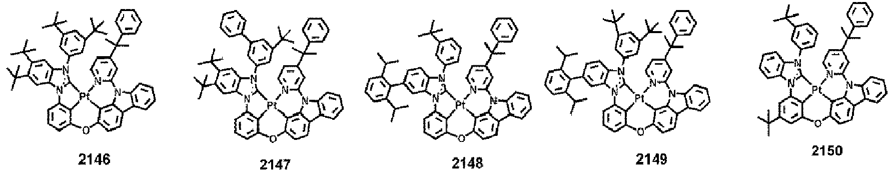

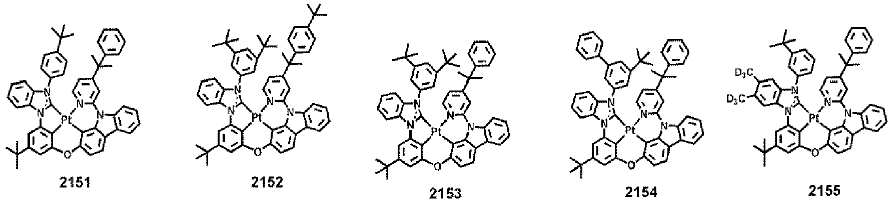

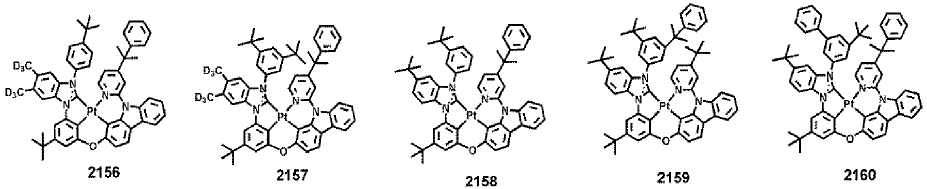

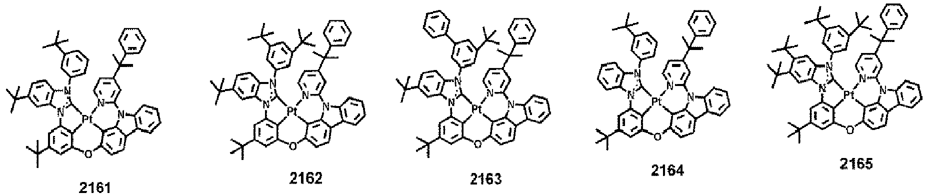

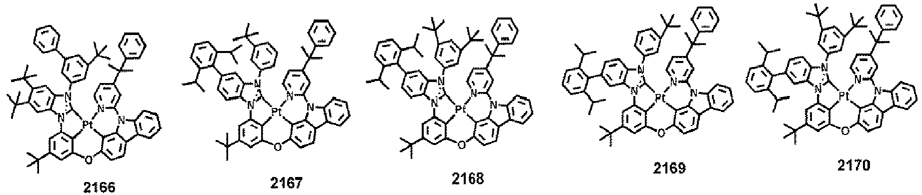

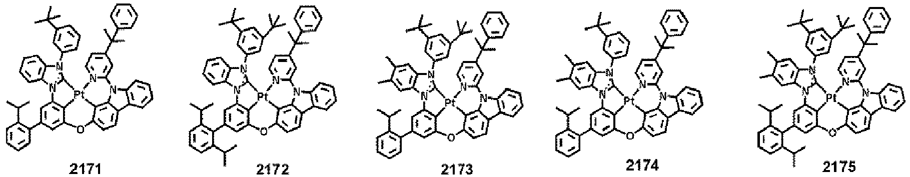

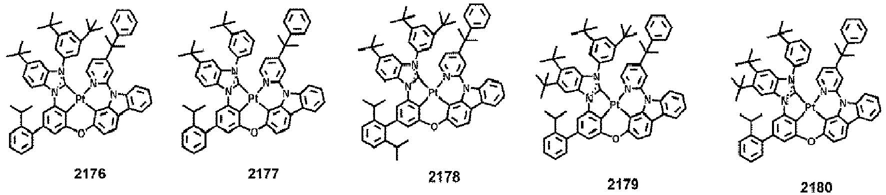

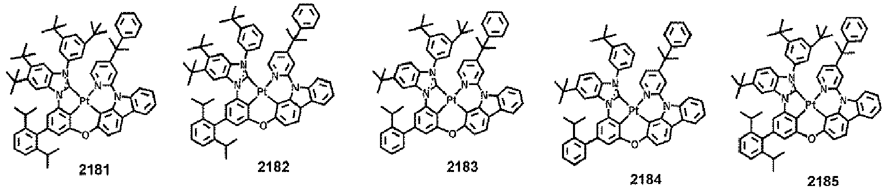

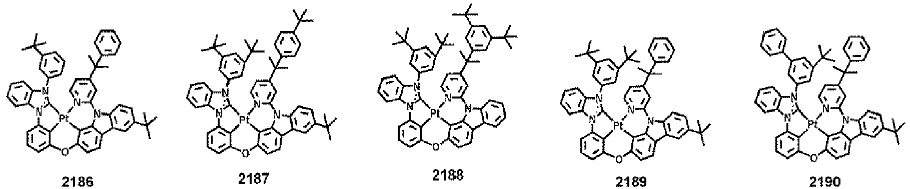

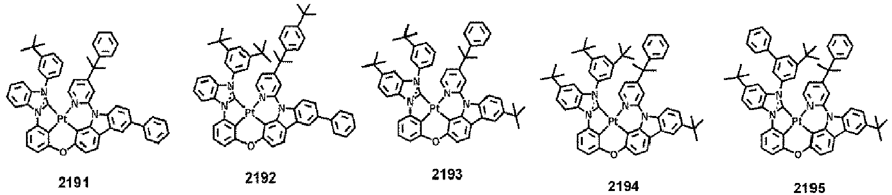

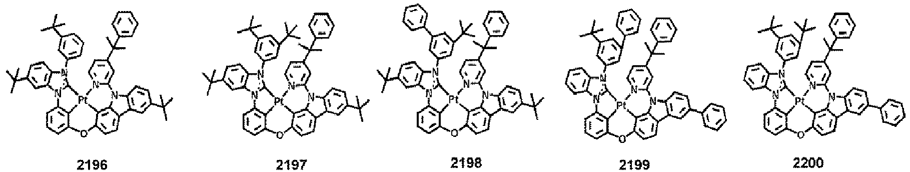

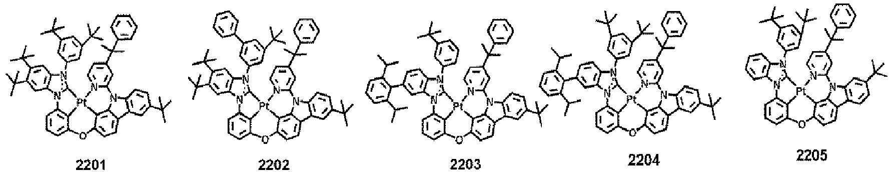

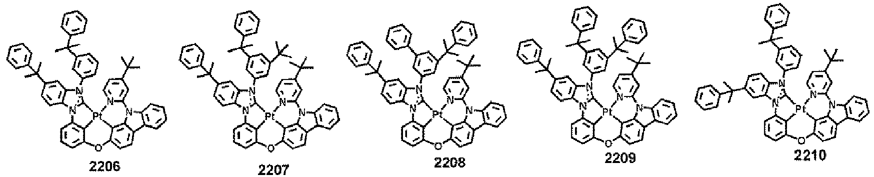

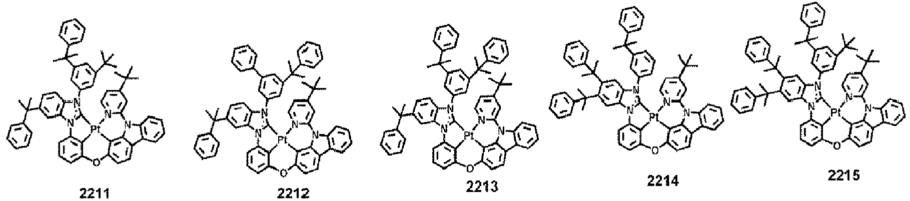

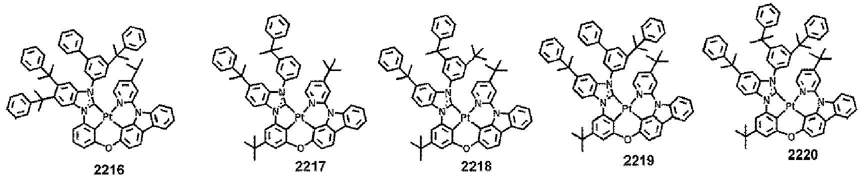

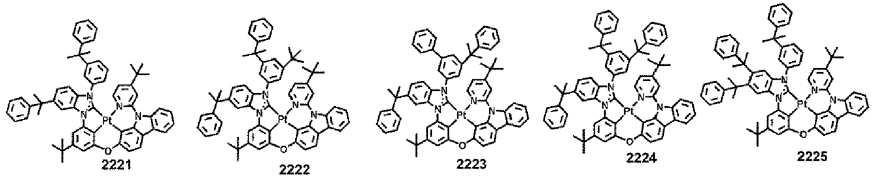

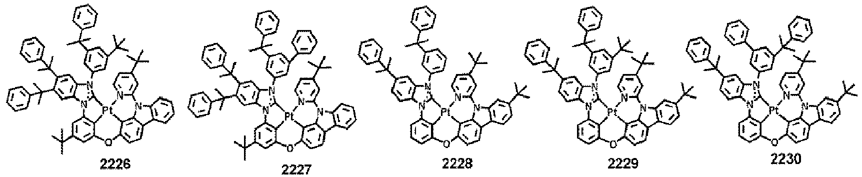

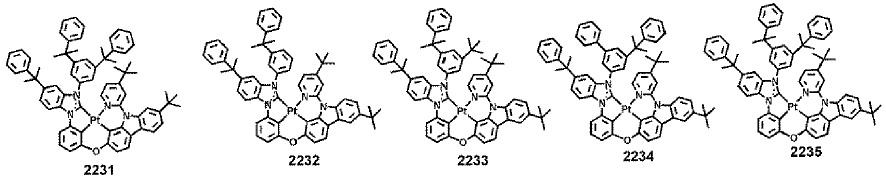

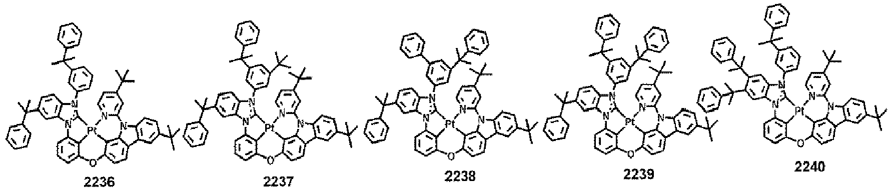

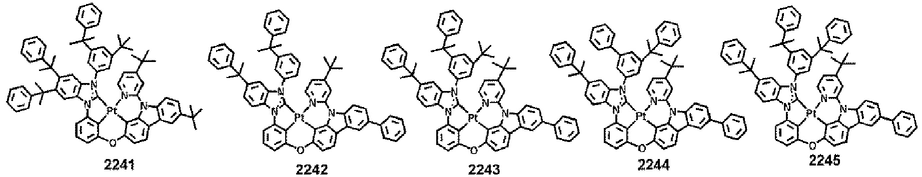

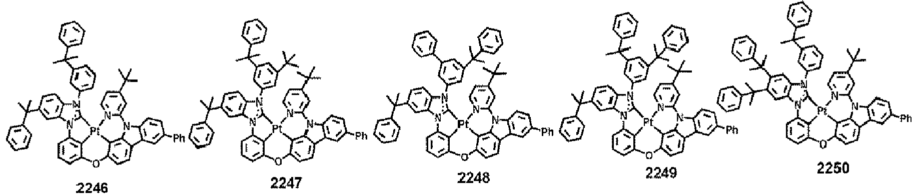

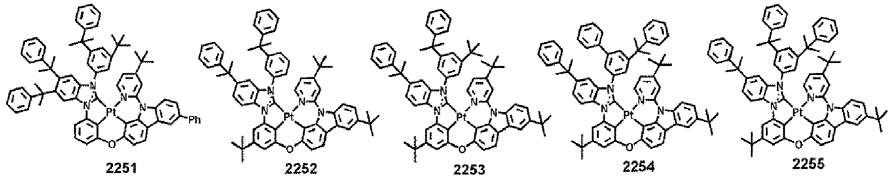

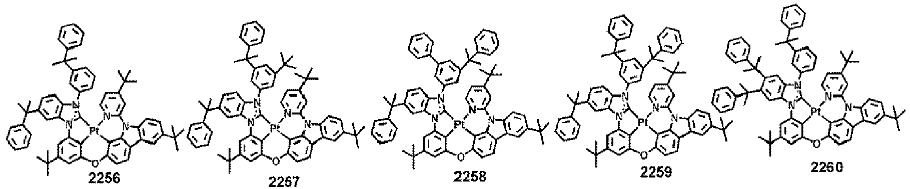

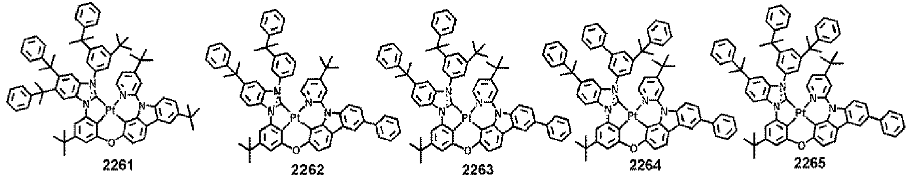

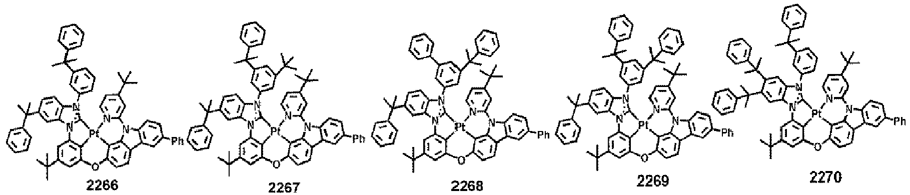

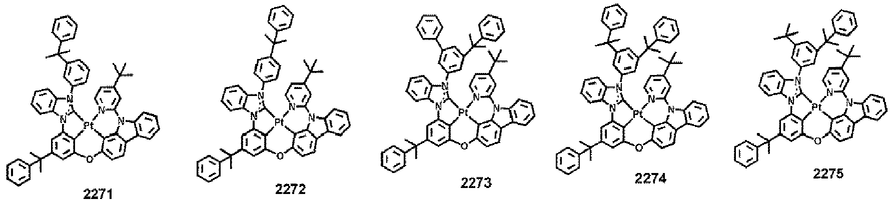

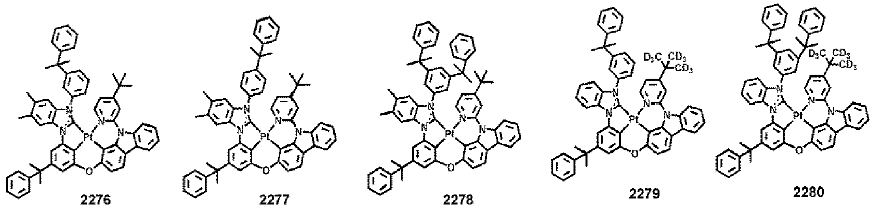

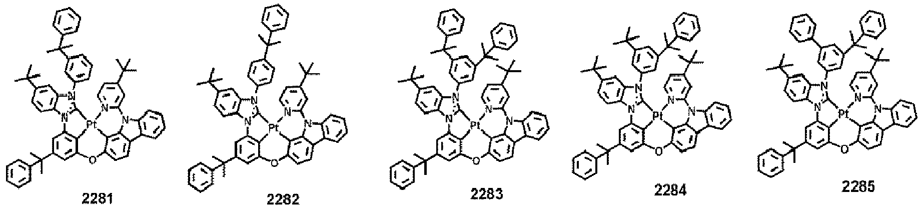

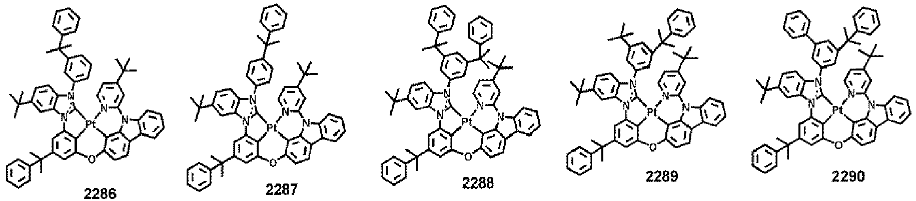

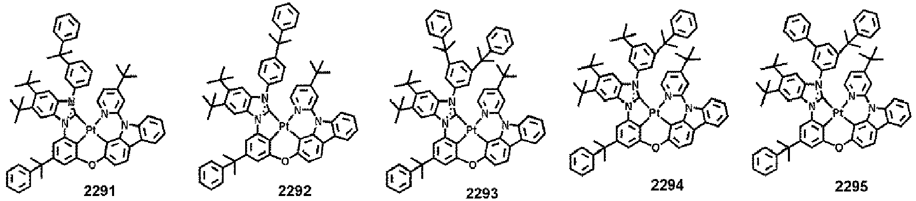

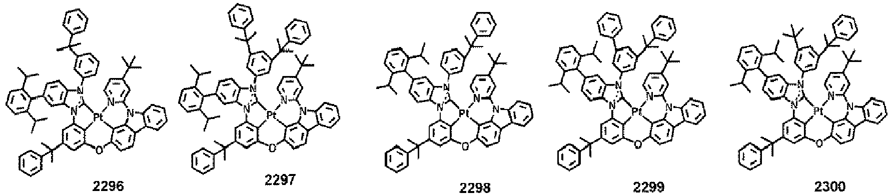

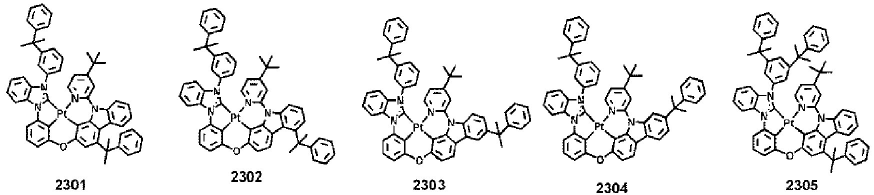

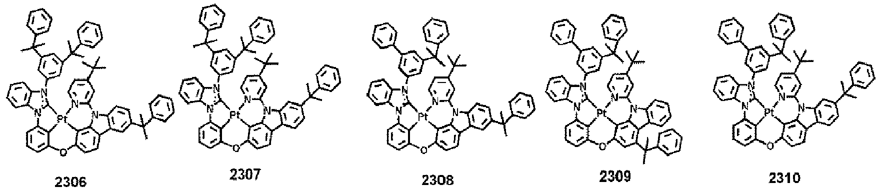

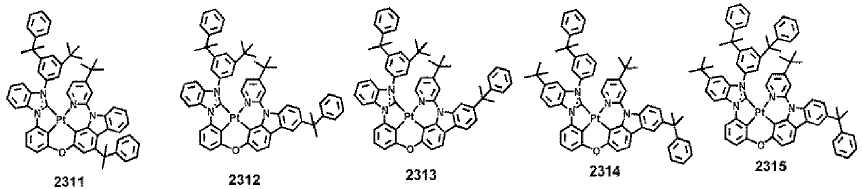

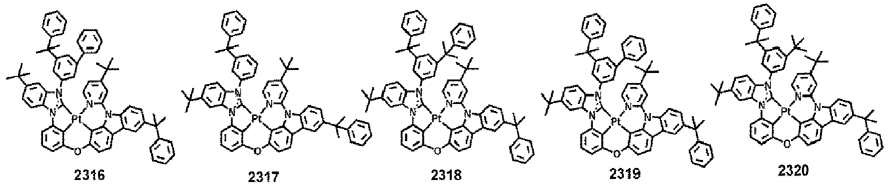

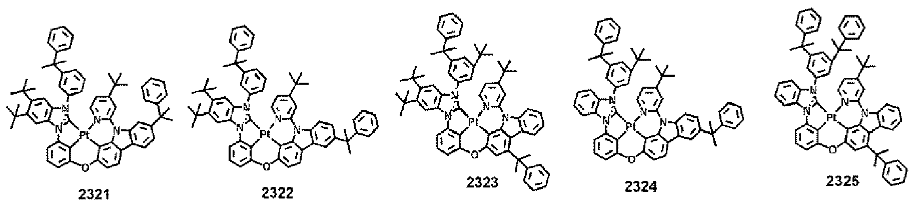

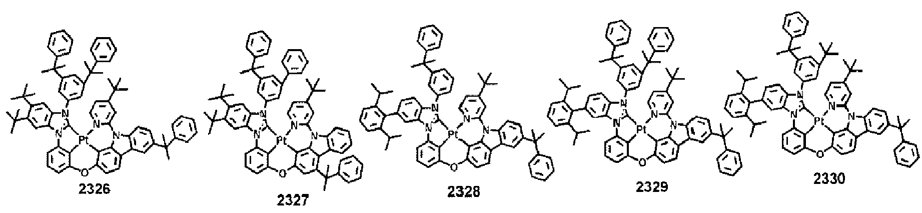

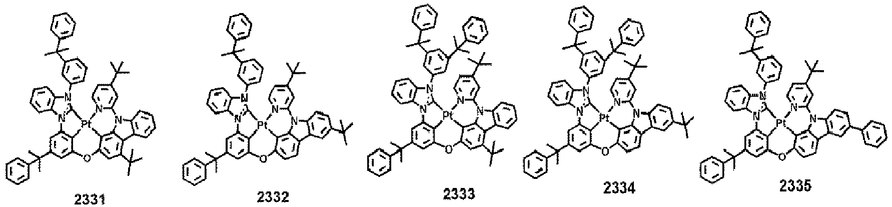

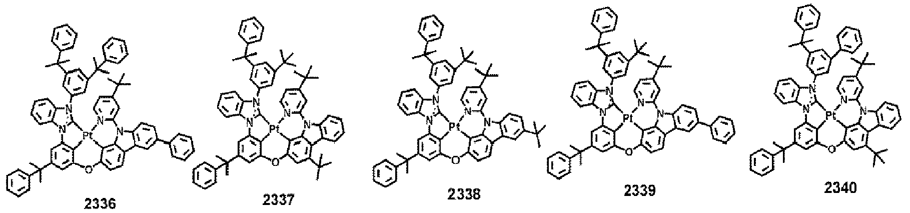

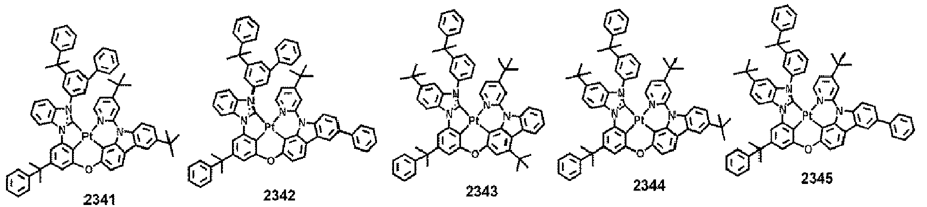

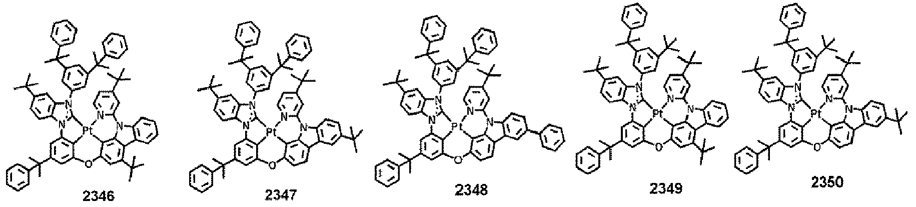

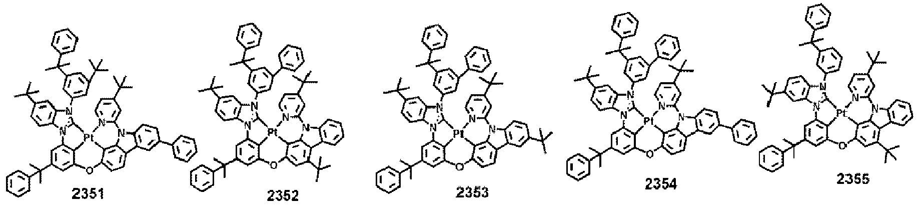

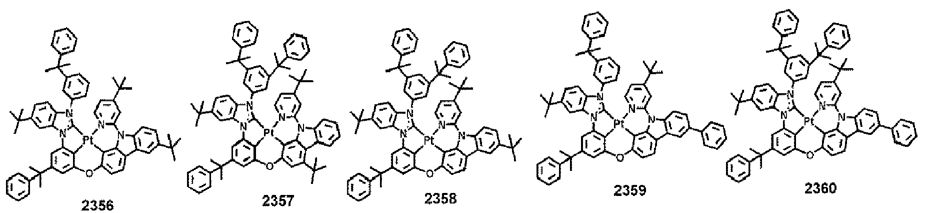

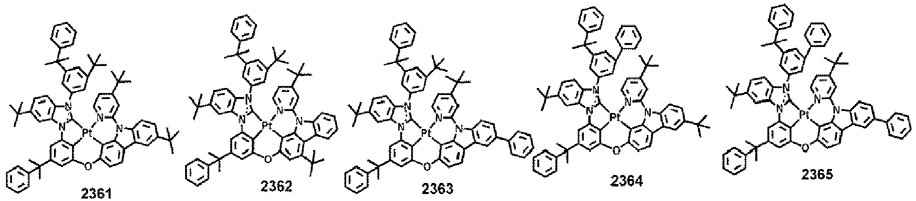

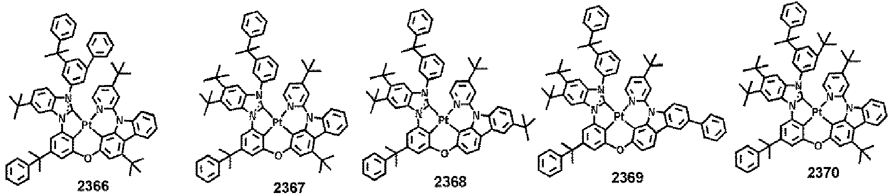

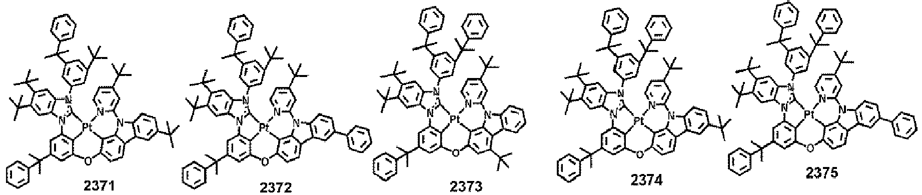

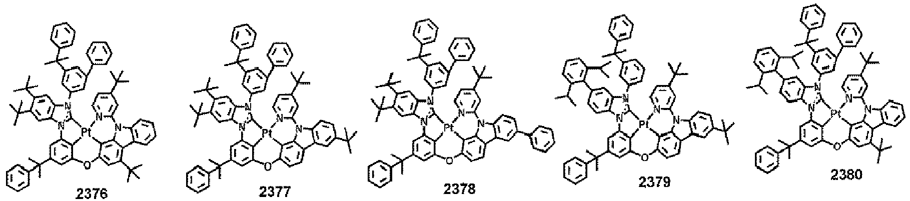

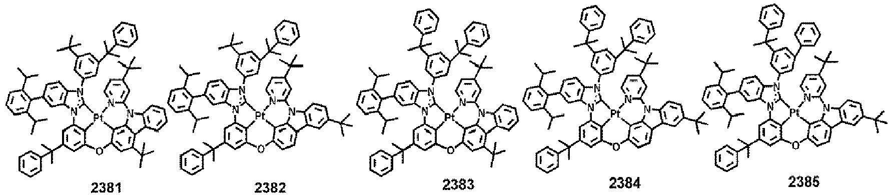

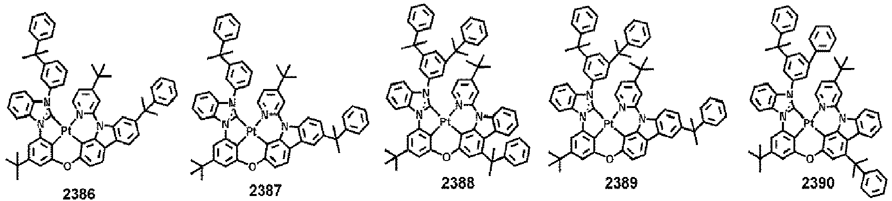

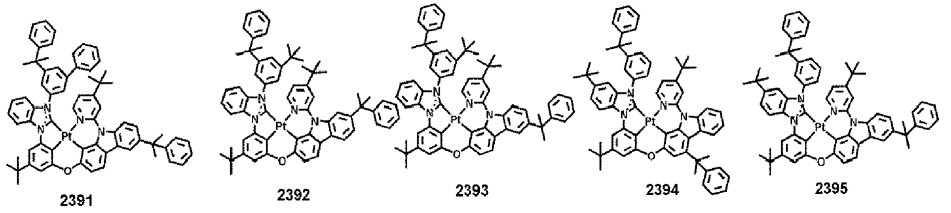

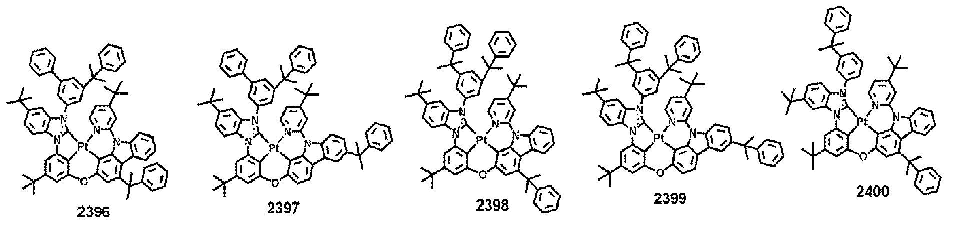

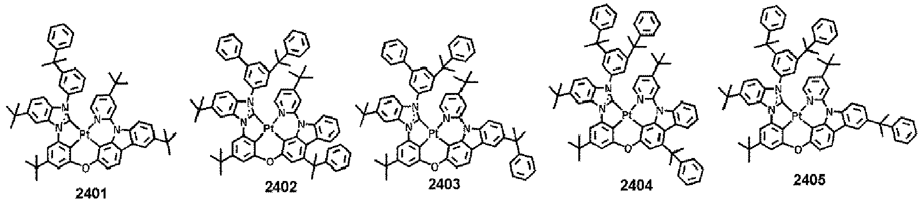

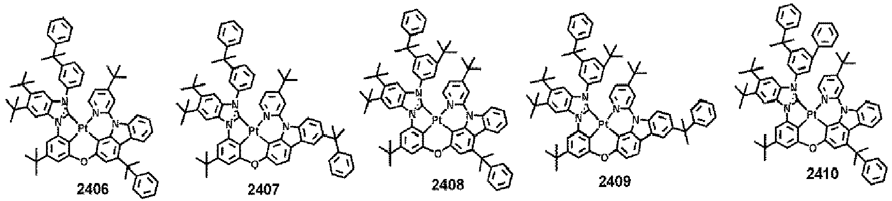

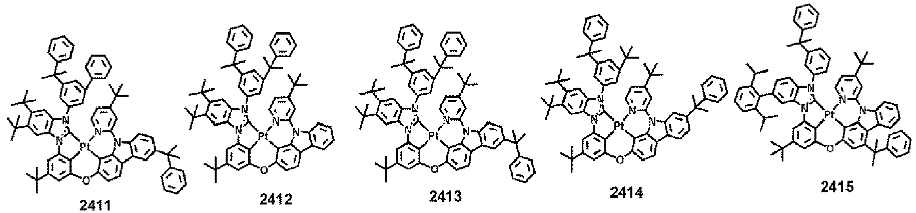

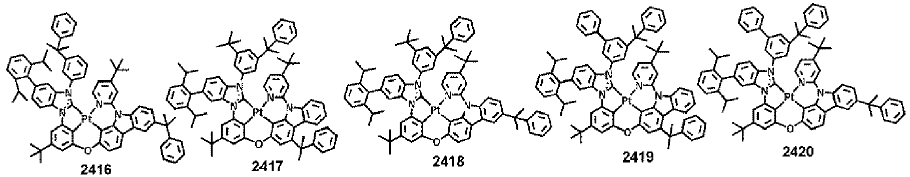

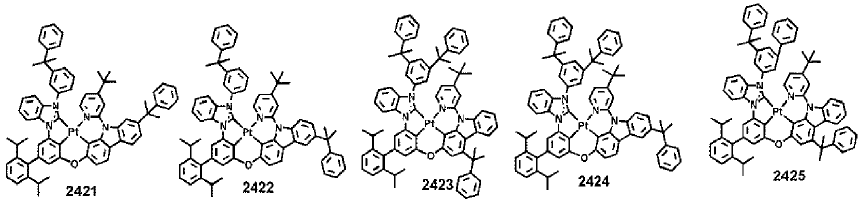

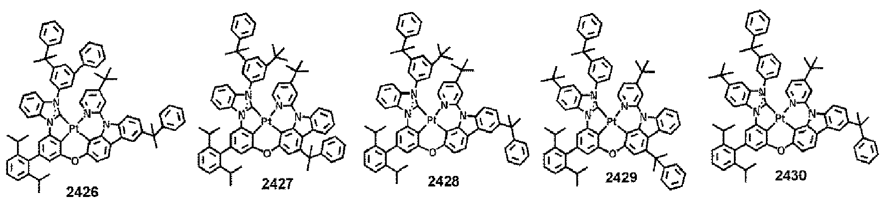

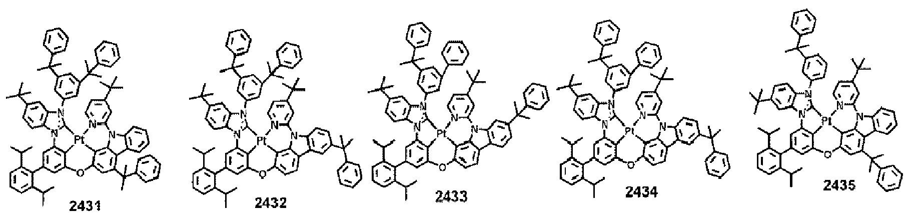

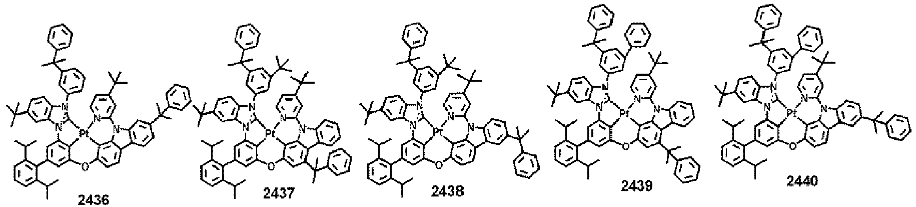

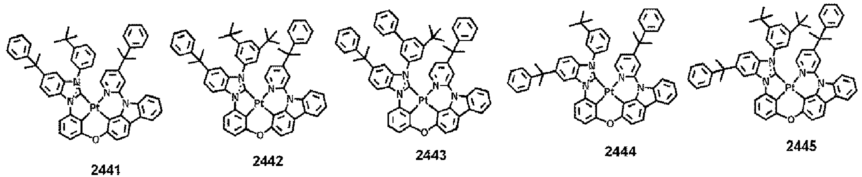

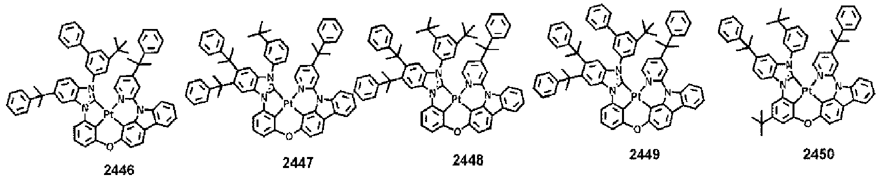

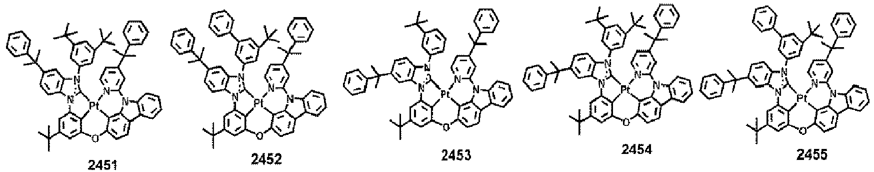

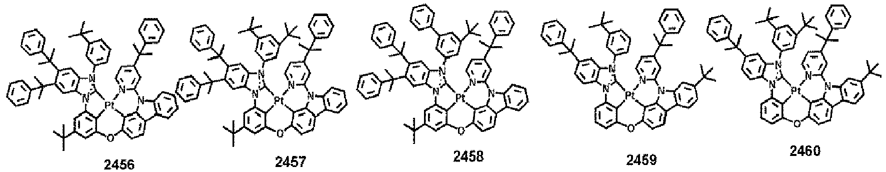

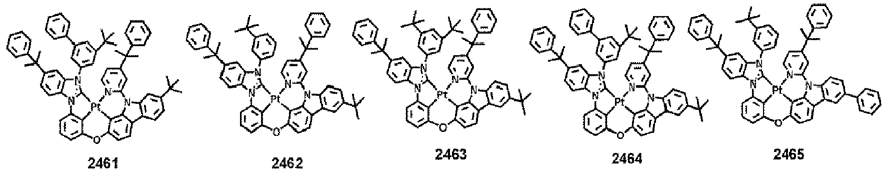

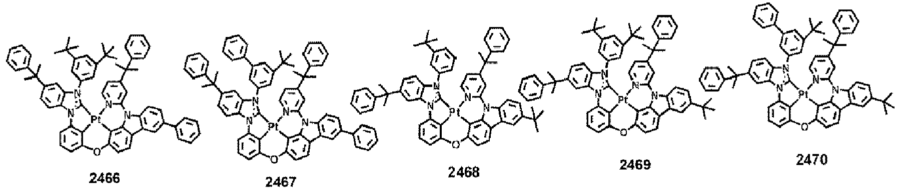

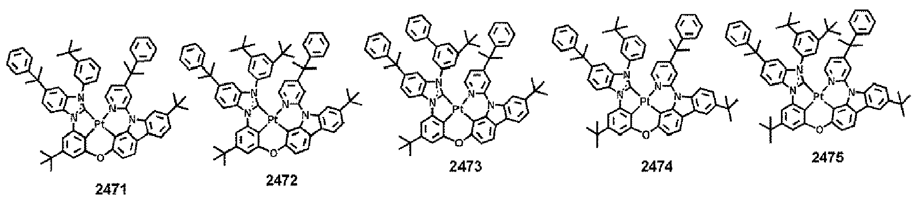

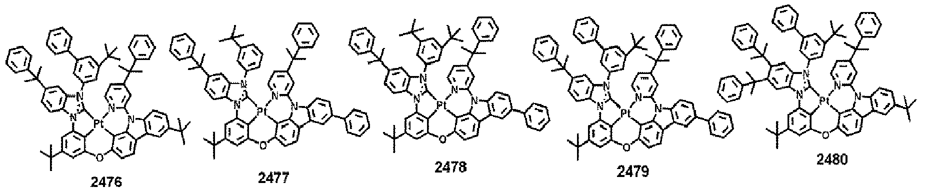

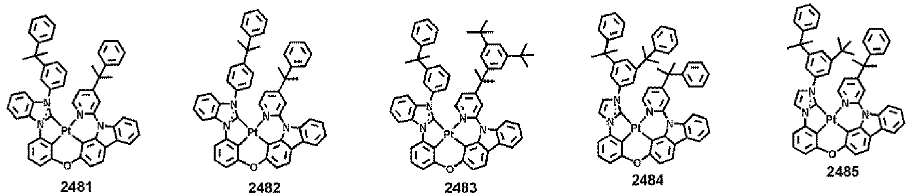

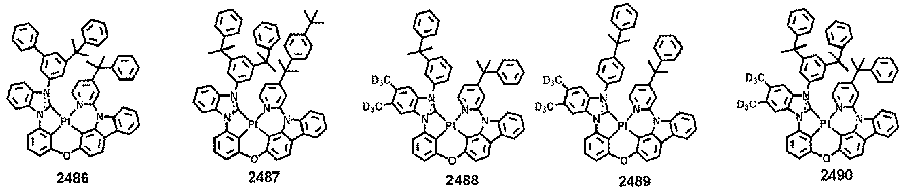

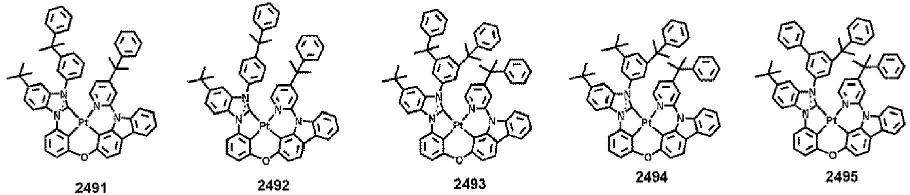

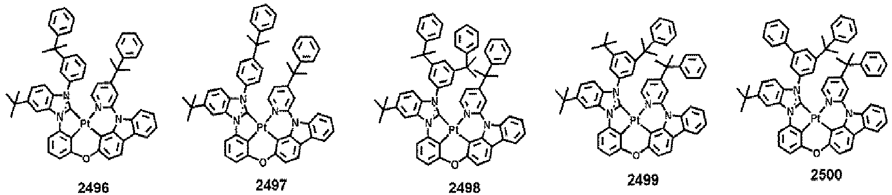

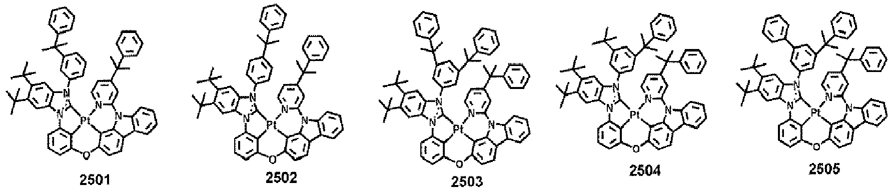

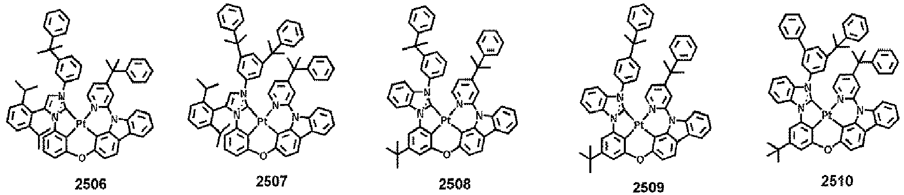

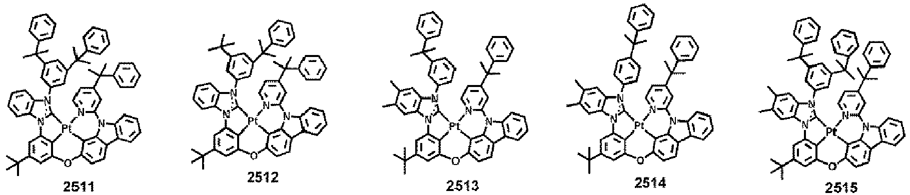

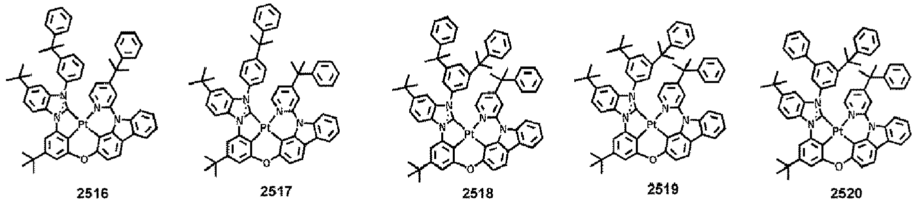

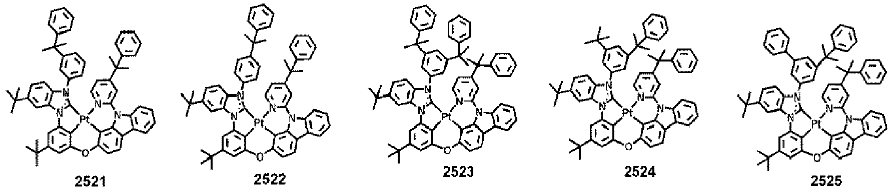

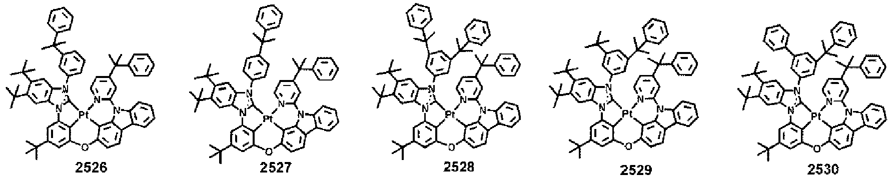

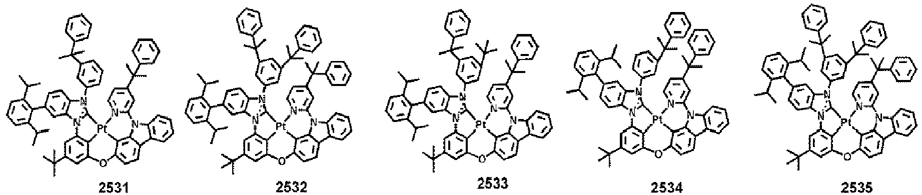

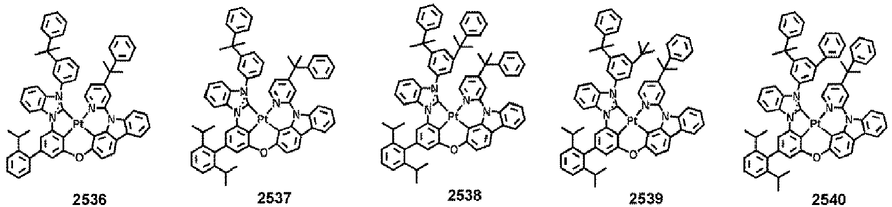

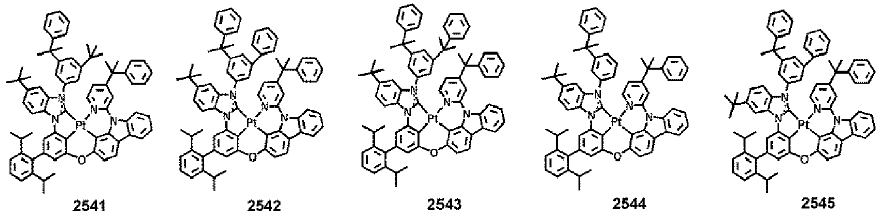

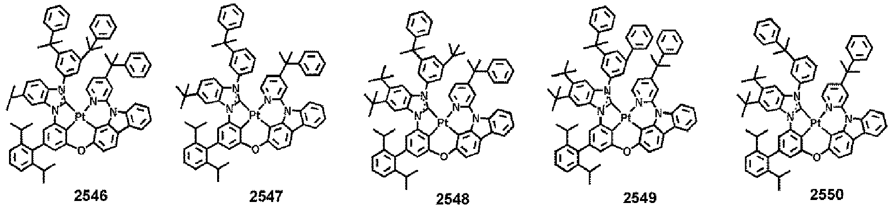

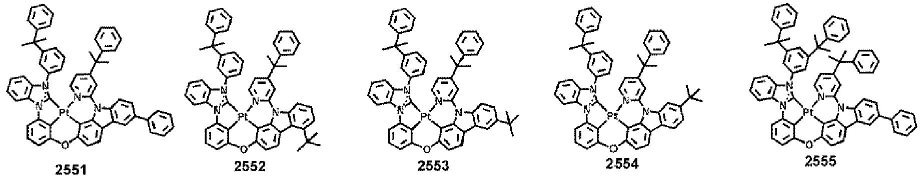

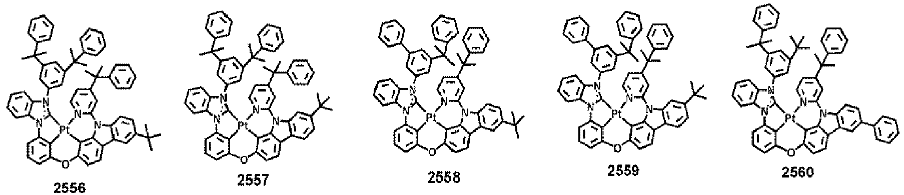

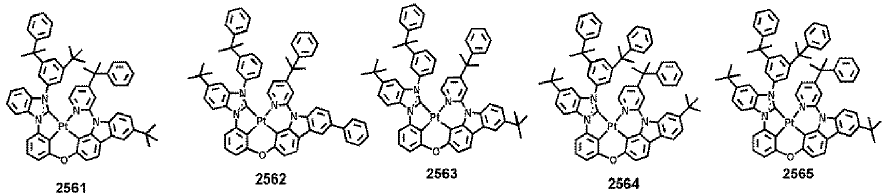

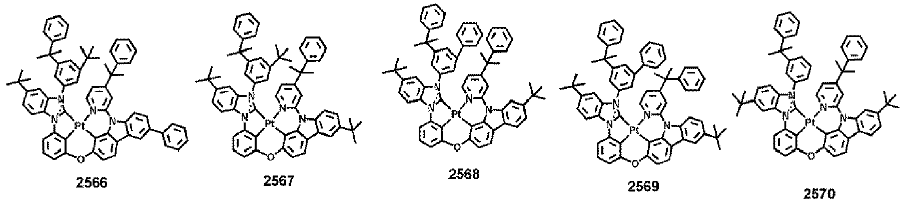

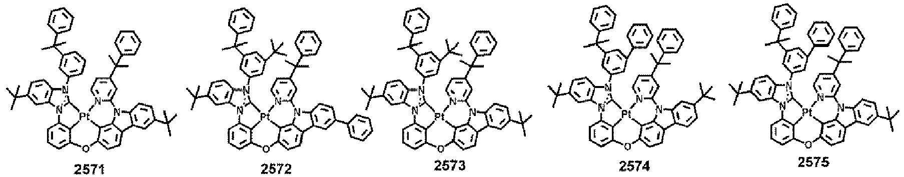

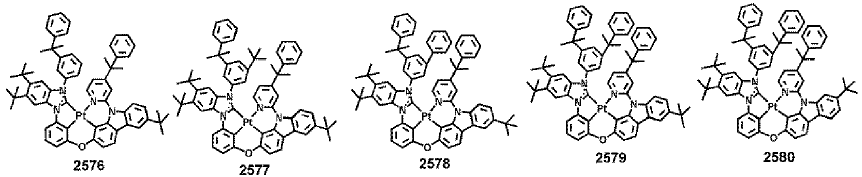

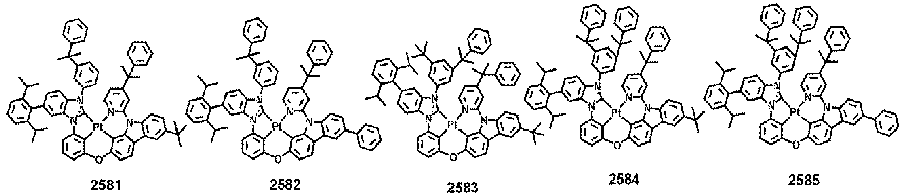

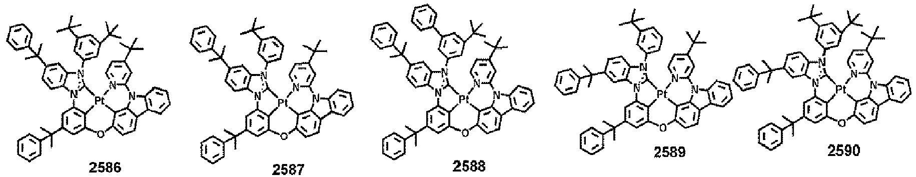

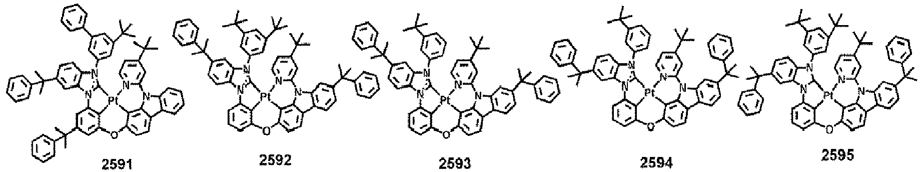

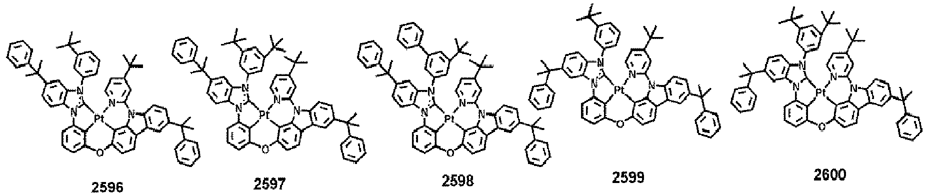

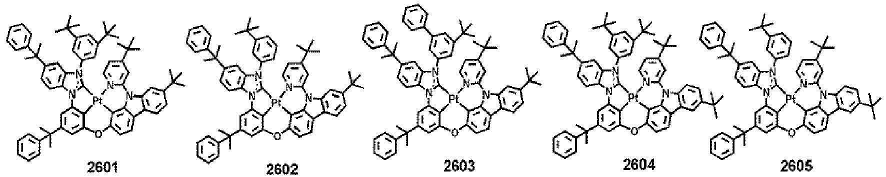

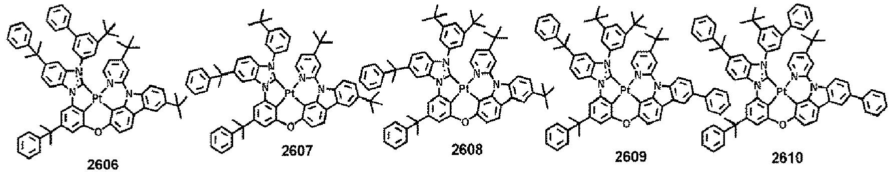

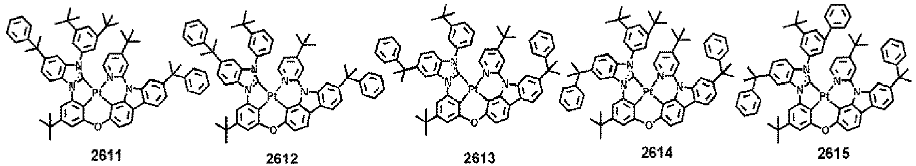

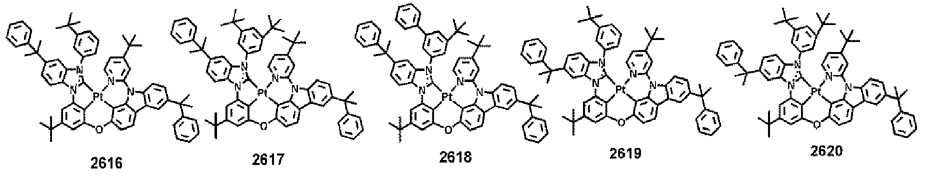

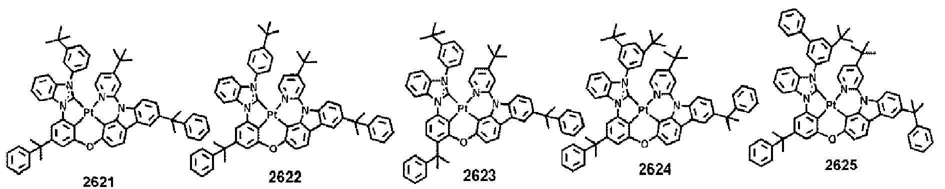

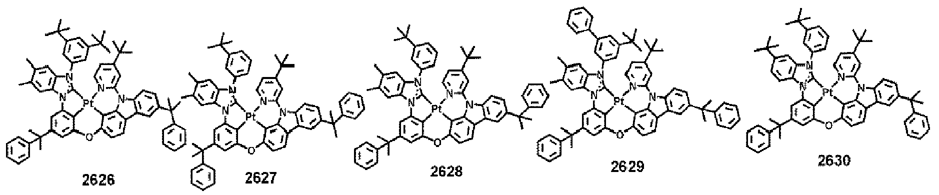

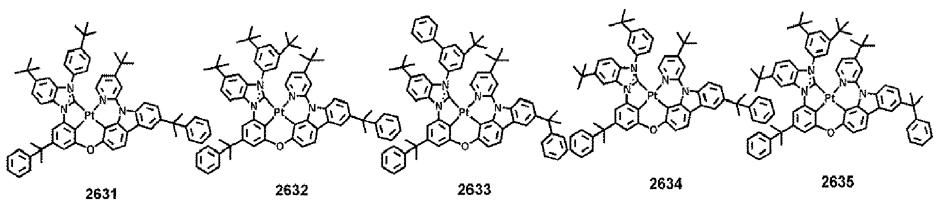

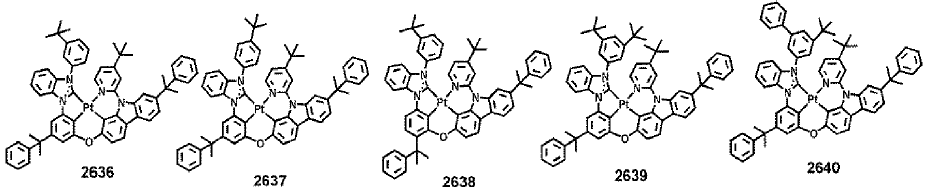

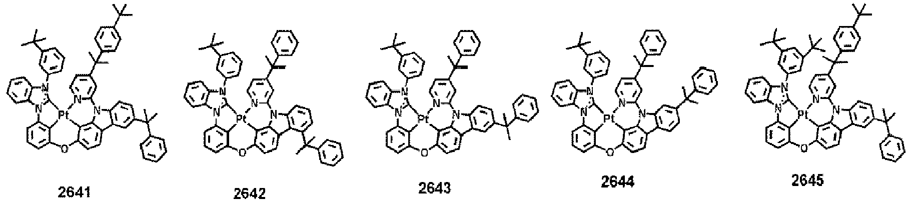

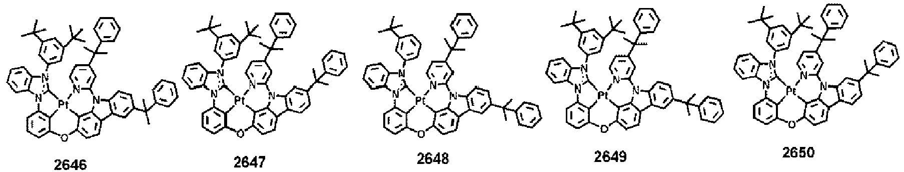

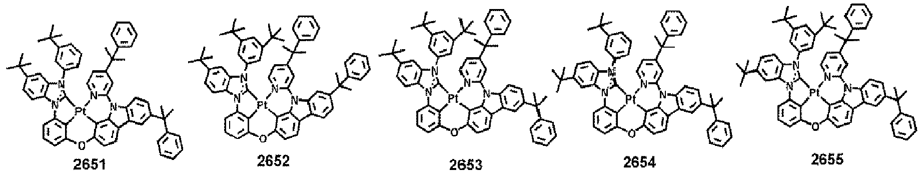

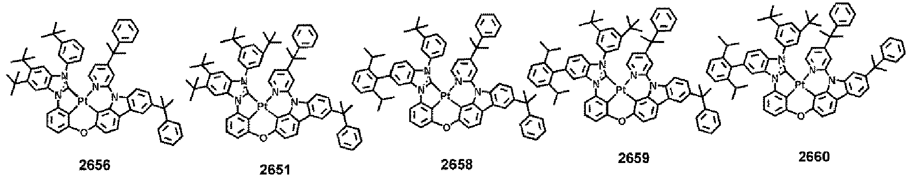

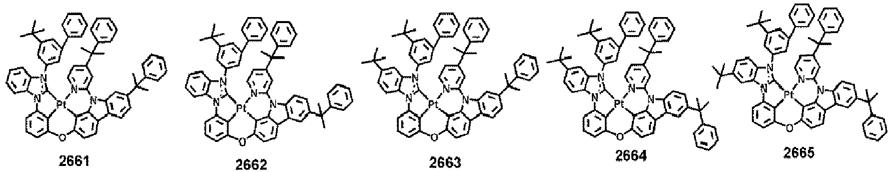

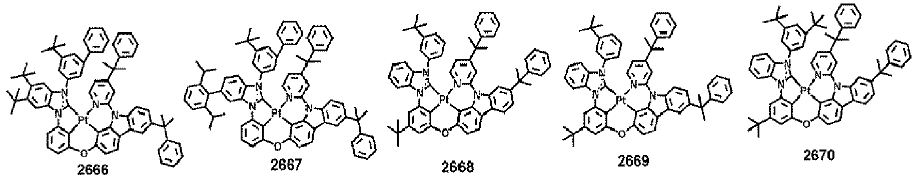

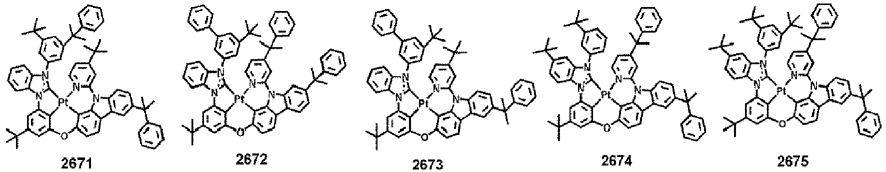

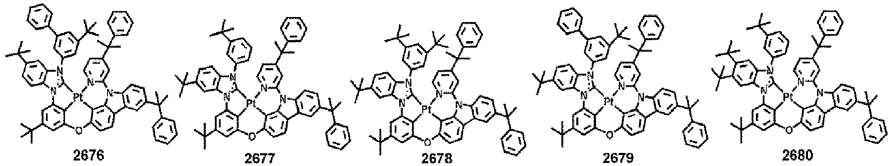

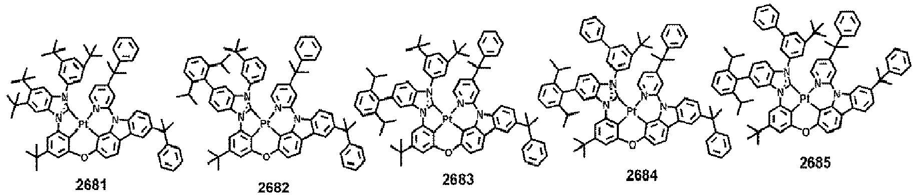

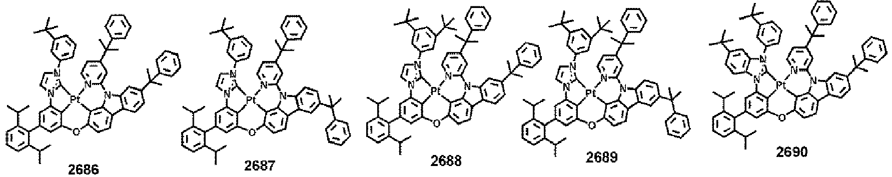

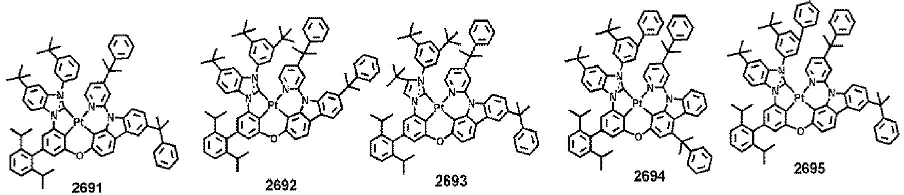

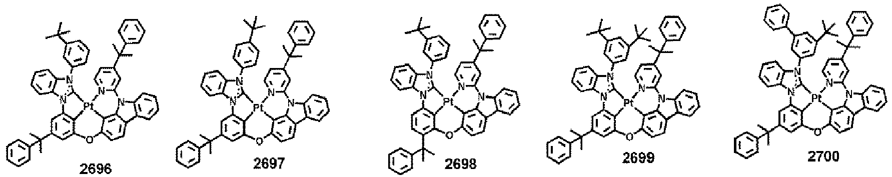

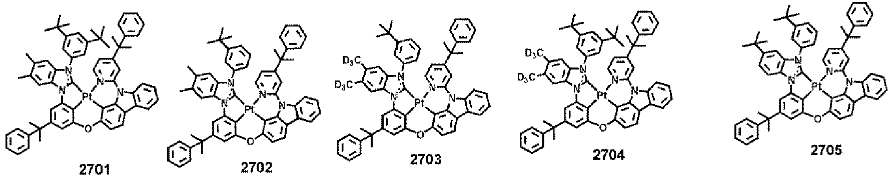

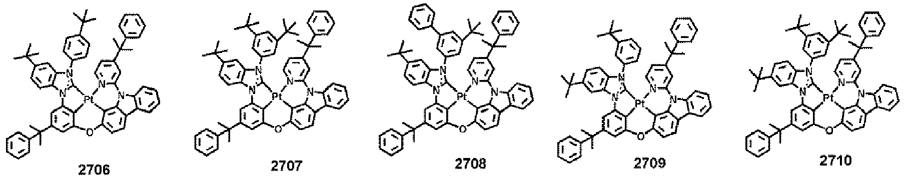

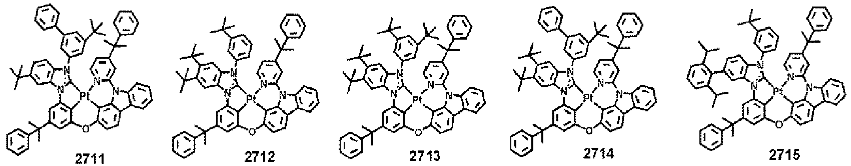

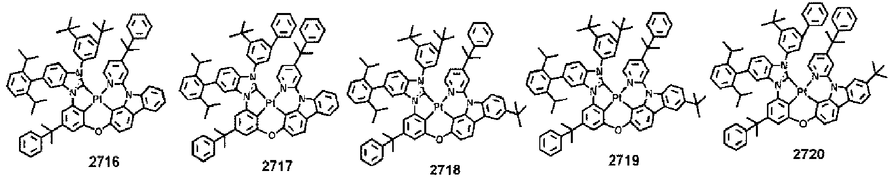

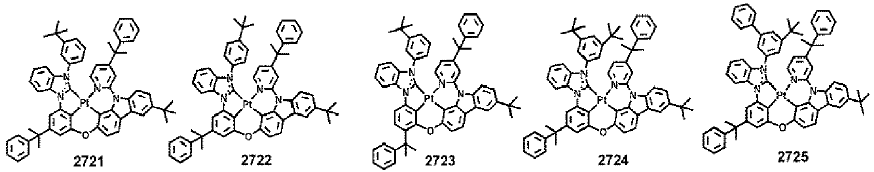

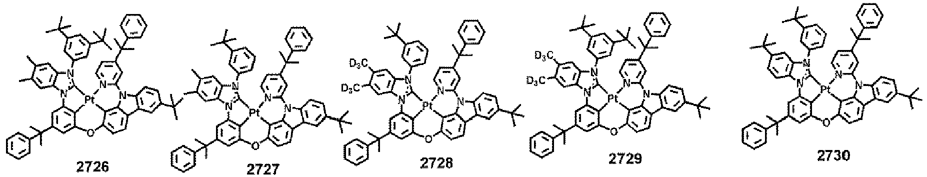

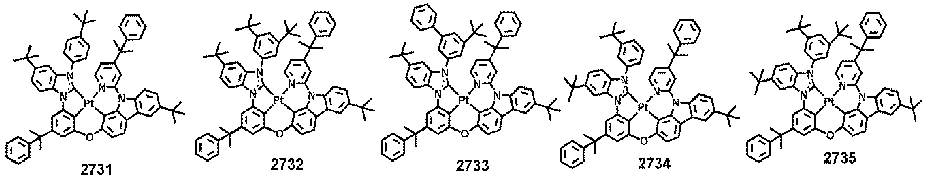

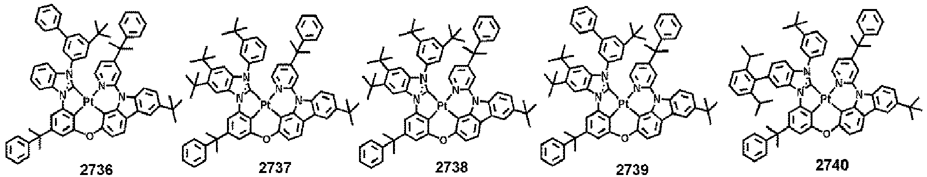

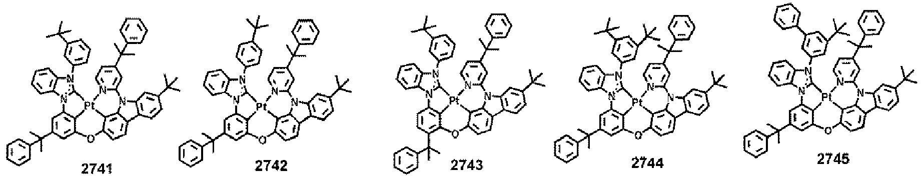

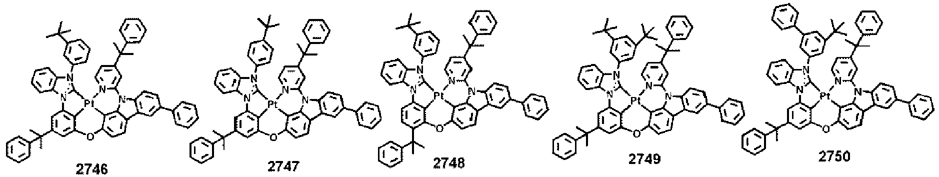

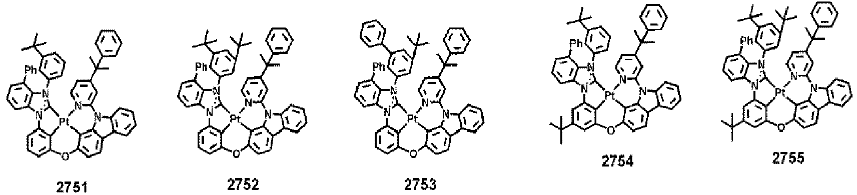

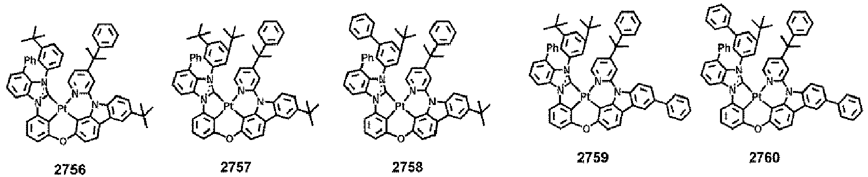

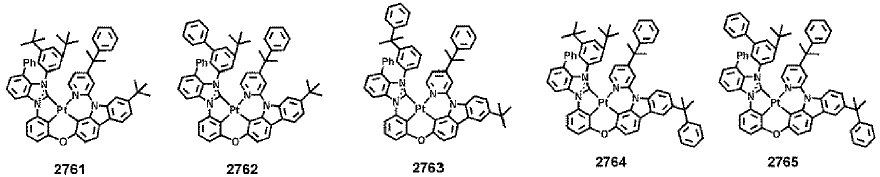

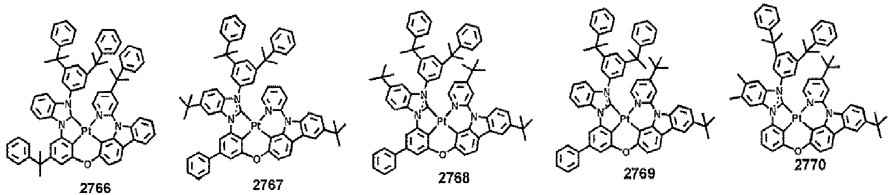

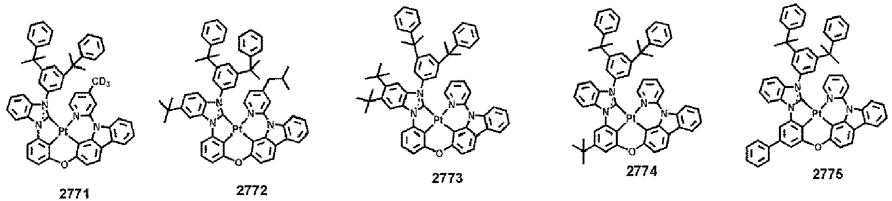

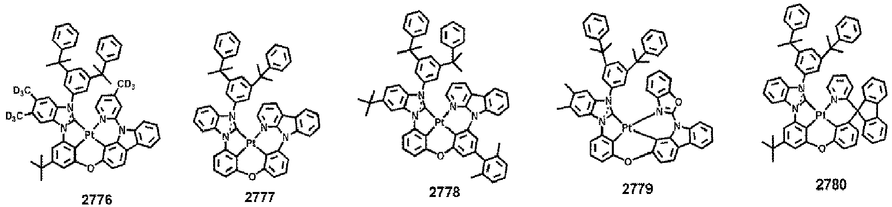

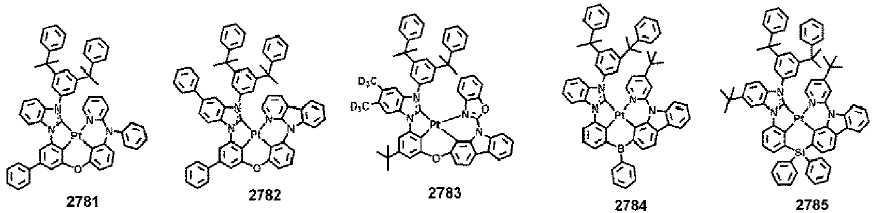

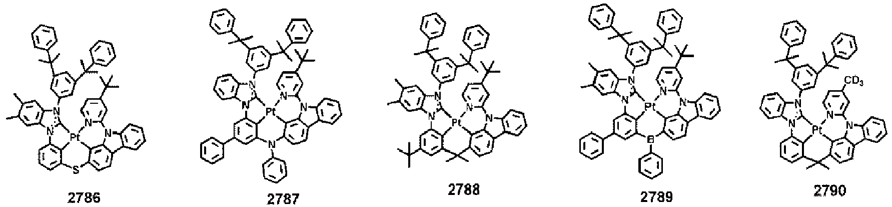

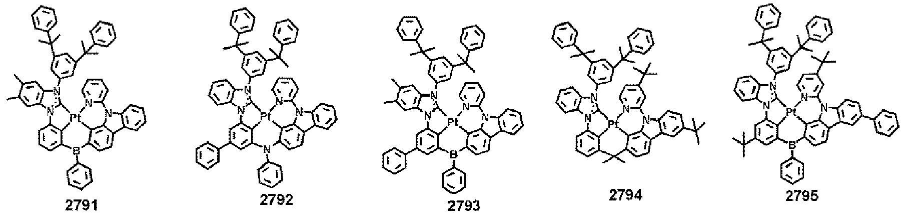

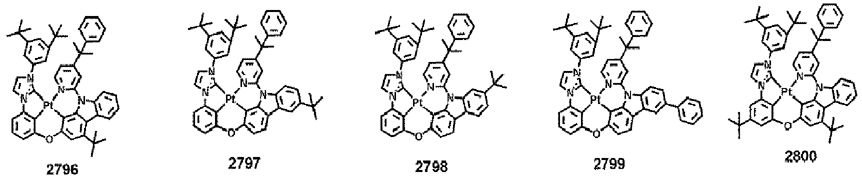

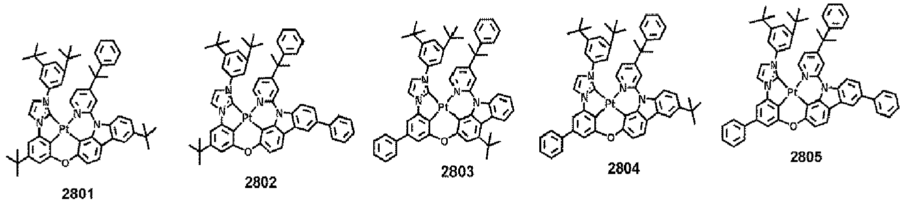

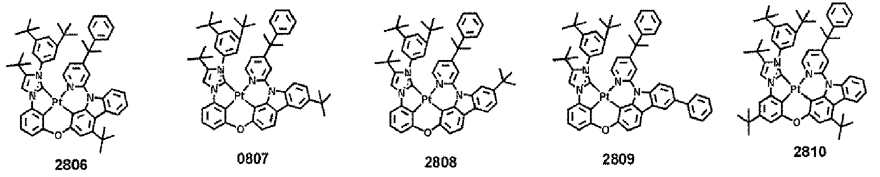

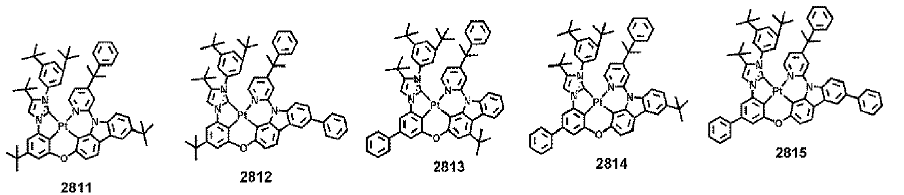

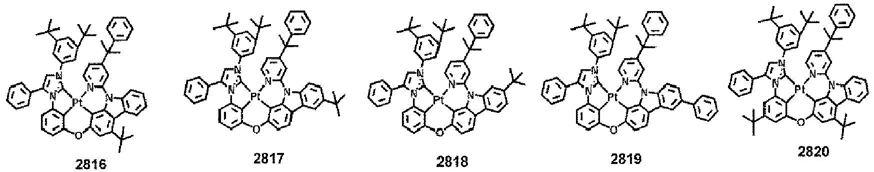

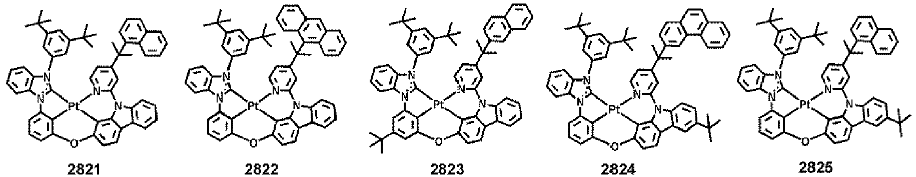

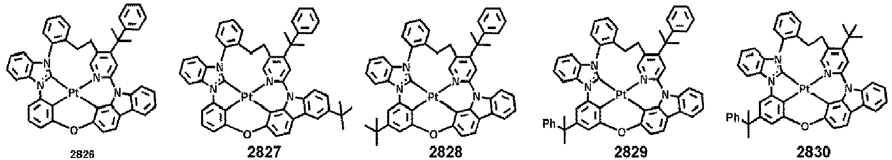

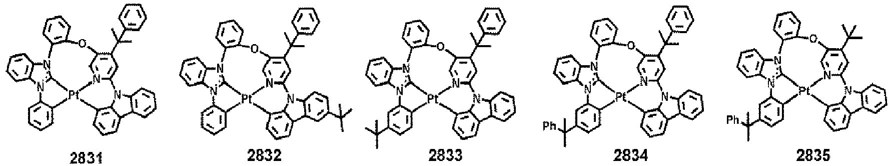

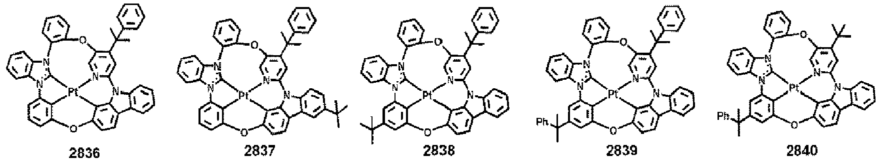

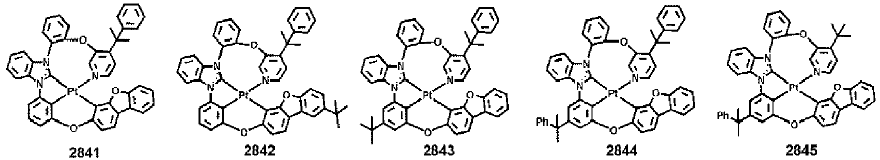

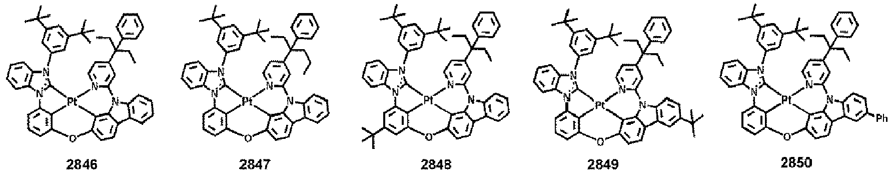

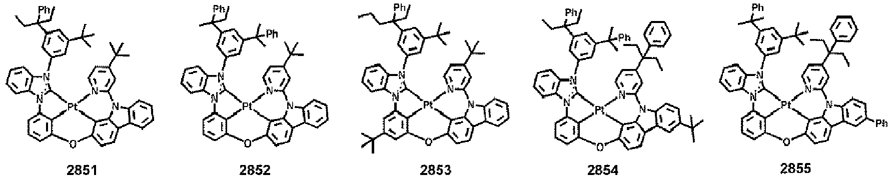

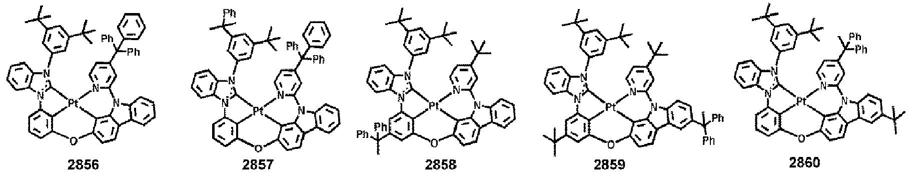

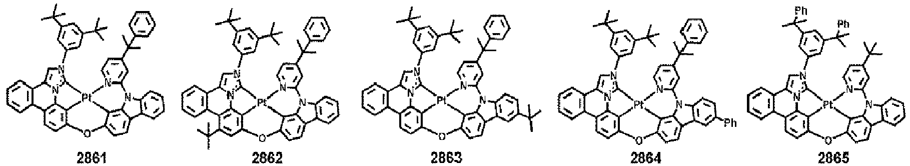

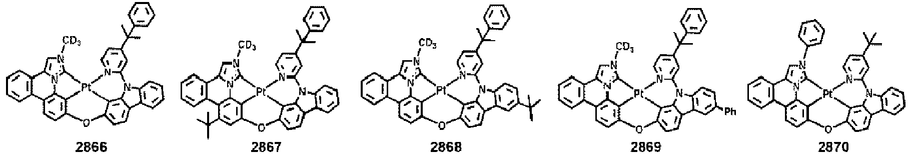

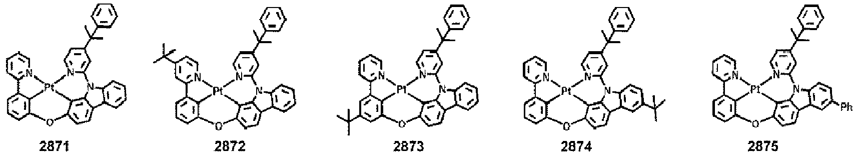

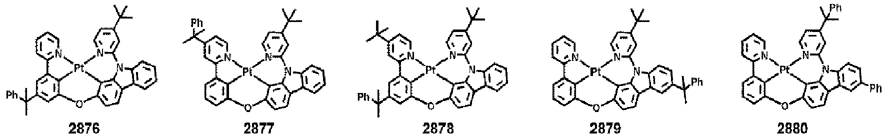

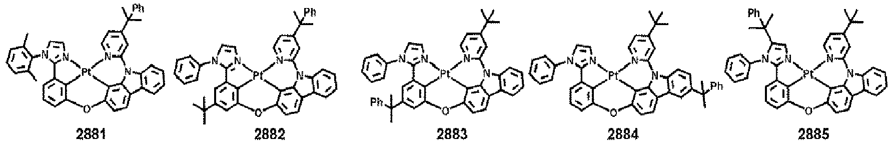

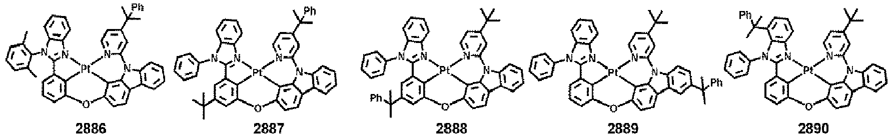

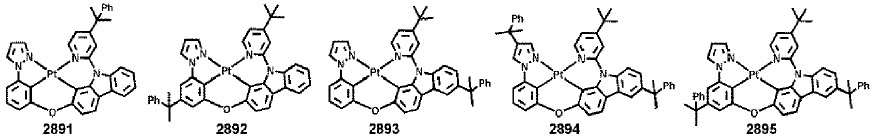

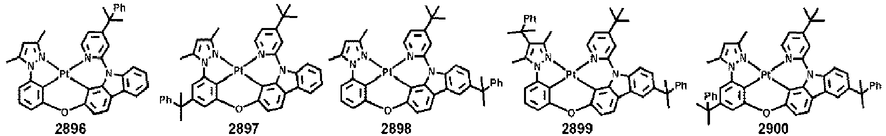

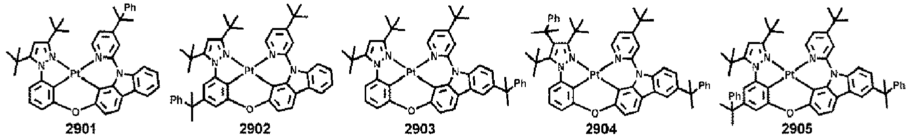

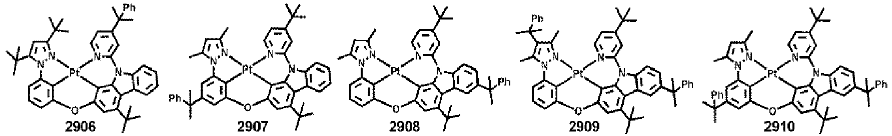

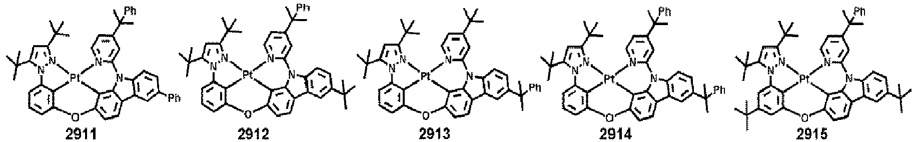

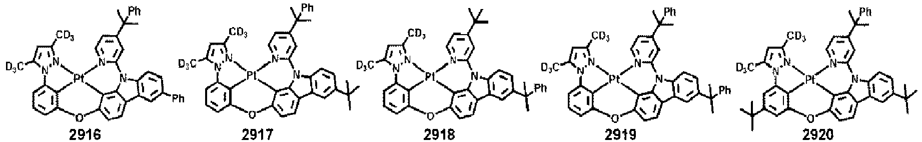

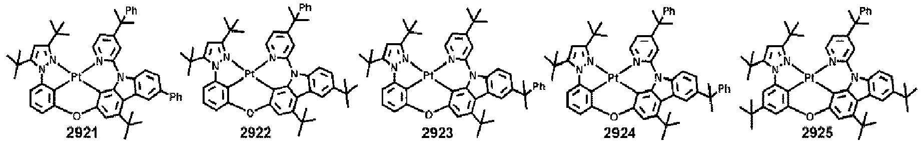

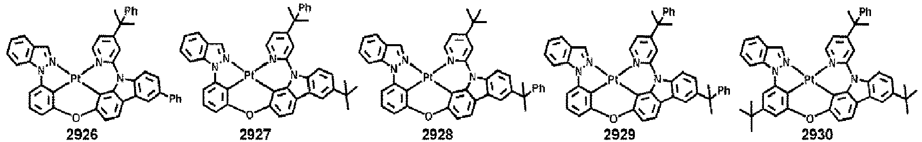

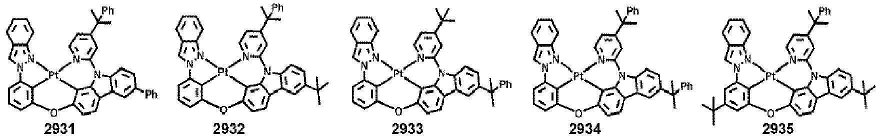

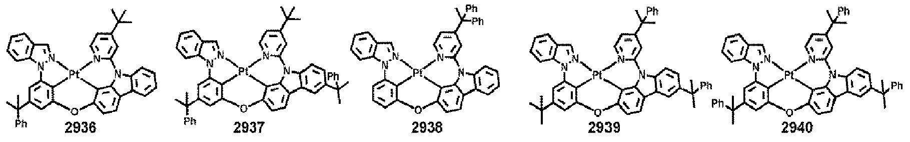

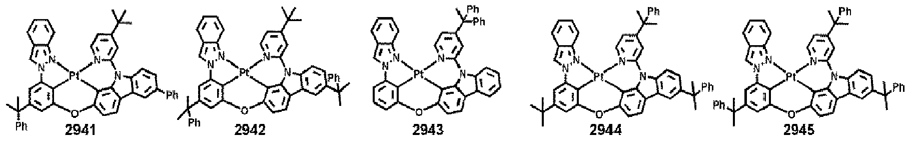

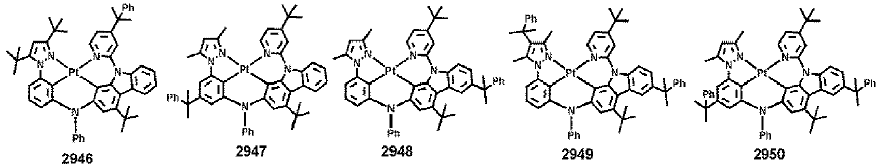

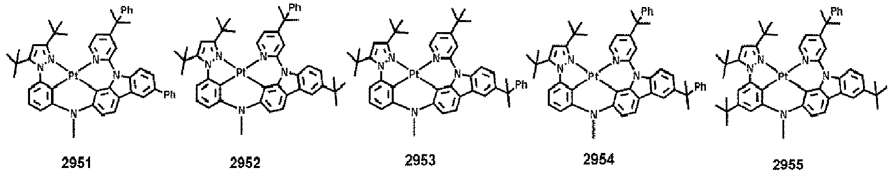

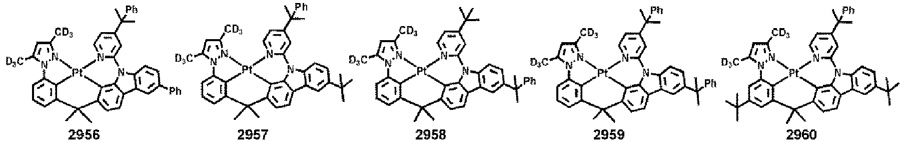

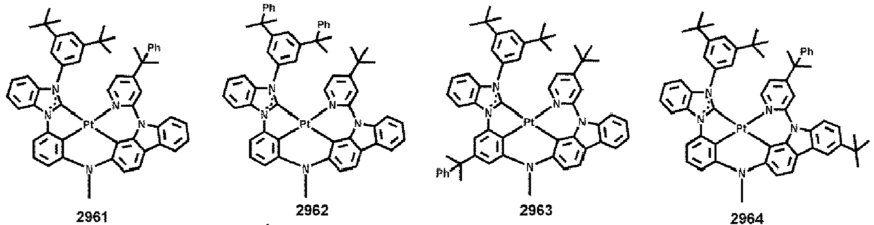

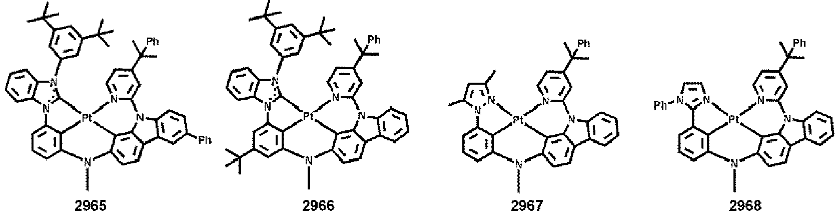

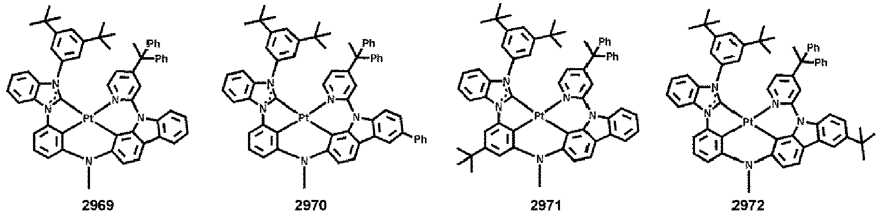

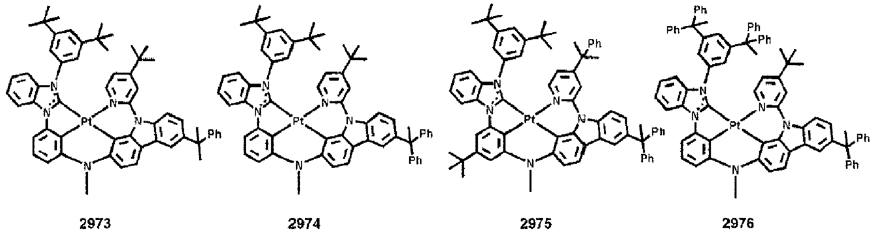

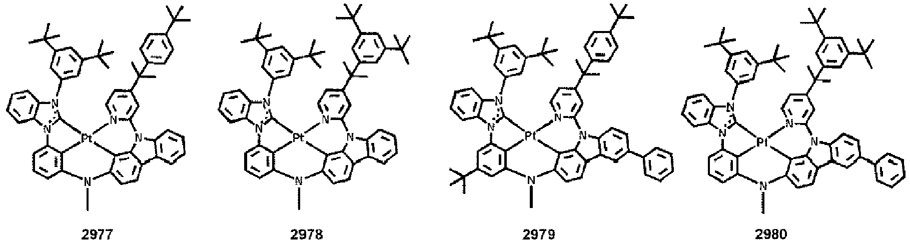

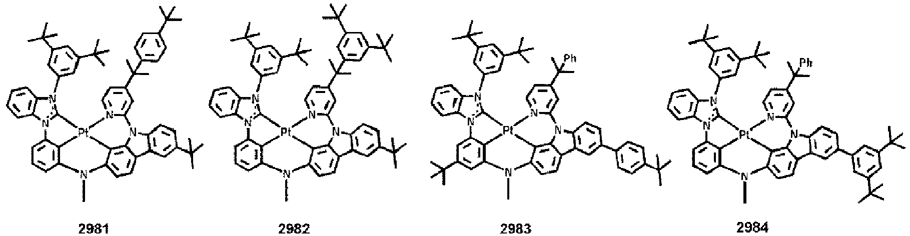

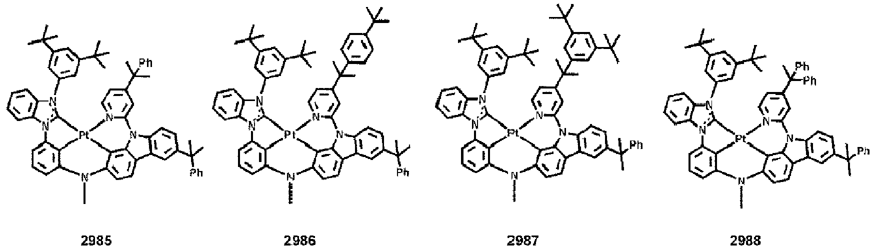

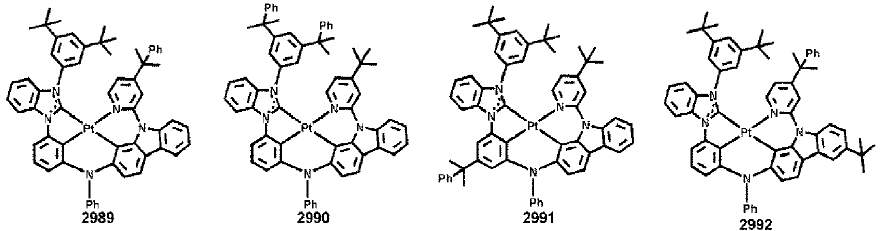

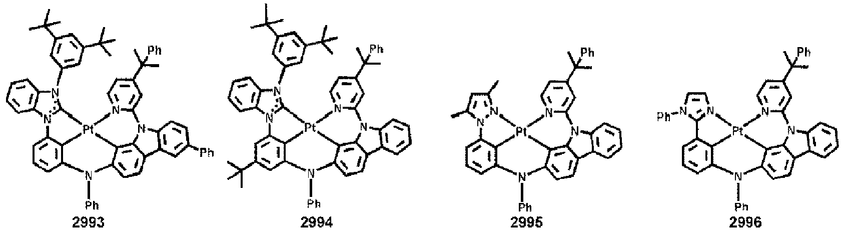

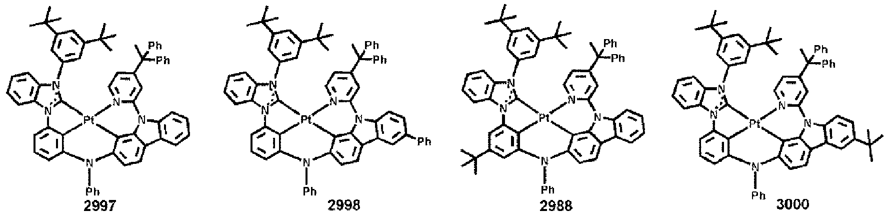

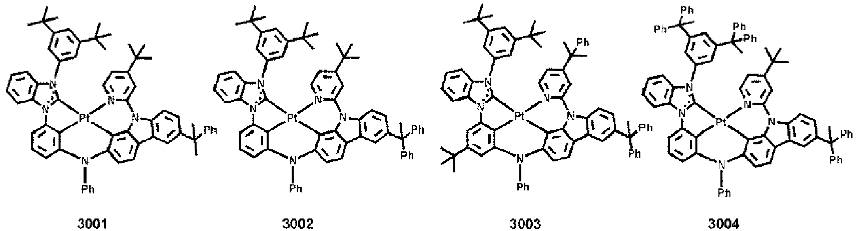

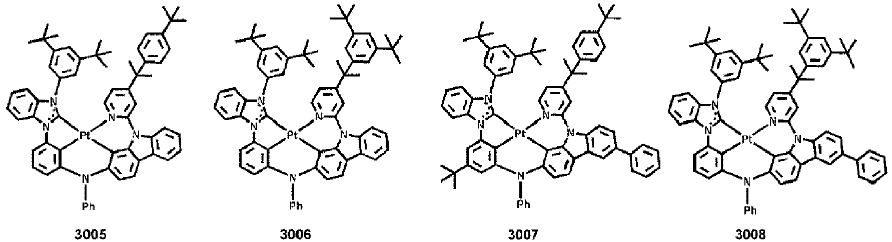

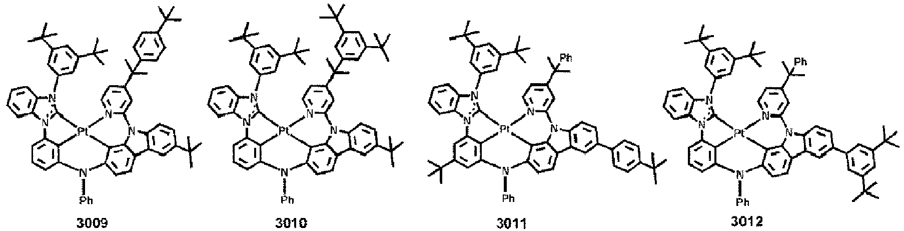

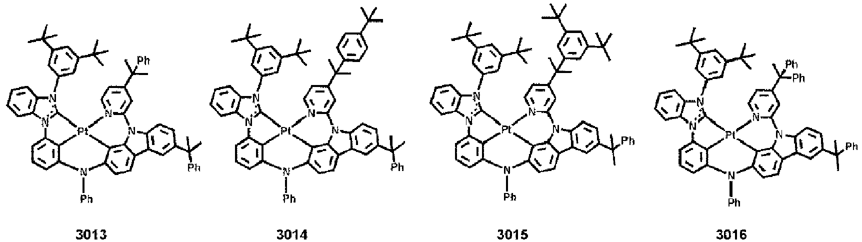

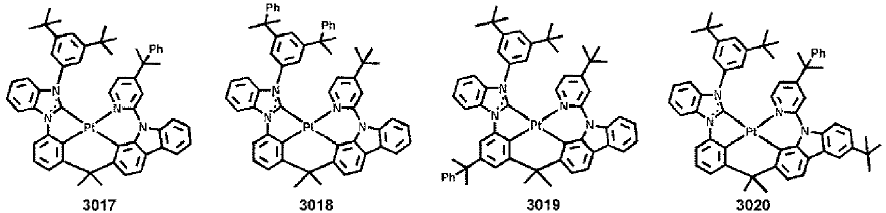

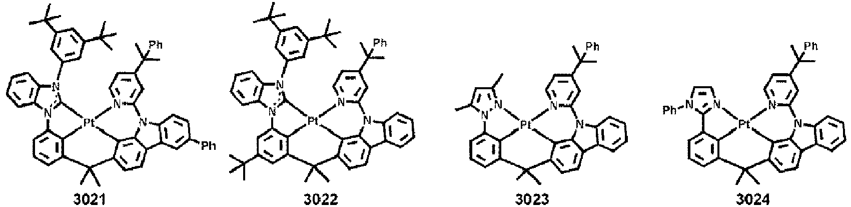

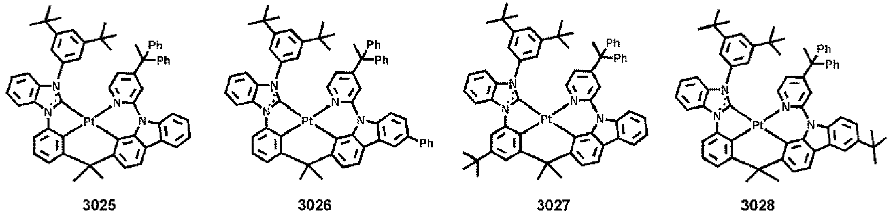

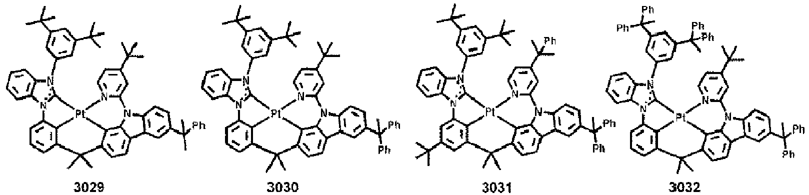

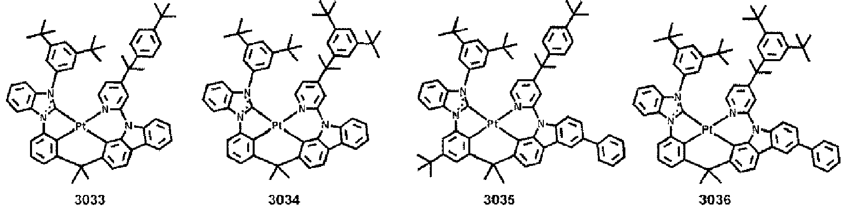

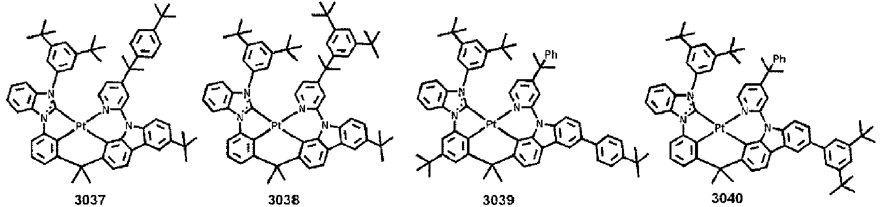

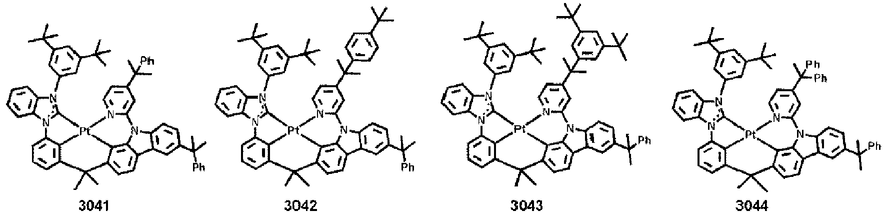

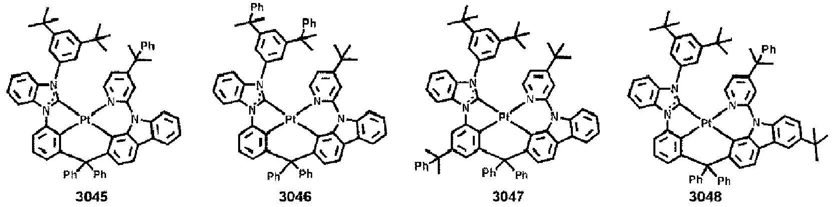

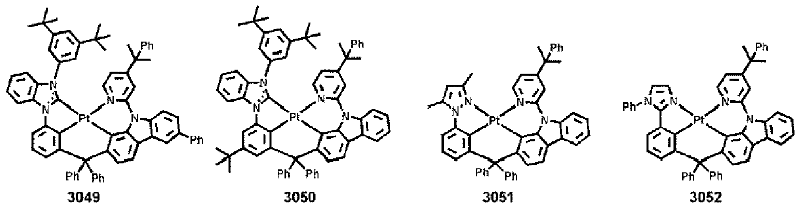

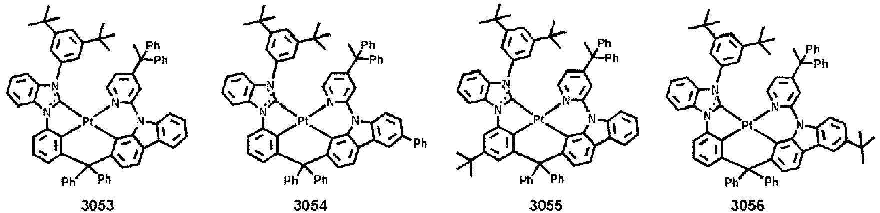

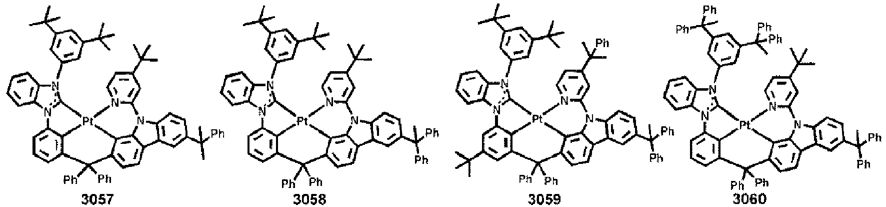

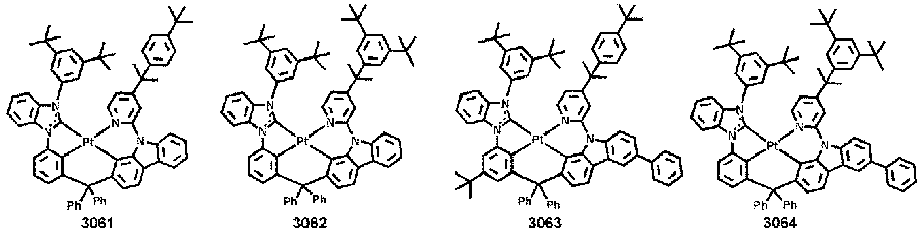

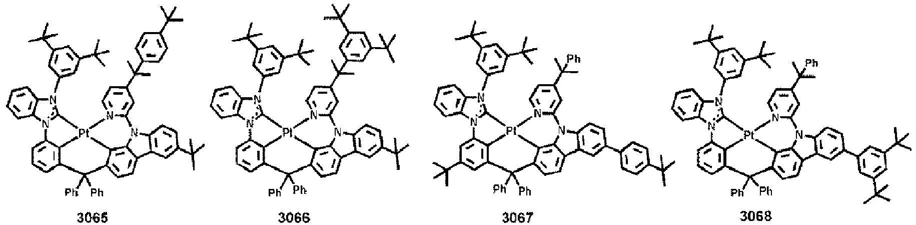

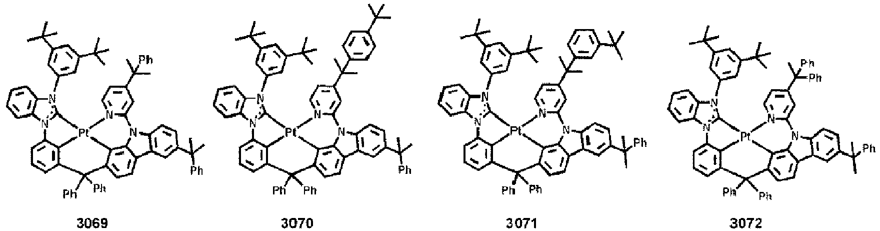

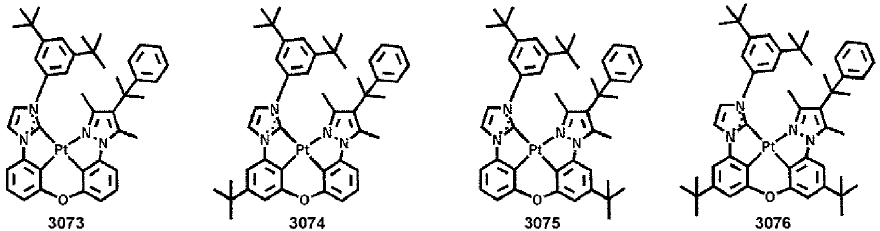

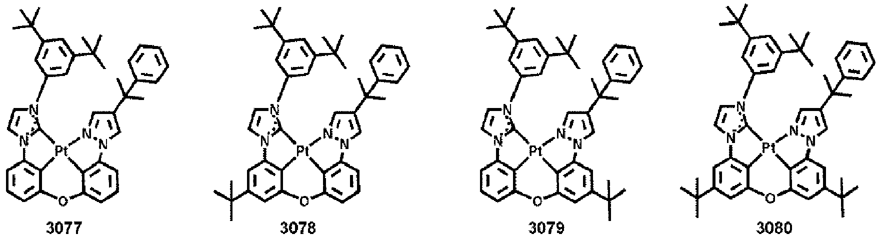

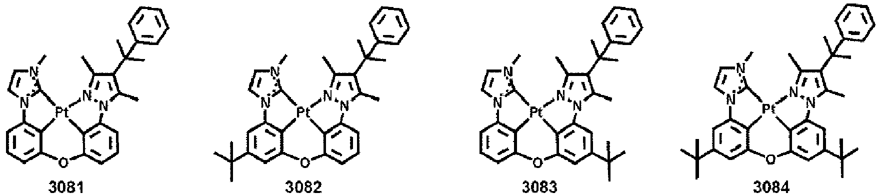

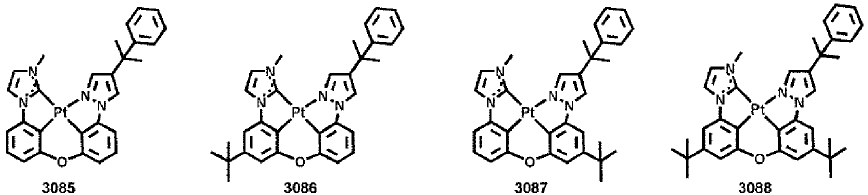

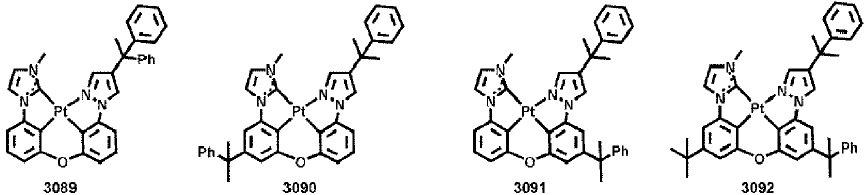

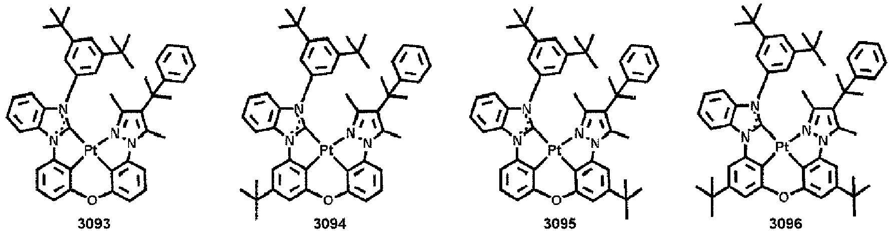

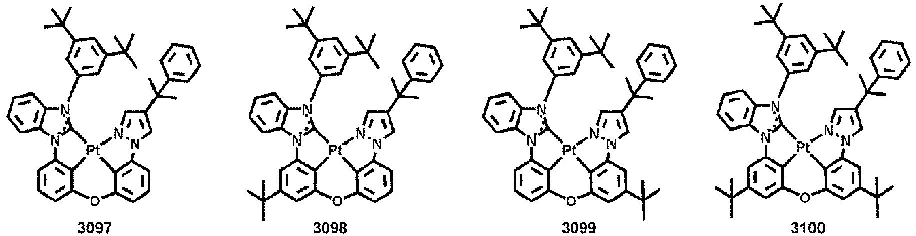

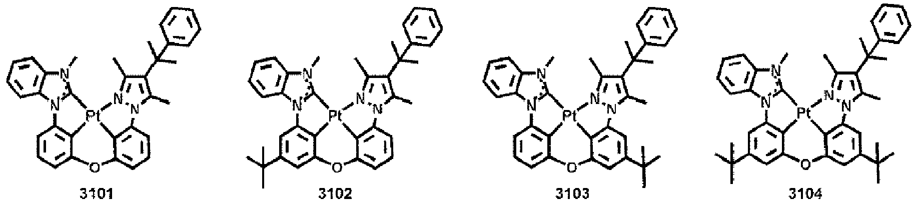

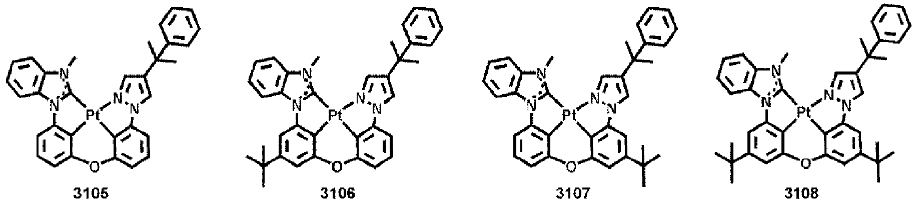

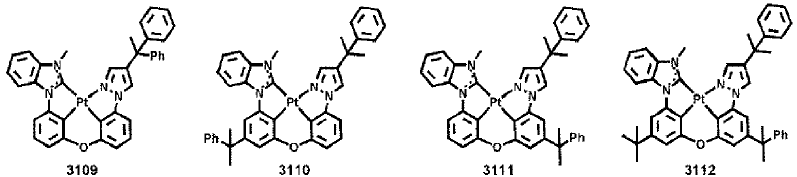

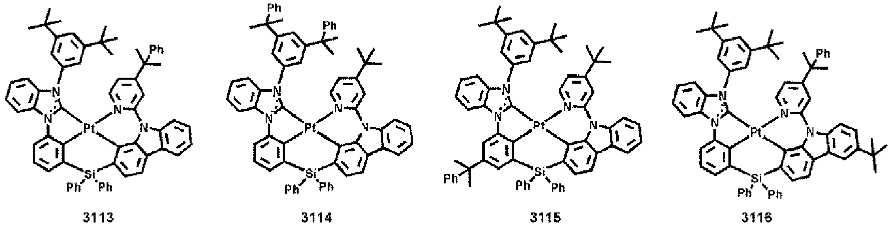

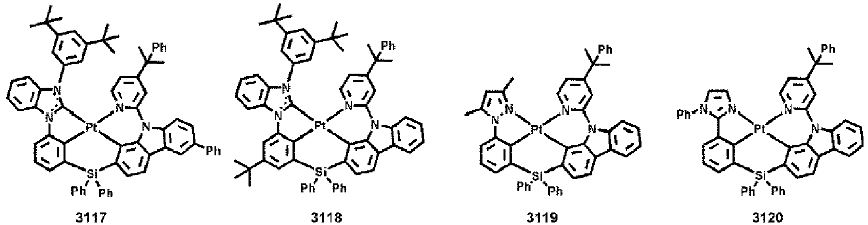

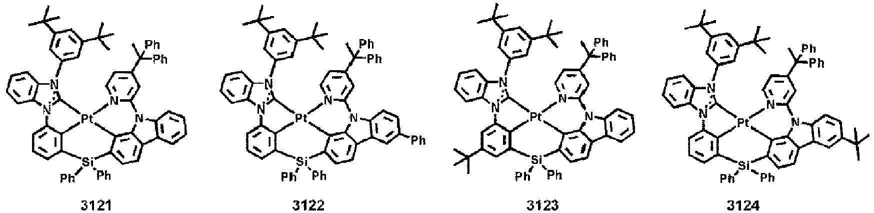

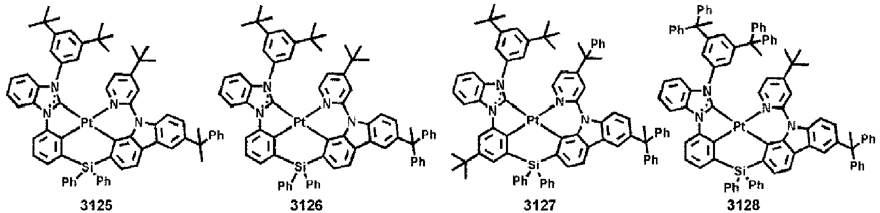

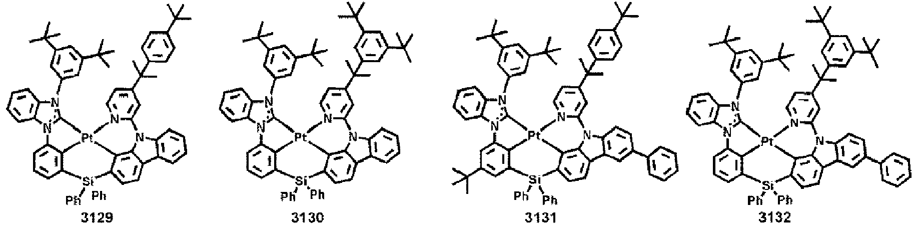

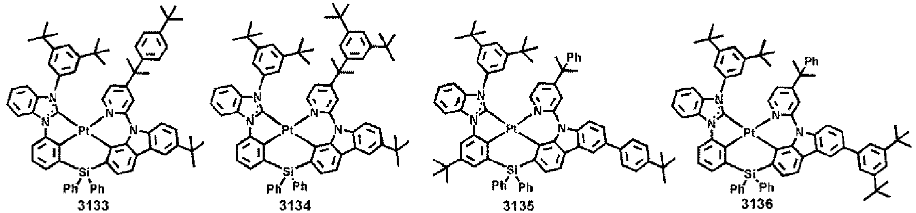

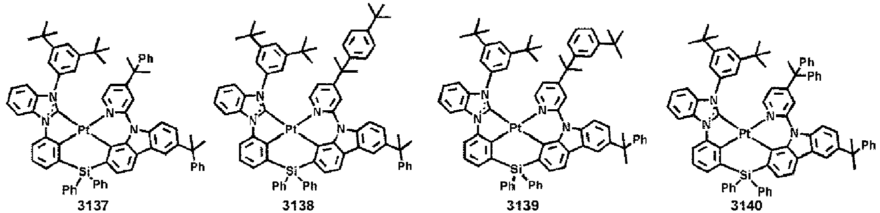

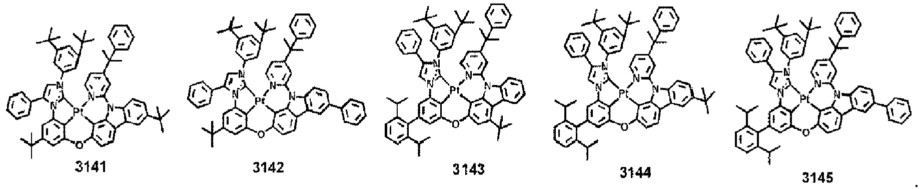

In the organometallic compound represented by Formula 1, Z₁ to Z₄ may each independently be the group represented by Formula 2, and the sum of b1 to b4, which respectively indicate the number of Z₁(s) to Z₄(s), may be 1 or greater. That is, the organometallic compound represented by Formula 1 may include at least one group represented by Formula 2. Accordingly, the organometallic compound represented by Formula 1 may have an improved orientation without a change in conjugation length. In addition, the group represented by *-C(Q₅₁)(Q₅₂)(Q₅₃) in the group represented by Formula 2 may not include hydrogen at a benzyl site including a weak chemical bond (that is, none of Q₅₁ to Q₅₃ in Formula 2 may be hydrogen). Thus, the organometallic compound including at least one group represented by Formula 2 may have excellent chemical and/or electrical stability. Accordingly, an electronic device, e.g., an organic light-emitting device, including the organometallic compound represented by Formula 1 may have improved luminescence efficiency and lifespan.

The highest occupied molecular orbital (HOMO) energy level, lowest unoccupied molecular orbital (LUMO) energy level, S₁ energy level, and T₁ energy level of some of the organometallic compounds represented by Formula 1 were evaluated by using Gaussian 09 that performs molecular structure optimizations according to density functional theory (DFT) at a degree of B3LYP. The results thereof are shown in Table 1.

**Table 1**

| Compound No. | HOMO (eV) | LUMO (eV) | T₁ (eV) |
|---|---|---|---|
| Pt-1 | -4.63 | -1.23 | 2.64 |
| Pt-2 | -4.65 | -1.23 | 2.64 |
| Pt-3 | -4.62 | -1.20 | 2.63 |
| Pt-4 | -4.62 | -1.21 | 2.64 |
| Pt-5 | -4.66 | -1.26 | 2.64 |
| Pt-6 | -4.61 | -1.22 | 2.61 |
| Pt-7 | -4.70 | -1.25 | 2.74 |
| Pt-8 | -4.56 | -1.13 | 2.60 |
| Pt-9 | -4.65 | -1.27 | 2.64 |
| Pt-10 | -4.66 | -1.28 | 2.64 |
| Pt-11 | -4.62 | -1.23 | 2.61 |
| Pt-12 | -4.64 | -1.22 | 2.64 |
| Pt-13 | -4.63 | -1.21 | 2.64 |
| Pt-14 | -4.65 | -1.25 | 2.64 |
| Pt-15 | -4.63 | -1.23 | 2.61 |
| Pt-16 | -4.67 | -1.25 | 2.64 |
| Pt-17 | -4.62 | -1.21 | 2.64 |
| Pt-18 | -4.62 | -1.20 | 2.65 |
| Pt-19 | -4.63 | -1.23 | 2.64 |
| Pt-20 | -4.64 | -1.22 | 2.65 |
| Pt-21 | -4.61 | -1.20 | 2.64 |
| Pt-22 | -4.60 | -1.19 | 2.65 |
| Pt-23 | -4.64 | -1.24 | 2.61 |
| Pt-24 | -4.64 | -1.24 | 2.62 |

Referring to the results shown in Table 1, the organometallic compound represented by Formula 1 was found to have suitable electrical characteristics for use as an emission layer material in an electronic device, e.g., an organic light-emitting device.

A method of synthesizing the organometallic compound represented by Formula 1 may be apparent to one of ordinary skill in the art by referring to Synthesis Examples provided herein.

The organometallic compound represented by Formula 1 may be suitable for use in an organic layer of an organic light-emitting device, e.g., as an emission layer material in the organic layer. Thus, according to another aspect, there is provided an organic light-emitting device that may include a first electrode; a second electrode; and an organic layer disposed between the first electrode and the second electrode and including an emission layer; wherein the organic layer may include at least one organometallic compound represented by Formula 1.

The organic light-emitting device may include an organic layer including the organometallic compound represented by Formula 1. Thus, the organic light-emitting device may have excellent driving voltage, excellent external quantum efficiency, a relatively small full width at half maximum (FWHM) of an emission peak in an electroluminescence (EL) spectrum, and excellent lifespan characteristics.

The organometallic compound represented by Formula 1 may be used in a pair of electrodes of an organic light-emitting device. For example, the organometallic compound represented by Formula 1 may be included in the emission layer. In some embodiments, the emission layer may further include a host. In some embodiments, a content of the host may be greater than a content of the organometallic compound. The emission layer may emit red light, green light, or blue light. In some embodiments, the organometallic compound may emit blue light.

In some embodiments, the emission layer may be a First Embodiment or a Second Embodiment.

### First Embodiment

The emission layer may include the organometallic compound represented by Formula 1, and the organometallic compound may serve as a phosphorescence emitter. For example, a ratio of emission components emitted from the organometallic compound may be 80 percent (%) or more, 85 % or more, 90 % or more, or 95 % or more of the total emission components emitted from the emission layer. Blue light may be emitted from the organometallic compound.

### Second Embodiment

The emission layer may further include, in addition to the organometallic compound represented by Formula 1, a phosphorescent dopant, a fluorescent dopant, or any combination thereof, which is different from the organometallic compound. Here, the organometallic compound may serve, not as a phosphorescence emitter, but as a sensitizer or an auxiliary dopant. In some embodiments, the emission layer may further include a fluorescent dopant, the fluorescent dopant may be different from the organometallic compound, and a ratio of emission components emitted from the fluorescent dopant may be 80 % or more, 85 % or more, 90 % or more, or 95 % or more of the total emission components emitted from the emission layer.

In the Second Embodiment, a content of the fluorescent dopant may be in a range of about 1 part to about 100 parts by weight, about 5 parts to about 50 parts by weight, or about 10 parts to about 20 parts by weight, based on 100 parts by weight of the organometallic compound represented by Formula 1.

In the Second Embodiment, a total content of the organometallic compound represented by Formula 1 and the fluorescent dopant may be in a range of about 1 part to about 30 parts by weight, about 3 parts to about 20 parts by weight, or about 5 parts to about 15 parts by weight, based on 100 parts by weight of the emission layer.

A fluorescent dopant that may be used in the Second Embodiment may not include a transition metal.

In some embodiments, a fluorescent dopant that may be used in the Second Embodiment may be a fluorescence-emitting material not including a cyano group (-CN) and a fluoro group (-F).

In some embodiments, a fluorescent dopant that may be used in the Second Embodiment may be a condensed ring-containing compound, an amino group-containing compound, a styryl group-containing compound, or a boron group-containing compound.

In some embodiments, a fluorescent dopant that may be used in the Second Embodiment may include an amino group-containing compound.

In some embodiments, the fluorescent dopant that may be used in the Second Embodiment may include a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group(a tetracene group), a picene group, a perylene group, a pentaphene group, an indenoanthracene group, a group represented by one of Formulae 501-1 to 501-21, or any combination thereof:

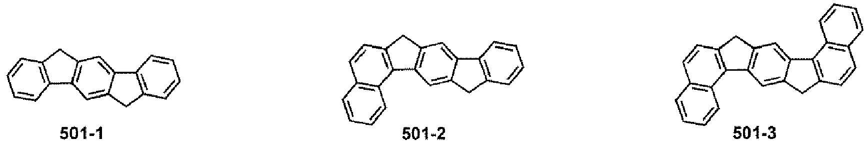

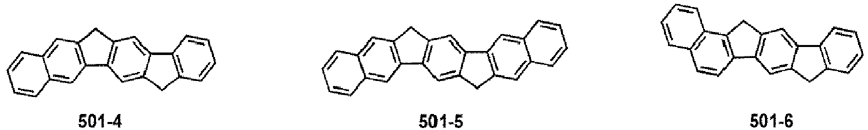

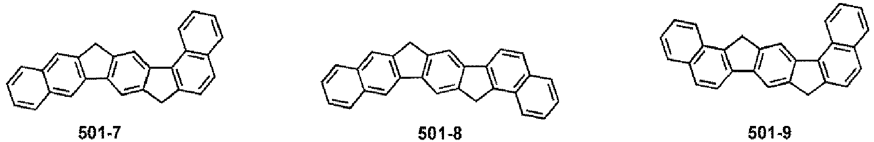

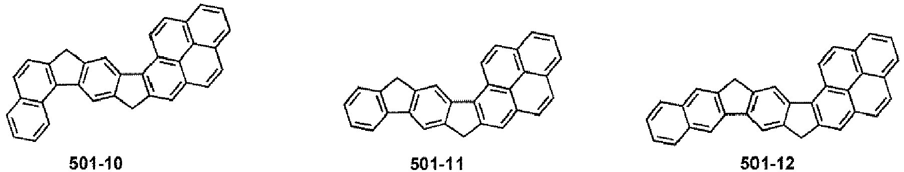

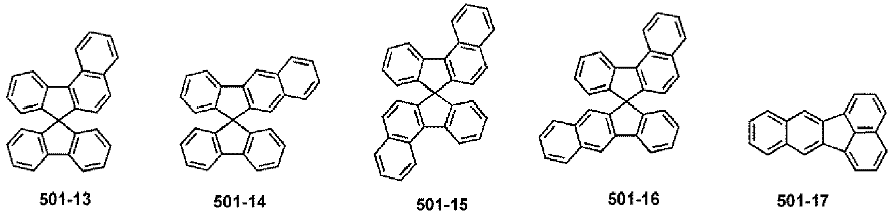

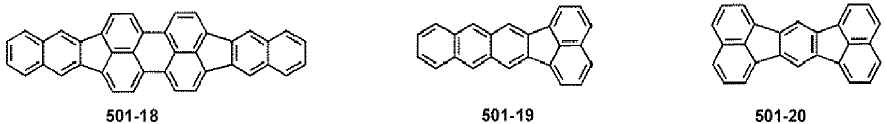

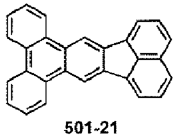

In one or more embodiments, the fluorescent dopant that may be used in the Second Embodiment may include a compound represented by Formula 501A or 501 B: 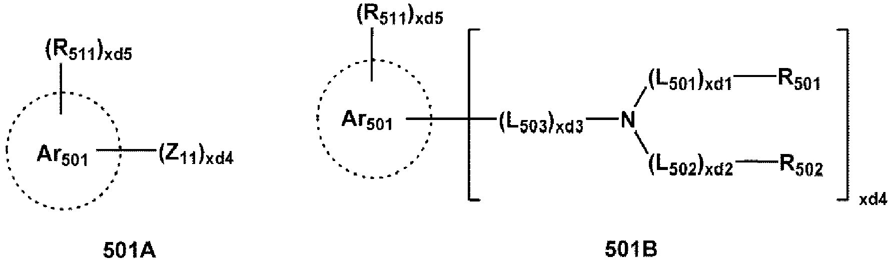
wherein, in Formulae 501A and 501B,
Ar₅₀₁ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, or a group represented by one of Formulae 501-1 to 501-21,
R₅₁₁ may be hydrogen, deuterium, -F, -CI, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or -Si(Q₅₀₁)(Q₅₀₂)(Q₅₀₃),
xd5 may be an integer from 0 to 10,
L₅₀₁ to L₅₀₃ may each independently be:
   a single bond; and
   a C₃-C₁₀ cycloalkylene group, a C₁-C₁₀ heterocycloalkylene group, a C₃-C₁₀ cycloalkenylene group, a C₂-C₁₀ heterocycloalkenylene group, an unsaturated C1-C10 heterocyclic group, a C₆-C₆₀ arylene group, a C₁-C₆₀ heteroarylene group, a divalent non-aromatic condensed polycyclic group, or a divalent non-aromatic condensed heteropolycyclic group, each unsubstituted or substituted with deuterium, -F, -CI, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C1-C10 heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₅₀₁)(Q₅₀₂)(Q₅₀₃), or any combination thereof,
xd1 to xd3 may each independently be 1, 2, or 3,
R₅₀₁ and R₅₀₂ may each independently be a phenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, a dibenzothiophenyl group, or a dibenzosilolyl group, each unsubstituted or substituted with deuterium, -F, -CI, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₅₀₁)(Q₅₀₂)(Q₅₀₃), or any combination thereof,
Z₁₁ may be a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -CI, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₅₀₁) (Q₅₀₂) (Q₅₀₃), or any combination thereof,
xd4 may be 1, 2, 3, 4, 5, or 6, and
wherein Q₅₀₁ to Q₅₀₃ may each independently be hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, or a monovalent non-aromatic condensed heteropolycyclic group.

In one or more embodiments, the fluorescent dopant may include a compound represented by Formula 501A or 501B, xd4 in Formula 501A may be 1, 2, 3, 4, 5, or 6, and xd4 in Formula 501B may be 2, 3, or 4.

In one or more embodiments, the fluorescent dopant may include one of Compounds FD(1) to FD(16), one of Compounds FD1 to FD16, or any combination thereof:

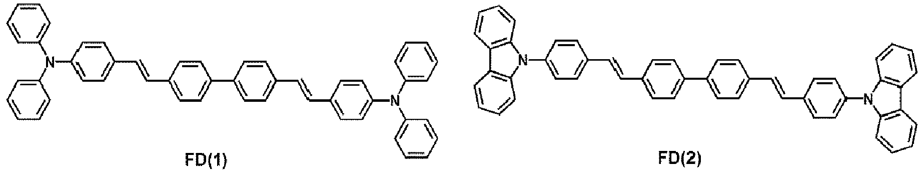

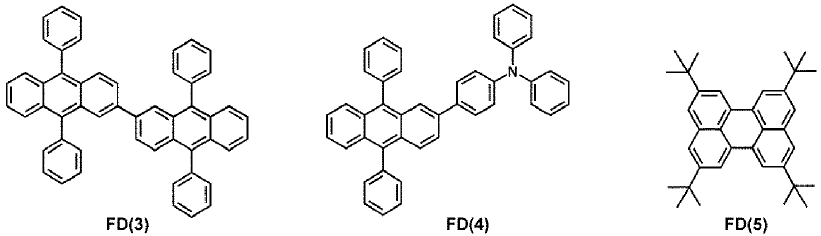

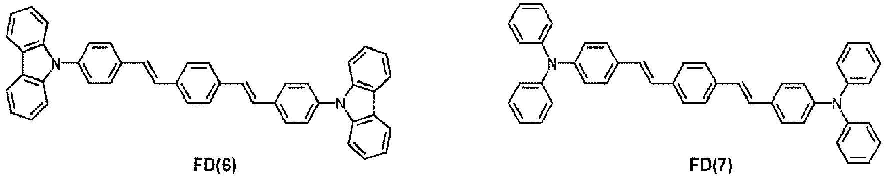

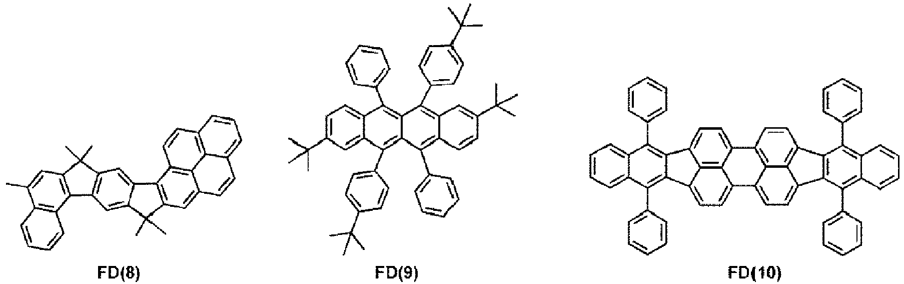

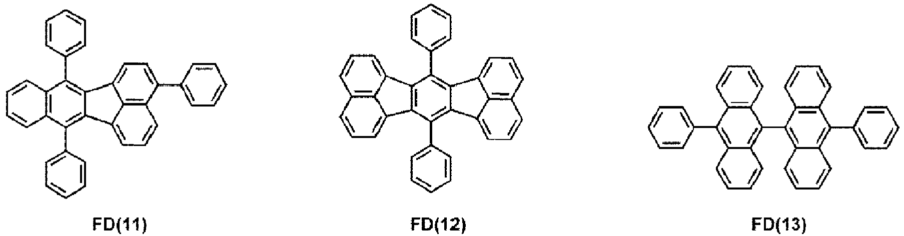

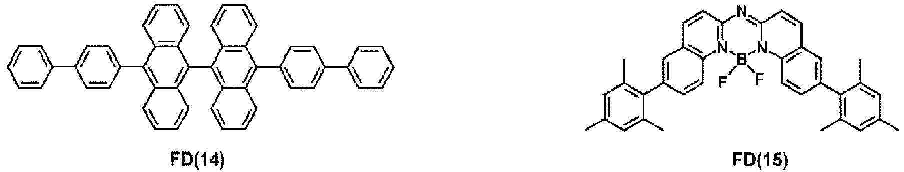

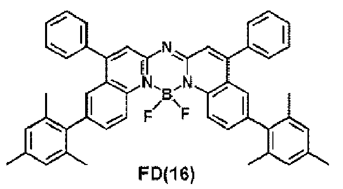

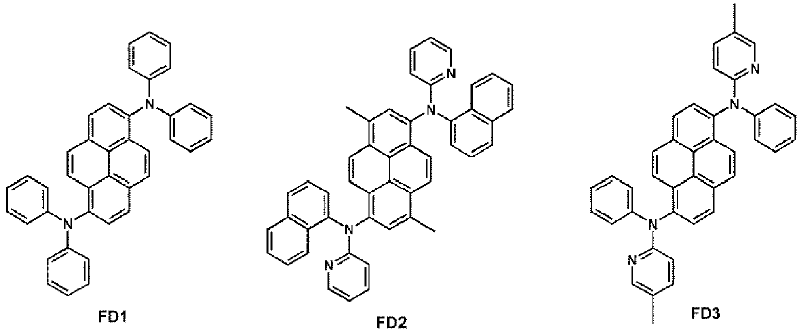

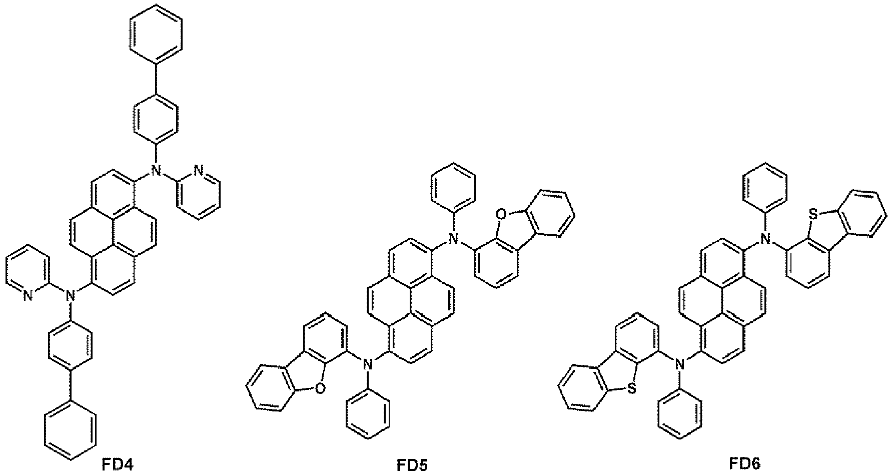

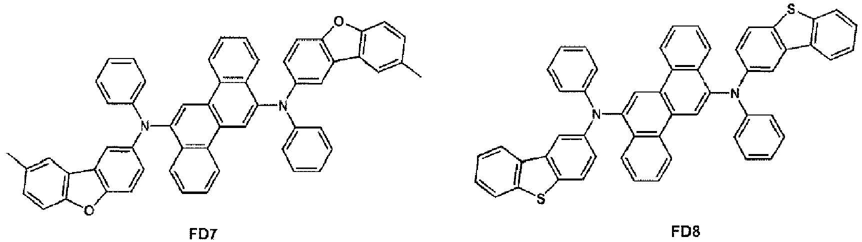

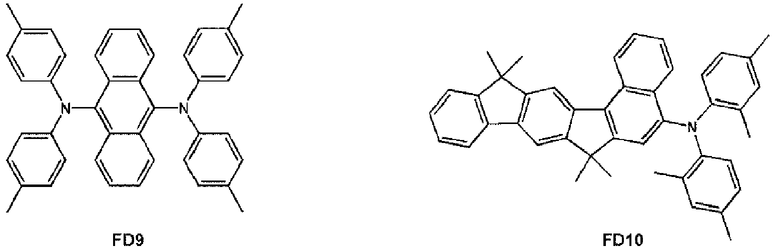

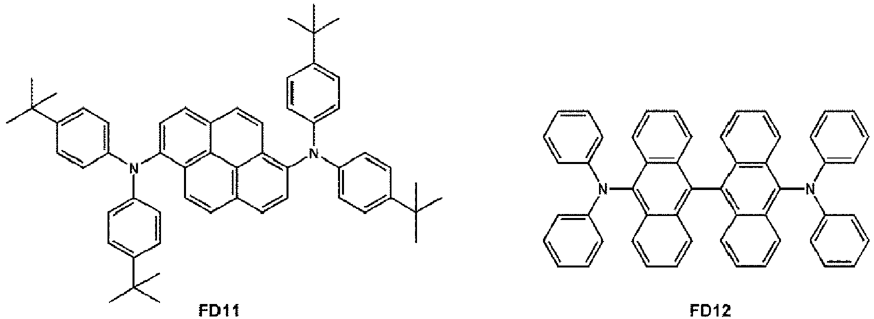

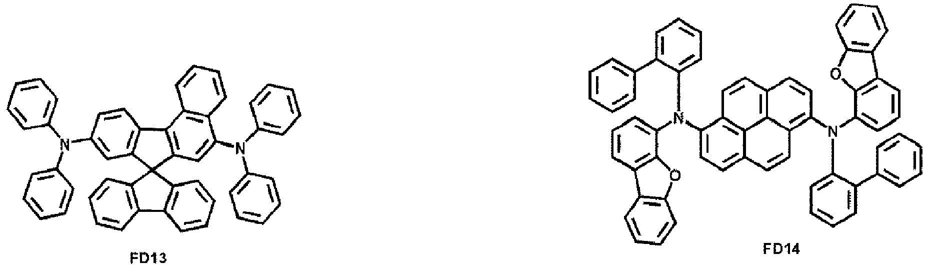

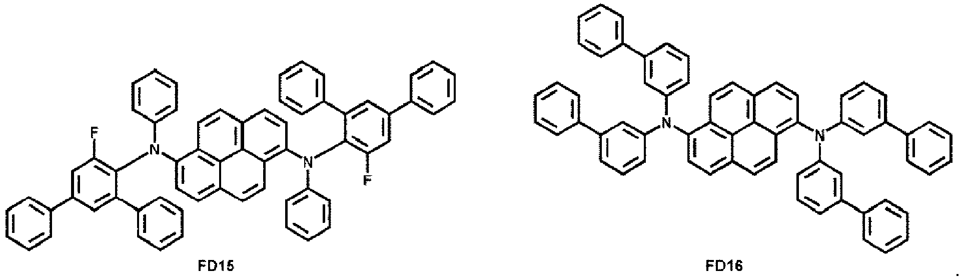

As used herein, the expression the "(organic layer) includes at least one organometallic compound" may be construed as meaning the "(organic layer) may include one organometallic compound of Formula 1 or two different organometallic compounds of Formula 1".

For example, Compound 1 may only be included in the organic layer as an organometallic compound. In this embodiment, Compound 1 may be included in the emission layer of the organic light-emitting device. In some embodiments, Compounds 1 and 2 may be included in the organic layer as organometallic compounds. In this embodiment, Compounds 1 and 2 may both be included in the same layer (for example, both Compounds 1 and 2 may be included in the emission layer).

The first electrode may be an anode, which is a hole injection electrode, and the second electrode may be a cathode, which is an electron injection electrode. In some embodiments, the first electrode may be a cathode, which is an electron injection electrode, and the second electrode may be an anode, which is a hole injection electrode.

For example, in the organic light-emitting device, the first electrode may be an anode, the second electrode may be a cathode, and the organic layer may further include a hole transport region disposed between the first electrode and the emission layer and an electron transport region disposed between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single and/or a plurality of layers between the first electrode and the second electrode in an organic light-emitting device. The "organic layer" may include not only organic compounds but also organometallic complexes including metals.

The FIGURE illustrates a schematic cross-sectional view of an organic light-emitting device 10 according to an exemplary embodiment. Hereinafter, a structure of an organic light-emitting device according to one or more embodiments and a method of manufacturing the organic light-emitting device will be described with reference to the FIGURE. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

The first electrode 11 may be formed by depositing or sputtering, onto the substrate, a material for forming the first electrode 11. The first electrode 11 may be an anode. The material for forming the first electrode 11 may include a material with a high work function for easy hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), and zinc oxide (ZnO). In some embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In some embodiments, the first electrode 11 may have a triple-layered structure of ITO/Ag/ITO.

The organic layer 15 may be on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or a combination thereof.

The hole transport region may include a hole injection layer only or a hole transport layer only. In some embodiments, the hole transport region may include a hole injection layer and a hole transport layer which are sequentially stacked on the first electrode 11. In some embodiments, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum deposition, for example, the vacuum deposition may be performed at a deposition temperature in a range of about 100°C to about 500°C, at a vacuum degree in a range of about 10⁻⁸ torr to about 10⁻³ torr, and at a deposition rate in a range of about 0.01 Angstroms per second (Å/sec) to about 100 Å/sec, though the conditions may vary depending on a compound that is used as a hole injection material and a structure and thermal properties of a desired hole injection layer, but conditions for the vacuum deposition are not limited thereto.

When a hole injection layer is formed by spin coating, the spin coating may be performed at a coating rate in a range of about 2,000 revolutions per minute (rpm) to about 5,000 rpm, and at a temperature in a range of about 80°C to 200°C, to facilitate removal of a solvent after the spin coating, though the conditions may vary depending on a compound that is used as a hole injection material and a structure and thermal properties of a desired hole injection layer, but conditions for the spin coating are not limited thereto.

The conditions for forming a hole transport layer and an electron blocking layer may be inferred from the conditions for forming the hole injection layer.

The hole transport region may include m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor-sulfonic acid (PANI/CSA), polyaniline/poly(4-styrene sulfonate) (PANI/PSS), a compound represented by Formula 201, a compound represented by Formula 202, or any combination thereof: 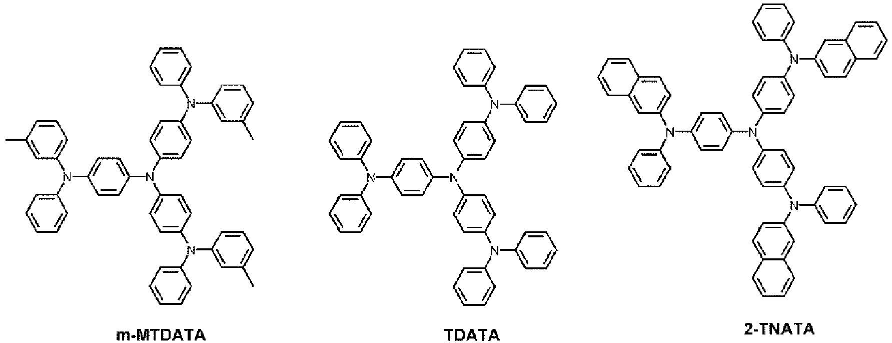 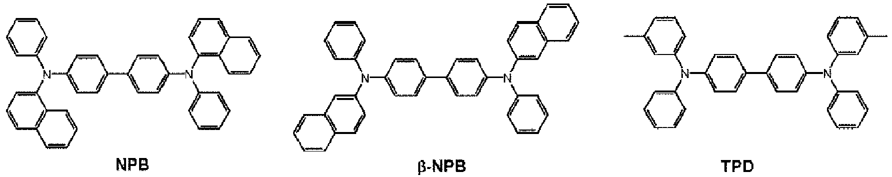 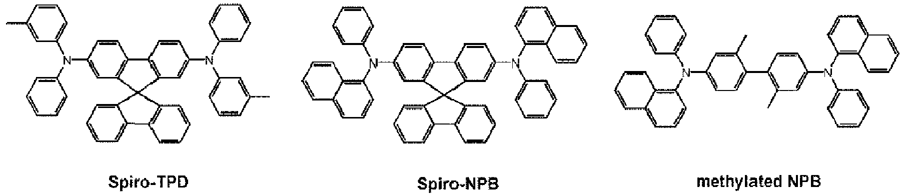 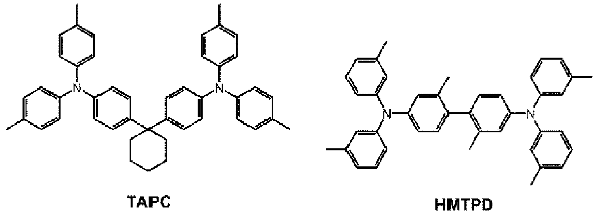 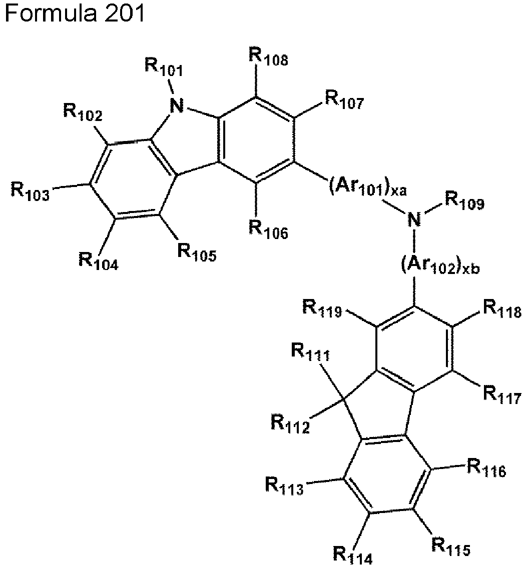 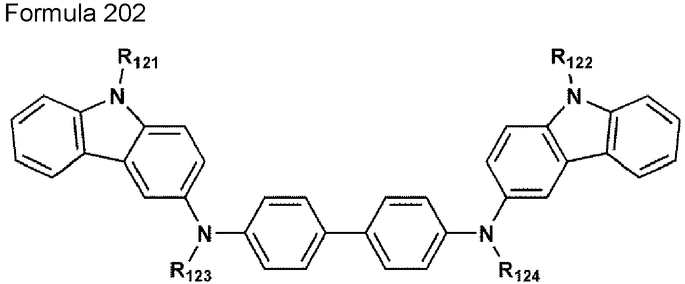 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, - CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5. In some embodiments, xa and xb may each independently be an integer from 0 to 2. In some embodiments, xa may be 1, and xb may be 0, but embodiments are not limited thereto.

In Formulae 201 and 202, R₁₀₁ to R₁₀₈, R₁₁₁ to R₁₁₉, and R₁₂₁ to R₁₂₄ may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, pentyl group, or a hexyl group), or a C₁-C₁₀ alkoxy group (e.g., a methoxy group, an ethoxy group, a propoxy group, a butoxy group, or a pentoxy group);
a C₁-C₁₀ alkyl group or a C₁-C₁₀ alkoxy group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or
a phenyl group, a naphthyl group, an anthracenyl group, a fluorenyl group, or a pyrenyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or any combination thereof. In Formula 201, R₁₀₉ may be a phenyl group, a naphthyl group, an anthracenyl
group, or a pyridinyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In some embodiments, the compound represented by Formula 201 may be represented by Formula 201A: 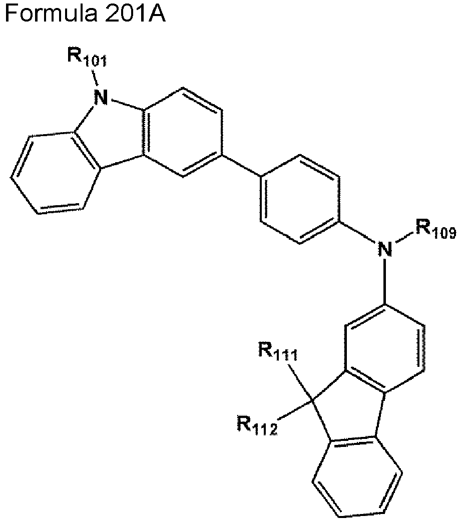 wherein, in Formula 201A, R₁₀₁, R₁₁₁, R₁₁₂, and R₁₀₉ may respectively be understood by referring to the descriptions of R₁₀₁, R₁₁₁, R₁₁₂, and R₁₀₉ provided herein. In some embodiments, the hole transport region may include one of Compounds HT1 to HT20 or any combination thereof:

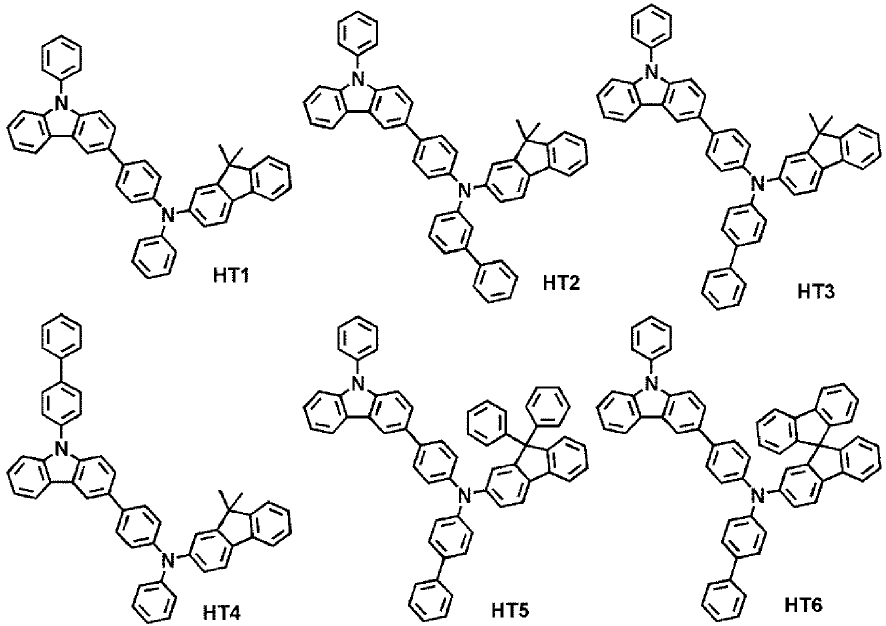

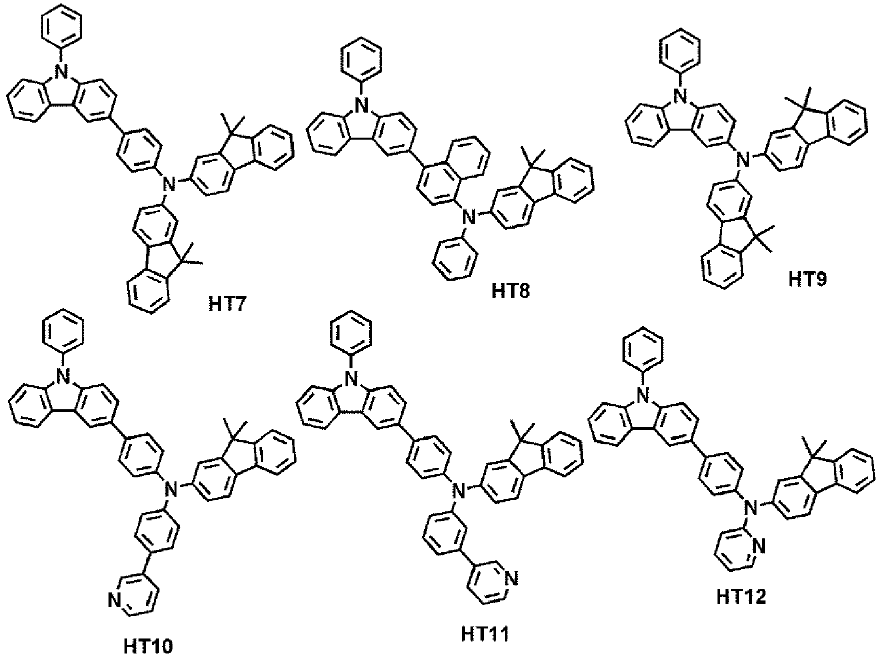

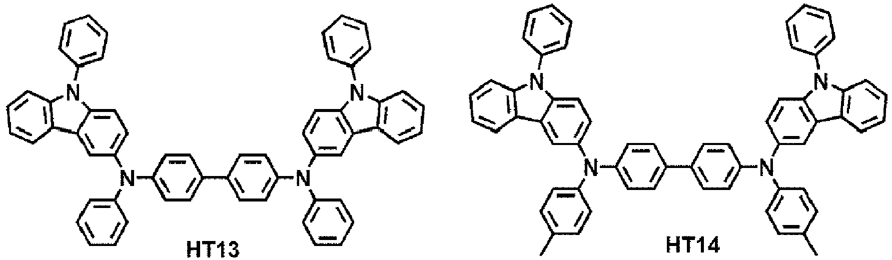

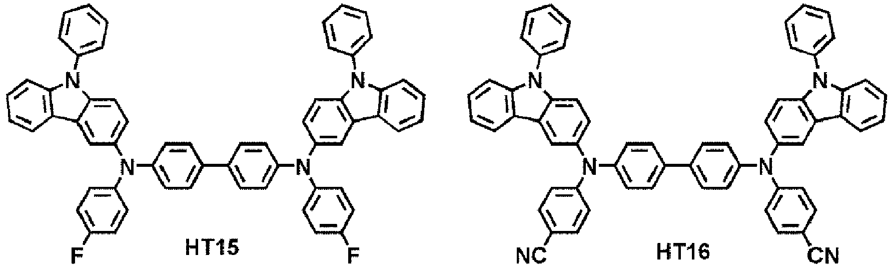

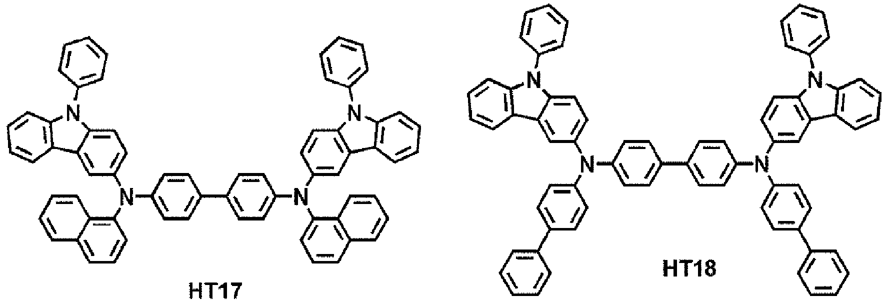

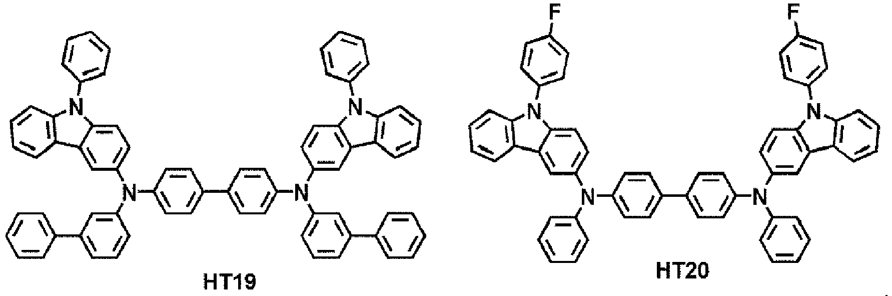

The thickness of the hole transport region may be in a range of about 100 (Angstroms) Å to about 10,000 Å, and in some embodiments, about 100 Å to about 1,000 Å. When the hole transport region includes a hole injection layer, a hole transport layer an electron blocking layer, or any combination thereof, the thickness of the hole injection layer may be in a range of about 100 Å to about 10,000 Å, and in some embodiments, about 100 Å to about 1,000 Å, and the thickness of the hole transport layer may be in a range of about 50 Å to about 2,000 Å, and in some embodiments, about 100 Å to about 1,500 Å. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may be a quinone derivative, a metal oxide, a compound containing a cyano group, or any combination thereof, but embodiments are not limited thereto. In some embodiments, the p-dopant may be a quinone derivative, such as tetracyanoquinodimethane (TCNQ), a 2,3,5,6-tetrafluoro-tetracyano-1,4-benzoquinonedimethane (F4-TCNQ), or F6-TCNNQ; a metal oxide, such as a tungsten oxide or a molybdenum oxide; a compound containing a cyano group, such as Compound HT-D1; or any combination thereof:

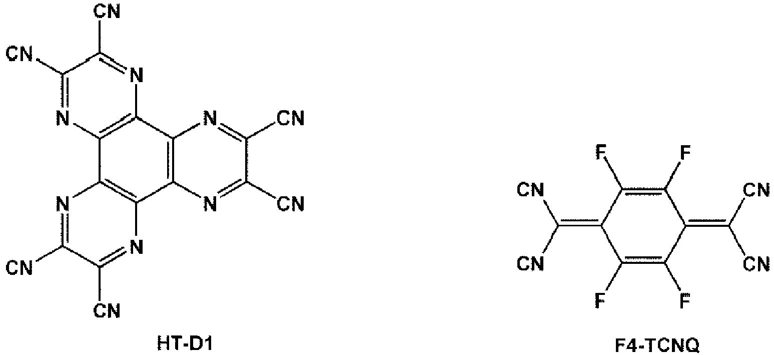

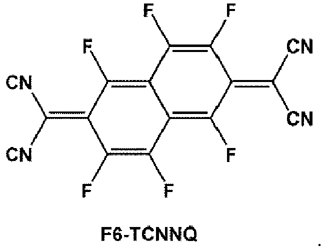

The hole transport region may further include a buffer layer.

The buffer layer may compensate for an optical resonance distance depending on a wavelength of light emitted from the emission layer to improve the efficiency of an organic light-emitting device.

When the hole transport region includes an electron blocking layer, a material for forming the electron blocking layer may include the material for forming a hole transport region, the host material described herein or any combination thereof. In some embodiments, when the hole transport region includes an electron blocking layer, mCP described herein or the like may be used for forming the electron blocking layer.

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to those conditions for forming a hole injection layer, though the conditions may vary depending on a compound that is used.

The emission layer may include a host and a dopant, and the dopant may include the organometallic compound represented by Formula 1 described herein.

The host may include TPBi, TBADN, ADN (also known as "DNA"), CBP, CDBP, TCP, mCP, Compound H50, Compound H51, Compound H52, or any combination thereof:

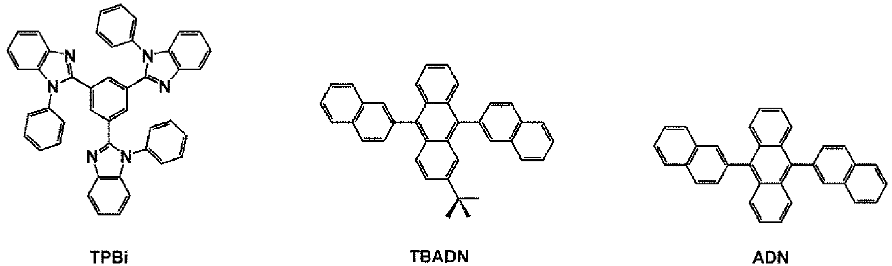

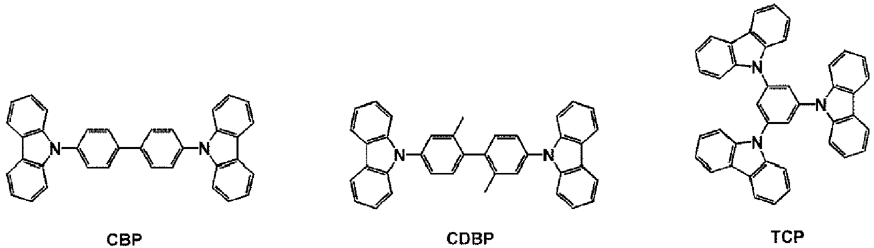

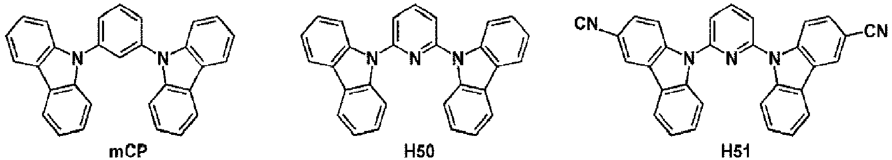

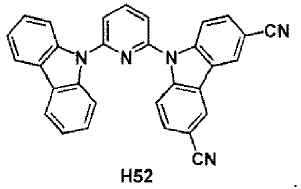

When the organic light-emitting device 10 is a full-color organic light-emitting device, the emission layer may be patterned into a red emission layer, a green emission layer, and/or a blue emission layer. In some embodiments, the emission layer may have a structure in which the red emission layer, the green emission layer, and/or the blue emission layer are layered to emit white light. In some embodiments, the structure of the emission layer may vary.

When the emission layer includes the host and the dopant, an amount of the dopant may be a range of about 0.01 parts to about 15 parts by weight based on about 100 parts by weight of the host, but embodiments are not limited thereto.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

Next, an electron transport region may be formed on the emission layer.

The electron transport region may include a hole blocking layer, an electron transport layer, an electron injection layer, or a combination thereof.

In some embodiments, the electron transport region may have a hole blocking layer/an electron transport layer/an electron injection layer structure or an electron transport layer/an electron injection layer structure, but embodiments are not limited thereto. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer may include, for example, at least one BCP, Bphen, and BAlq:

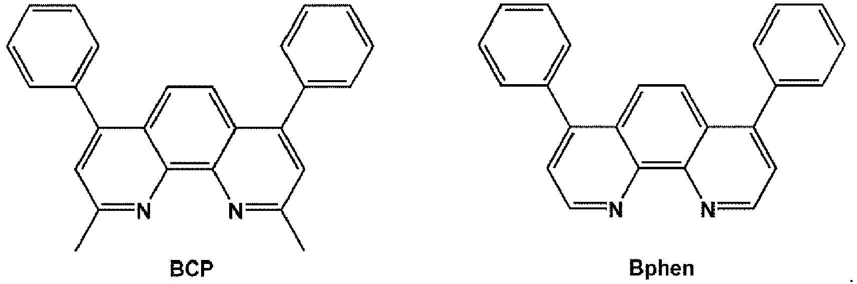

In some embodiments, the hole blocking layer may include the host, the material for forming an electron transport layer described herein, the material for forming an electron injection layer described herein, or any combination thereof.

The thickness of the hole blocking layer may be in a range of about 20 Å to about 1,000 Å, and in some embodiments, about 30 Å to about 600 Å. When the thickness of the hole blocking layer is within any of these ranges, excellent hole blocking characteristics may be obtained without a substantial increase in driving voltage.

The electron transport layer may include BCP, Bphen, TPBi, Alq₃, BAlq, TAZ, NTAZ, or any combination thereof:

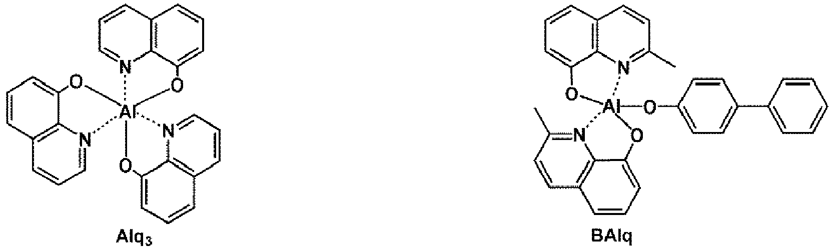

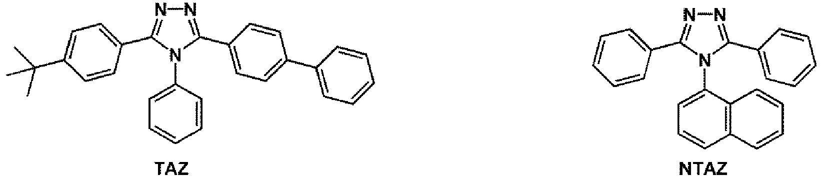

In some embodiments, the electron transport layer may include one of Compounds ET1 to ET25 or any combination thereof:

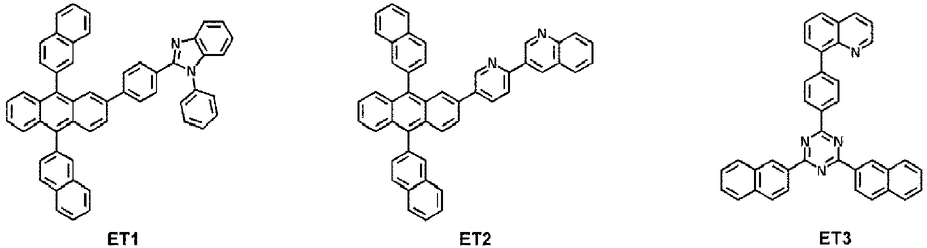

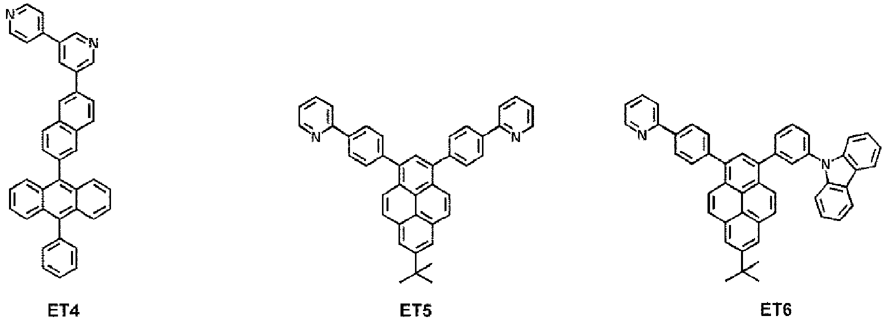

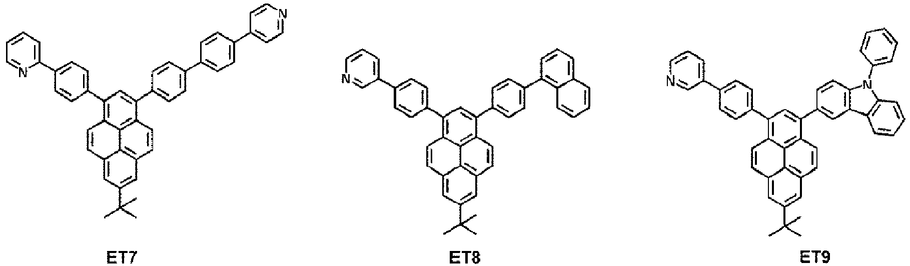

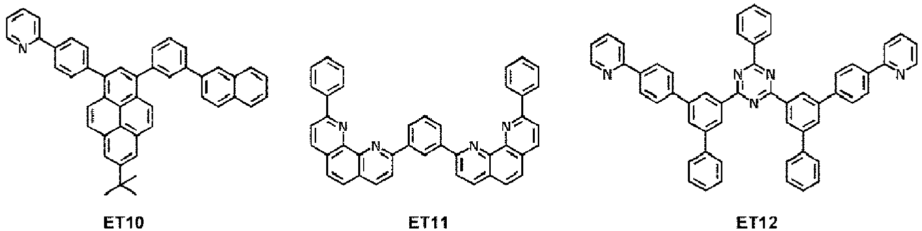

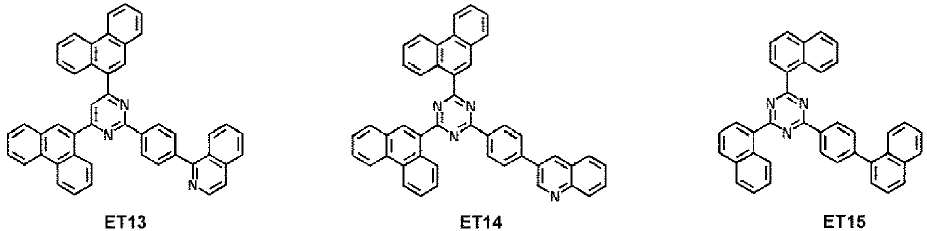

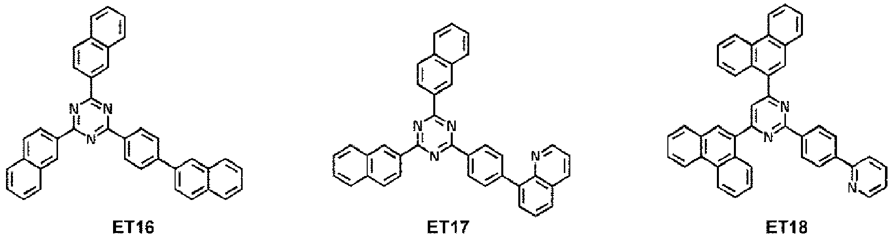

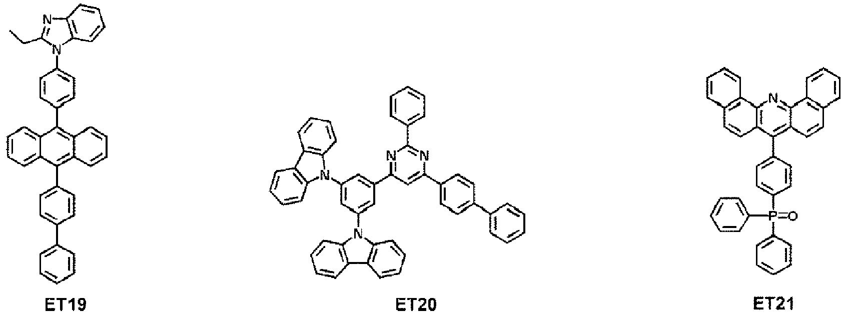

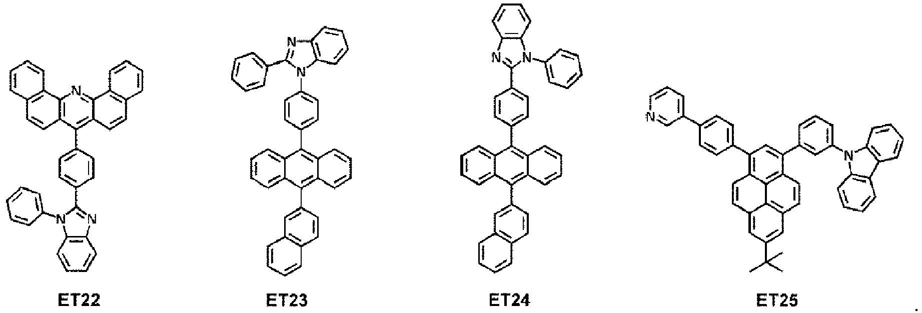

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport layer may further include a material containing metal, in addition to the materials described above.

The material containing metal may include a Li complex. The Li complex may include, e.g., Compound ET-D1 or Compound ET-D2:

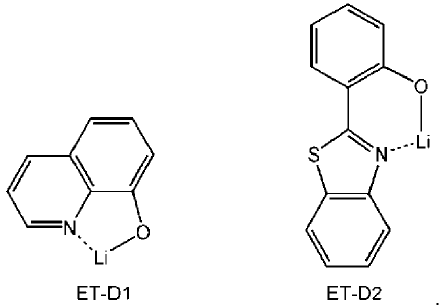

The electron transport region may include an electron injection layer that facilitates electron injection from the second electrode 19.

The electron injection layer may include LiF, NaCl, CsF, Li₂O, BaO, or any combination thereof.

The thickness of the electron injection layer may be in a range of about 1 Å to about 100 Å, for example, about 3 Å to about 90 Å. When the thickness of the electron injection layer is within any of these ranges, excellent electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, or any combination thereof. Examples of the material for forming the second electrode 19 may include lithium (Li), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore the organic light-emitting device 10 has been described with reference to the FIGURE, but embodiments are not limited thereto.

According to another aspect, the organic light-emitting device may be included in an electronic apparatus. Thus, another aspect of the present disclosure provides an electronic apparatus including the organic light-emitting device. The electronic apparatus may include, for example, a display, an illumination, a sensor, and the like.

According to an aspect of still another embodiment, a diagnostic composition may include at least one organometallic compound represented by Formula 1.

Since the organometallic compound represented by Formula 1 provides high luminescence efficiency, the diagnostic efficiency of the diagnostic composition that includes the organometallic compound represented by Formula 1 may be excellent.

The diagnostic composition may be applied in various ways, such as in a diagnostic kit, a diagnostic reagent, a biosensor, or a biomarker.

All groups and compounds are understood to include all possible isomers, including structural isomers, occurring in the groups or compounds. Structural isomers differ from each other in the connectivity of the constituent atoms. By way of general example, and without limitation, the structural isomers of oxadiazole include 1,2,3-oxadiazole, 1,2,4-oxadiazole, 1,2,5-oxadiazole, and 1,3,4-oxadiaozole.

The term "C₁-C₆₀ alkyl group" as used herein refers to a linear or branched saturated aliphatic hydrocarbon monovalent group having 1 to 60 carbon atoms. The term "C₁-C₆₀ alkylene group" as used herein refers to a divalent group having the same structure as the C₁-C₆₀ alkyl group.

Examples of the C₁-C₆₀ alkyl group, the C₁-C₂₀ alkyl group, and/or the C₁-C₁₀ alkyl group as used herein may include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or any combination thereof. In some embodiments, Formula 9-33 may be a branched C₆ alkyl group. Formula 9-33 may be a tert-butyl group substituted with two methyl groups.

The term "C₁-C₆₀ alkoxy group" as used herein refers to a monovalent group represented by -OA₁₀₁ (wherein A₁₀₁ is a C₁-C₆₀ alkyl group).

Examples of the C₁-C₆₀ alkoxy group, the C₁-C₂₀ alkoxy group, or the C₁-C₁₀ alkoxy group as used herein may include a methoxy group, an ethoxy group, a propoxy group, a butoxy group, or a pentoxy group.

The term "C₂-C₆₀ alkenyl group" as used herein refers to a group formed by placing at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a group formed by placing at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent cyclic saturated hydrocarbon group including 3 to 10 carbon atoms. The term "C₃-C₁₀ cycloalkylene group" as used herein refers to a divalent group having the same structure as the C₃-C₁₀ cycloalkyl group.

Examples of the C₃-C₁₀ cycloalkyl group as used herein may include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl group (a norbornanyl group), or a bicyclo[2.2.2]octyl group.

The term "C₁-C₁₀ heterocycloalkyl group" as used herein refers to a monovalent monocyclic group including at least one N, O, P, Si, B, Se, Ge, S, or any combination thereof as a ring-forming atom and 1 to 10 carbon atoms. The term "C₁-C₁₀ heterocycloalkylene group" as used herein refers to a divalent group having the same structure as the C₁-C₁₀ heterocycloalkyl group.

Examples of the C₁-C₁₀ heterocycloalkyl group as used herein may include a silolanyl group, a silinanyl group, a tetrahydrofuranyl group, a tetrahydro-2H-pyranyl group, or a tetrahydrothiophenyl group.

The term "C₃-C₁₀ cycloalkenyl group" as used herein refers to a monovalent monocyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₂-C₁₀ heterocycloalkenyl group" as used herein refers to a monovalent monocyclic group including at least one N, O, P, Si, B, Se, Ge, S, or any combination thereof as a ring-forming atom, 2 to 10 carbon atoms, and at least one carbon-carbon double bond in its ring. Examples of the C₂-C₁₀ heterocycloalkenyl group include a 2,3-dihydrofuranyl group and a 2,3-dihydrothiophenyl group. The term "C₂-C₁₀ heterocycloalkylene group" as used herein refers to a divalent group having the same structure as the C₂-C₁₀ heterocycloalkenyl group.

The term "unsaturated C₁-C₁₀ heterocyclic group" as used herein refers to a monovalent monocyclic group including at least one N, O, P, Si, B, Se, Ge, S, or any combination thereof as a ring-forming atom, 1 to 10 carbon atoms, and at least one heteroatom-carbon double bond, heteroatom-heteroatom double bond, or a combination thereof in its ring. Examples of the unsaturated C₁-C₁₀ heterocyclic group include an oxazine group and an imidazoline group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include a plurality of rings, the plurality of rings may be fused to each other.

The term "C₇-C₆₀ alkyl aryl group" as used herein refers to a C₆-C₅₉ aryl group substituted with at least one C₁-C₅₄ alkyl group.

The term "C₁-C₆₀ heteroaryl group" as used herein refers to a monovalent group having a heterocyclic aromatic system having at least one N, O, P, Si, B, Se, Ge, S, or any combination thereof as a ring-forming atom and 1 to 60 carbon atoms. The term "C₁-C₆₀ heteroarylene group" as used herein refers to a divalent group having a heterocyclic aromatic system having at least one N, O, P, Si, B, Se, Ge, S, or any combination thereof as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include a plurality of rings, the plurality of rings may be fused to each other.

The term "C₂-C₆₀ alkyl heteroaryl group" as used herein refers to a C₁-C₅₉ heteroaryl group substituted with at least one C₁-C₅₉ alkyl group.

The term "C₆-C₆₀ aryloxy group" as used herein is represented by -OA₁₀₂ (wherein A₁₀₂ is the C₆-C₆₀ aryl group). The term "C₆-C₆₀ arylthio group" as used herein is represented by -SA₁₀₃ (wherein A₁₀₃ is the C₆-C₆₀ aryl group). The term "C₁-C₆₀ alkylthio group" as used herein is represented by -SA₁₀₄ (wherein A₁₀₄ is the C₁-C₆₀ alkyl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a N, O, P, Si, B, Se, Ge, S, or any combination thereof and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. Examples of the "C₅-C₃₀ carbocyclic group (unsubstituted or substituted with at least one R₁₀ₐ)" may include an adamantane group, a norbornene group, a bicyclo[1.1.1]pentane group, a bicyclo[2.1,1]hexane group, a bicyclo[2.2.1]heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group, each (unsubstituted or substituted with at least one R₁₀ₐ).

The term "C₁-C₃₀ heterocyclic group" as used herein refers to saturated or unsaturated cyclic group including 1 to 30 carbon atoms and at least one N, O, P, Si, B, Se, Ge, S, or any combination thereof as ring-forming atoms. The C₁-C₃₀ heterocyclic group may be a monocyclic group or a polycyclic group. Examples of the "C₁-C₃₀ heterocyclic group (unsubstituted or substituted with at least one R₁₀ₐ)" may include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a 1,3,5-triazine group, a 1,2,3-triazine group, a 1,2,4-triazine group, a quinoline group, an isoquinoline group, a quinoxaline group, a quinazoline group, a phenanthroline group, a pyrazole group, an imidazole group, a 1,2,3-triazole group, a 1,2,4-triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one R₁₀ₐ).

The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", and "deuterated phenyl group" as used herein may respectively be a C₁-C₆₀ alkyl group (or C₁-C₂₀ alkyl group or the like), C₃-C₁₀ cycloalkyl group, a C₁-C₁₀ heterocycloalkyl group, and a phenyl group, each substituted with at least one deuterium. Examples of the "deuterated C₁ alkyl group (i.e., a deuterated methyl group)" may include -CD₃, -CD₂H, and -CDH₂. Examples of the "deuterated C₃-C₁₀ cycloalkyl group" may include Formula 10-501. The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", or "deuterated phenyl group" may respectively be: i) a fully deuterated C₁-C₆₀ alkyl group (or fully deuterated C₁-C₂₀ alkyl group or the like), fully deuterated C₃-C₁₀ cycloalkyl group, fully deuterated C₁-C₁₀ heterocycloalkyl group, or fully deuterated phenyl group, in which all hydrogen atoms are substituted with deuterium atoms; or ii) a partially deuterated C₁-C₆₀ alkyl group (or partially deuterated C₁-C₂₀ alkyl group or the like), partially deuterated C₃-C₁₀ cycloalkyl group, partially deuterated C₁-C₁₀ heterocycloalkyl group, or partially deuterated phenyl group, in which some of hydrogen atoms are substituted with deuterium atoms.

The "(C₁-C₂₀ alkyl)'X' group" refers to a 'X' group substituted with at least one C₁-C₂₀ alkyl group. For example, the "(C₁-C₂₀ alkyl)C₃-C₁₀ cycloalkyl group" as used herein refers to a C₃-C₁₀ cycloalkyl group substituted with at least one C₁-C₂₀ alkyl group, and the "(C₁-C₂₀ alkyl)phenyl group" as used herein refers to a phenyl group substituted with at least one C₁-C₂₀ alkyl group. Examples of the (C₁ alkyl)phenyl group may include a toluyl group.

In the present specification, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a hetero ring in which at least one ring-forming carbon atom is substituted with nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

A substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted unsaturated C₁-C₁₀ heterocyclic group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may each independently be:
deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or C₁-C₆₀ alkoxy group, each substituted with deuterium, -F, -CI, -Br, -I, -CD₃, -CD₂H, - CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), -P(=O)(Q₁₆)(Q₁₉), -P(Q₁₆)(Q₁₉), or any combination thereof;
a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), - P(=O)(Q₂₆)(Q₂₉), -P(Q₂₈)(Q₂₉), or any combination thereof;
-N(Q₃₁)(Q₃₂), -Si(Q₃₃)(Q₃₄)(Q₃₅), -B(Q36)(Q37), -P(=O)(Q₃₆)(Q₃₉), or - P(Q₃₆)(Q₃₉); or
any combination thereof.

In the present specification, Q₁ to Q₉, Q₁₁ to Q₁₉, Q₂₁ to Q₂₉, and Q₃₁ to Q₃₉ may each independently be: hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₂-C₁₀ heterocycloalkenyl group; an unsaturated C₁-C₁₀ heterocyclic group, a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used based on molar equivalence.

### Examples

### Synthesis Example 1 (Compound Pt-1)

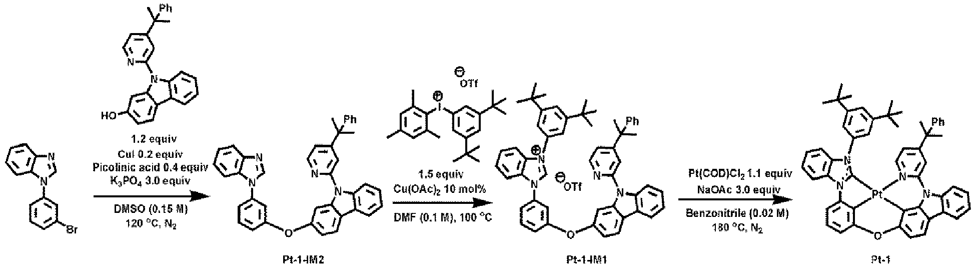

### (1) Synthesis of Intermediate Pt-1-IM2

5.46 grams (g) (20 mmol) of 1-(3-bromophenyl)-1H-benzo[d]imidazole, 9.08 g (24 mmol) of 9-(4-(2-phenylpropan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of dimethyl sulfoxide (DMSO), followed by stirring at a temperature of 120°C for 12 hours. Once the reaction was complete, the mixture was cooled to room temperature, and then, an organic layer extracted using saturated ammonium chloride (NH₄Cl) and ethyl acetate (EA) was dried with anhydrous magnesium sulfate (MgSO₄) and subjected to filtration, followed by concentration under reduced pressure. The resulting product was subjected to silica gel column chromatography to thereby obtain 7.42 g (13 mmol) of Intermediate Pt-1-IM2 (yield: 65 %).
LC-MS (calculated value: 570.24 g/mol, measured value: M+1 = 571 g/mol)

### (2) Synthesis of Intermediate Pt-1-IM1

7.42 g (13 mmol) of Intermediate Pt-1-IM2, 11.40 g (19.5 mmol) of (3,5-di-tert-butylphenyl)(mesityl)iodonium triflate, and 0.24 g (1.3 mmol) of copper (II) acetate were mixed with 130 mL of N,N-dimethylformamide (DMF), followed by stirring at a temperature of 100 °C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 10.05 g (11.05 mmol) of Intermediate Pt-1-IM1 (yield: 85 %).
LC-MS (calculated value: 759.41 g/mol, measured value: M+1 = 759 g/mol)

### (3) Synthesis of Compound Pt-1

5.00 g (5.50 mmol) of Intermediate Pt-1-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.88 g (3.03 mmol) of Compound Pt-1 (yield: 55 %).
LC-MS (calculated value: 951.35 g/mol, measured value: M+1 = 952 g/mol)

### Synthesis Example 2 (Compound Pt-2)

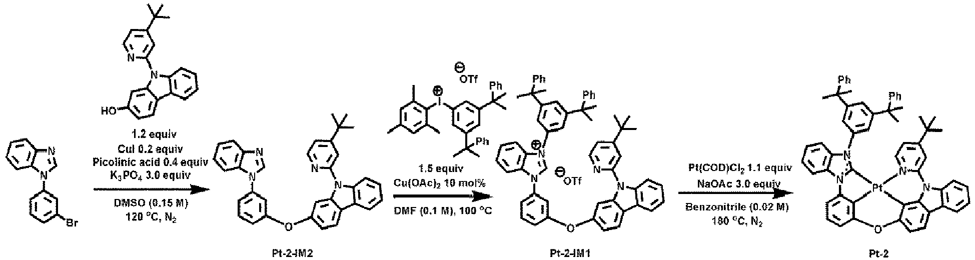

### (1) Synthesis of Intermediate Pt-2-IM2

5.46 g (20 mmol) of 1-(3-bromophenyl)-1H-benzo[d]imidazole, 7.59 g (24 mmol) of 9-(4-(tert-butyl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 6.92 g (13.60 mmol) of Intermediate Pt-2-IM2 (yield: 68 %).
LC-MS (calculated value: 508.23 g/mol, measured value: M+1 = 509 g/mol)

### (2) Synthesis of Intermediate Pt-2-IM1

6.92 g (13.60 mmol) of Intermediate Pt-2-IM2, 14.45 g (20.40 mmol) of (3,5-bis(2-phenylpropan-2-yl)phenyl)(mesityl)iodonium triflate, and 0.25 g (1.36 mmol) of copper (II) acetate were mixed with 136 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 11.09 g (11.42 mmol) of Intermediate Pt-2-IM1 (yield: 84 %).
LC-MS (calculated value: 821.42 g/mol, measured value: M+1 = 821 g/mol)

### (3) Synthesis of Compound Pt-2

5.34 g (5.50 mmol) of Intermediate Pt-2-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.96 g (2.92 mmol) of Compound Pt-2 (yield: 53 %).
LC-MS (calculated value: 1013.36 g/mol, measured value: M+1 = 1014 g/mol)

### Synthesis Example 3 (Compound Pt-3)

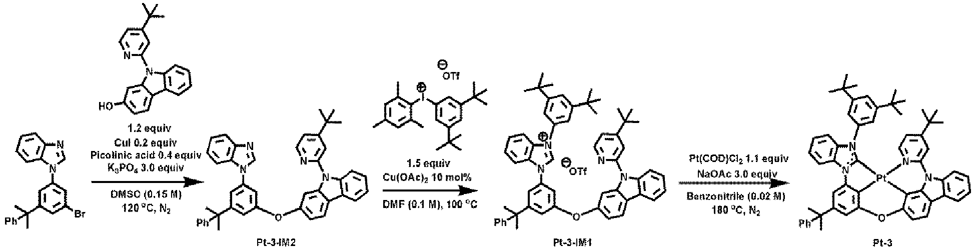

### (1) Synthesis of Intermediate Pt-3-IM2

7.83 g (20 mmol) of 1-(3-bromo-5-(2-phenylpropan-2-yl)phenyl)-1H-benzo[d]imidazole, 7.59 g (24 mmol) of 9-(4-(tert-butyl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 7.77 g (12.40 mmol) of Intermediate Pt-3-IM2 (yield: 62 %).
LC-MS (calculated value: 626.31 g/mol, measured value: M+1 = 627 g/mol)

### (2) Synthesis of Intermediate Pt-3-IM1

7.77 g (12.40 mmol) of Intermediate Pt-3-IM2, 10.87 g (18.60 mmol) of (3,5-di-tert-butylphenyl)(mesityl)iodonium triflate, and 0.23 g (1.24 mmol) of copper (II) acetate were mixed with 124 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 11.09 g (11.42 mmol) of Intermediate Pt-3-IM1 (yield: 84 %).
LC-MS (calculated value: 815.47 g/mol, measured value: M+1 = 816 g/mol)

### (3) Synthesis of Compound Pt-3

5.31 g (5.50 mmol) of Intermediate Pt-3-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.94 g (2.92 mmol) of Compound Pt-3 (yield: 53 %).
LC-MS (calculated value: 1007.41 g/mol, measured value: M+1 = 1008 g/mol)

### Synthesis Example 4 (Compound Pt-4)

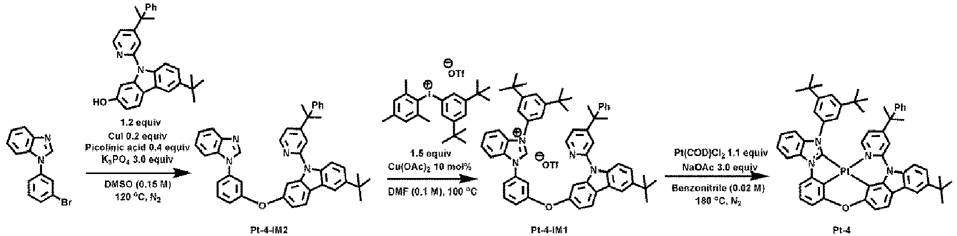

### (1) Synthesis of Intermediate Pt-4-IM2

5.46 g (20 mmol) of 1-(3-bromophenyl)-1H-benzo[d]imidazole, 10.43 g (24 mmol) of 6-(tert-butyl)-9-(4-(2-phenylpropan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 8.40 g (13.40 mmol) of Intermediate Pt-4-IM2 (yield: 67 %).
LC-MS (calculated value: 626.31 g/mol, measured value: M+1 = 627 g/mol)

### (2) Synthesis of Intermediate Pt-4-IM1

8.40 g (13.40 mmol) of Intermediate Pt-4-IM2, 11.75 g (20.10 mmol) of (3,5-di-tert-butylphenyl)(mesityl)iodonium triflate, and 0.24 g (1.34 mmol) of copper (II) acetate were mixed with 124 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 11.09 g (11.42 mmol) of Intermediate Pt-4-IM1 (yield: 84 %).
LC-MS (calculated value: 815.47 g/mol, measured value: M+1 = 816 g/mol)

### (3) Synthesis of Compound Pt-4

5.31 g (5.50 mmol) of Intermediate Pt-4-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.94 g (2.92 mmol) of Compound Pt-4 (yield: 53 %).
LC-MS (calculated value: 1007.41 g/mol, measured value: M+1 = 1008 g/mol)

### Synthesis Example 5 (Compound Pt-5)

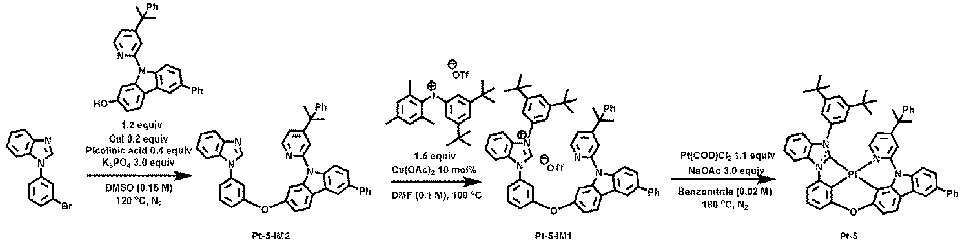

### (1) Synthesis of Intermediate Pt-5-IM2

5.46 g (20 mmol) of 1-(3-bromophenyl)-1H-benzo[d]imidazole, 10.91 g (24 mmol) of 6-phenyl-9-(4-(2-phenylpropan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 6.86 g (10.60 mmol) of Intermediate Pt-5-IM2 (yield: 53 %).
LC-MS (calculated value: 646.27 g/mol, measured value: M+1 = 647 g/mol)

### (2) Synthesis of Intermediate Pt-5-IM1

6.86 g (10.60 mmol) of Intermediate Pt-5-IM2, 9.29 g (15.90 mmol) of (3,5-di-tert-butylphenyl)(mesityl)iodonium triflate, and 0.19 g (1.06 mmol) of copper (II) acetate were mixed with 106 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 8.56 g (8.69 mmol) of Intermediate Pt-5-IM1 (yield: 82 %).
LC-MS (calculated value: 835.44 g/mol, measured value: M+1 = 836 g/mol)

### (3) Synthesis of Compound Pt-5

5.42 g (5.50 mmol) of Intermediate Pt-5-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 3.11 g (3.03 mmol) of Compound Pt-5 (yield: 55 %).
LC-MS (calculated value: 1027.38 g/mol, measured value: M+1 = 1028 g/mol)

### Synthesis Example 6 (Compound Pt-6)

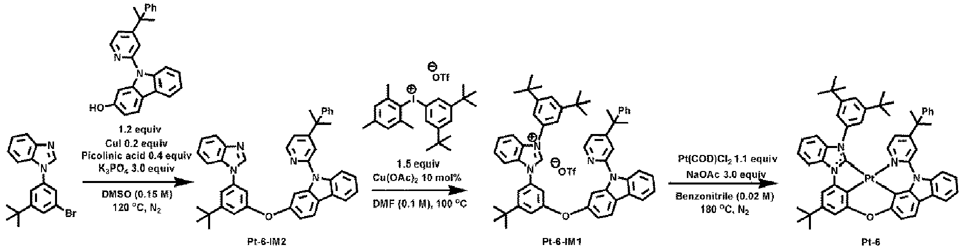

### (1) Synthesis of Intermediate Pt-6-IM2

6.58 g (20 mmol) of 1-(3-bromo-5-(tert-butyl)phenyl)-1H-benzo[d]imidazole, 9.08 g (24 mmol) of 9-(4-(2-phenylpropan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 6.64 g (10.60 mmol) of Intermediate Pt-6-IM2 (yield: 53 %).
LC-MS (calculated value: 626.31 g/mol, measured value: M+1 = 627 g/mol)

### (2) Synthesis of Intermediate Pt-6-IM1

6.64 g (10.60 mmol) of Intermediate Pt-6-IM2, 9.29 g (15.90 mmol) of (3,5-di-tert-butylphenyl)(mesityl)iodonium triflate, and 0.19 g (1.06 mmol) of copper (II) acetate were mixed with 106 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 8.29 g (8.59 mmol) of Intermediate Pt-6-IM1 (yield: 81 %).
LC-MS (calculated value: 815.47 g/mol, measured value: M+1 = 816 g/mol)

### (3) Synthesis of Compound Pt-6

5.31 g (5.50 mmol) of Intermediate Pt-6-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 3.33 g (3.30 mmol) of Compound Pt-6 (yield: 60 %).
LC-MS (calculated value: 1007.41 g/mol, measured value: M+1 = 1008 g/mol)

### Synthesis Example 7 (Compound Pt-7)

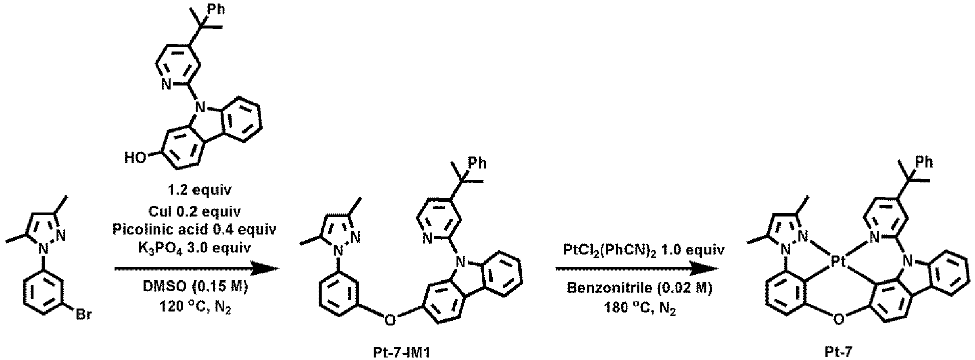

### (1) Synthesis of Intermediate Pt-7-IM1

5.02 g (20 mmol) of 1-(3-bromophenyl)-3,5-dimethyl-1H-pyrazole, 9.08 g (24 mmol) of 9-phenyl-9-(4-(2-phenylpropan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 6.04 g (11.00 mmol) of Intermediate Pt-7-IM1 (yield: 55 %).
LC-MS (calculated value: 548.26 g/mol, measured value: M+1 = 549 g/mol)

### (2) Synthesis of Compound Pt-7

3.02 g (5.50 mmol) of Intermediate Pt-7-IM1 and 2.11 g (6.05 mmol) of PtCl₂(PhCN)₂ were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.24 g (3.03 mmol) of Compound Pt-7 (yield: 55 %).
LC-MS (calculated value: 741.21 g/mol, measured value: M+1 = 742 g/mol)

### Synthesis Example 8 (Compound Pt-8)

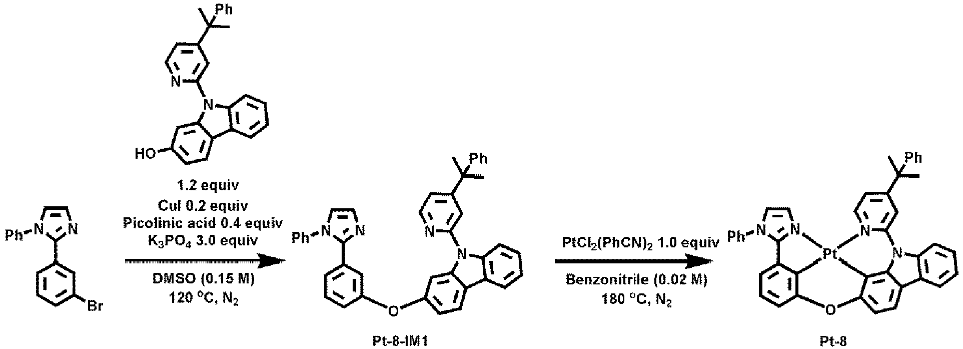

### (1) Synthesis of Intermediate Pt-8-IM1

5.98 g (20 mmol) of 2-(3-bromophenyl)-1-phenyl-1H-imidazole, 9.08 g (24 mmol) of 9-phenyl-9-(4-(2-phenylpropan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 5.85 g (9.80 mmol) of Intermediate Pt-8-IM1 (yield: 49 %).
LC-MS (calculated value: 596.26 g/mol, measured value: M+1 = 597 g/mol)

### (2) Synthesis of Compound Pt-8

3.28 g (5.50 mmol) of Intermediate Pt-8-IM1 and 2.11 g (6.05 mmol) of PtCl₂(PhCN)₂ were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.43 g (3.08 mmol) of Compound Pt-8 (yield: 56 %).
LC-MS (calculated value: 789.21 g/mol, measured value: M+1 = 790 g/mol)

### Synthesis Example 9 (Compound Pt-9)

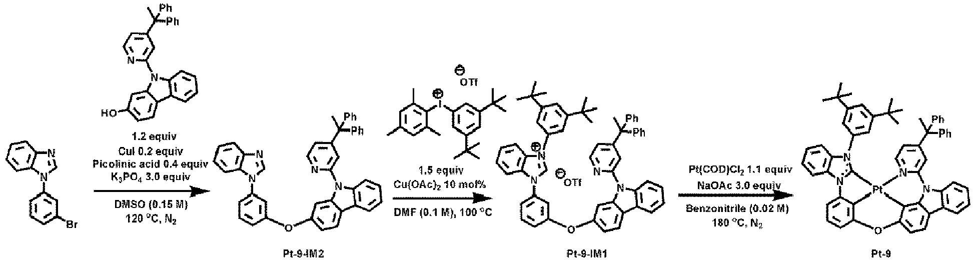

### (1) Synthesis of Intermediate Pt-9-IM2

5.46 g (20 mmol) of 1-(3-bromophenyl)-1H-benzo[d]imidazole, 10.56 g (24 mmol) of 9-(4-(1,1-diphenylethyl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 6.70 g (10.60 mmol) of Intermediate Pt-9-IM2 (yield: 53 %).
LC-MS (calculated value: 632.26 g/mol, measured value: M+1 = 633 g/mol)

### (2) Synthesis of Intermediate Pt-9-IM1

6.86 g (10.60 mmol) of Intermediate Pt-9-IM2, 9.29 g (15.90 mmol) of (3,5-di-tert-butylphenyl)(mesityl)iodonium triflate, and 0.19 g (1.06 mmol) of copper (II) acetate were mixed with 106 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 8.43 g (8.69 mmol) of Intermediate Pt-9-IM1 (yield: 82 %).
LC-MS (calculated value: 821.44 g/mol, measured value: M+1 = 821 g/mol)

### (3) Synthesis of Compound Pt-9

5.34 g (5.50 mmol) of Intermediate Pt-9-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 3.07 g (3.03 mmol) of Compound Pt-9 (yield: 55 %).
LC-MS (calculated value: 1013.36 g/mol, measured value: M+1 = 1014 g/mol)

### Synthesis Example 10 (Compound Pt-10)

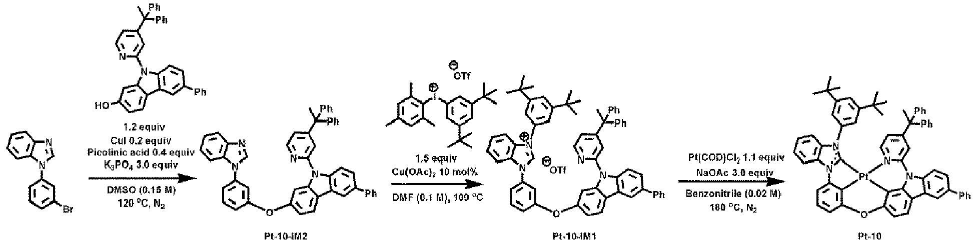

### (1) Synthesis of Intermediate Pt-10-IM2

5.46 g (20 mmol) of 1-(3-bromophenyl)-1H-benzo[d]imidazole, 12.39 g (24 mmol) of 9-(4-(1,1-diphenylethyl)pyridin-2-yl)-6-phenyl-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 7.08 g (10.00 mmol) of Intermediate Pt-10-IM2 (yield: 50 %).
LC-MS (calculated value: 708.29 g/mol, measured value: M+1 = 709 g/mol)

### (2) Synthesis of Intermediate Pt-10-IM1

7.08 g (10.00 mmol) of Intermediate Pt-10-IM2, 8.76 g (15.00 mmol) of (3,5-di-tert-butylphenyl)(mesityl)iodonium triflate, and 0.19 g (1.00 mmol) of copper (II) acetate were mixed with 100 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 8.37 g (8.00 mmol) of Intermediate Pt-10-IM1 (yield: 80 %).
LC-MS (calculated value: 897.45 g/mol, measured value: M+1 = 898 g/mol)

### (3) Synthesis of Compound Pt-10

5.76 g (5.50 mmol) of Intermediate Pt-10-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 3.06 g (2.81 mmol) of Compound Pt-10 (yield: 51 %).
LC-MS (calculated value: 1089.40 g/mol, measured value: M+1 = 1090 g/mol)

### Synthesis Example 11 (Compound Pt-13)

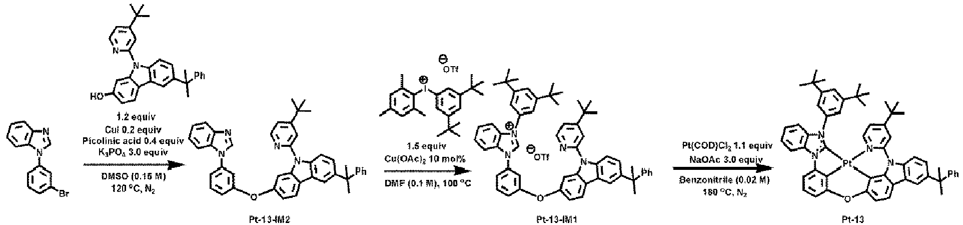

### (1) Synthesis of Intermediate Pt-13-IM2

5.46 g (20 mmol) of 1-(3-bromophenyl)-1H-benzo[d]imidazole, 10.42 g (24 mmol) of 9-(4-(tert-butyl)pyridin-2-yl)-6-(2-phenylpropan-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 6.89 g (11.00 mmol) of Intermediate Pt-13-IM2 (yield: 55 %).
LC-MS (calculated value: 626.31 g/mol, measured value: M+1 = 627 g/mol)

### (2) Synthesis of Intermediate Pt-13-IM1

6.89 g (11.00 mmol) of Intermediate Pt-13-IM2, 9.64 g (16.50 mmol) of (3,5-di-tert-butylphenyl)(mesityl)iodonium triflate, and 0.20 g (1.10 mmol) of copper (II) acetate were mixed with 110 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 8.49 g (8.80 mmol) of Intermediate Pt-13-IM1 (yield: 80 %).
LC-MS (calculated value: 815.47 g/mol, measured value: M+1 = 816 g/mol)

### (3) Synthesis of Compound Pt-13

5.30 g (5.50 mmol) of Intermediate Pt-13-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.83 g (2.81 mmol) of Compound Pt-13 (yield: 51 %).
LC-MS (calculated value: 1007.41 g/mol, measured value: M+1 = 1008 g/mol)

### Synthesis Example 12 (Compound Pt-17)

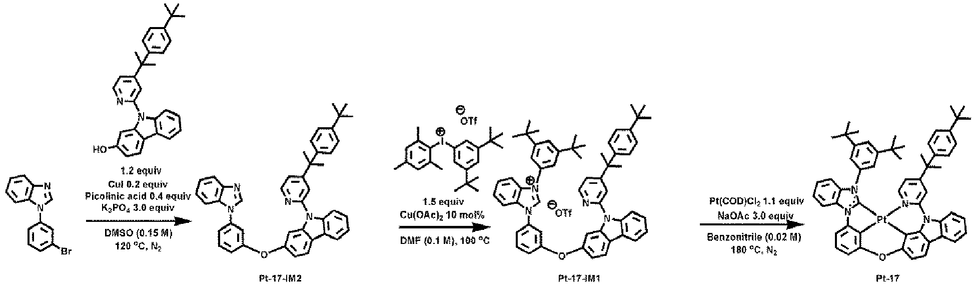

### (1) Synthesis of Intermediate Pt-17-IM2

5.46 g (20 mmol) of 1-(3-bromophenyl)-1H-benzo[d]imidazole, 10.42 g (24 mmol) of 9-(4-(2-(4-(tert-butyl)phenyl)propan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 6.89 g (11.00 mmol) of Intermediate Pt-17-IM2 (yield: 55 %).
LC-MS (calculated value: 626.31 g/mol, measured value: M+1 = 627 g/mol)

### (2) Synthesis of Intermediate Pt-17-IM1

6.89 g (11.00 mmol) of Intermediate Pt-17-IM2, 9.64 g (16.50 mmol) of (3,5-di-tert-butylphenyl)(mesityl)iodonium triflate, and 0.20 g (1.10 mmol) of copper (II) acetate were mixed with 110 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 8.49 g (8.80 mmol) of Intermediate Pt-17-IM1 (yield: 80 %).
LC-MS (calculated value: 815.47 g/mol, measured value: M+1 = 816 g/mol)

### (3) Synthesis of Compound Pt-17

5.30 g (5.50 mmol) of Intermediate Pt-17-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 2.94 g (2.92 mmol) of Compound Pt-17 (yield: 53 %).
LC-MS (calculated value: 1007.41 g/mol, measured value: M+1 = 1008 g/mol)

### Synthesis Example 13 (Compound Pt-18)

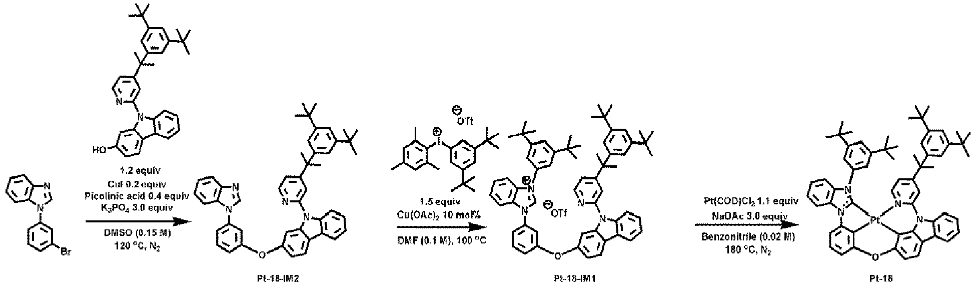

### (1) Synthesis of Intermediate Pt-18-IM2

5.46 g (20 mmol) of 1-(3-bromophenyl)-1H-benzo[d]imidazole, 11.78 g (24 mmol) of 9-(4-(2-(3,5-di-tert-butylphenyl)propan-2-yl)pyridin-2-yl)-9H-carbazol-2-ol, 0.76 g (4 mmol) of copper (I) iodide, 0.98 g (8 mmol) of picolinic acid, and 12.7 g (60 mmol) of potassium phosphate tribasic were mixed with 133 mL of DMSO, followed by stirring at a temperature of 120°C for 12 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 7.78 g (11.40 mmol) of Intermediate Pt-18-IM2 (yield: 57 %).
LC-MS (calculated value: 682.37 g/mol, measured value: M+1 = 683 g/mol)

### (2) Synthesis of Intermediate Pt-18-IM1

7.78 g (11.40 mmol) of Intermediate Pt-18-IM2, 9.99 g (17.10 mmol) of (3,5-di-tert-butylphenyl)(mesityl)iodonium triflate, and 0.21 g (1.14 mmol) of copper (II) acetate were mixed with 114 mL of DMF, followed by stirring at a temperature of 100°C for 4 hours. Once the reaction was complete, the mixture was cooled to room temperature, and then, an organic layer extracted using saturated NH₄Cl and EA was dried with anhydrous MgSO₄ and subjected to filtration, followed by concentration under reduced pressure. The resulting product was subjected to silica gel column chromatography to thereby obtain 9.66 g (9.46 mmol) of Intermediate Pt-18-IM1 (yield: 83 %).
LC-MS (calculated value: 871.53 g/mol, measured value: M+1 = 872 g/mol)

### (3) Synthesis of Compound Pt-18

5.62 g (5.50 mmol) of Intermediate Pt-18-IM1, 2.26 g (6.05 mmol) of Pt(COD)Cl₂, and 1.35 g (16.50 mmol) of sodium acetate were mixed with 275 mL of benzonitrile, followed by stirring at a temperature of 180°C for 18 hours. Once the reaction was complete, the mixture was cooled to room temperature and concentrated under reduced pressure. The resulting product was subjected to silica gel column chromatography to thereby obtain 3.22 g (3.03 mmol) of Compound Pt-18 (yield: 55 %).
LC-MS (calculated value: 1063.47 g/mol, measured value: M+1 = 1064 g/mol)

### Evaluation Example 1: Evaluation of Photoluminescence (PL) spectrum

Compound Pt-1 was diluted in toluene at a concentration of 10 millimole (mM), and a PL spectrum of Compound Pt-1 was measured by using an ISC PC1 spectrofluorometer, in which a xenon lamp is mounted. The same process was performed on Compound Pt-2 to Pt-6, Pt-9, Pt-10, Pt-13, Pt-17, and Pt-18. The maximum emission wavelength and FWHM of the compounds are shown in Table 2.

**Table 2**

| Compound No. | Maximum emission wavelength (nm) | FWHM (nm) |
|---|---|---|
| Pt-1 | 460 | 21 |
| Pt-2 | 460 | 22 |
| Pt-3 | 465 | 27 |
| Pt-4 | 461 | 21 |
| Pt-5 | 460 | 19 |
| Pt-6 | 465 | 26 |
| Pt-9 | 462 | 22 |
| Pt-10 | 462 | 21 |
| Pt-13 | 461 | 21 |
| Pt-17 | 460 | 21 |
| Pt-18 | 460 | 21 |

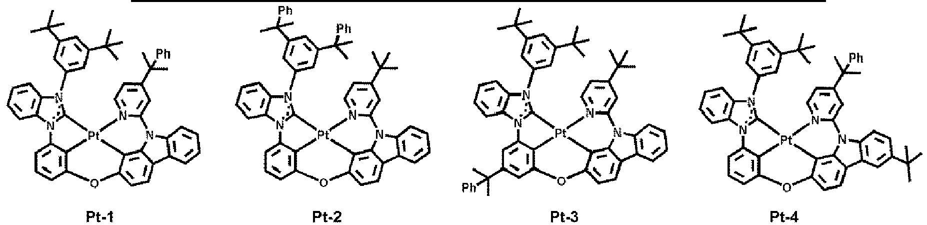

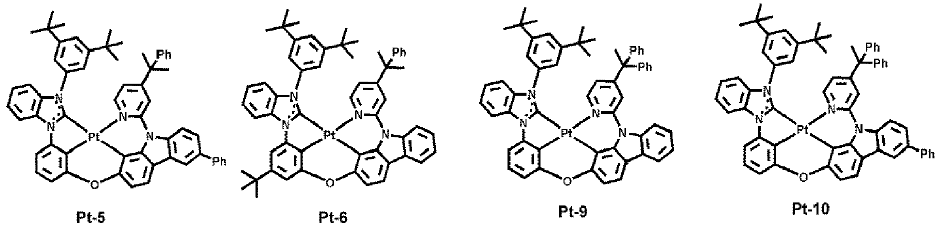

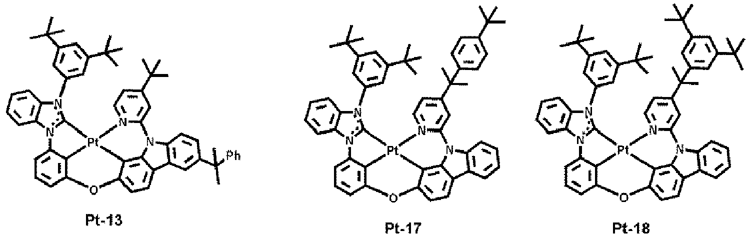

Referring to the results of Table 2, Compounds Pt-1 to Pt-6, Pt-9, Pt-10, Pt-13, Pt-17, and Pt-18 were found to emit blue light having a narrow FWHM.

### Example 1

As a first electrode (an anode), a glass substrate having an indium tin oxide (ITO) electrode deposited thereon at a thickness of 1,500 Å was washed with distilled water in the presence of ultrasound waves. Once the washing with distilled water was complete, ultrasound wave washing was performed on the substrate by using isopropyl alcohol, acetone, and methanol in this stated order. Subsequently, the substrate was dried, transferred to a plasma washer, washed for 5 minutes using oxygen plasma, and mounted in a vacuum deposition device.

Compound HT3 was vacuum-deposited on the ITO electrode of the glass substrate to form a first hole injection layer having a thickness of about 3500 Å, Compound HT-D1 was vacuum-deposited on the first hole injection layer to form a second hole injection layer having a thickness of about 300 Å, and TAPC was vacuum-deposited on the second hole injection layer to form an electron blocking layer having a thickness of about 100 Å, thereby forming a hole transport region.

Compound H52 and Compound Pt-1 (10 wt%) were co-deposited on the hole transport region to form an emission layer having a thickness of 300 Å.

Compound ET3 was vacuum-deposited on the emission layer to form an electron transport layer having a thickness of about 250 Å, ET-D1 (Liq) was deposited on the electron transport layer to form an electron injection layer having a thickness of about 5 Å, and an Al second electrode (a cathode) was formed on the electron injection layer to have a thickness of about 1,000 Å, thereby completing the manufacture of an organic light-emitting device.

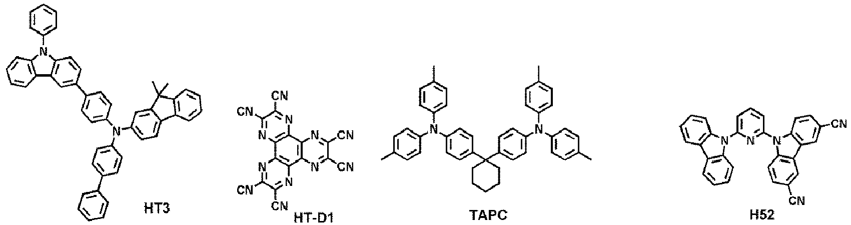

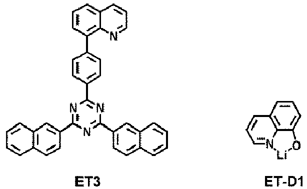

### Examples 1 and 6 and Comparative Examples A and B

Organic light-emitting devices were manufactured in substantially the same manner as in Example 1, except that the compounds shown in Table 3 were used instead of Compound Pt-1 as a dopant in the formation of an emission layer.

### Evaluation Example 2: Evaluation of characteristics of organic light-emitting device

The maximum emission wavelength of the EL spectrum, the driving voltage, the external quantum luminescence efficiency, and lifespan (LT₉₅) of each of the organic light-emitting devices manufactured in Examples 1 to 6 and Comparative Examples A and B were evaluated. The results thereof are shown in Table 3. The lifespan (LT₉₅) indicates time (hour) for the luminance of each light-emitting device to decline to 95 % of its initial luminance of 100 %. EL spectra of the manufactured organic light-emitting devices at a luminance of 1,000 candelas per square meter (cd/m²) were measured by using a luminance meter (Minolta Cs-1000A). Then, the maximum emission wavelength was evaluated. A Keithley 2400 current voltmeter and a luminance meter (Minolta Cs-1000A) were used in evaluation of driving voltage and external quantum luminescence efficiency. In Table 3, the driving voltage, external quantum luminescence efficiency, and lifespan of the organic light-emitting devices manufactured in Examples 1 to 6 and Comparative Example B are shown in a relative value (%).

**Table 3**

| | Dopant Compound No. | Maximum emission wavelength (nm) | Driving voltage (V) (relative value, %) | External quantum Luminescence efficiency (External quantum efficiency (EQE) (at 1,000 cd/m²) (relative value, %) | Lifespan (LT₉₅) (at 1,000 cd/m²) (relative value, %) |
|---|---|---|---|---|---|
| Example 1 | Pt-1 | 460 | 93 | 120 | 159 |
| Example 2 | Pt-2 | 461 | 94 | 105 | 116 |
| Example 3 | Pt-3 | 466 | 95 | 124 | 236 |
| Example 4 | Pt-4 | 461 | 96 | 123 | 175 |
| Example 5 | Pt-5 | 460 | 94 | 122 | 188 |
| Example 6 | Pt-13 | 461 | 95 | 110 | 145 |
| Comparative Example A | A | 461 | 100 | 100 | 100 |
| Comparative Example B | B | 452 | 121 | 62 | 17 |

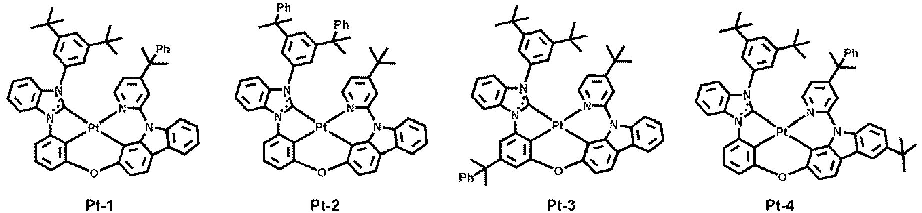

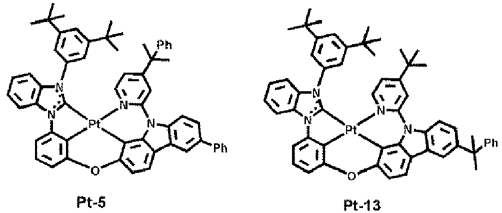

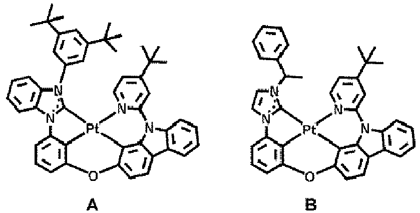

Referring to Table 3, the organic light-emitting device of Examples 1 to 6 were found to have improved driving voltage, improved external quantum luminescence efficiency, and improved lifespan, as compared with the organic light-emitting devices of Comparative Examples A and B.

### Example 7

An organic light-emitting device was manufactured in substantially the same manner as in Example 1, except that CBP, Compound Pt-1, and Compound FD16 were co-deposited at a weight ratio of 88.5:10:1.5 to form an emission layer instead of Compound H52 and Compound Pt-1.

### Comparative Example C

An organic light-emitting device was manufactured in the same manner as in Example 1, except that CBP and Compound FD16 were co-deposited at a weight ratio of 90:10 to form an emission layer instead of Compound H52 and Compound Pt-1. Evaluation Example 3: Evaluation of characteristics of organic light-emitting device

The maximum emission wavelength of the EL spectrum, driving voltage, external quantum luminescence efficiency, and lifespan (LT₉₅) of the organic light-emitting devices manufactured in Example 7 and Comparative Example C were evaluated in substantially the same manner as in Evaluation Example 2. The results are shown in Table 4. In Table 4, the driving voltage, external quantum luminescence efficiency, and lifespan of the organic light-emitting devices manufactured in Example 7 and Comparative Example C are shown in a relative value (%).

**Table 4**

| No. | Emission layer | Maximum emission wavelength (nm) | Driving voltage (relative value, %) | External quantum luminescence efficiency (EQE) (at 1,000 cd/m²) (relative value, %) | Lifespan (LT₉₅) (at 1,000 cd/m²) (relative value, %) |
|---|---|---|---|---|---|
| Example 7 | CBP:Pt-1:FD16 (88.5:10:1.5) | 461 | 96 | 603 | 536 |
| Comparative Example C | CBP:FD16 (90:10) | 462 | 100 | 100 | 100 |

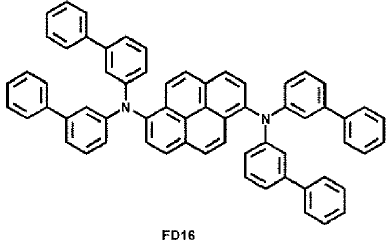

Referring to Table 4, the organic light-emitting device of Example 7 was found to have improved driving voltage, improved external quantum luminescence efficiency, and improved lifespan, as compared with the organic light-emitting device of Comparative Example C.

As the organometallic compound has excellent thermal stability and electrical characteristics, an electronic device, e.g., an organic light-emitting device including the organometallic compound may have improved driving voltage, improved external quantum efficiency, and improved lifespan characteristics and emit light having a relatively narrow FWHM.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula 1: 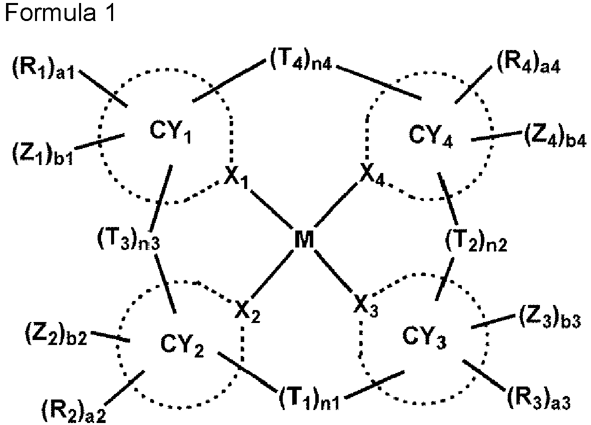
wherein, M in Formula 1 is a transition metal,
X₁ to X₄ in Formula 1 are each independently C or N,
in Formula 1, two of a bond between X₁ and M, a bond between X₂ and M, a bond between X₃ and M, and a bond between X₄ and M are each a coordinate bond, and the rest are each a covalent bond,
Z₁ to Z₄ in Formula 1 are each independently a group represented by Formula 2: 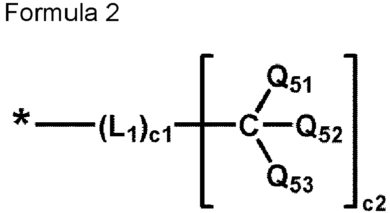
b1 to b4 in Formula 1 are each independently an integer from 0 to 20, and the sum of b1 to b4 is 1 or greater,
ring CY₁ to ring CY₄ in Formula 1 are each independently a C₅-C₃₀ carbocyclic group or a C₁-C₃₀ heterocyclic group,
T₁ in Formula 1 is a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₂ in Formula 1 is a single bond, a double bond, *-N(R₆ₐ)-*', *-B(R₆ₐ)-*', *-P(R₆ₐ)-*', *-C(R₆ₐ)(R_{6b})-*', *-Si(R₆ₐ)(R_{6b})-*', *-Ge(R₆ₐ)(R_{6b})-*', *-S-*', *-Se-*', *-O-*', *-C(=O)-*', *-S(=O)-*', *-S(=O)₂-*', *-C(R₆ₐ)=*', *=C(R₆ₐ)-*', *-C(R₆ₐ)=C(R_{6b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₃ in Formula 1 is a single bond, a double bond, *-N(R₇ₐ)-*', *-B(R₇ₐ)-*', *-P(R₇ₐ)-*', *-C(R₇ₐ)(R_{7b})-*', *-Si(R₇ₐ)(R_{7b})-*', *-Ge(R₇ₐ)(R_{7b})-*', *-S-*', *-Se-*', *-O-*', *-C(=O)-*', *-S(=O)-*', *-S(=O)₂-*', *C(R₇ₐ)=*', *=C(R₇ₐ)-*', *-C(R₇ₐ)=C(R_{7b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₄ in Formula 1 is a single bond, a double bond, *-N(R₈ₐ)-*', *-B(R₈ₐ)-*', *-P(R₈ₐ)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*1, *-C(=O)-*', *-S(=O)-*', *-S(=O)₂-*', *-C(R₈ₐ)=*', *=C(R₈ₐ)-*', *-C(R₈ₐ)=C(R_{8b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
n1 to n4 in Formula 1 are each independently an integer from 0 to 5, and at least three of n1 to n4 are each independently an integer from 1 to 5,
in Formula 1, when n1 is 0, T₁ is not present, when n2 is 0, T₂ is not present, when n3 is 0, T₃ is not present, and when n4 is 0, T₄ is not present,
in Formula 1, when n1 is 2 or greater, at least two T₁(s) are identical to or different from each other, when n2 is 2 or greater, at least two T₂(s) are identical to or different from each other, when n3 is 2 or greater, at least two T₃(s) are identical to or different from each other, and when n4 is 2 or greater, at least two T₄(s) are identical to or different from each other,
R₁ to R₄, R₅ₐ, R_{5b}, R₆ₐ, R_{6b}, R₇ₐ, R_{7b}, R₈ₐ, R_{8b}, and Q₅₁ to Q₅₃ in Formulae 1 and 2 are each independently hydrogen, deuterium, -F, -CI, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted unsaturated C₁-C₁₀ heterocyclic group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - Ge(Q₃)(Q₄)(Q₅), -B(Q₆)(Q₇), -P(=O)(Q₆)(Q₉), or -P(Q₆)(Q₉), and none of Q₅₁ to Q₅₃ in Formula 2 is hydrogen,
at least one of Q₅₁ to Q₅₃ in Formula 2 is independently a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
a1 to a4 in Formula 1 are each independently an integer from 0 to 20,
L₁ in Formula 2 is a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
c1 in Formula 2 is an integer from 1 to 10,
c2 in Formula 2 is an integer from 1 to 20,
at least two R₁(s) in the number of a1 in Formula 1 are optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two R₂(s) in the number of a2 in Formula 1 are optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two R₃(s) in the number of a3 in Formula 1 are optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two R₄(s) in the number of a4 in Formula 1 are optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two of R₁ to R₄, R₅ₐ, R_{5b}, R₆ₐ, R_{6b}, R₇ₐ, R_{7b}, R₈ₐ, and R_{8b} are optionally bound to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is understood by referring to the description of R₁ provided herein,
* and *' each indicate a binding site to an adjacent atom, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted unsaturated C₁-C₁₀ heterocyclic group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₆), -Ge(Q₁₃)(Q₁₄)(Q₁₆), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, an unsaturated C₁-C₁₀ heterocyclic group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉),-P(Q28)(Q29), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇),-P(=O)(Q₃₈)(Q₃₉), or -P(Q₃₈)(Q₃₉); or
any combination thereof,
wherein Q₁ to Q₉, Q₁₁ to Q₁₉, Q₂₁ to Q₂₉, and Q₃₁ to Q₃₉ are each independently hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₂-C₁₀ heterocycloalkenyl group; an unsaturated C₁-C₁₀ heterocyclic group, a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

2. The organometallic compound of claim 1, wherein M in Formula 1 is Pt, Pd, or Au; and/or
wherein a bond between X₁ and M in Formula 1 is a coordinate bond.

3. The organometallic compound of claims 1 or 2, wherein ring CY₁ to ring CY₄ in Formula 1 are each independently i) a first ring, ii) a second ring, iii) a condensed ring in which at least two first rings are condensed, iv) a condensed ring in which at least two second rings are condensed, or v) a condensed ring in which at least one first ring is condensed with at least one second ring,
the first ring is a cyclopentane group, a cyclopentadiene group, a furan group, a thiophene group, a pyrrole group, a silole group, an oxazole group, a borole group, a phosphole group, a germole group, a selenophene group, an isoxazole group, a 1,2,3-oxadiazole group, a 1,2,4-oxadiazole group, a 1,2,5-oxadiazole group, a 1,3,4-oxadiazole group, an oxatriazole group, an isooxatriazole group, a thiazole group, an isothiazole group, a 1,2,3-thiadiazole group, a 1,2,4-thiadiazole group, a 1,2,5-thiadiazole group, a 1,3,4-thiadiazole group, a thiatriazole group, an isothiatriazole group, a pyrazole group, an imidazole group, a 1,2,3-triazole group, a 1,2,4-triazole group, a tetrazole group, an azasilole group, an isoazasilole group, a 1,2,3-diazasilole group, a 1,2,4-diazasilole group, a 1,2,5-diazasilole group, a 1,3,4-diazasilole group, a triazasilole group, or an isotriazasilole group, and
the second ring is an adamantane group, a norbornane group, a norbornene group, a cyclohexane group, a cyclohexene group, a cyclohexadiene group, a benzene group, a pyridine group, a pyrimidine group, a pyrazine group, a pyridazine group, a 1,3,5-triazine group, a 1,2,3-triazine group, a 1,2,4-triazine group, a 1,2-oxazine group, a 1,3-oxazine group, a 1,4-oxazine group, a 1,2-thiazine group, a 1,3-thiazine group, a 1,4-thiazine group, a dihydropyrazine group, a dihydropyridine group, or a dihydroazasilole group.

4. The organometallic compound of any of claims 1-3, wherein ring CY₁ in Formula 1 is i) a first ring, ii) a condensed ring in which at least two first rings are condensed, or iii) a condensed ring in which at least one first ring is condensed with at least one second ring,
C or N in the first ring comprised in ring CY₁ is X₁ in Formula 1,
the first ring is a cyclopentane group, a cyclopentadiene group, a furan group, a thiophene group, a pyrrole group, a silole group, an oxazole group, an isoxazole group, a 1,2,3-oxadiazole group, a 1,2,4-oxadiazole group, a 1,2,5-oxadiazole group, a 1,3,4-oxadiazole group, an oxatriazole group, an isooxatriazole group, a thiazole group, an isothiazole group, a 1,2,3-thiadiazole group, a 1,2,4-thiadiazole group, a 1,2,5-thiadiazole group, a 1,3,4-thiadiazole group, a thiatriazole group, an isothiatriazole group, a pyrazole group, an imidazole group, a 1,2,3-triazole group, a 1,2,4-triazole group, a tetrazole group, an azasilole group, a 1,2,3-diazasilole group, a 1,2,4-diazasilole group, a 1,2,5-diazasilole group, a 1,3,4-diazasilole group, or a triazasilole group, and
the second ring is an adamantane group, a norbornane group, a norbornene group, a cyclohexane group, a cyclohexene group, a benzene group, a pyridine group, a pyrimidine group, a pyrazine group, a pyridazine group, a 1,3,5-triazine group, a 1,2,3-triazine group, a 1,2,4-triazine group, a 1,2-oxazine group, a 1,3-oxazine group, a 1,4-oxazine group, a 1,2-thiazine group, a 1,3-thiazine group, a 1,4-thiazine group, a dihydropyrazine group, a dihydropyridine group, or a dihydroazasilole group.

5. The organometallic compound of any of claims 1-4, wherein in Formula 1, n3 is not 0, and ring CY₁ is represented by one of Formulae CY1(1) to CY1(56) and CY1(101) to CY1(108): 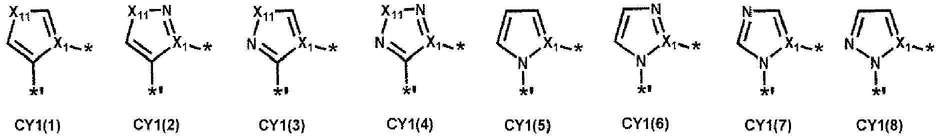 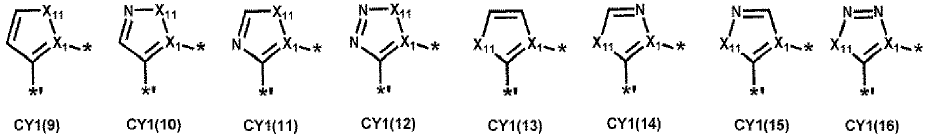 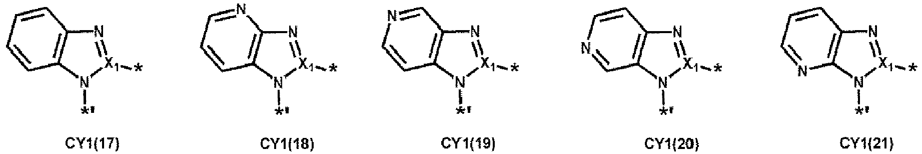 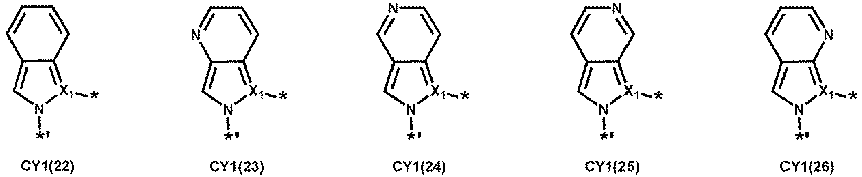 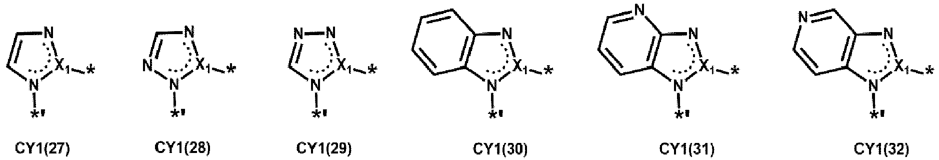 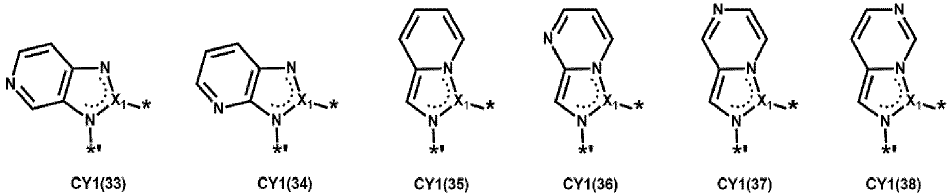 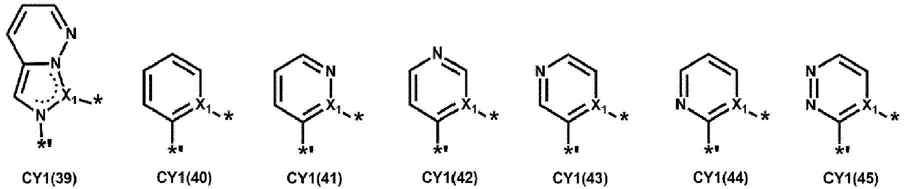 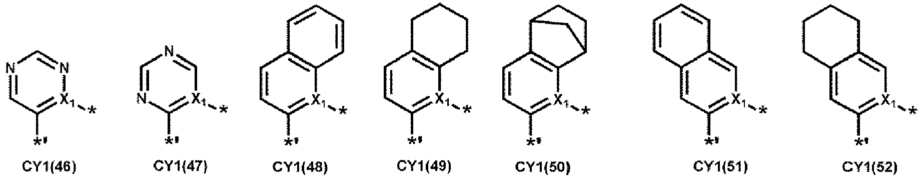 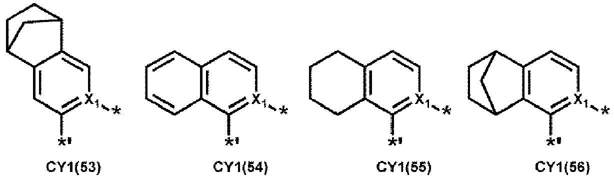 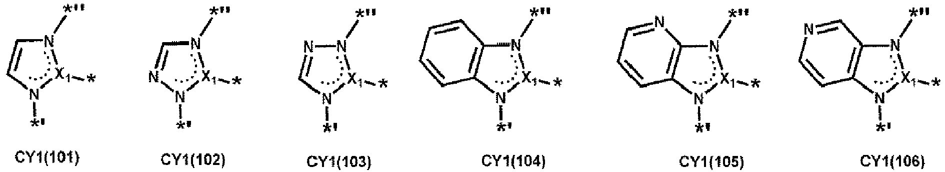 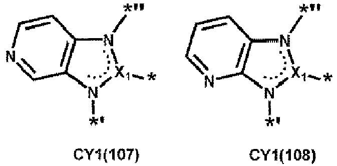
wherein, in Formulae CY1(1) to CY1(56) and CY1(101) to CY1(108),
X₁ is C or N, provided that, X₁ in Formulae CY1(27) to CY1(39) and CY1(101) to CY1 (108) is C,
X₁₁ is O, S, N(R₁₈), C(R₁₈)(R₁₉), or Si(R₁₈)(R₁₉), and R₁₈ and R₁₉ are each understood by referring to the descriptions of R₁ in claim 1,
* indicates a binding site to M in Formula 1,
*' indicates a binding site to T₃ in Formula 1, and
*" indicates a binding site to T₄ in Formula 1.

6. The organometallic compound of any of claims 1-5, wherein in Formula 1, n1 is not 0, n3 is not 0, and ring CY₂ is represented by one of Formulae CY2(1) to CY2(15): 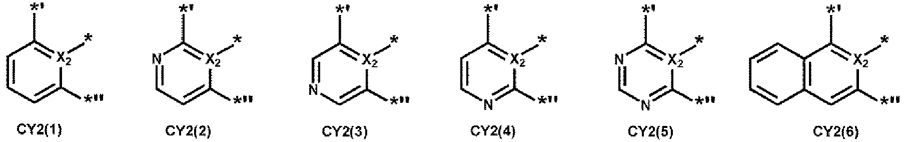 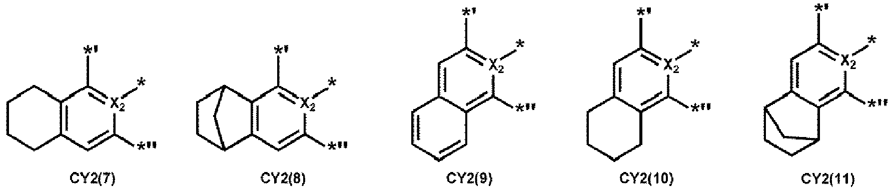 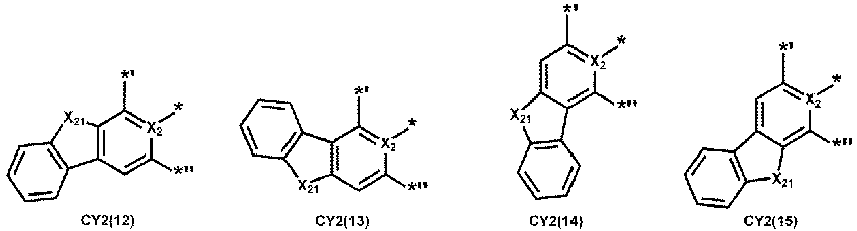
wherein, in Formulae CY2(1) to CY2(15),
X₂ is C or N,
X₂₁ is O, S, N(R₂₈), C(R₂₈)(R₂₉), or Si(R₂₈)(R₂₉), and R₂₈ and R₂₉ are each understood by referring to the descriptions of R₂ in claim 1,
*' indicates a binding site to T₃ in Formula 1,
* indicates a binding site to M in Formula 1, and
*" indicates a binding site to T₁ in Formula 1.

7. The organometallic compound of any of claims 1-6, wherein in Formula 1, n1 is not 0, and ring CY₃ is represented by one of Formulae CY3(1) to CY3(12) and CY3(101) to CY3(122): 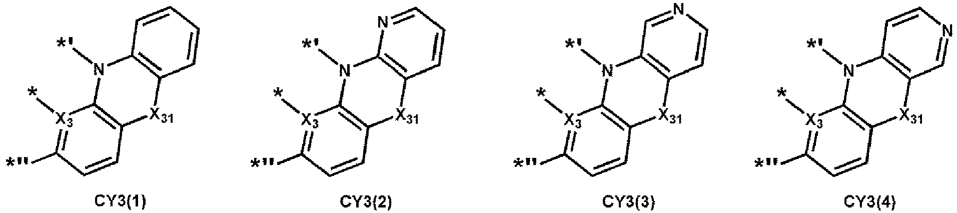 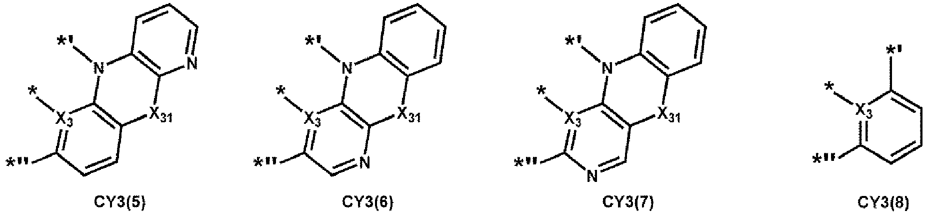 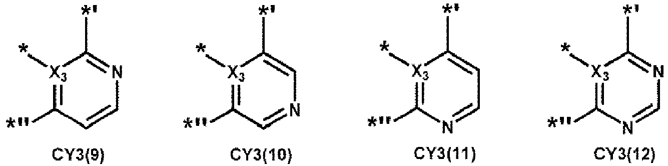 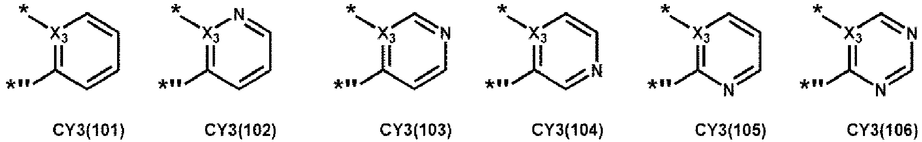 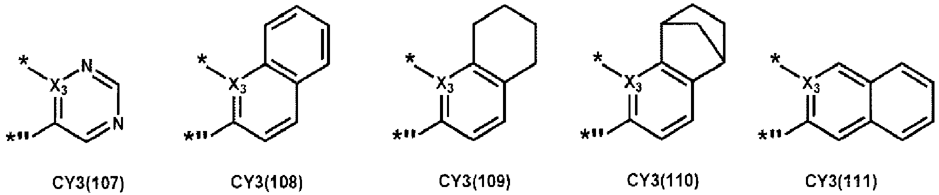 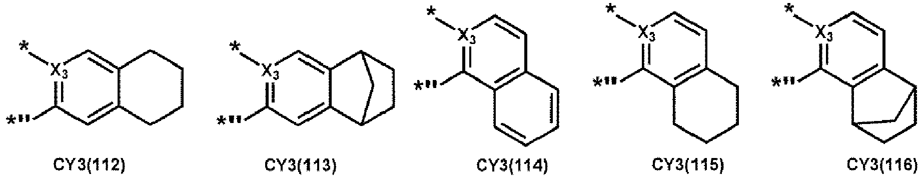 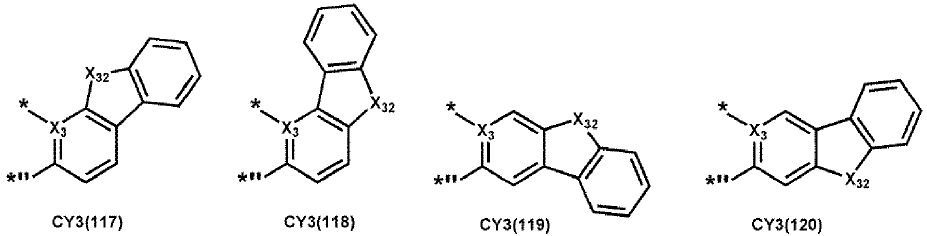 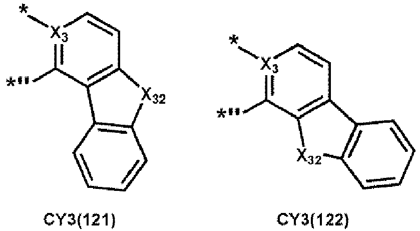
wherein, in Formulae CY3(1) to CY3(12) and CY3(101) to CY3(122),
X₃ is C or N,
X₃₁ is a single bond, O, S, N(R₃₈), C(R₃₈)(R₃₉), or Si(R₃₈)(R₃₉), X₃₂ is O, S, N(R₃₈), C(R₃₈)(R₃₉), or Si(R₃₈)(R₃₉), R₃₈ and R₃₉ are each understood by referring to the description of R₃ in claim 1,
*" indicates a binding site to T₁ in Formula 1,
* indicates a binding site to M in Formula 1, and
*' indicates a binding site to T₂ in Formula 1.

8. The organometallic compound of any of claims 1-7, wherein in Formula 1, n2 is not 0, and ring CY₄ is represented by one of Formulae CY4(1) to CY4(42) and CY4(101) to CY4(111): 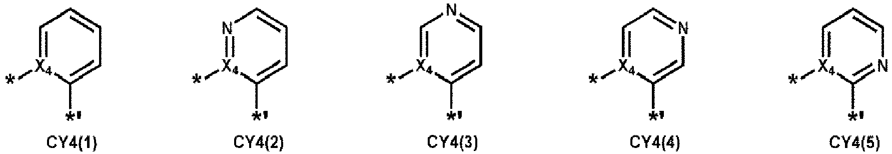 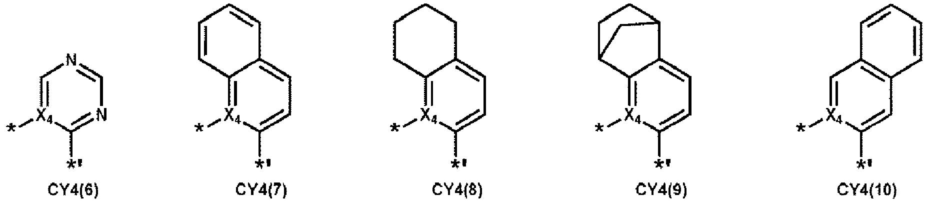 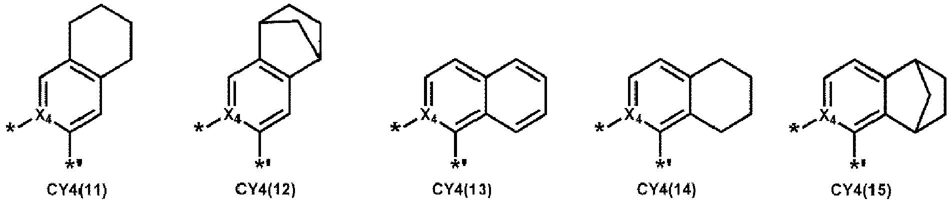 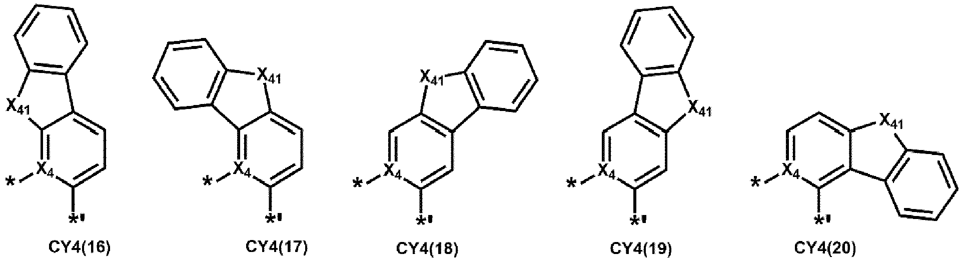 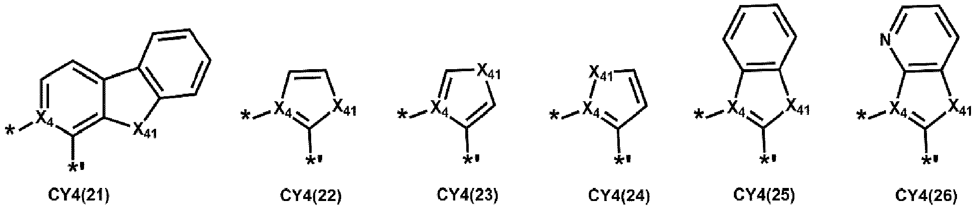 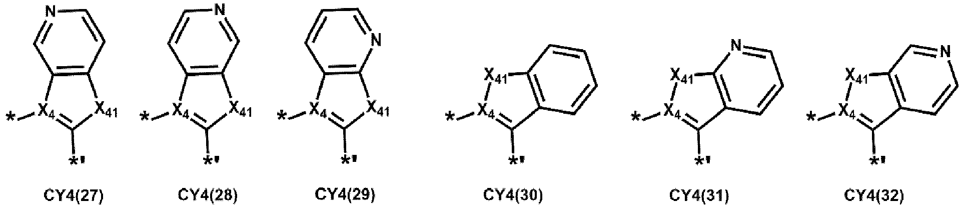 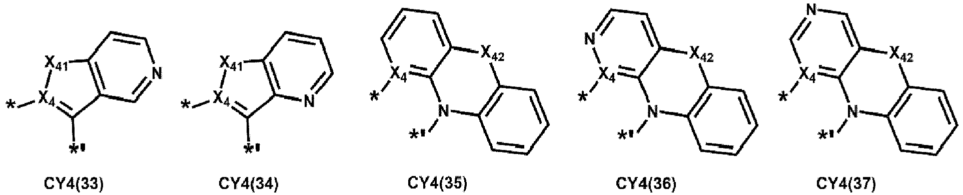 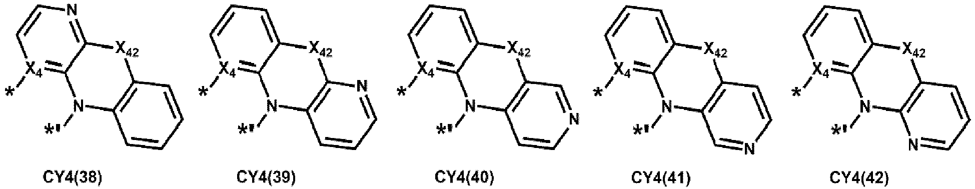 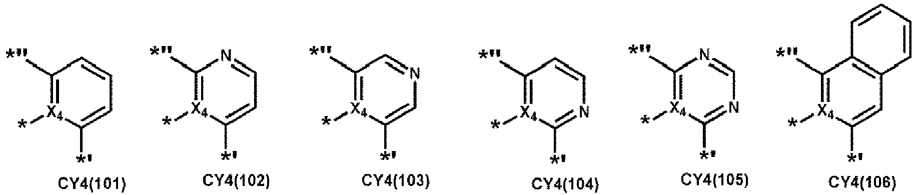 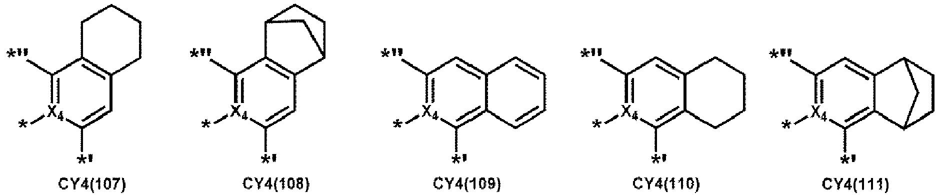
wherein, in Formulae CY4(1) to CY4(42) and CY4(101) to CY4(111),
X₄ is C or N,
X₄₁ is O, S, N(R₄₈), C(R₄₈)(R₄₉), or Si(R₄₈)(R₄₉), X₄₂ is a single bond, O, S, N(R₄₈), C(R₄₈)(R₄₉), or Si(R₄₈)(R₄₉), and R₄₈ and R₄₉ are each understood by referring to the descriptions of R₄ in claim 1,
* indicates a binding site to M in Formula 1,
*' indicates a binding site to T₂ in Formula 1, and
*" indicates a binding site to T₄ in Formula 1.

9. The organometallic compound of any of claims 1-8, wherein a group represented by *-C(Q₅₁)(Q₅₂)(Q₅₃) in Formula 2 is represented by one of Formulae 2-1 to 2-20: 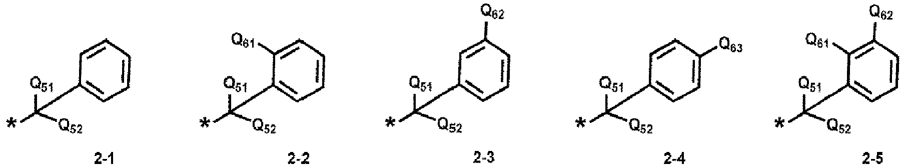 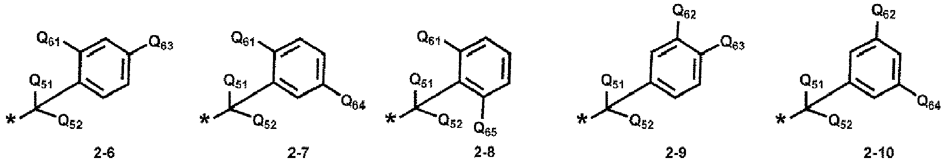 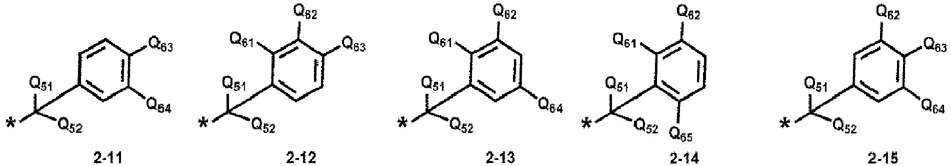 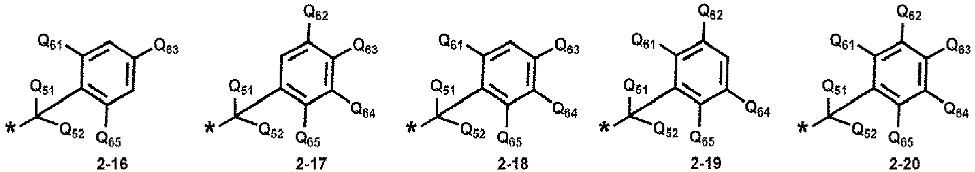 wherein, in Formulae 2-1 to 2-20, Q₅₁, Q₅₂, and Q₆₁ to Q₆₅ are each independently a substituted or unsubstituted C₁-C₆₀ alkyl group or a substituted or unsubstituted phenyl group, wherein Q₅₁, Q₅₂, and Q₆₁ to Q₆₅ are identical to or different from each other, and * indicates a binding site to L₁ in Formula 2.

10. The organometallic compound of any of claims 1-9, wherein the group represented by Formula 2 is represented by one of Formulae 2(1) to 2(19): 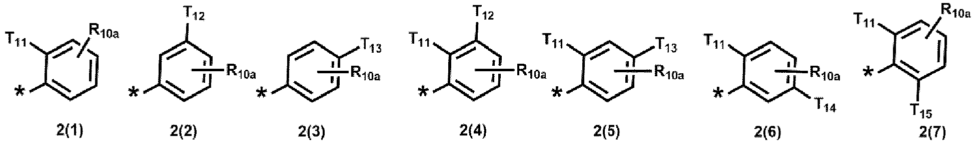 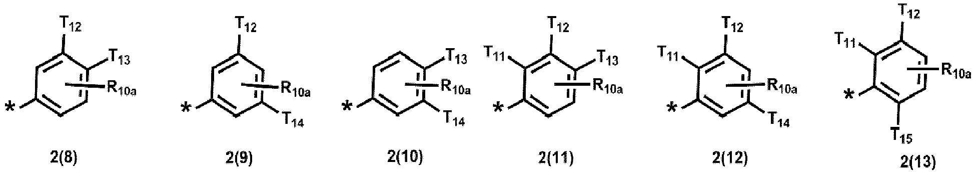 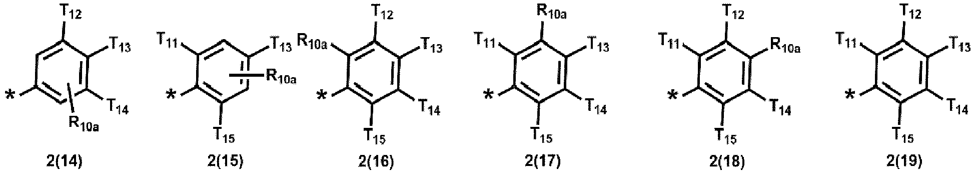 wherein, in Formulae 2(1) to 2(19), T₁₁ to T₁₅ are each a group represented by *-C(Q₅₁)(Q₅₂)(Q₅₃) in Formula 2, T₁₁ to T₁₅ are identical to or different from each other, R₁₀ₐ is understood by referring to the description of R₁ in claim 1, and * indicates a binding site to at least one of ring CY₁ to ring CY₄ in Formula 1.

11. An organic light-emitting device comprising:
a first electrode;
a second electrode; and
an organic layer disposed between the first electrode and the second electrode and comprising an emission layer;
wherein the organic layer comprises at least one organometallic compound of any of claims 1-10;
preferably wherein
the first electrode is an anode,
the second electrode is a cathode, and
the organic layer further comprises a hole transport region disposed between the first electrode and the emission layer and an electron transport region disposed between the emission layer and the second electrode,
wherein the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

12. The organic light-emitting device of claim 11, wherein the emission layer comprises the organometallic compound;
preferably wherein the emission layer further comprises a host.

13. The organic light-emitting device of claim 12, wherein a ratio of emission components emitted from the organometallic compound is 80 percent (%) or more of the total emission components emitted from the emission layer;
preferably wherein blue light is emitted from the organometallic compound.

14. The organic light-emitting device of claims 12 or 13, wherein the emission layer further comprises a fluorescent dopant different from the organometallic compound, and a ratio of emission components emitted from the fluorescent dopant is 80 % or more of the total emission components emitted from the emission layer;
preferably wherein the fluorescent dopant comprises an amino group-containing compound.

15. An electronic apparatus comprising the organic light-emitting device of any of claims 11-14.
